# EUROPEAN PATENT APPLICATION

(11) **EP 4 675 351 A1**
(43) Date of publication of application: **07.01.2026**
(21) Application number: 25185269.5
(22) Date of filing: 25.06.2025
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 03.07.2024 JP 2024107565
(71) Applicant: Shin-Etsu Chemical Co., Ltd., Tokyo 100-0005 (JP)
(72) Inventor: FUKUSHIMA, Masahiro, Joetsu-shi, 9428601 (JP); WATANABE, Satoshi, Joetsu-shi, 9428601 (JP); FUNATSU, Kenji, Joetsu-shi, 9428601 (JP); MASUNAGA, Keiichi, Joetsu-shi, 9428601 (JP); KOTAKE, Masaaki, Joetsu-shi, 9428601 (JP); MATSUZAWA, Yuta, Joetsu-shi, 9428601 (JP)
(74) Representative: Ter Meer Steinmeister & Partner

(57) **Abstract**

A chemically amplified positive resist composition containing a base polymer (A) which is a polymer whose solubility in an aqueous alkaline solution is increased by the action of an acid, contains a repeat unit containing an aromatic sulfonate anion having the formula (A1-1) and a sulfonium cation having the formula (A1-2) and a repeat unit having the formula (A2), and contains a polymer whose solubility in an aqueous alkaline solution is increased by the action of an acid.

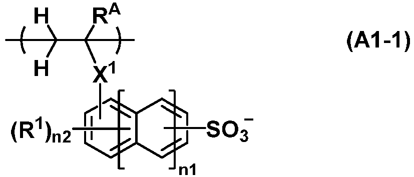

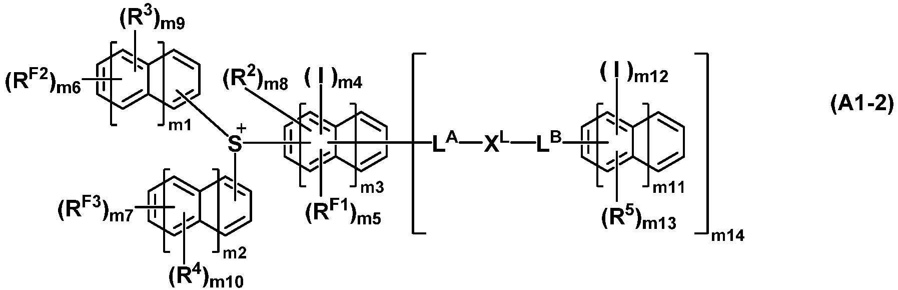

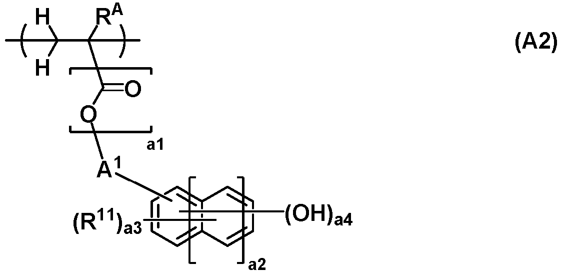

## Description

### TECHNICAL FIELD

This invention relates to a chemically amplified positive resist composition and a resist pattern forming process.

### BACKGROUND ART

In recent years, finer pattern formation is required along with high integration of integrated circuits, and a chemically amplified resist composition using an acid as a catalyst is exclusively used for processing a pattern with a feature size of 0.2 µm or less. As an exposure source at this time, high-energy radiation such as an ultraviolet ray, a far ultraviolet ray, or an electron beam (EB) is used, and in particular, EB lithography used as an ultrafine processing technique is also indispensable as a method for processing a photomask blank into a photomask for use in the fabrication of semiconductors. As a resist composition to be used for such photolithography, there are a positive one in which an exposed portion is dissolved to form a pattern and a negative one in which an exposed portion is left to form a pattern, and a resist composition that is easy to use is selected according to a form of a required resist pattern.

In general, writing with EB is performed by a method in which a mask is not used, and in the case of a positive resist, a portion other than a region where a resist film is desired to be left is sequentially irradiated with EB having a fine area. In the case of a negative resist, a region where a resist film is desired to be left is sequentially irradiated. This is an operation of sweeping over the entire finely divided region on the work surface, and therefore, it takes more time than batch exposure using a photomask, and the resist film is required to have high sensitivity in order to prevent throughput reduction. Because of a long image writing time, it is likely that a difference arises between an initially imaged portion and a lately imaged portion, and the stability with time of the exposed portion in vacuum is one of the important performance factors. Further, in processing of a photomask blank, which is a particularly important application, some photomask blanks have a surface material that easily affects the pattern profile of a chemically amplified resist film, such as a chromium compound film including chromium oxide formed on a photomask substrate, and in order to maintain high resolution and the profile after etching, it is also an important performance to maintain the profile of a resist film pattern rectangular independent of the type of substrate.

Various improvements have been made on the control of the sensitivity and pattern profile of the resist film described above depending on the selection and combination of materials to be used for the resist composition, process conditions, and the like. One outstanding problem is the diffusion of an acid, which has a significant impact on the resolution of a chemically amplified resist film. In photomask processing, it is required that the profile of the resist pattern resulting from exposure does not change depending on the time until post exposure bake (PEB), but a major cause for the time-dependent change is diffusion of an acid generated by exposure. Since the problem of acid diffusion has a large impact on sensitivity and resolution not only in the photomask processing, but also in general resist compositions, many studies have been made thereon.

Patent Documents 1 and 2 describe examples in which acid diffusion is prevented and roughness is reduced by increasing the volume of an acid generated from an acid generator. However, with such an acid generator, prevention of acid diffusion is still insufficient, and thus development of an acid generator with more controlled diffusion has been desired.

Patent Documents 3 to 6 describe an example in which acid diffusion is controlled by bonding sulfonic acid generated by exposure to a resin used for a resist composition. Such a method of preventing acid diffusion by introducing a repeat unit that generates an acid by exposure into a base polymer is effective for obtaining a pattern having a small line edge roughness (LER). However, depending on the structure and introduction rate of such a repeat unit, there has been a case where there is a problem in solubility of a base polymer containing a repeat unit that generates an acid by exposure in an organic solvent.

A polymer having a large amount of an aromatic skeleton having an acidic side chain, for example, polyhydroxystyrene, has been used as a material of a resist composition for KrF lithography, but has not been used as a material of a resist composition for ArF lithography since it exhibits large absorption with respect to light having a wavelength of around 200 nm. However, as a resist composition for EB lithography and a resist composition for extreme ultraviolet (EUV) lithography, which are prominent techniques for forming a pattern smaller than the processing limit by ArF lithography, the polymer is an important material because it offers high etching resistance.

Mainly used as a base polymer of a positive resist composition for EB lithography or a positive resist composition for EUV lithography is a material which is solubilized in an alkaline developer by deprotecting an acid labile group (acid-decomposable protective group) masking an acidic functional group of a phenol side chain of the base polymer using an acid generated from a photoacid generator by irradiation with high-energy radiation as a catalyst. As the acid labile group, a tertiary alkyl group, a tert-butoxycarbonyl group, an acetal group, or the like has been mainly used. Here, when a protective group such as an acetal group having a relatively small activation energy required for deprotection is used, there is an advantage that a resist film having high sensitivity can be obtained, but there has been a problem that if the prevention of diffusion of the generated acid is not sufficient, a deprotection reaction occurs even in an unexposed portion in the resist film giving rise to problems of degradation of LER and deterioration of dimensional uniformity (CDU) of a pattern line width.

With the progress of miniaturization of a resist pattern in recent years, collapse of the resist pattern during development and poor resistance in an etching process are problems. Although the acid diffusion of the generated acid is prevented to some extent by the introduction of a repeat unit that generates an acid by exposure, there is still room for improvement in various lithographic performance, resist pattern collapse, and poor etching resistance. In order to meet the demand for miniaturization in the future, it is extremely important to develop a polymeric acid generator that achieves lithographic performance, resist pattern collapse, and etching resistance.

### Citation List

Patent Document 1: JP-A 2009-053518
Patent Document 2: JP-A 2010-100604
Patent Document 3: JP 4425776
Patent Document 4: JP 5201363
Patent Document 5: JP 5231357
Patent Document 6: WO 2008/081832 A

### SUMMARY OF THE INVENTION

In recent years, there has been a demand for a resist composition capable of forming not only line-and-space (LS), isolated line (IL) and isolated space (IS) patterns of satisfactory profile, but also hole patterns of satisfactory profile, and also having excellent etching resistance after pattern formation.

The invention has been made in view of the above circumstances, and an object of the invention is to provide a chemically amplified positive resist composition that exhibits good solvent solubility, and excellent lithographic performance such as resolution, LER, and pattern profile particularly in photolithography using high-energy radiation such as KrF excimer laser light, ArF excimer laser light, EB, or EUV, as well as resistance to pattern collapse and excellent etching resistance even in small-size pattern formation, and a pattern forming process using the chemically amplified positive resist composition.

As a result of intensive studies to achieve the above object, the inventors have found that, use of a polymer containing a repeat unit derived from an onium salt containing an aromatic sulfonate anion having a polymerizable group and a triarylsulfonium cation having an iodine atom on an aromatic ring and a repeat unit having a phenolic hydroxy group as a material of a chemically amplified positive resist composition as a polymer-bound acid generator exhibits good solvent solubility and excellent lithographic performance such as resolution, LER, and pattern profile particularly in EB lithography and EUV lithography, as well as resistance to pattern collapse and excellent etching resistance even in small-size pattern formation, and have completed the invention.

That is, the invention provides a chemically amplified positive resist composition and a resist pattern forming process described below.
1. A chemically amplified positive resist composition comprising a base polymer (A) containing a polymer adapted to increase its solubility in an alkaline aqueous solution under the action of acid, the polymer comprising a repeat unit containing an aromatic sulfonate anion having the formula (A1-1) and a sulfonium cation having the formula (A1-2) and a repeat unit having the formula (A2), 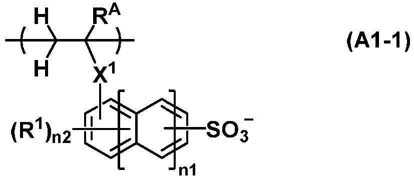 wherein n1 is 0 or 1, n2 is 0, 1, 2, 3, or 4 when n1 is 0, and is 0, 1, 2, 3, 4, 5, or 6 when n1 is 1.
   R^{A} is a hydrogen atom, a fluorine atom, a methyl group, or a trifluoromethyl group,
   R¹ is a halogen atom, a nitro group, a cyano group, a hydroxy group, a C₁-C₂₀ hydrocarbyl group which may contain a heteroatom, a C₁-C₂₀ hydrocarbyloxy group which may contain a heteroatom, or a C₁-C₂₀ hydrocarbylthio group which may contain a heteroatom, when n2 is 2 or more, a plurality of R¹'s may be identical or different, and a plurality of R¹'s may bond together to form a ring with the carbon atom to which they are attached, and
   X¹ is a single bond, an ether bond, an ester bond, or an amide bond, 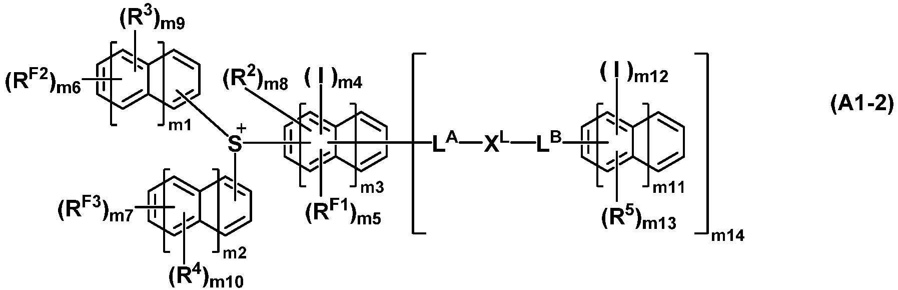 wherein m1 is 0 or 1, m2 is 0 or 1, m3 is 0 or 1, m4 is 0, 1, 2, 3, or 4, m5 is 0, 1, 2, 3, or 4, m6 is 0, 1, 2, 3, 4, 5, or 6, m7 is 0, 1, 2, 3, 4, 5, or 6, m8 is 0, 1, or 2, m9 is 0, 1, or 2, m10 is 0, 1, or 2, m11 is 0 or 1, m12 is 0, 1, 2, 3, or 4, m13 is 0, 1, or 2, m14 is 0, 1, or 2, meeting 0 ≤ m6+m9 ≤ 4 when m1 is 0, 0 ≤ m6+m9 ≤ 6 when m1 is 1, 0 ≤ m7+m10 ≤ 4 when m2 is 0, 0 ≤ m7+m10 ≤ 6 when m2 is 1, 1 ≤ m4+m5+m8+m14 ≤ 4 when m3 is 0, 1 ≤ m4+m5+m8+m14 ≤ 6 when m3 is 1, 0 ≤ m12+m13 ≤ 4 when m11 is 0, 0 ≤ m12+m13 ≤ 6 when m11 is 1, and m4+m12 ≥ 1,
   R^{F1} to R^{F3} are each independently a fluorine atom, a C₁-C₆ fluorinated saturated hydrocarbyl group, a C₁-C₆ fluorinated saturated hydrocarbyloxy group, or a C₁-C₆ fluorinated saturated hydrocarbylthio group, when m5 is 2 or more, a plurality of R^{F1}'s may be identical or different, when m6 is 2 or more, a plurality of R^{F2}'s may be identical or different, when m7 is 2 or more, a plurality of R^{F3}'s may be identical or different,
   R² to R⁵ are a halogen atom other than an iodine atom and a fluorine atom, a nitro group, a cyano group, a C₁-C₂₀ hydrocarbyl group which may contain a heteroatom, a C₁-C₂₀ hydrocarbyloxy group which may contain a heteroatom, or a C₁-C₂₀ hydrocarbylthio group which may contain a heteroatom, when m8 is 2, two R²'s may be identical or different and two R²'s may bond together to form a ring with the carbon atoms to which they are attached, when m9 is 2, two R³'s may be identical or different and two R³'s may bond together to form a ring with the carbon atoms to which they are attached, when m10 is 2, two R⁴'s may be identical or different and two R⁴'s may bond together to form a ring with the carbon atoms to which they are attached, when m13 is 2, two R⁵'s may be identical or different and two R⁵'s may bond together to form a ring with the carbon atoms to which they are attached,
   the aromatic rings directly bonded to S⁺ in the sulfonium cation may bond together to form a ring with S⁺,
   L^{A} and L^{B} are each independently a single bond, an ether bond, an ester bond, an amide bond, a sulfonate ester bond, a sulfonamide bond, a carbonate bond, or a carbamate bond, and
   X^{L} is a single bond or a C₁-C₄₀ hydrocarbylene group which may contain a heteroatom, 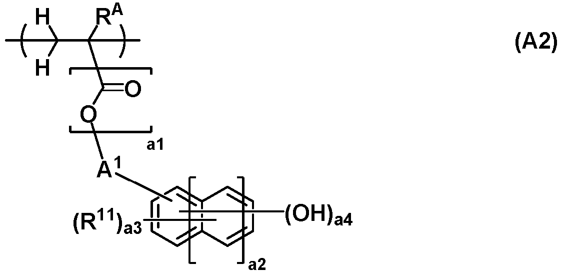 wherein a1 is 0 or 1, a2 is 0, 1, or 2, a3 is an integer meeting 0 ≤ a3 ≤ 5+2(a2)-a4, a4 is 1, 2, or 3,
   R^{A} is a hydrogen atom, a fluorine atom, a methyl group, or a trifluoromethyl group,
   R¹¹ is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom, and
   A¹ is a single bond or a C₁-C₁₀ saturated hydrocarbylene group, and -CH₂- in the saturated hydrocarbylene group may be substituted with -O-.
2. The chemically amplified positive resist composition of 1, wherein the sulfonium cation having the formula (A1-2) has the formula (A1-2-1): 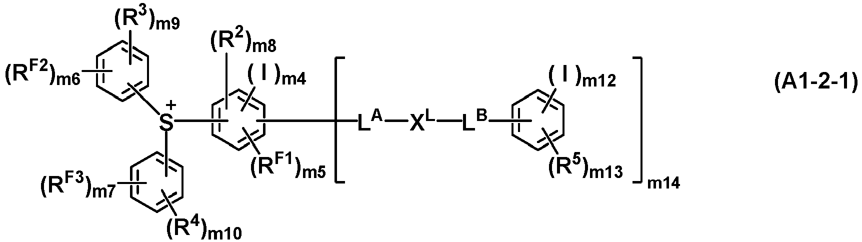 wherein m4 to m10, m12 to m14, R^{F1} to R^{F3}, R² to R⁵, L^{A}, L^{B}, and X^{L} are as defined above.
3. The chemically amplified positive resist composition of 2, wherein the sulfonium cation having the formula (A1-2-1) has the formula (A1-2-2): 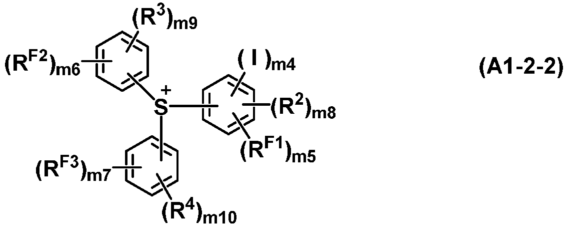 wherein m4 to m10, R^{F1} to R^{F3}, and R² to R⁵ are as defined above.
4. The chemically amplified positive resist composition of any one of 1 to 3, wherein the repeat unit having the formula (A2) has the formula (A2-1): 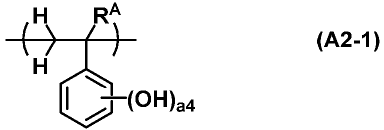 wherein R^{A} and a4 are as defined above.
5. The chemically amplified positive resist composition of any one of 1 to 4, wherein the polymer further contains at least one repeat unit selected from a repeat unit having the formula (A3-1) and a repeat unit having the formula (A3-2): 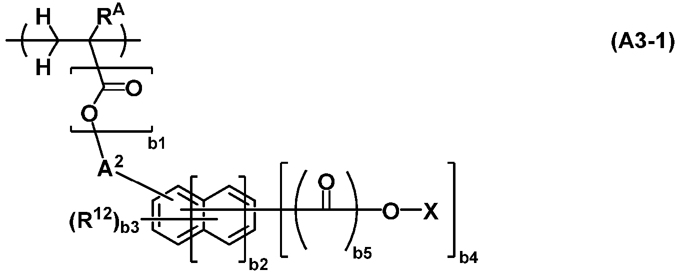 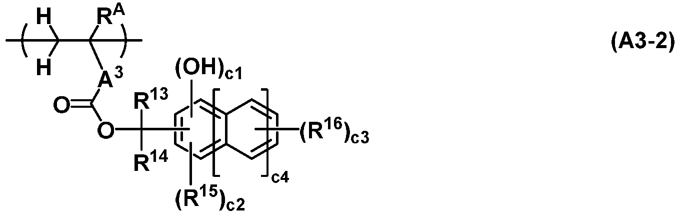 wherein b1 is 0 or 1, b2 is 0, 1, or 2, b3 is an integer meeting 0 ≤ b3 ≤ 5+2(b2)-b4, b4 is 1, 2, or 3, b5 is 0 or 1,
   R^{A} is a hydrogen atom, a fluorine atom, a methyl group, or a trifluoromethyl group,
   R¹² is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom,
   A² is a single bond or a C₁-C₁₀ saturated hydrocarbylene group, and some -CH₂-in the saturated hydrocarbylene group may be replaced by -O-,
   when b4 is 1, X is an acid labile group, when b4 is 2 or 3, X's are each independently a hydrogen atom or an acid labile group, but at least one X is an acid labile group,
   c1 is 0, 1, or 2, c2 is 0, 1, or 2, c3 is 0, 1, 2, 3, 4, or 5, c4 is 0, 1, or 2,
   R¹³ and R¹⁴ are each independently a C₁-C₁₀ hydrocarbyl group which may contain a heteroatom, and R¹³ and R¹⁴ may bond together to form a ring with the carbon atom to which they are attached,
   R¹⁵'s are each independently a fluorine atom, a C₁-C₅ fluorinated alkyl group, or a C₁-C₅ fluorinated alkoxy group,
   R¹⁶'s are each independently a C₁-C₁₀ hydrocarbyl group which may contain a heteroatom,
   A³ is a single bond, a phenylene group, a naphthylene group, or *-C(=O)-O-A³¹-, A³¹ is a C₁-C₂₀ aliphatic hydrocarbylene group, a phenylene group, or a naphthylene group, and the aliphatic hydrocarbylene group may contain at least one selected from a hydroxy group, an ether bond, an ester bond, and a lactone ring, and * designates a point of attachment to the carbon atom in the backbone.
6. The chemically amplified positive resist composition of any one of 1 to 5, wherein the polymer further contains at least one type selected from a repeat unit having the formula (B3), a repeat unit having the formula (B4), and a repeat unit having the formula (B5): 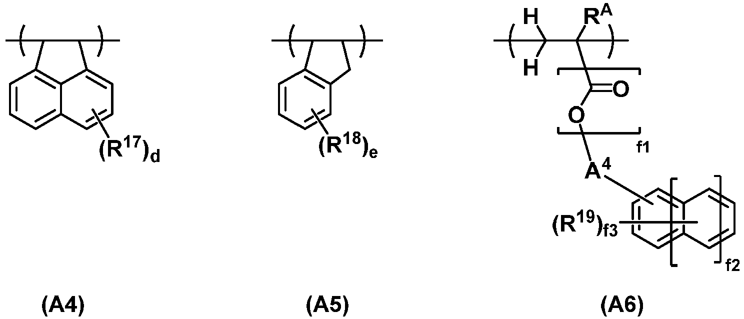 wherein d is 0, 1, 2, 3, 4, 5, or 6, e is 0, 1, 2, 3, or 4, f1 is 0 or 1, f2 is 0, 1, or 2, f3 is 0, 1, 2, 3, 4, or 5,
   R^{A} is a hydrogen atom, a fluorine atom, a methyl group, or a trifluoromethyl group,
   R¹⁷ and R¹⁸ are each independently a hydroxy group, a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom,
   R¹⁹ is a halogen atom, a nitro group, a cyano group, a C₁-C₂₀ saturated hydrocarbyl group, a C₁-C₂₀ saturated hydrocarbyloxy group, a C₂-C₂₀ saturated hydrocarbylcarbonyloxy group, a C₂-C₂₀ saturated hydrocarbyloxyhydrocarbyl group, or a C₂-C₂₀ saturated hydrocarbylthiohydrocarbyl group, and may be a hydroxy group when f2 is 1 or 2, and
   A⁴ is a single bond or a C₁-C₁₀ saturated hydrocarbylene group, and -CH₂- in the saturated hydrocarbylene group may be substituted with -O-.
7. The chemically amplified positive resist composition of any one of 1 to 6, wherein the content of a repeat unit having an aromatic ring skeleton is 60 mol% or more of the overall repeat units of the polymer contained in the base polymer (A).
8. The chemically amplified positive resist composition of any one of 1 to 7, further containing a quencher (B).
9. The chemically amplified positive resist composition of any one of 1 to 8, further containing an organic solvent (C).
10. The chemically amplified positive resist composition of any one of 1 to 9, further containing a fluorine atom-containing polymer (D) containing at least one type selected from a repeat unit having the formula (D1), a repeat unit having the formula (D2), a repeat unit having the formula (D3), and a repeat unit having the formula (D4): 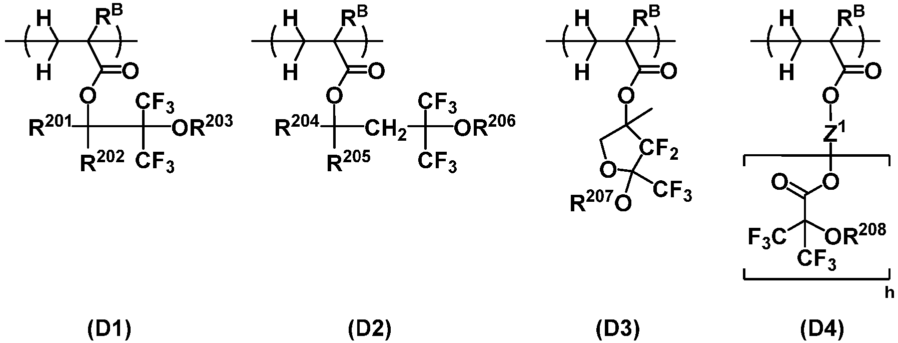 wherein h is 1, 2, or 3,
   R^{B}'s are each independently a hydrogen atom, a fluorine atom, a methyl group, or a trifluoromethyl group,
   R²⁰¹, R²⁰², R²⁰⁴, and R²⁰⁵ are each independently a hydrogen atom or a C₁-C₁₀ saturated hydrocarbyl group,
   R²⁰³, R²⁰⁶, R²⁰⁷, and R²⁰⁸ are each independently a hydrogen atom, a C₁-C₁₅ hydrocarbyl group, a C₁-C₁₅ fluorinated hydrocarbyl group, or an acid labile group, and when R²⁰³, R²⁰⁶, R²⁰⁷, and R²⁰⁸ are a hydrocarbyl group or a fluorinated hydrocarbyl group, an ether bond or a carbonyl group may intervene in a carbon-carbon bond, and
   Z¹ is a C₁-C₂₀ (h+1)-valent hydrocarbon group or a C₁-C₂₀ (h+1)-valent fluorinated hydrocarbon group.
11. The chemically amplified positive resist composition of 10, wherein the fluorine atom-containing polymer further contains at least one type selected from a repeat unit having the formula (D5) and a repeat unit having the formula (D6): 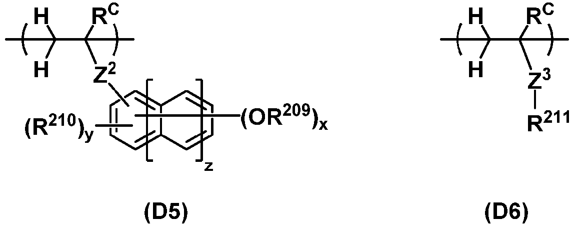 wherein x is 1, 2, or 3, y is an integer meeting 0 ≤ y ≤ 5+2z-x, z is 0 or 1,
   R^{C}'s are each independently a hydrogen atom or a methyl group,
   R²⁰⁹ is a hydrogen atom or a C₁-C₅ straight or branched hydrocarbyl group in which a heteroatom-containing group may intervene in a carbon-carbon bond,
   R²¹⁰ is a C₁-C₅ straight or branched hydrocarbyl group in which a heteroatom-containing group may intervene in a carbon-carbon bond,
   R²¹¹ is a C₁-C₂₀ saturated hydrocarbyl group in which at least one hydrogen atom is substituted with a fluorine atom, and some -CH₂- in the saturated hydrocarbyl group may be replaced by an ester bond or an ether bond,
   Z² is a single bond, *-C(=O)-O- or *-C(=O)-NH-,
   Z³ is a single bond, -O-, *-C(=O)-O-Z³¹-Z³²-, or *-C(=O)-NH-Z³¹-Z³²-, Z³¹ is a single bond or a C₁-C₁₀ saturated hydrocarbylene group, and Z³² is a single bond, an ester bond, an ether bond, or a sulfonamide bond, and
   * is a point of attachment to the carbon atom in the backbone.
12. The chemically amplified positive resist composition of any one of 1 to 11, further containing an acid generator (E).
13. A resist pattern forming process comprising the steps of forming a resist film on a substrate using the chemically amplified positive resist composition of any one of 1 to 12, irradiating the resist film patternwise with high-energy radiation, and developing the resist film irradiated patternwise using an alkaline developer.
14. The resist pattern forming process of 13, wherein the high-energy radiation is KrF excimer laser light, ArF excimer laser light, an extreme ultraviolet ray, or an electron beam.
15. The resist pattern forming process of 13 or 14, wherein the substrate has an outermost surface made of a material containing at least one type selected from chromium, silicon, tantalum, molybdenum, cobalt, nickel, tungsten, and tin.
16. The resist pattern forming process of any one of 13 to 15, wherein the substrate is a transmissive or reflective mask blank.
17. A transmissive or reflective mask blank, which is coated with the chemically amplified positive resist composition of any one of 1 to 12.

### ADVANTAGEOUS EFFECTS OF THE INVENTION

The chemically amplified positive resist composition of the invention has extremely high resolution and can provide a pattern with a small LER in microfabrication techniques, particularly in EB lithography and EUV lithography. In addition, since it is excellent in etching resistance after resist pattern formation, it is suitable as a chemically amplified positive resist material.

### BRIEF DESCRIPTION OF THE DRAWINGS

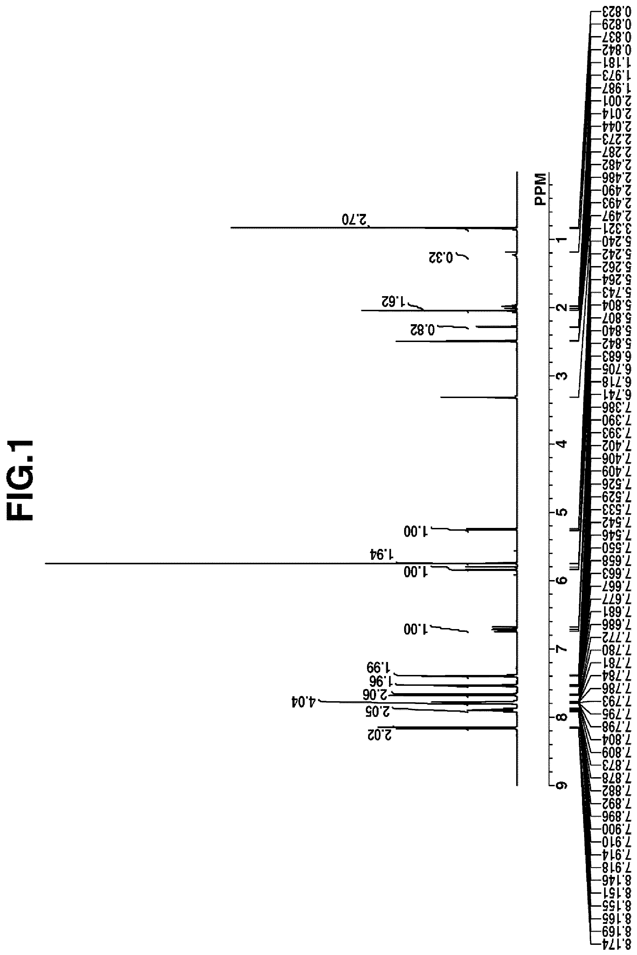

FIG. 1 shows a nuclear magnetic resonance spectrum (¹H-NMR/DMSO-d₆) of an onium salt type monomer A1-1 synthesized in Synthesis Example 1-1.

### DESCRIPTION OF THE PREFERRED EMBODIMENT

Hereinafter, the invention is described in detail. In the following description, depending on a structure having a chemical formula, an asymmetric carbon may exist, and an enantiomer or a diastereomer may exist, and in that case, those isomers are represented by one formula as a representative. One type of these isomers may be used alone, or two or more types of isomers may be used as a mixture.

### Chemically amplified positive resist composition

### (A) Base polymer

The resist composition of the invention contains, as a component (A), a base polymer containing a polymer which is decomposed by the action of an acid to increase its solubility in an alkaline developer.

The polymer contains a repeat unit derived from an onium salt containing an aromatic sulfonate anion having a polymerizable group and a triarylsulfonium cation having an iodine atom on an aromatic ring (hereinafter also referred to as repeat unit A1).

The anion in the repeat unit A1 has the formula (A1-1).

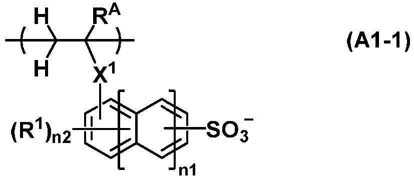

In the formula (A1-1), n1 is 0 or 1. The relevant structure is a benzene ring when n1 is 0 and a naphthalene ring when n1 is 1, and from the aspect of solvent solubility, a benzene ring when n1 is 0 is preferred. n2 is 0, 1, 2, 3, or 4 when n1 is 0, and is 0, 1, 2, 3, 4, 5, or 6 when n1 is 1. From the aspect of raw material procurement, n2 is preferably 0, 1, 2, 3, or 4, and more preferably 0, 1, or 2.

In the formula (A1-1), R^{A} is a hydrogen atom, a fluorine atom, a methyl group, or a trifluoromethyl group. Among them, a hydrogen atom and a methyl group are preferred, and a hydrogen atom is more preferred.

In the formula (A1-1), R¹ is a halogen atom, a nitro group, a cyano group, a hydroxy group, a C₁-C₂₀ hydrocarbyl group which may contain a heteroatom, a C₁-C₂₀ hydrocarbyloxy group which may contain a heteroatom, or a C₁-C₂₀ hydrocarbylthio group which may contain a heteroatom. The halogen atom is preferably a fluorine atom, a chlorine atom, a bromine atom, or an iodine atom, and more preferably a fluorine atom or an iodine atom. The hydrocarbyl group and the hydrocarbyl moiety in the hydrocarbyloxy group and the hydrocarbylthio group may be saturated or unsaturated and straight, branched, or cyclic. Specific examples thereof include C₁-C₂₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-octyl group, a n-nonyl group, a n-decyl group, an undecyl group, a dodecyl group, a tridecyl group, a tetradecyl group, a pentadecyl group, a heptadecyl group, an octadecyl group, a nonadecyl group, and an icosyl group; C₃-C₂₀ cyclic saturated hydrocarbyl groups such as a cyclopropyl group, a cyclopentyl group, a cyclohexyl group, a cyclopropylmethyl group, a 4-methylcyclohexyl group, a cyclohexylmethyl group, a norbornyl group, and an adamantyl group; C₂-C₂₀ alkenyl groups such as a vinyl group, an allyl group, a propenyl group, a butenyl group, and a hexenyl group; C₃-C₂₀ cyclic unsaturated hydrocarbyl groups such as a cyclohexenyl group; C₆-C₂₀ aryl groups such as a phenyl group and a naphthyl group; C₇-C₂₀ aralkyl groups such as a benzyl group, a 1-phenylethyl group, and a 2-phenylethyl group; and a group obtained by combining these groups. Among them, an aryl group is preferred. Some or all hydrogen atoms in the hydrocarbyl group may be substituted with a group containing a heteroatom such as an oxygen atom, a sulfur atom, a nitrogen atom, or a halogen atom, and some -CH₂- in the hydrocarbyl group may be replaced by a group containing a heteroatom such as an oxygen atom, a sulfur atom, or a nitrogen atom, so that the hydrocarbyl group may contain a hydroxy group, a cyano group, a fluorine atom, a chlorine atom, a bromine atom, an iodine atom, a carbonyl group, an ether bond, an ester bond, a sulfonate ester bond, a carbonate bond, a lactone ring, a sultone ring, a carboxylic anhydride (-C(=O)-O-C(=O)-), a haloalkyl group, or the like. When n2 is 2 or more, a plurality of R¹'s may be identical or different.

Further, when n2 is 2 or more, a plurality of R¹'s may bond together to form a ring with the carbon atom to which they are attached. Specific examples of the ring formed at this time include a cyclopropane ring, a cyclobutane ring, a cyclopentane ring, a cyclohexane ring, a norbornane ring, and an adamantane ring. Some or all hydrogen atoms in the ring may be substituted with a group containing a heteroatom such as an oxygen atom, a sulfur atom, a nitrogen atom, or a halogen atom, and some -CH₂- in the ring may be replaced by a group containing a heteroatom such as an oxygen atom, a sulfur atom, or a nitrogen atom, so that the ring may contain a hydroxy group, a fluorine atom, a chlorine atom, a bromine atom, an iodine atom, a cyano group, a carbonyl group, an ether bond, an ester bond, a sulfonate ester bond, a carbonate bond, a lactone ring, a sultone ring, a carboxylic anhydride (-C(=O)-O-C(=O)-), a haloalkyl group, or the like.

In the formula (A1-1), X¹ is a single bond, an ether bond, an ester bond, or an amide bond. Among them, a single bond or an ester bond is preferred, and a single bond is more preferred.

Specific examples of the aromatic sulfonate anion having the formula (A1-1) are shown below, but not limited thereto. In the following formulae, R^{A} is as defined above.

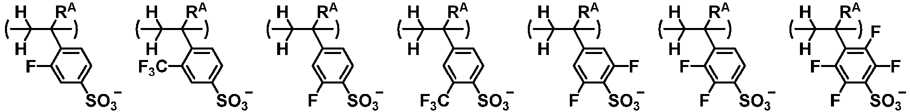

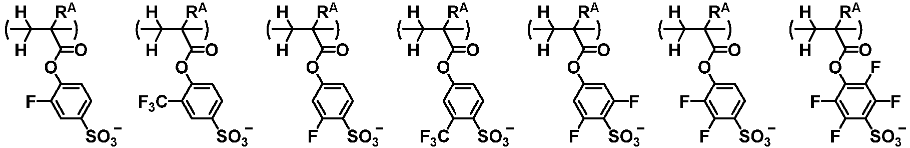

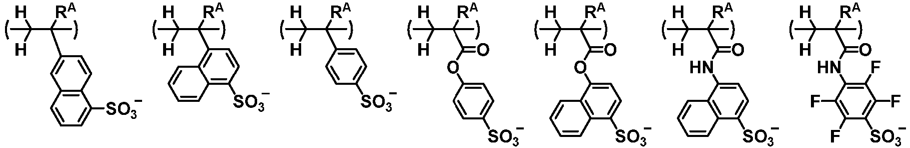

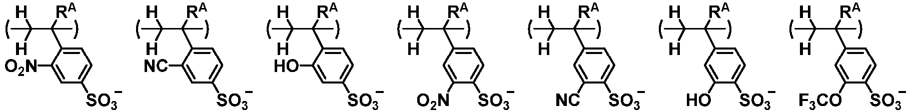

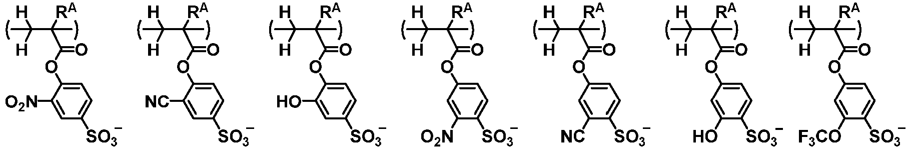

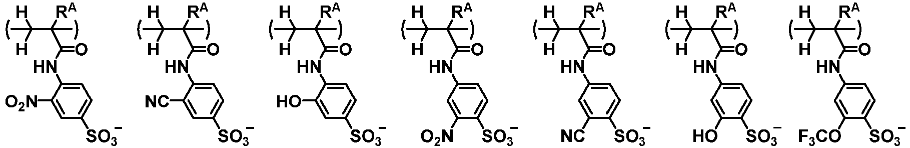

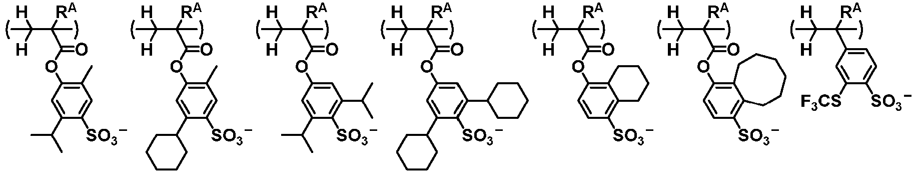

The sulfonium cation in the repeat unit A1 has the formula (A1-2).

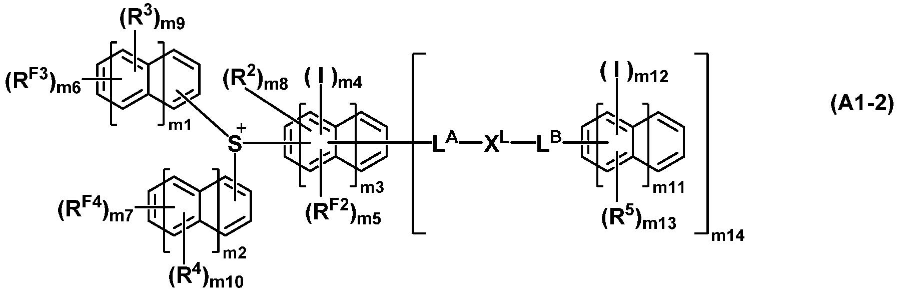

In the formula (A1-2), m1 is 0 or 1. The relevant structure is a benzene ring when m1 is 0 and a naphthalene ring when m1 is 1, and from the aspect of solvent solubility, a benzene ring when m1 is 0 is preferred. m2 is 0 or 1. The relevant structure is a benzene ring when m2 is 0 and a naphthalene ring when m2 is 1, and from the aspect of solvent solubility, a benzene ring when m2 is 0 is preferred. m3 is 0 or 1. The relevant structure is a benzene ring when m3 is 0 and a naphthalene ring when m3 is 1, and from the aspect of solvent solubility, a benzene ring when m3 is 0 is preferred.

In the formula (A1-2), m4 is 0, 1, 2, 3, or 4. The larger the number of iodine atoms in the cationic structure is, the lower the solvent solubility is, and there is a concern that precipitation occurs in the resist composition, and therefore m4 is preferably 0, 1, 2, or 3, and more preferably 0, 1, or 2.

In the formula (A1-2), m5 is 0, 1, 2, 3, or 4. From the aspect of raw material procurement, m5 is preferably 0, 1, 2, or 3, and more preferably 0, 1, or 2. m6 is 0, 1, 2, 3, 4, 5, or 6. From the aspect of raw material procurement, m6 is preferably 0, 1, 2, or 3, and more preferably 0, 1, or 2. m7 is 0, 1, 2, 3, 4, 5, or 6. From the aspect of raw material procurement, m7 is preferably 0, 1, 2, or 3, and more preferably 0, 1, or 2.

In the formula (A1-2), m8 is 0, 1, or 2. From the aspect of raw material procurement, m8 is preferably 0 or 1. m9 is 0, 1, or 2. From the aspect of raw material procurement, m9 is preferably 0 or 1. m10 is 0, 1, or 2. From the aspect of raw material procurement, m10 is preferably 0 or 1.

In the formula (A1-2), m11 is 0 or 1. The relevant structure is a benzene ring when m11 is 0 and a naphthalene ring when m11 is 1, and from the aspect of solvent solubility, a benzene ring when m11 is 0 is preferred.

In the formula (A1-2), m12 is 0, 1, 2, 3, or 4. The larger the number of iodine atoms in the cationic structure is, the lower the solvent solubility is, and there is a concern that precipitation occurs in the resist composition, and therefore m12 is preferably 0, 1, 2, or 3, and more preferably 0, 1, or 2.

In the formula (A1-2), m13 is 0, 1, or 2. From the aspect of raw material procurement, m13 is preferably 0 or 1. m14 is 0, 1, or 2. From the aspect of synthesis, m14 is preferably 0 or 1.

These subscripts meet 0 ≤ m6+m9 ≤ 4 when m1 is 0, 0 ≤ m6+m9 ≤ 6 when m1 is 1, 0 ≤ m7+m10 ≤ 4 when m2 is 0, 0 ≤ m7+m10 ≤ 6 when m2 is 1, 1 ≤ m4+m5+m8+m14 ≤ 4 when m3 is 0, 1 ≤ m4+m5+m8+m14 ≤ 6 when m3 is 1, 0 ≤ m12+m13 ≤ 4 when m11 is 0, 0 ≤ m12+m13 ≤ 6 when m11 is 1, and m4+m12 ≥ 1.

In the formula (A1-2), R^{F1} to R^{F3} are each independently a fluorine atom, a C₁-C₆ fluorinated saturated hydrocarbyl group, a C₁-C₆ fluorinated saturated hydrocarbyloxy group, or a C₁-C₆ fluorinated saturated hydrocarbylthio group. Among them, a trifluoromethyl group, a trifluoromethoxy group, and a trifluorothiomethoxy group are preferred. When m5 is 2 or more, a plurality of R^{F1}'s may be identical or different, when m6 is 2 or more, a plurality of R^{F2}'s may be identical or different, when m7 is 2 or more, a plurality of R^{F3}'s may be identical or different.

In the formula (A1-2), R² to R⁵ are each independently a halogen atom other than an iodine atom and a fluorine atom, a nitro group, a cyano group, a C₁-C₂₀ hydrocarbyl group which may contain a heteroatom, a C₁-C₂₀ hydrocarbyloxy group which may contain a heteroatom, or a C₁-C₂₀ hydrocarbylthio group which may contain a heteroatom. The hydrocarbyl group and the hydrocarbyl moiety in the hydrocarbyloxy group and the hydrocarbylthio group may be saturated or unsaturated and straight, branched, or cyclic. Specific examples thereof are as exemplified above for the hydrocarbyl group of R¹ in the description of the formula (A1-1). Some or all hydrogen atoms in the hydrocarbyl group and the hydrocarbyl moiety in the hydrocarbyloxy group and the hydrocarbylthio group may be substituted with a group containing a heteroatom such as an oxygen atom, a sulfur atom, a nitrogen atom, or a halogen atom, and some -CH₂- in the hydrocarbyl group may be replaced by a group containing a heteroatom such as an oxygen atom, a sulfur atom, or a nitrogen atom, so that the hydrocarbyl group may contain a hydroxy group, a cyano group, a fluorine atom, a chlorine atom, a bromine atom, an iodine atom, a carbonyl group, an ether bond, an ester bond, a sulfonate ester bond, a carbonate bond, a lactone ring, a sultone ring, a carboxylic anhydride (-C(=O)-O-C(=O)-), a haloalkyl group, or the like.

When m8 is 2, two R²'s may be identical or different and two R²'s may bond together to form a ring with the carbon atoms to which they are attached. When m9 is 2, two R³'s may be identical or different and two R³'s may bond together to form a ring with the carbon atoms to which they are attached. When m10 is 2, two R^{4'}s may be identical or different and two R⁴'s may bond together to form a ring with the carbon atoms to which they are attached. When m13 is 2, two R⁵'s may be identical or different and two R⁵'s may bond together to form a ring with the carbon atoms to which they are attached. Specific examples of the ring formed at this time include a cyclopropane ring, a cyclobutane ring, a cyclopentane ring, a cyclohexane ring, a norbornane ring, and an adamantane ring. Some or all hydrogen atoms in the ring may be substituted with a group containing a heteroatom such as an oxygen atom, a sulfur atom, a nitrogen atom, or a halogen atom, and some -CH₂- in the ring may be replaced by a group containing a heteroatom such as an oxygen atom, a sulfur atom, or a nitrogen atom, so that the ring may contain a hydroxy group, a fluorine atom, a chlorine atom, a bromine atom, an iodine atom, a cyano group, a carbonyl group, an ether bond, an ester bond, a sulfonate ester bond, a carbonate bond, a lactone ring, a sultone ring, a carboxylic anhydride (-C(=O)-O-C(=O)-), a haloalkyl group, or the like.

The aromatic rings directly bonded to S⁺ in the sulfonium cation having the formula (A1-2) may bond together to form a ring with S⁺. At this time, specific examples of the structure of the ring include those having the following formulae.

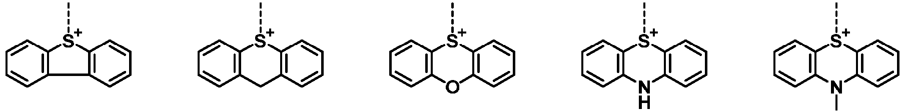

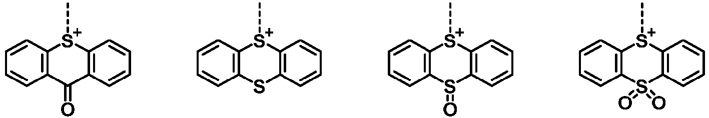

In the formulae, a broken line designates a point of attachment.

In the formula (A1-2), L^{A} and L^{B} are each independently a single bond, an ether bond, an ester bond, an amide bond, a sulfonate ester bond, a sulfonamide bond, a carbonate bond, or a carbamate bond. Among them, L^{A} is preferably a single bond, an ether bond, an ester bond, or a sulfonate ester bond, and more preferably an ester bond or a sulfonate ester bond. L^{B} is preferably a single bond, an ether bond, or an ester bond, and more preferably a single bond.

In the formula (A1-2), X^{L} is a single bond or a C₁-C₄₀ hydrocarbylene group which may contain a heteroatom. The hydrocarbylene group may be straight, branched, or cyclic, and specific examples thereof include an alkanediyl group and a divalent saturated cyclic hydrocarbon group. Examples of the heteroatom include an oxygen atom, a nitrogen atom, and a sulfur atom.

As the C₁-C₄₀ hydrocarbylene group which may contain a heteroatom of X^{L}, those shown below are preferred. In the following formulae, * designates bonds to L^{A} and L^{B}.

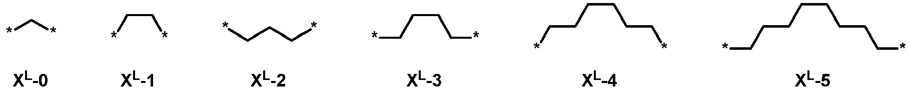

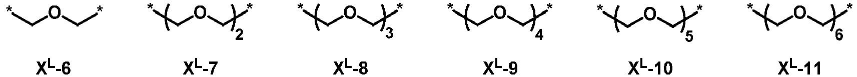

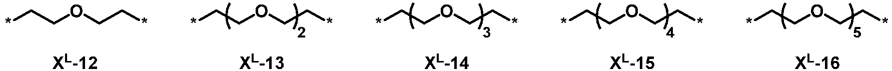

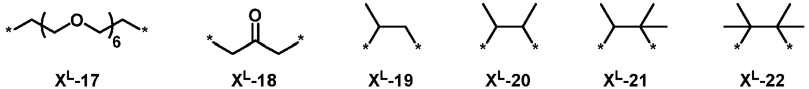

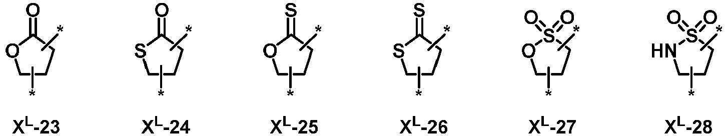

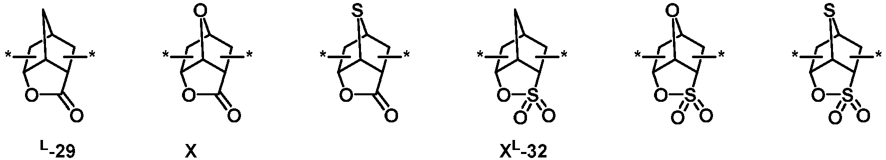

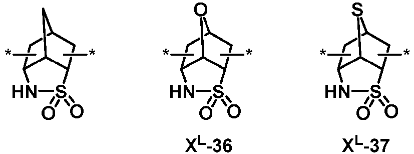

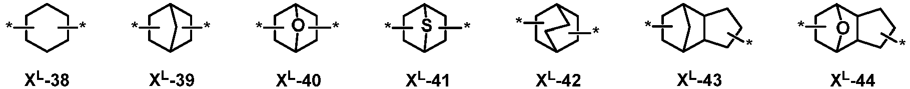

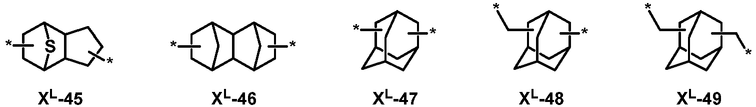

Among them, X^{L}-0 to X^{L}-3, X^{L}-29 to X^{L}-34, and X^{L}-47 to X^{L}-49 are preferred, and X^{L}-0 to X^{L}-2, X^{L}-29, and X^{L}-47 are more preferred.

As the sulfonium cation having the formula (A1-2), a sulfonium cation having the formula (A1-2-1) is preferred.

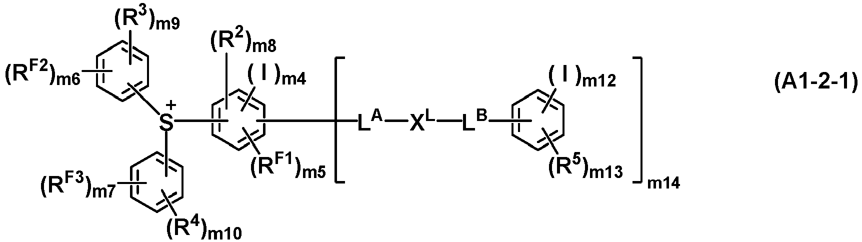

In the formula, m4 to m10, m12 to m14, R^{F1} to R^{F3}, R² to R⁵, L^{A}, L^{B}, and X^{L} are as defined above.

As the sulfonium cation having the formula (A1-2-1), a sulfonium cation having the formula (A1-2-2) is preferred.

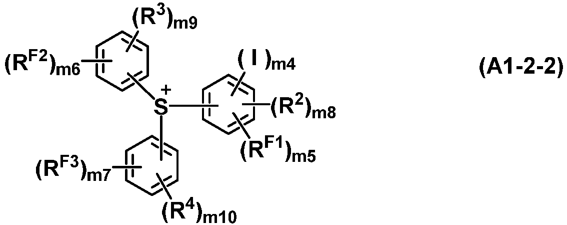

In the formula, m4 to m10, R^{F1} to R^{F3}, and R² to R⁵ are as defined above.

Specific examples of the sulfonium cation having the formula (A1-2) are shown below, but not limited thereto. In the following formulae, Me is a methyl group.

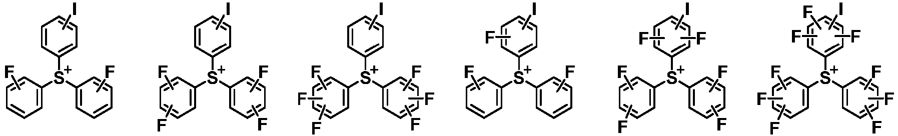

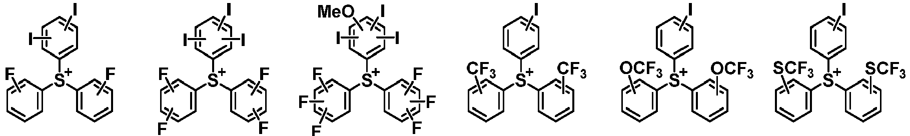

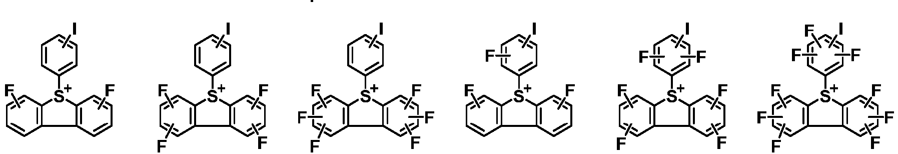

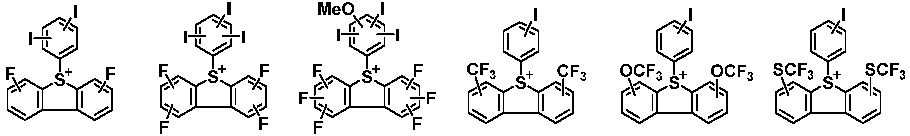

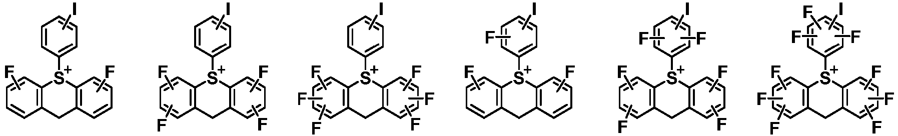

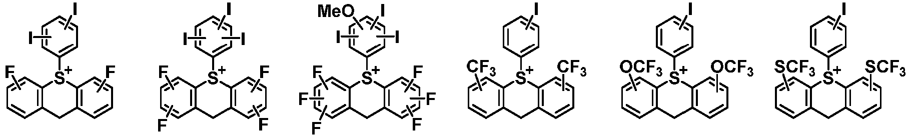

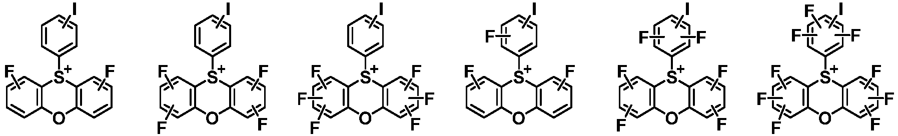

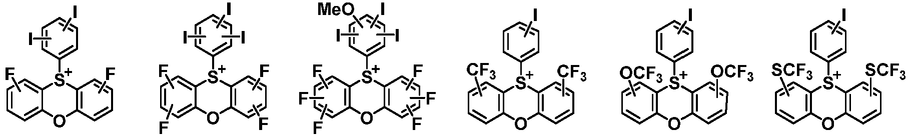

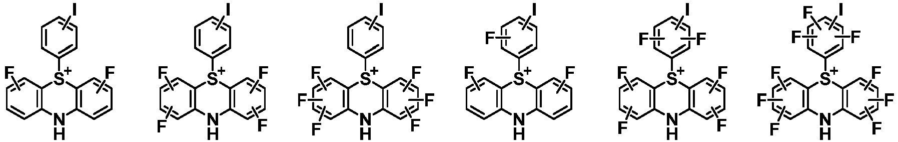

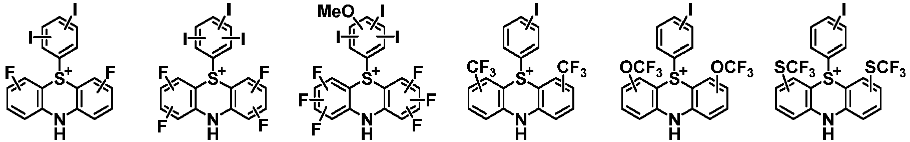

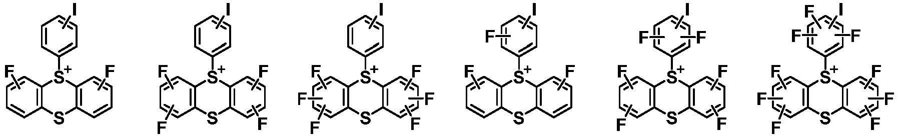

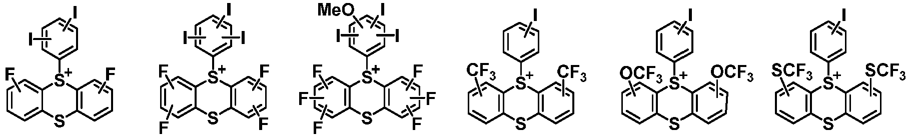

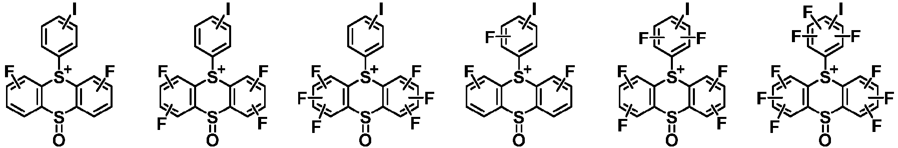

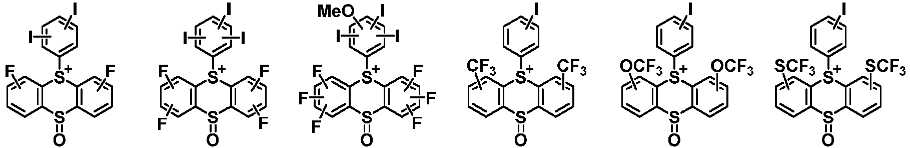

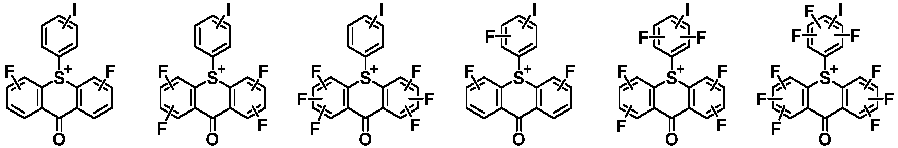

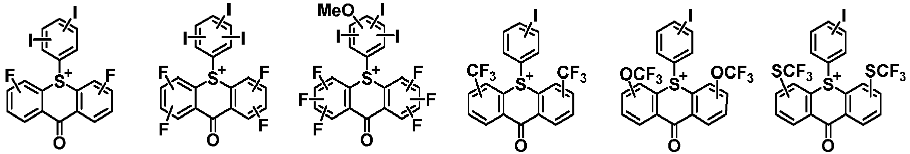

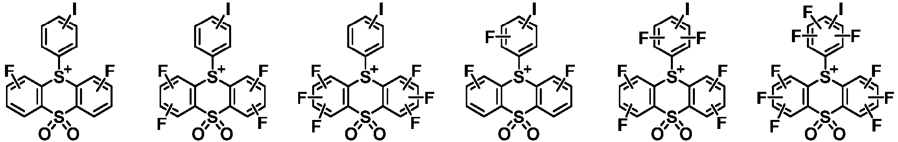

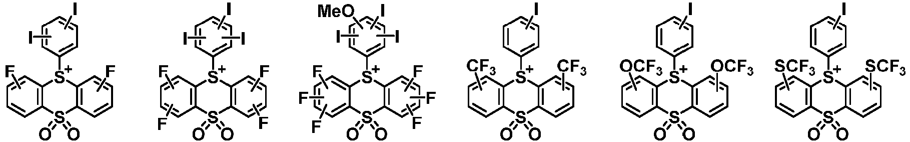

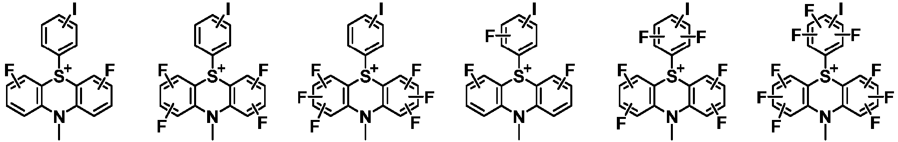

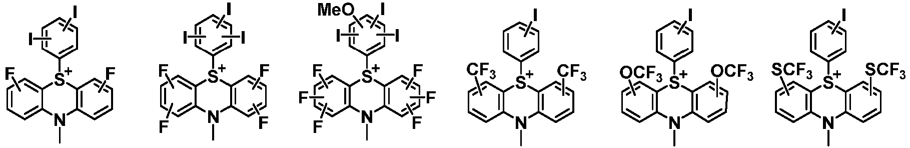

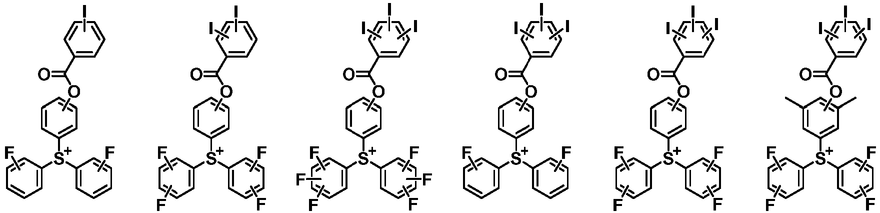

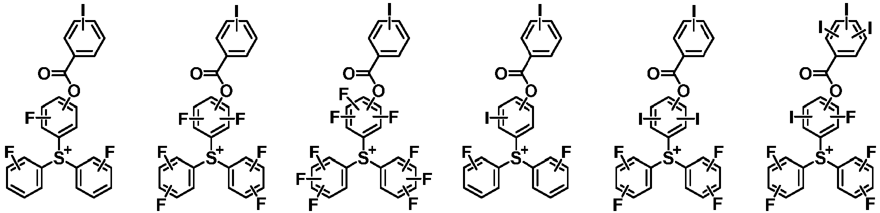

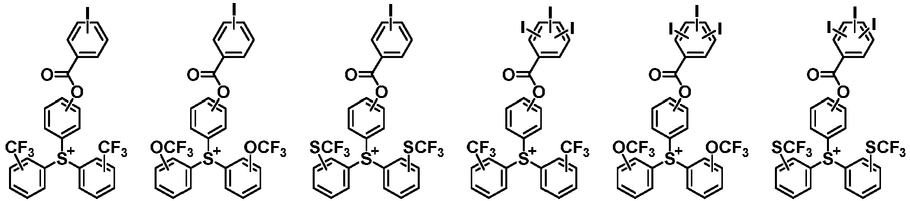

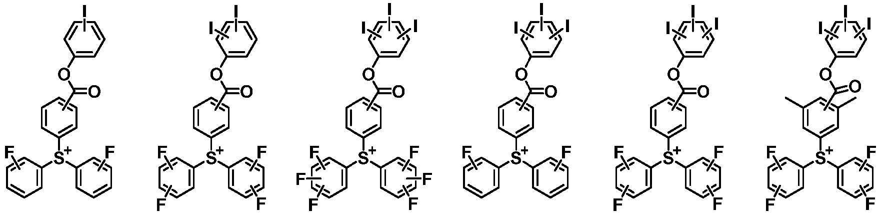

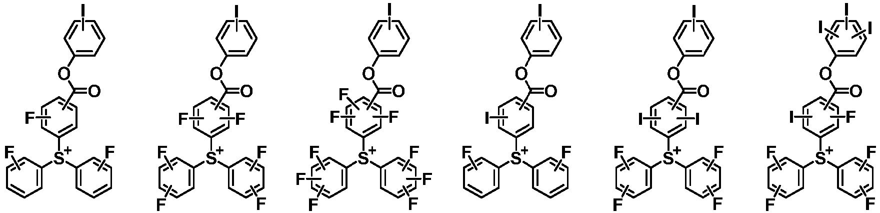

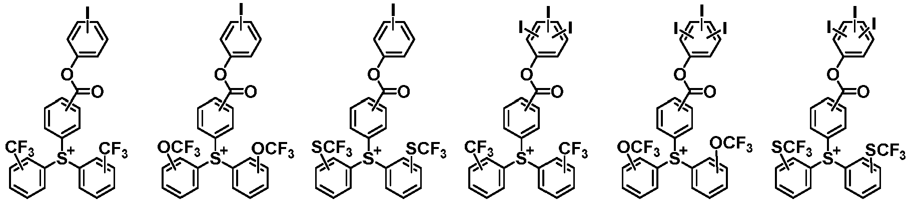

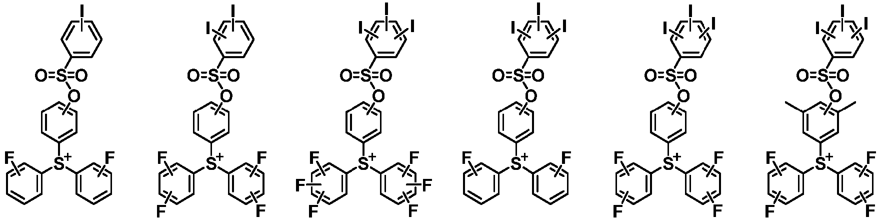

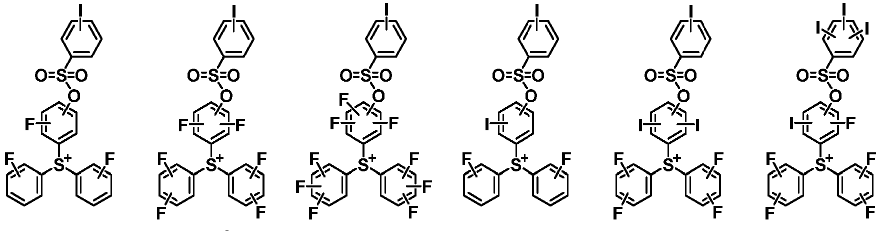

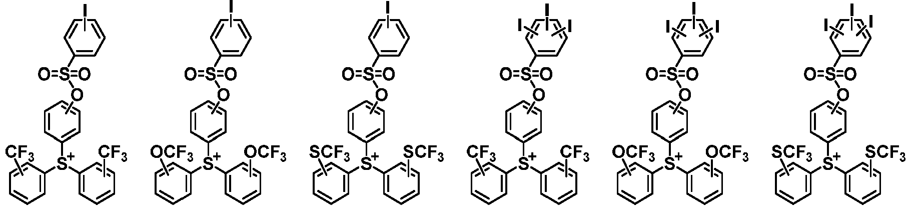

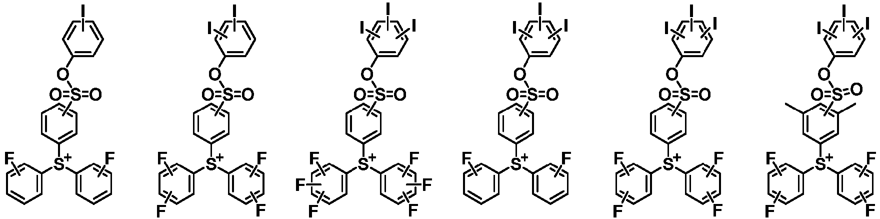

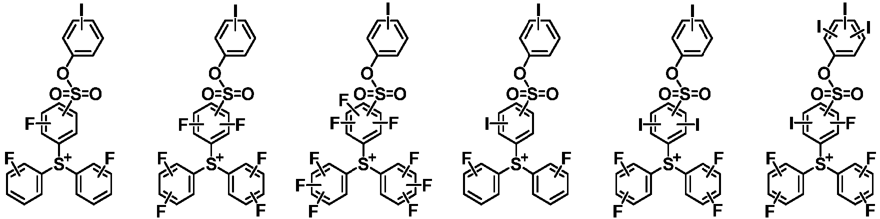

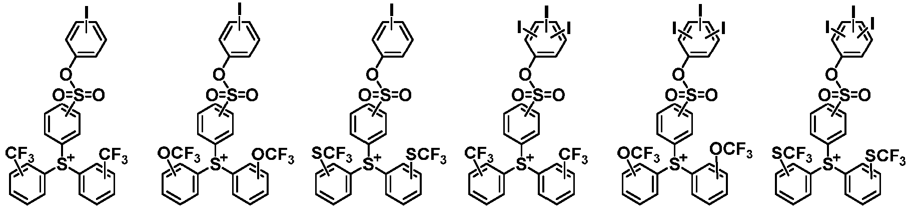

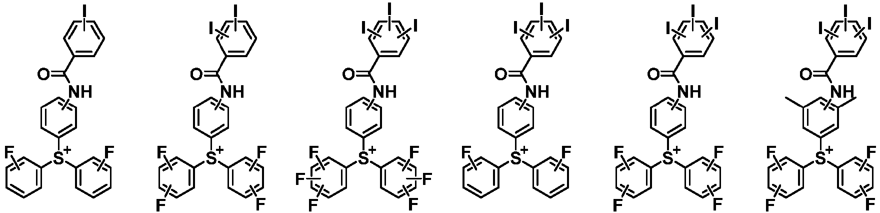

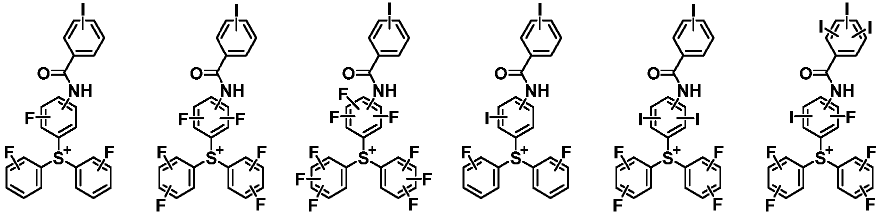

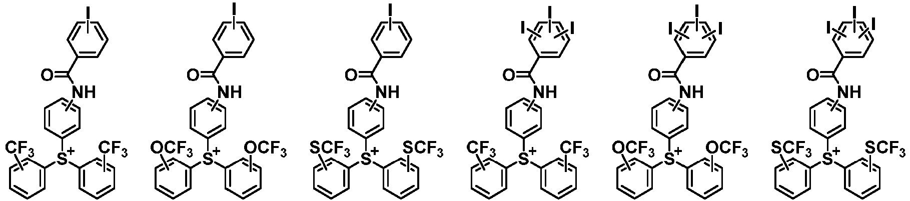

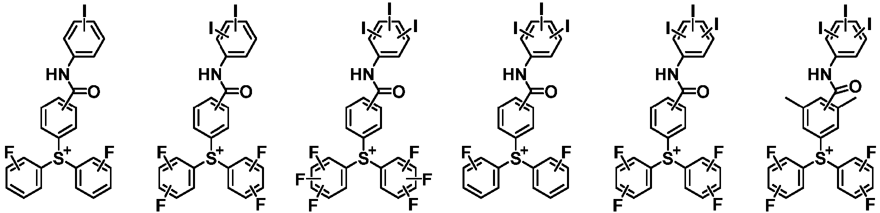

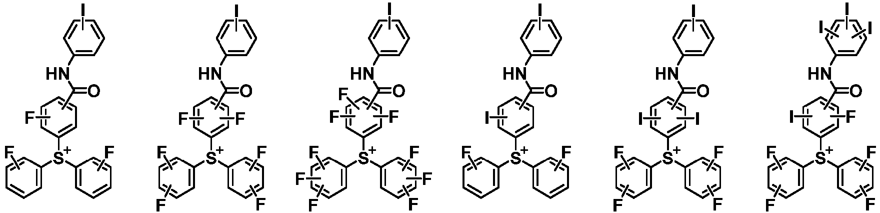

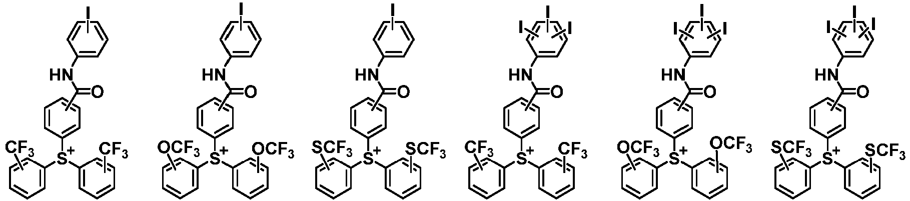

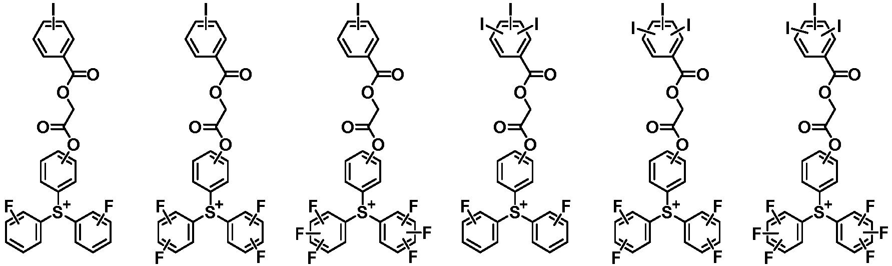

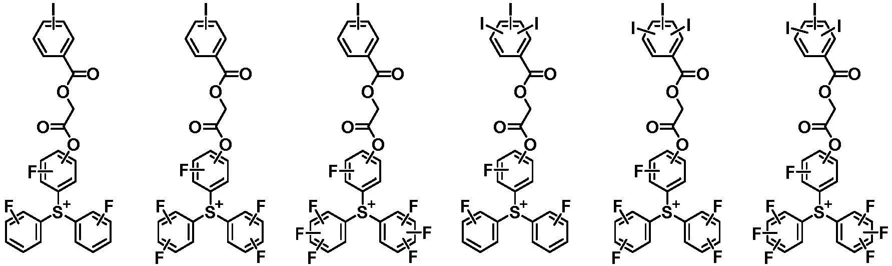

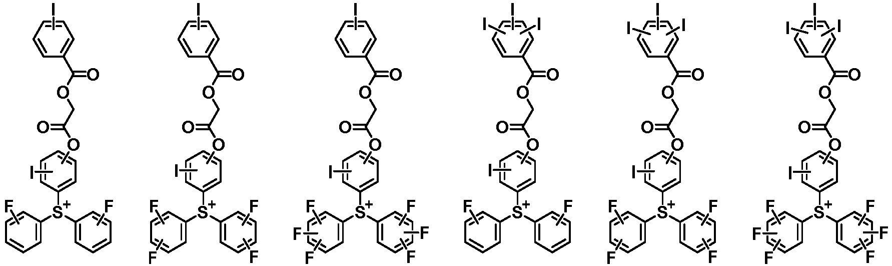

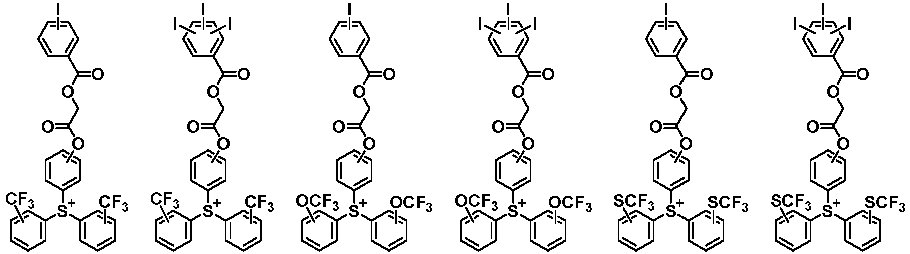

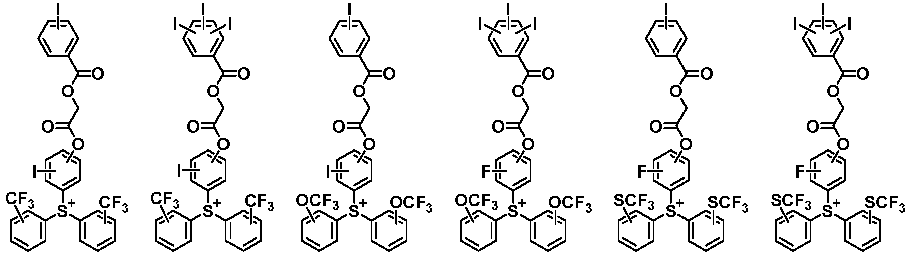

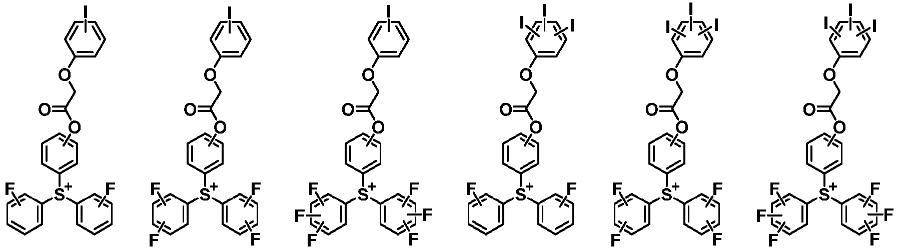

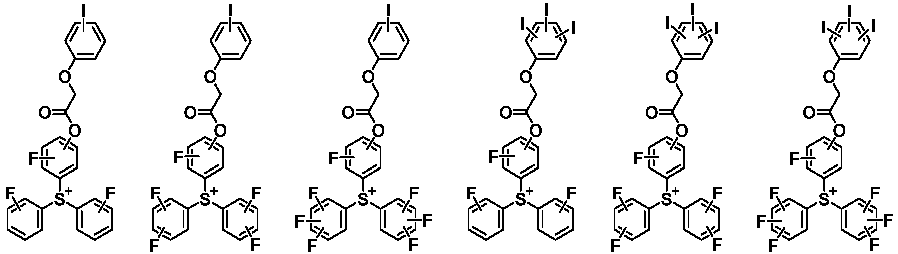

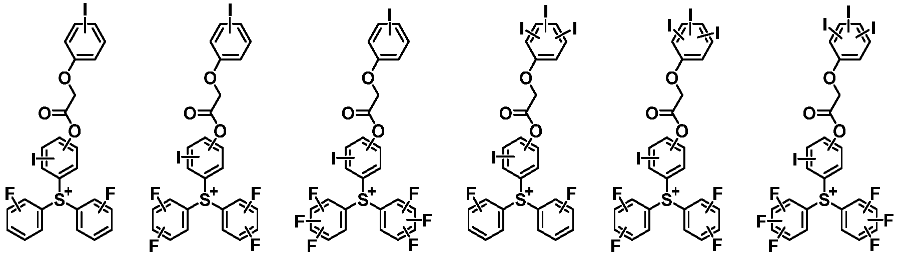

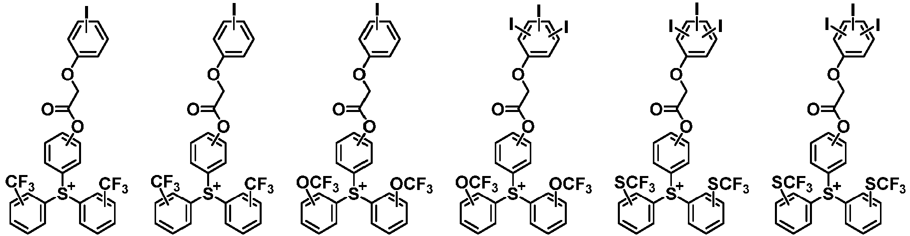

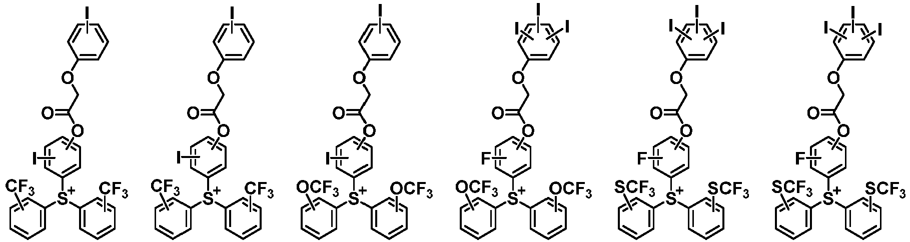

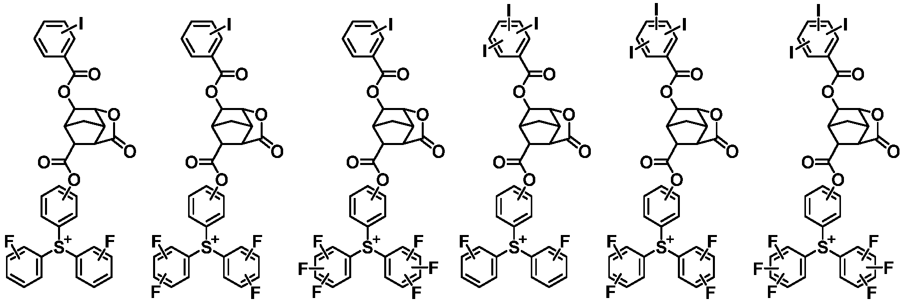

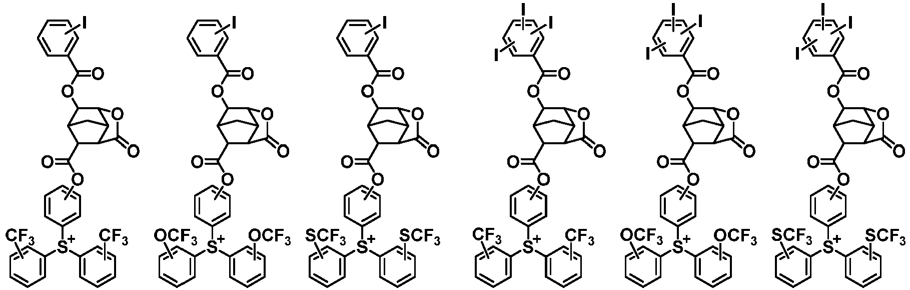

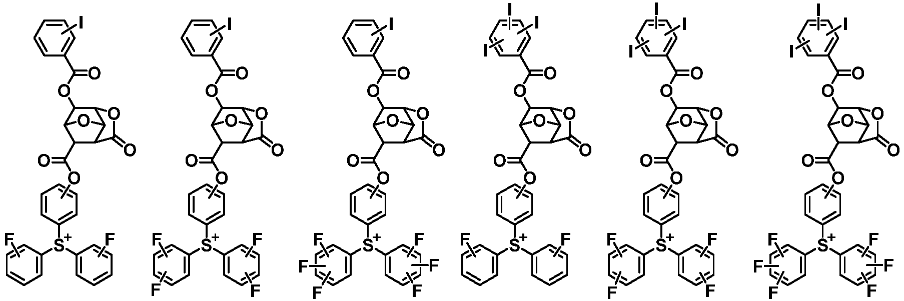

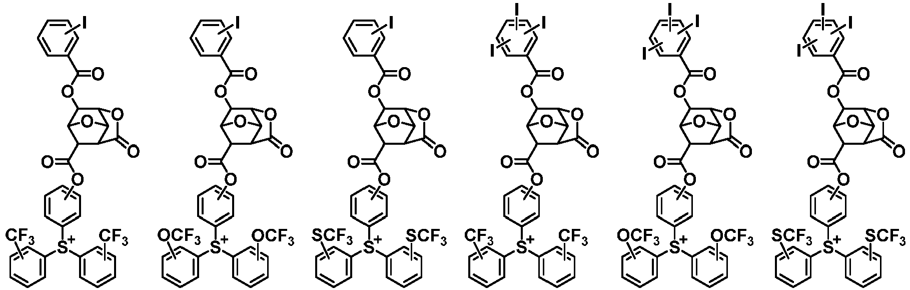

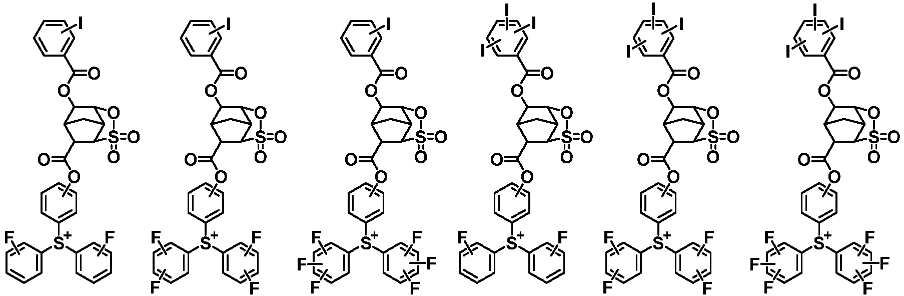

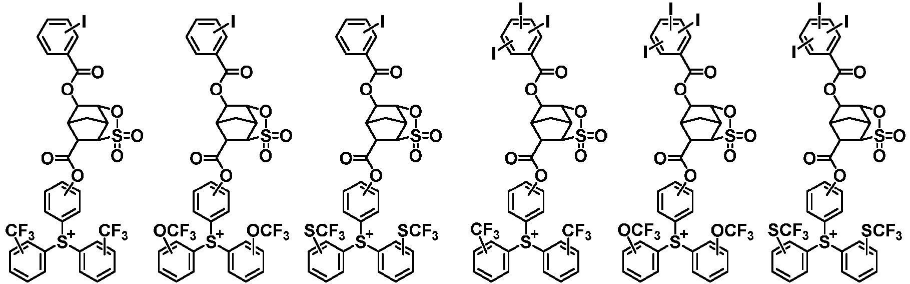

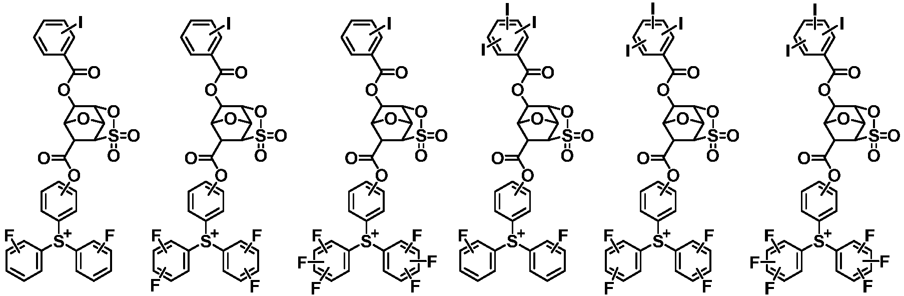

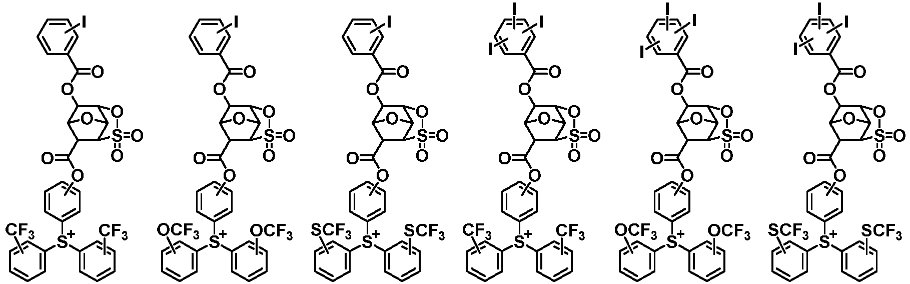

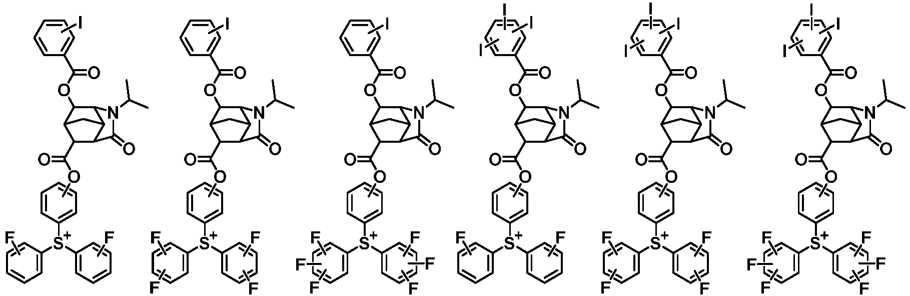

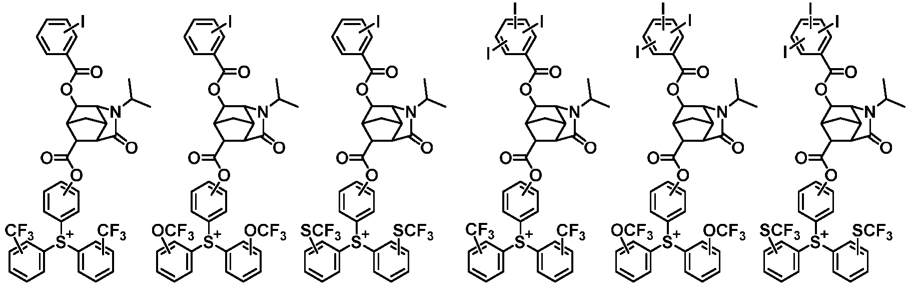

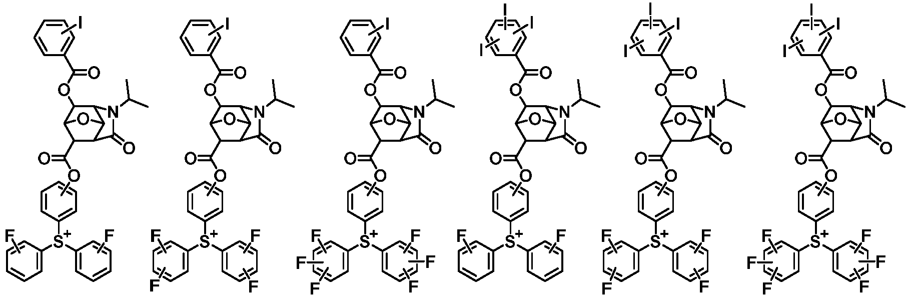

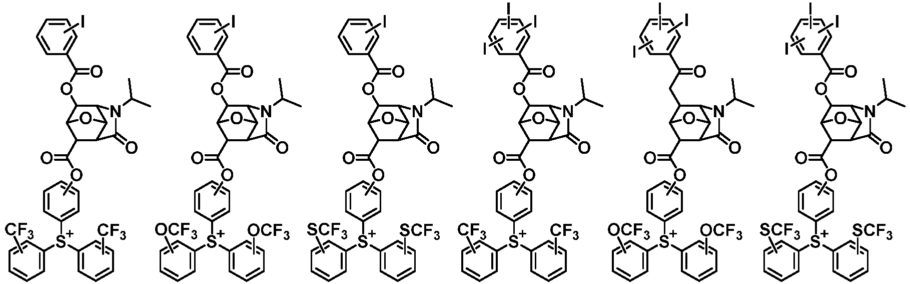

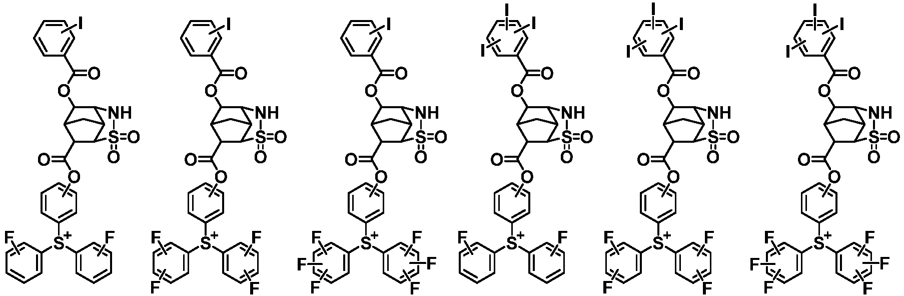

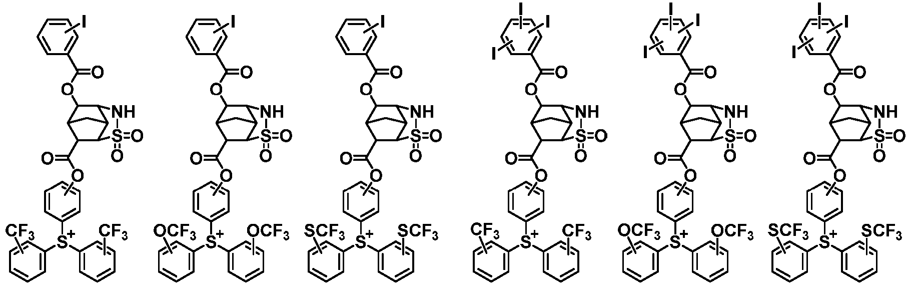

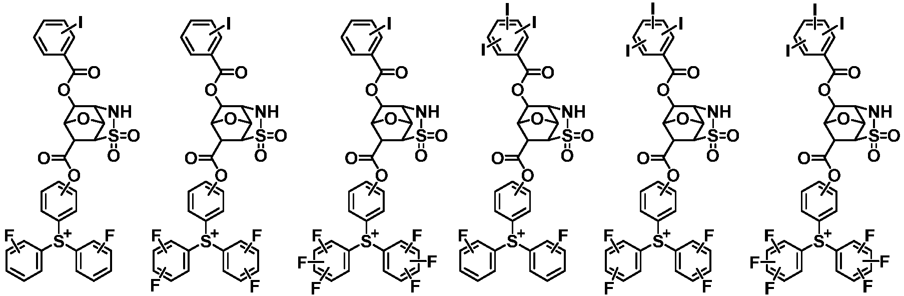

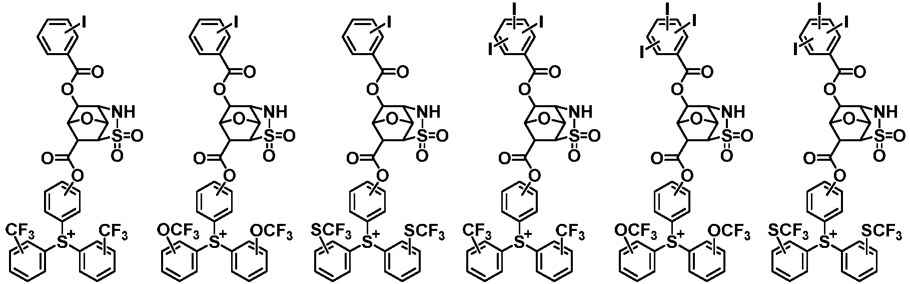

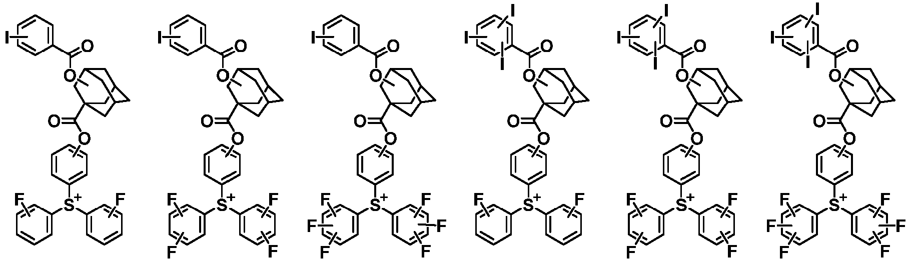

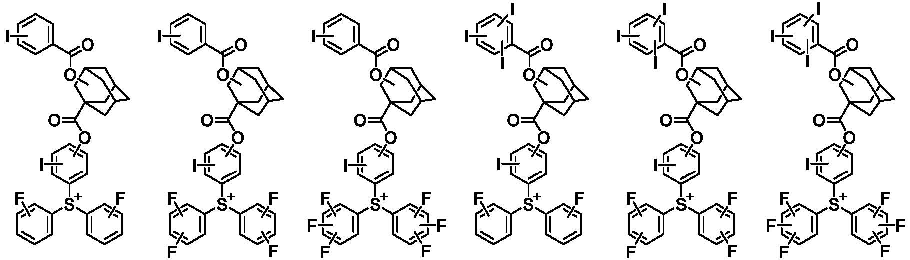

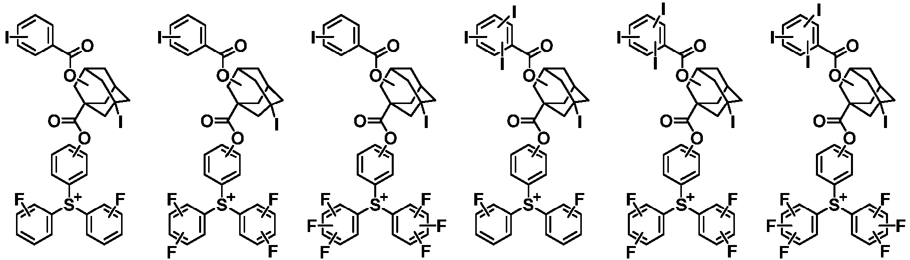

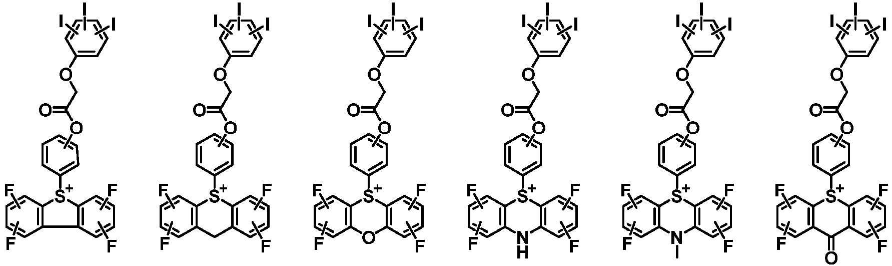

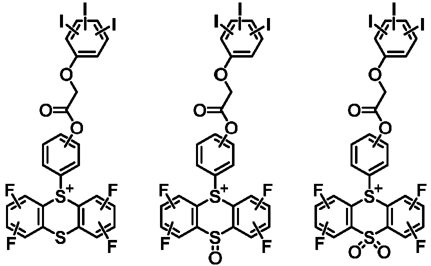

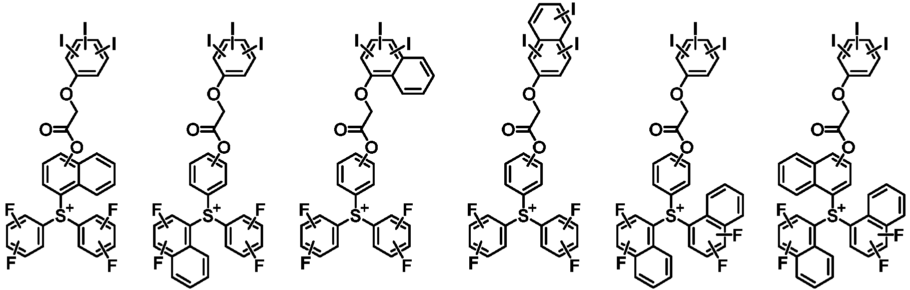

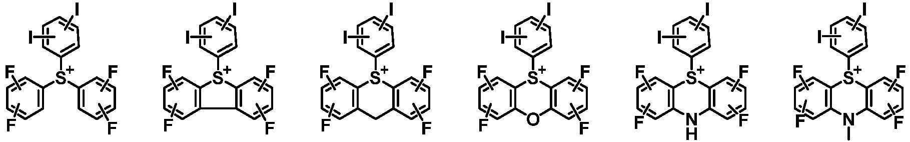

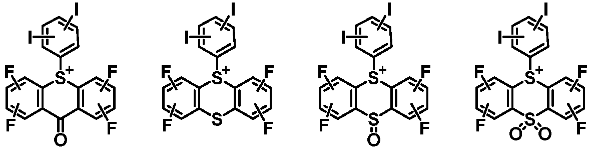

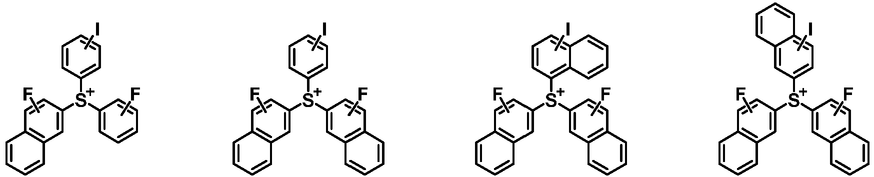

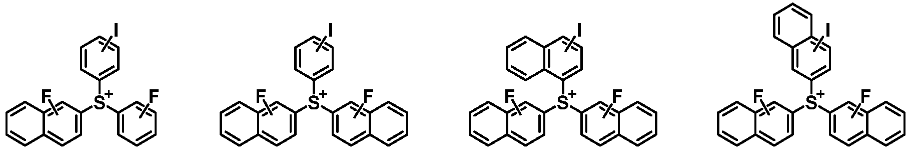

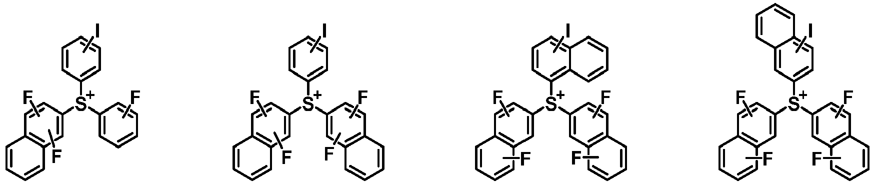

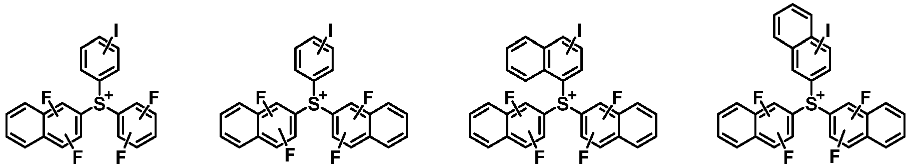

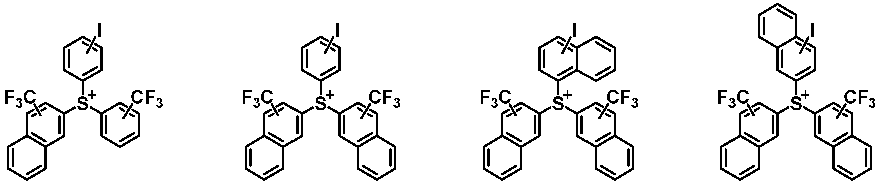

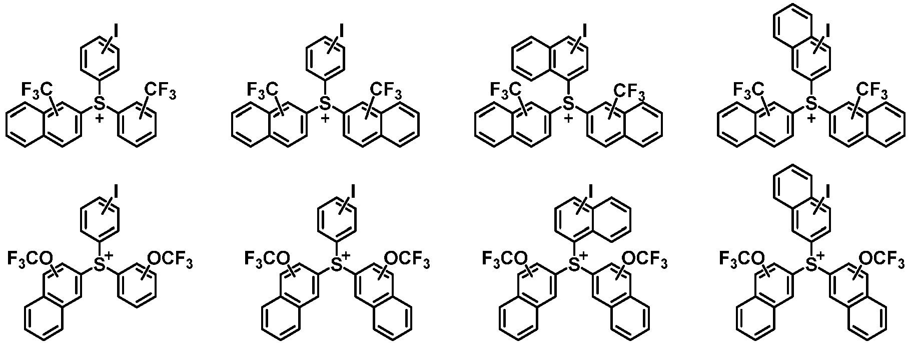

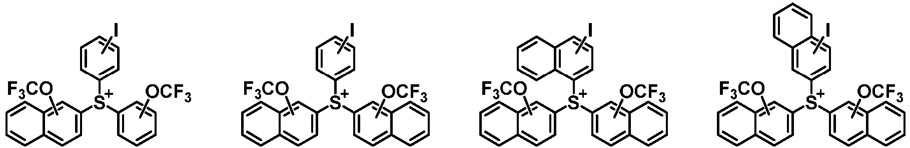

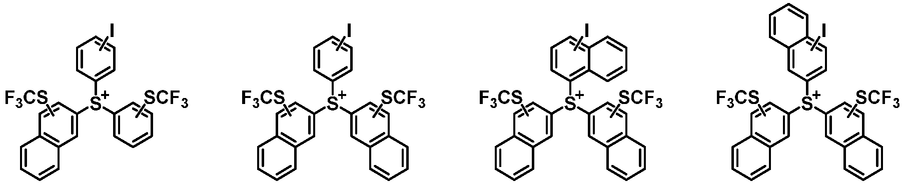

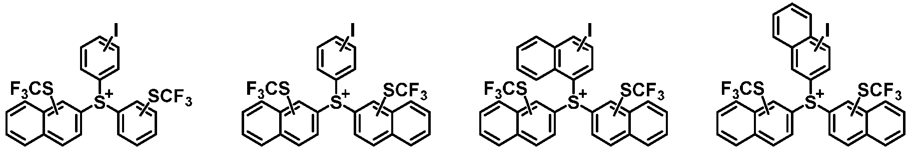

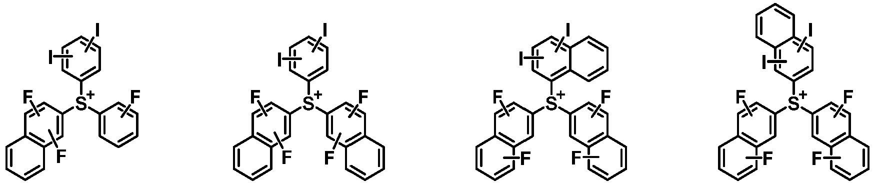

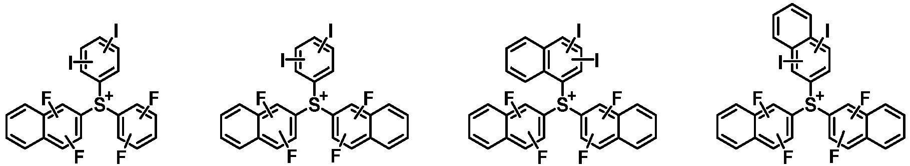

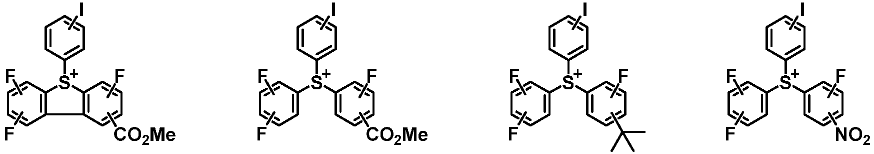

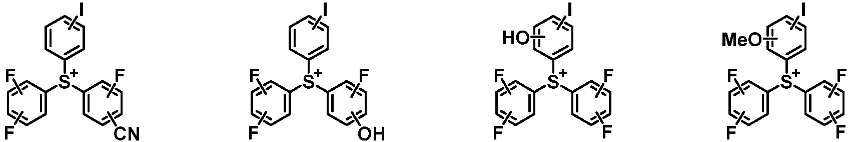

Specific examples of the repeat unit A1 include arbitrary combinations of anions with cations, both as exemplified above.

Examples of the method for synthesizing the monomer derived from the repeat unit A1 include methods described in JP-A 2010-155824, JP 7067271, and the like, but the production method is merely an example, and the method for producing the monomer derived from the repeat unit A1 is not limited thereto.

The repeat unit A1 is structurally characterized in that it is derived from an onium salt containing an aromatic sulfonate anion in which a polymerizable group is directly bonded to an aromatic ring and a triarylsulfonium cation containing an iodine atom. The aromatic sulfonate anion in which a polymerizable group is directly bonded to an aromatic ring generates an acid by exposure, but since an aromatic sulfonic acid is directly bonded to the polymer backbone, acid diffusion can be highly controlled. In addition, the aromatic ring interacts with another aromatic ring-containing copolymerization unit (π-π stacking interaction), and is regularly and densely arranged, so that the pattern collapse is prevented. On the other hand, in the aromatic sulfonate anion in which a polymerizable group is directly bonded to an aromatic ring, the organic solvent solubility is not so high, and the solubility is further lowered due to incorporation of an iodine atom in the triarylsulfonium cation, however, by separately introducing a plurality of fluorine atoms onto the aromatic ring of the cation, organic solvent solubility can be ensured. Further, since an iodine atom or a fluorine atom in the cation has an electron withdrawing property, the energy level of the lowest unoccupied molecular orbital (LUMO) in the frontier orbital theory is lowered, and a generated secondary electron is easily received, so that the decomposition of the cation is promoted, and an acid is effectively generated, resulting in high sensitivity. In the exposed portion, the acid is sufficiently generated by efficient decomposition of the cation, the deprotection reaction of the protective group in the base polymer proceeds well, and the aromatic sulfonic acid bonded to the backbone of the base polymer is extremely easily dissolved in an alkaline developer, so that the dissolution rate in the alkaline developer is increased. On the other hand, in the unexposed portion, the iodine atom in the triarylsulfonium cation exhibits a dissolution inhibition property against the alkaline developer, and the film thickness loss of the pattern of the unexposed portion is reduced. This improves the dissolution contrast. Due to these synergistic effects, the chemically amplified positive resist composition of the invention has high sensitivity and low acid diffusibility so as to exhibit good resolution and LER, and enable the formation of a pattern that is resistant to pattern collapse, and thus is suitable for small-size pattern formation.

The repeat unit A1 can be suitably used as a polymer-bound photoacid generator.

The polymer further contains a repeat unit A2 having a phenolic hydroxy group having the formula (A2).

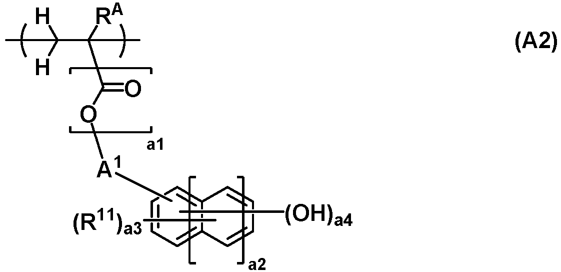

In the formula (A2), a1 is 0 or 1. a2 is 0, 1, or 2, and the relevant structure is a benzene skeleton when a2 is 0, a naphthalene skeleton when a2 is 1, and an anthracene skeleton when a2 is 2. a3 is an integer meeting 0 ≤ a3 ≤ 5+2(a2)-a4. a4 is 1, 2, or 3. When a2 is 0, a3 is preferably 0, 1, 2, or 3, and a4 is preferably 1, 2, or 3. When a2 is 1 or 2, a3 is preferably 0, 1, 2, 3, or 4, and a4 is preferably 1, 2, or 3.

In the formula (A2), R^{A} is a hydrogen atom, a fluorine atom, a methyl group, or a trifluoromethyl group.

In the formula (A2), R¹¹ is a halogen atom, a nitro group, a cyano group, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom. The saturated hydrocarbylene group, and the saturated hydrocarbyl moiety in the saturated hydrocarbyloxy group and the saturated hydrocarbylcarbonyloxy group may be straight, branched, or cyclic, and specific examples thereof include alkyl groups such as a methyl group, an ethyl group, a n-propyl group, an isopropyl group, a butyl group, a pentyl group, a hexyl group, and structural isomers thereof; cycloalkyl groups such as a cyclopropyl group, a cyclobutyl group, a cyclopentyl group, and a cyclohexyl group; and a group obtained by combining these groups. When the number of carbon atoms is equal to or less than the upper limit, solubility in an alkaline developer is good. When a3 is 2 or more, a plurality of R¹¹'s may be identical or different.

In the formula (A2), A¹ is a single bond or a C₁-C₁₀ saturated hydrocarbylene group, and some -CH₂- in the saturated hydrocarbylene group may be replaced by -O-. The saturated hydrocarbylene group may be straight, branched, or cyclic, and specific examples thereof include a methylene group, C₁-C₁₀ alkanediyl groups such as an ethane-1,2-diyl group, a propane-1,3-diyl group, a butane-1,4-diyl group, a pentane-1,5-diyl group, a hexane-1,6-diyl group, and structural isomers thereof; C₃-C₁₀ cyclic saturated hydrocarbylene groups such as a cyclopropanediyl group, a cyclobutanediyl group, a cyclopentanediyl group, and a cyclohexanediyl group; and a group obtained by combining these groups. In the case where the saturated hydrocarbylene group contains an ether bond, when a1 in the formula (A2) is 1, the ether bond may be inserted at any position except between a carbon atom at α-position and a carbon atom at β-position with respect to an ester oxygen atom. When a1 is 0, an atom bonded to the backbone is an ether oxygen atom, and a second ether bond may be inserted at any position except between a carbon atom at α-position and a carbon atom at β-position with respect to the ether oxygen atom. It is preferred that the number of carbon atoms in the saturated hydrocarbylene group is 10 or less because solubility in an alkaline developer can be sufficiently obtained.

When a1 is 0 and A¹ is a single bond, that is, when the aromatic ring is directly bonded to the backbone of the polymer (that is, free of a linker (-C(=O)-O-A¹-)), preferred examples of the repeat unit A2 include units derived from 3-hydroxystyrene, 4-hydroxystyrene, 5-hydroxy-2-vinylnaphthalene, 6-hydroxy-2-vinylnaphthalene, and the like. In particular, a repeat unit having the formula (A2-1) is preferred.

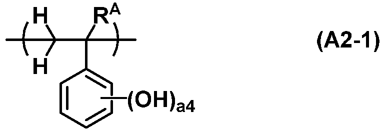

In the formula, R^{A} and a4 are as defined above.

When a1 is 0 and A¹ is a single bond (that is, free of a linker (-C(=O)-O-A¹-)), preferred examples of the repeat unit A2 are shown below, but not limited thereto. In the following formulae, R^{A} is as defined above.

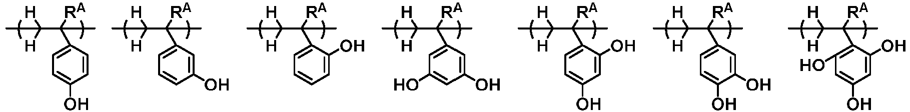

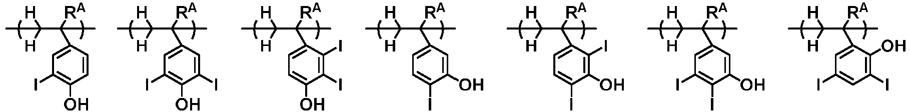

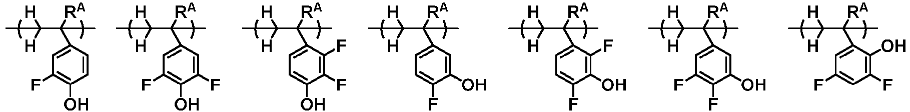

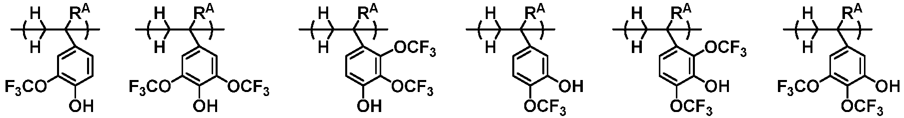

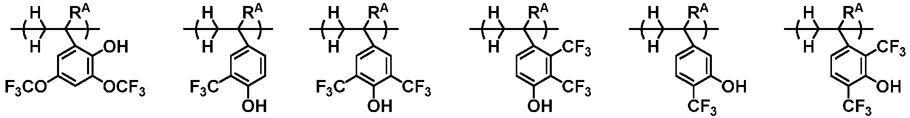

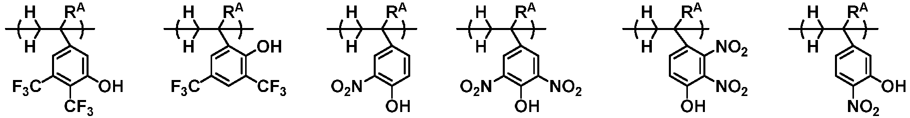

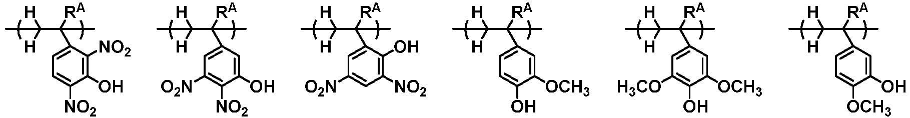

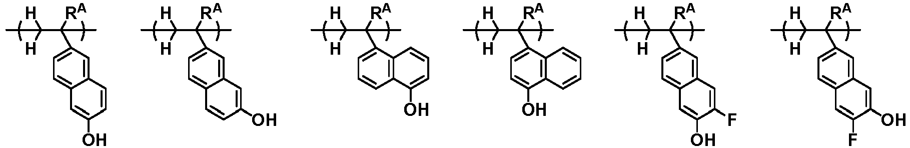

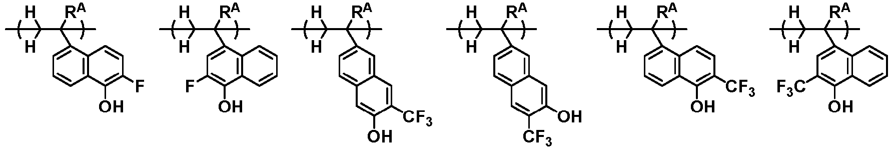

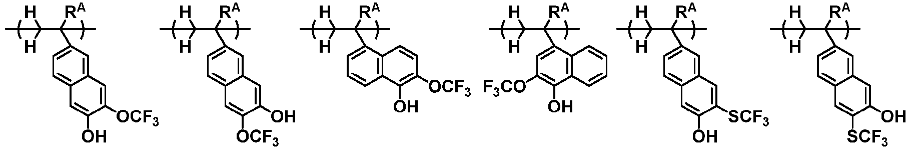

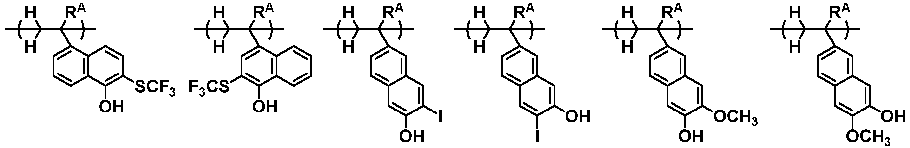

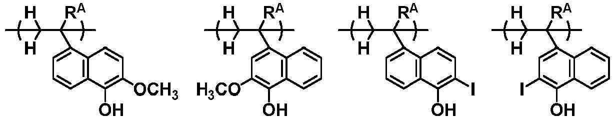

When a1 is 1 (that is, (-C(=O)-O-A¹-) is contained as a linker), preferred examples of the repeat unit A2 are shown below, but not limited thereto. In the following formulae, R^{A} is as defined above.

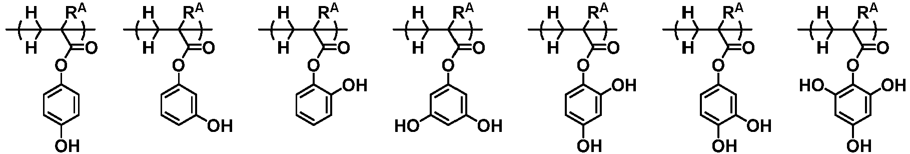

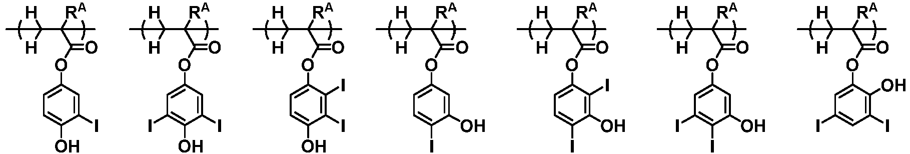

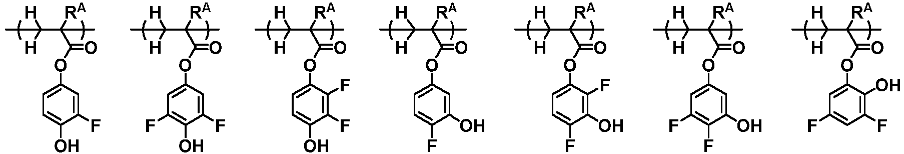

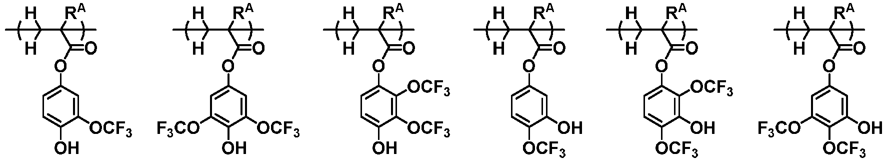

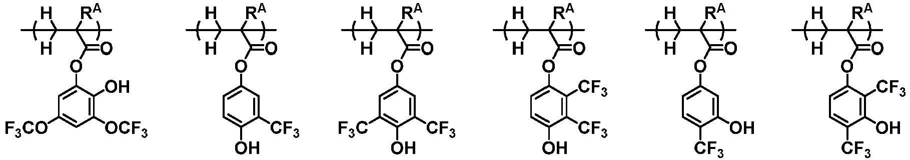

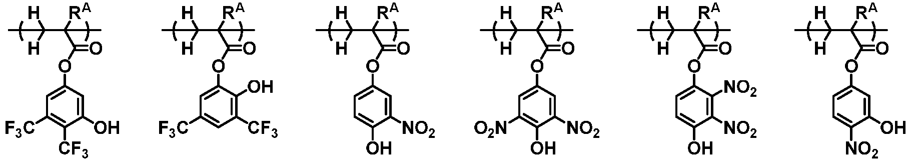

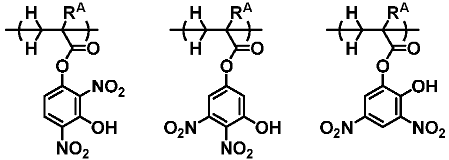

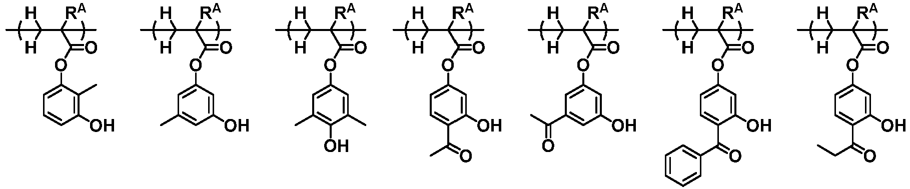

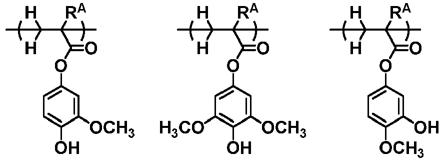

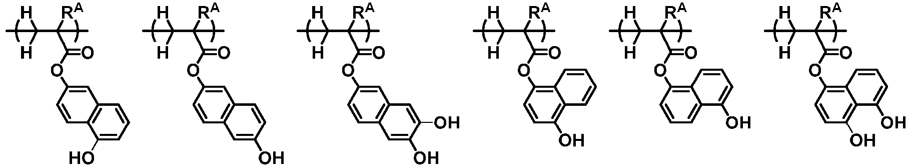

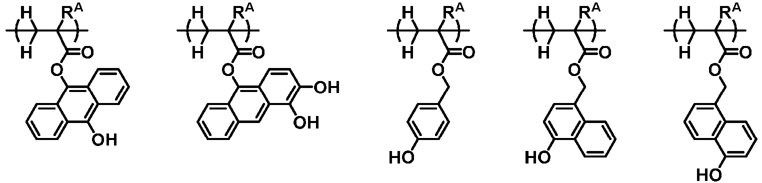

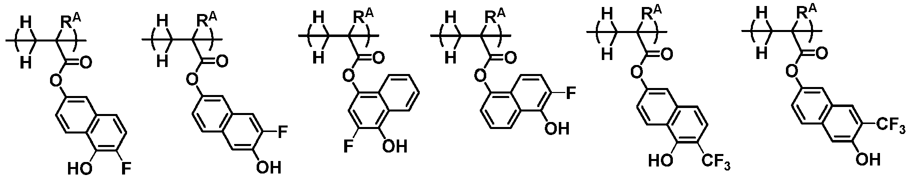

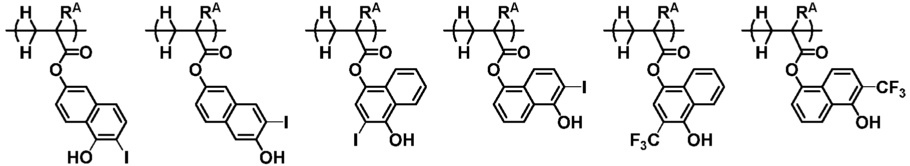

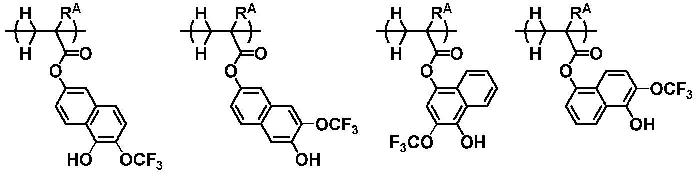

The content of the repeat unit A2 is preferably 30 to 90 mol% and more preferably 40 to 85 mol% of the overall repeat units of the polymer. However, when at least one repeat unit of the repeat unit having the formula (A4) and the repeat unit having the formula (A5), which give higher etching resistance to the polymer described later, is contained, and the unit has a phenolic hydroxy group as a substituent, the proportion thereof is also preferably within the above range. As the repeat unit A2, one type may be used alone or two or more types may be combined and used.

Since the polymer gives a property that an exposed portion is dissolved in an alkaline developer as a positive resist composition, it is preferred that the polymer contains a repeat unit having an acidic functional group protected with an acid labile group, that is, a repeat unit that is protected with an acid labile group and becomes alkali-soluble by the action of an acid (hereinafter also referred to as repeat unit A3).

Most preferred examples of the repeat unit A3 include those having the formula (A3-1) (hereinafter also referred to as repeat unit A3-1).

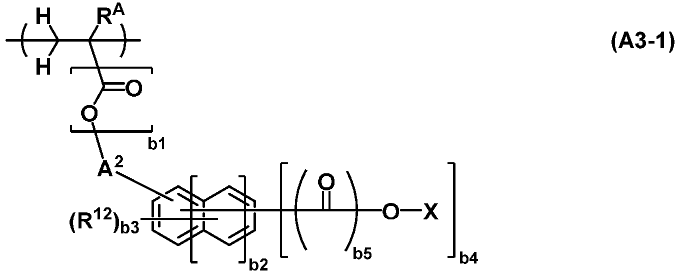

In the formula (A3-1), b1 is 0 or 1. b2 is 0, 1, or 2, and the relevant structure is a benzene skeleton when b2 is 0, a naphthalene skeleton when b2 is 1, and an anthracene skeleton when b2 is 2. b3 is an integer meeting 0 ≤ b3 ≤ 5+2(b2)-b4. b4 is 1, 2, or 3. b5 is 0 or 1. When b2 is 0, preferably b3 is 0, 1, 2, or 3 and b4 is 1, 2, or 3, and when b2 is 1 or 2, preferably b3 is 0, 1, 2, 3, or 4 and b4 is 1, 2, or 3.

In the formula (A3-1), R^{A} is a hydrogen atom, a fluorine atom, a methyl group, or a trifluoromethyl group.

In the formula (A3-1), R¹² is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom. The saturated hydrocarbylene group, and the saturated hydrocarbyl moiety in the saturated hydrocarbyloxy group and the saturated hydrocarbylcarbonyloxy group may be straight, branched, or cyclic, and specific examples thereof include alkyl groups such as a methyl group, an ethyl group, a n-propyl group, an isopropyl group, a butyl group, a pentyl group, a hexyl group, and structural isomers thereof; cycloalkyl groups such as a cyclopropyl group, a cyclobutyl group, a cyclopentyl group, and a cyclohexyl group; and a group obtained by combining these groups. When the number of carbon atoms is equal to or less than the upper limit, solubility in an alkaline developer is good. When b3 is 2 or more, a plurality of R¹²'s may be identical or different.

In the formula (A3-1), A² is a single bond or a C₁-C₁₀ saturated hydrocarbylene group, and some -CH₂- in the saturated hydrocarbylene group may be replaced by -O-. The saturated hydrocarbylene group may be straight, branched, or cyclic, and specific examples thereof include a methylene group, C₁-C₁₀ alkanediyl groups such as an ethane-1,2-diyl group, a propane-1,3-diyl group, a butane-1,4-diyl group, a pentane-1,5-diyl group, a hexane-1,6-diyl group, and structural isomers thereof; C₃-C₁₀ cyclic saturated hydrocarbylene groups such as a cyclopropanediyl group, a cyclobutanediyl group, a cyclopentanediyl group, and a cyclohexanediyl group; and a group obtained by combining these groups. In the case where the saturated hydrocarbylene group contains an ether bond, when b1 in the formula (A3-1) is 1, the ether bond may be inserted at any position except between a carbon atom at α-position and a carbon atom at β-position with respect to an ester oxygen atom. When b1 is 0, an atom bonded to the backbone is an ether oxygen atom, and a second ether bond may be inserted at any position except between a carbon atom at α-position and a carbon atom at β-position with respect to the ether oxygen atom. It is preferred that the number of carbon atoms in the saturated hydrocarbylene group is 10 or less because solubility in an alkaline developer can be sufficiently obtained.

In the formula (A3-1), when b4 is 1, X is an acid labile group. When b4 is 2 or 3, X's are each independently a hydrogen atom or an acid labile group, but at least one X is an acid labile group. That is, in the repeat unit A3-1, at least one of phenolic hydroxy groups bonded to an aromatic ring is protected with an acid labile group, or a carboxy group bonded to an aromatic ring is protected with an acid labile group. The acid labile group is not particularly limited, and any acid labile group can be used as long as it has been used in a large number of known chemically amplified positive resist compositions and is detached by an acid to give an acidic group.

Examples of the acid labile group include a tertiary saturated hydrocarbyl group. The tertiary saturated hydrocarbyl group preferably has 4 to 18 carbon atoms in order to obtain the resulting monomer for use in polymerization by distillation.

As the saturated hydrocarbyl group bonded to the tertiary carbon atom in the tertiary saturated hydrocarbyl group, those having 1 to 15 carbon atoms are preferred. The C₁-C₁₅ saturated hydrocarbyl group may be straight, branched, or cyclic, and may contain an ether bond or an oxygen atom-containing functional group such as a carbonyl group in its carbon-carbon bond. Saturated hydrocarbyl groups bonded to the tertiary carbon atom may bond together to form a ring with the tertiary carbon atom to which they are attached.

Examples of the saturated hydrocarbyl group bonded to the tertiary carbon atom include a methyl group, an ethyl group, a propyl group, an adamantyl group, a norbornyl group, a tetrahydrofuran-2-yl group, a 7-oxanorbornan-2-yl group, a cyclopentyl group, a 2-tetrahydrofuryl group, a tricyclo[5.2.1.0^{2,6}]decyl group, an 8-ethyl-8-tricyclo[5.2.1.0^{2,6}]decyl group, a 3-methyl-3-tetracyclo[4.4.0.1^{2,5} 1^{7,10}]dodecyl group, a tetracyclo[4.4.0.1^{2,5}.1^{7,10}]dodecyl group, and a 3-oxo-1-cyclohexyl group.

Examples of the tertiary saturated hydrocarbyl group include a tert-butyl group, a tert-pentyl group, a 1-ethyl-1-methylpropyl group, a 1,1-diethylpropyl group, a 1,1,2-trimethylpropyl group, a 1-adamantyl-1-methylethyl group, a 1-methyl-1-(2-norbornyl)ethyl group, a 1-methyl-1-(tetrahydrofuran-2-yl)ethyl group, a 1-methyl-1-(7-oxanorbornane-2-yl)ethyl group, a 1-methylcyclopentyl group, a 1-ethylcyclopentyl group, a 1-propylcyclopentyl group, a 1-cyclopentylcyclopentyl group, a 1-cyclohexylcyclopentyl group, a 1-(2-tetrahydrofuryl)cyclopentyl group, a 1-(7-oxanorbornane-2-yl)cyclopentyl group, a 1-methylcyclohexyl group, a 1-ethylcyclohexyl group, a 1-cyclopentylcyclohexyl group, a 1-cyclohexylcyclohexyl group, a 2-methyl-2-norbonyl group, a 2-ethyl-2-norbonyl group, an 8-methyl-8-tricyclo[5.2.1.0^{2,6}]decyl group, an 8-ethyl-8-tricyclo[5.2.1.0^{2,6}]decyl group, a 3-methyl-3-tetracyclo[4.4.0.1^{2,5}.1^{7,10}]dodecyl group, a 3-ethyl-3-tetracyclo[4.4.0.1^{2,5}.1^{7,10}]dodecyl group, a 2-methyl-2-adamantyl group, a 2-ethyl-2-adamantyl group, a 1-methyl-3-oxo-1-cyclohexyl group, a 1-methyl-1-(tetrahydrofuran-2-yl)ethyl group, a 5-hydroxy-2-methyl-2-adamantyl group, and a 5-hydroxy-2-ethyl-2-adamantyl group, but are not limited thereto.

Examples of the acid labile group include a group having the formula (A3-1-1). The group having the formula (A3-1-1) is often used as an acid labile group, and is a useful choice as an acid labile group that stably provides a pattern in which the interface between the pattern and the substrate is relatively rectangular. When X is a group having the formula (A3-1-1), an acetal structure is formed.

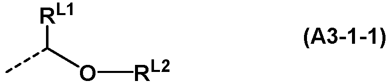

In the formula, a broken line designates a point of attachment.

In the formula (A3-1-1), R^{L1} is a hydrogen atom or a C₁-C₁₀ saturated hydrocarbyl group. The saturated hydrocarbyl group may be straight, branched, or cyclic.

R^{L1} is appropriately selected according to the designed sensitivity of a decomposable group to an acid. For example, a hydrogen atom or a group in which a carbon atom bonded to acetal carbon is a tertiary carbon atom is preferred when the acid labile group is designed to ensure relatively high stability and to be decomposed with a strong acid. Examples of R^{L1} bonded to acetal carbon via a tertiary carbon atom include a tert-butyl group, a tert-pentyl group, and a 1-adamantyl group, but are not limited thereto. A straight alkyl group is preferred when the acid labile group is designed to have relatively high reactivity and high sensitivity to pH changes. Although the choice varies with a particular combination of an acid generator and a quencher in the resist composition, when a relatively large alkyl group is selected at the terminal as R^{L2} and the solubility change due to decomposition is designed to be large, R^{L1} is preferably a group in which the carbon atom bonded to acetal carbon is a secondary carbon atom. Examples of R^{L1} bonded to acetal carbon via a secondary carbon atom include an isopropyl group, a sec-butyl group, a cyclopentyl group, and a cyclohexyl group, but are not limited thereto.

In the formula (A3-1-1), R^{L2} is a C₁-C₃₀ hydrocarbyl group. The hydrocarbyl group may be saturated or unsaturated and straight, branched, or cyclic, and some -CH₂- in the hydrocarbyl group may be replaced by a heteroatom such as an oxygen atom or a sulfur atom so that the group may contain an ether bond, a sulfide bond, or the like. Specific examples of the hydrocarbyl group include a C₁-C₃₀ saturated hydrocarbyl group and a C₆-C₃₀ aryl group. In particular, in order to obtain higher resolution in small-size pattern formation, R¹² is preferably a C₁-C₆ hydrocarbyl group. When R^{L2} is a C₁-C₆ hydrocarbyl group, an alcohol generated after a progress of a deprotection reaction by an acid is water-soluble, and therefore is dissolved in a developer when a positive pattern is formed with an alkaline developer, so that defects remaining in an exposed portion can be reduced.

Preferred examples of the group having the formula (A3-1-1) are shown below, but not limited thereto. In the following formulae, R^{L1} is as defined above, and a broken line designates a point of attachment.

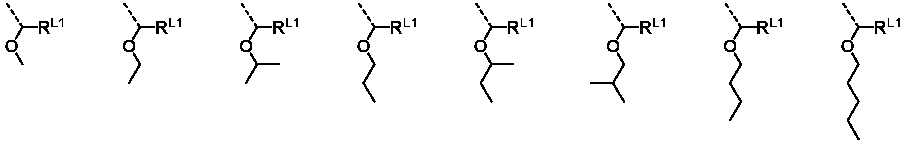

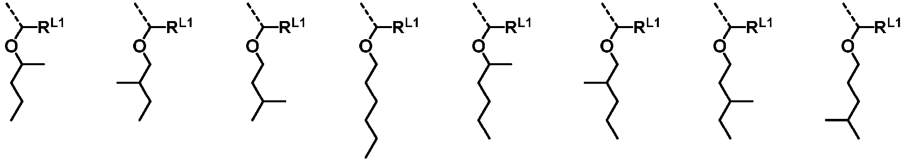

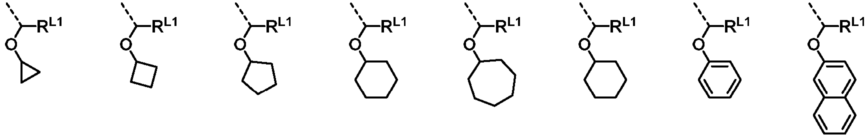

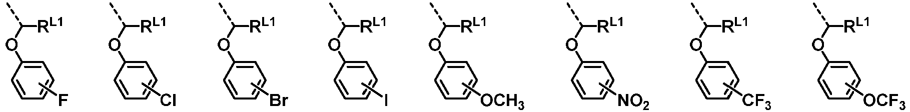

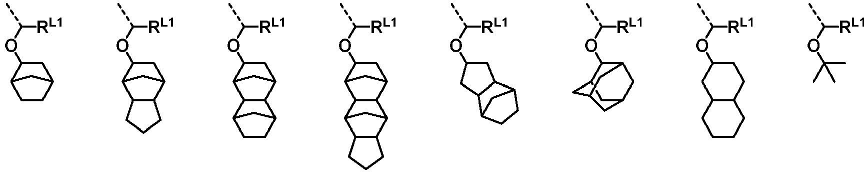

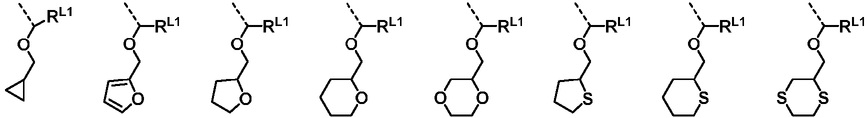

As the acid labile group, a group in which a hydrogen atom in a phenolic hydroxy group is substituted with -CH₂COO- (tertiary saturated hydrocarbyl group) can also be used. At this time, as the tertiary saturated hydrocarbyl group, the same group as the tertiary saturated hydrocarbyl group used for protecting the phenolic hydroxy group described above can be used.

Examples of the repeat unit A3 also include a repeat unit having the formula (A3-2) (hereinafter also referred to as repeat unit A3-2). The repeat unit A3-2 increase the dissolution rate in the exposed portion, and therefore is a useful choice as an acid labile group-containing unit that gives good performance against line width variations in development loading.

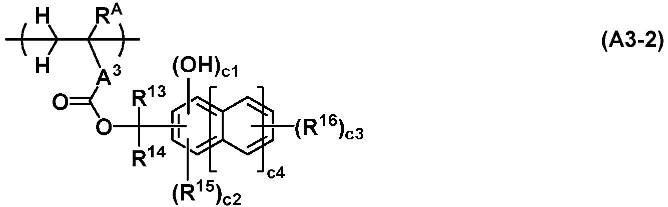

In the formula (A3-2), c1 is 0, 1 or 2. c2 is 0, 1, or 2. c3 is 0, 1, 2, 3, 4, or 5. c4 is 0, 1, or 2.

In the formula (A3-2), R^{A} is a hydrogen atom, a fluorine atom, a methyl group, or a trifluoromethyl group.

In the formula (A3-2), R¹³ and R¹⁴ are each independently a C₁-C₁₀ hydrocarbyl group which may contain a heteroatom, and R¹³ and R¹⁴ may bond together to form a ring with the carbon atom to which they are attached.

In the formula (A3-2), R¹⁵'s are each independently a fluorine atom, a C₁-C₅ fluorinated alkyl group, or a C₁-C₅ fluorinated alkoxy group.

In the formula (A3-2), R¹⁶'s are each independently a C₁-C₁₀ hydrocarbyl group which may contain a heteroatom.

In the formula (A3-2), A³ is a single bond, a phenylene group, a naphthylene group, or *-C(=O)-O-A³¹-. A³¹ is a C₁-C₂₀ aliphatic hydrocarbylene group, a phenylene group, or a naphthylene group, and the aliphatic hydrocarbylene group may contain at least one selected from a hydroxy group, an ether bond, an ester bond, and a lactone ring, and * designates a point of attachment to the carbon atom in the backbone.

Preferred examples of the repeat unit A3-2 are shown below, but not limited thereto. In the following formulae, R^{A} is as defined above.

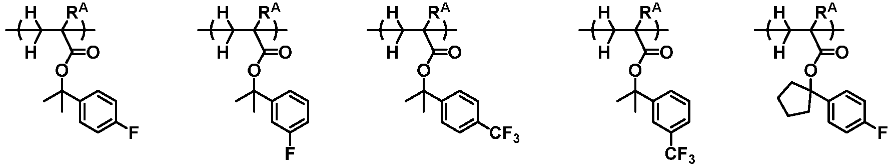

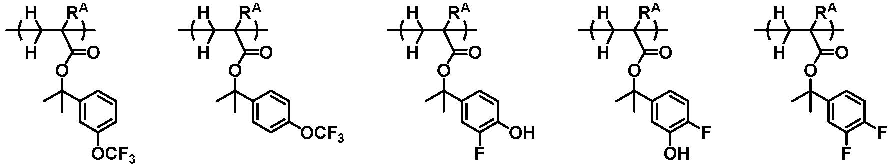

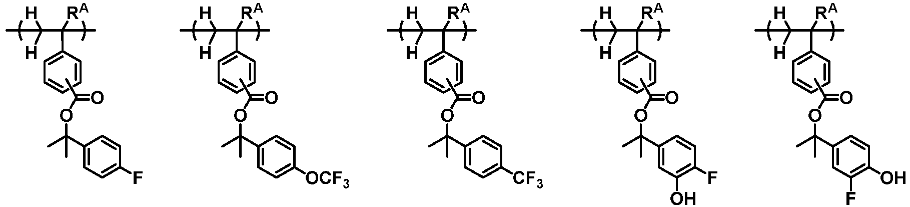

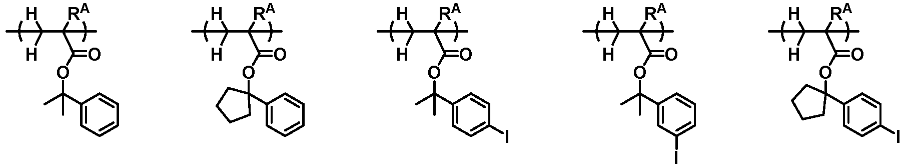

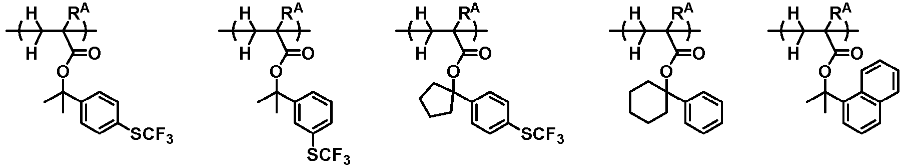

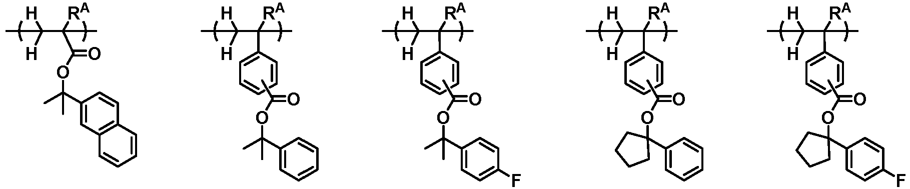

The content of the repeat unit A3 is preferably 5 to 95 mol% and more preferably 20 to 80 mol% of the overall repeat units constituting the polymer. As the repeat unit A3, one type may be used alone or two or more types may be combined and used.

The polymer may contain at least one repeat unit selected from a repeat unit having the formula (A4) (hereinafter also referred to as repeat unit A4), a repeat unit having the formula (A5) (hereinafter also referred to as repeat unit A5), and a repeat unit having the formula (A6) (hereinafter also referred to as repeat unit A6).

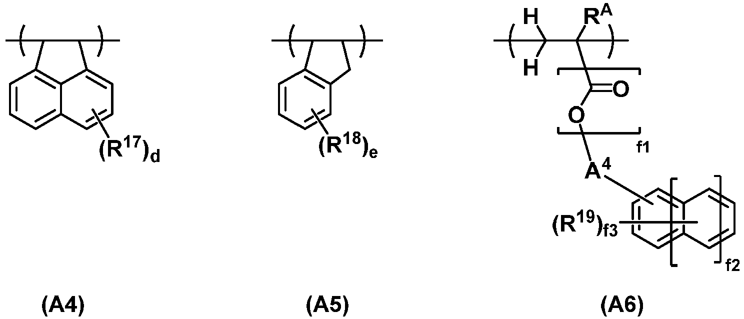

In the formulae (A4) and (A5), d is 0, 1, 2, 3, 4, 5, or 6. e is 0, 1, 2, 3, or 4.

In the formulae (A4) and (A5), R¹⁷ and R¹⁸ are each independently a hydroxy group, a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom. The saturated hydrocarbyl group, the saturated hydrocarbyloxy group, and the saturated hydrocarbylcarbonyloxy group may be straight, branched, or cyclic. When d is 2 or more, a plurality of R¹⁷'s may be identical or different. When e is 2 or more, a plurality of R¹⁸'s may be identical or different.

In the formula (A6), f1 is 0 or 1. f2 is 0, 1, or 2, and the relevant structure is a benzene skeleton when f2 is 0, a naphthalene skeleton when f2 is 1, and an anthracene skeleton when f2 is 2. f3 is 0, 1, 2, 3, 4, or 5. When f2 is 0, f3 is preferably 0, 1, 2, or 3, and when f2 is 1 or 2, f3 is preferably 0, 1, 2, 3, or 4.

In the formula (A6), R^{A} is a hydrogen atom, a fluorine atom, a methyl group, or a trifluoromethyl group.

In the formula (A6), R¹⁹ is a halogen atom, a nitro group, a cyano group, a C₁-C₂₀ saturated hydrocarbyl group, a C₁-C₂₀ saturated hydrocarbyloxy group, a C₂-C₂₀ saturated hydrocarbylcarbonyloxy group, a C₂-C₂₀ saturated hydrocarbyloxyhydrocarbyl group, or a C₂-C₂₀ saturated hydrocarbylthiohydrocarbyl group, and may be a hydroxy group when f2 is 1 or 2. The saturated hydrocarbyl group, the saturated hydrocarbyloxy group, the saturated hydrocarbylcarbonyloxy group, the saturated hydrocarbyloxyhydrocarbyl group, and the saturated hydrocarbylthiohydrocarbyl group may be straight, branched, or cyclic. When f3 is 2 or more, a plurality of R¹⁹'s may be identical or different.

In the formula (A6), A⁴ is a single bond or a C₁-C₁₀ saturated hydrocarbylene group, and some -CH₂- in the saturated hydrocarbylene group may be replaced by -O-. The saturated hydrocarbylene group may be straight, branched, or cyclic, and specific examples thereof are as exemplified above for A¹ in the formula (A2).

When at least one of the repeat units A4 to A6 is used as a constituent unit of the polymer, an effect of enhancing etching resistance and EB irradiation resistance in pattern inspection due to addition of a ring structure to the backbone is obtained in addition to etching resistance possessed by an aromatic ring.

The content of the repeat units A4 to A6 is preferably 5 mol% or more of the overall repeat units constituting the polymer in order to obtain the effect of improving etching resistance. The content of the repeat units A4 to A6 is preferably 25 mol% or less, and more preferably 20 mol% or less of the overall repeat units constituting the polymer. In the case of free of functional groups or having a functional group other than a hydroxy group, the introduction amount of 25 mol% or less is preferred because the risk of forming development defects is eliminated. As the repeat units A4 to A6, one type may be used alone or two or more types may be combined and used.

The content of the repeat unit having an aromatic ring skeleton is preferably 65 mol% or more, more preferably 75 mol% or more, and still more preferably 85 mol% or more of the overall repeat units of the polymer.

The polymer may contain a commonly used (meth)acrylate unit protected with an acid labile group or a (meth)acrylate unit having an adhesive group such as a lactone structure or a hydroxy group other than a phenolic hydroxy group. These repeat units enables fine adjustment of properties of a resist film, but not essential.

Examples of the (meth)acrylate unit having an adhesive group include a repeat unit having the formula (A7) (hereinafter also referred to as repeat unit A7),a repeat unit having the formula (A8) (hereinafter also referred to as repeat unit A8), and a repeat unit having the formula (A9) (hereinafter also referred to as repeat unit A9). These units do not exhibit acidity, and can be used as auxiliary units for providing adhesion to substrates or adjusting solubility.

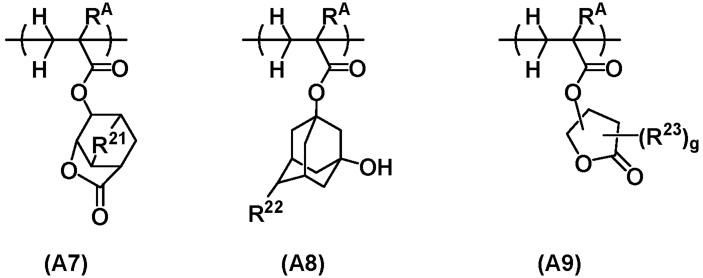

In the formulae (A7) to (A9), R^{A}'s are each independently a hydrogen atom, a fluorine atom, a methyl group, or a trifluoromethyl group. R²¹ is -O- or a methylene group. R²² is a hydrogen atom or a hydroxy group. R²³ is a C₁-C₄ saturated hydrocarbyl group. g is 0, 1, 2, or 3.

When the repeat units A7 to A9 are contained, the content thereof is preferably 0 to 20 mol%, more preferably 0 to 10 mol% of the overall repeat units of the polymer. As the repeat units B14 to B16, one type may be used alone or two or more types may be combined and used.

The polymer can be synthesized by copolymerizing suitable monomers protected with a protective group as necessary by a known method, and then performing a deprotection reaction as necessary. The copolymerization reaction is not particularly limited, but is preferably radical polymerization or anionic polymerization. With respect to these methods, reference may be made to JP-A 2004-115630.

The polymer preferably has a weight average molecular weight (Mw) of 1,000 to 50,000, and more preferably 2,000 to 20,000. A Mw of at least 1,000 eliminates the risk that pattern features are rounded at their top to degrade resolution and LER as conventionally known. A Mw of up to 50,000 eliminates the risk that LER is degraded when a pattern with a line width of 100 nm or less is formed. In the invention, Mw is a value measured in terms of polystyrene by gel permeation chromatography (GPC) using THF or DMF as a solvent.

The polymer preferably has a narrow dispersion such that the molecular weight distribution (Mw/Mn) is 1.0 to 2.0, preferably 1.0 to 1.9, and more preferably 1.0 to 1.8. In the case of narrow dispersion as described above, foreign matter is not generated on the pattern or the profile of the pattern is not deteriorated after development.

The base polymer is designed such that the dissolution rate in an alkaline developer is preferably 10 nm/min or less, more preferably 7 nm/min or less, and still more preferably 5 nm/min or less. In the advanced generation, when the coating film on the substrate is in a thin film range (100 nm or less), the influence of pattern film thickness loss on alkaline development increases, and when the alkaline dissolution rate of the polymer is more than 10 nm/min, the pattern is collapsed, and a small-size pattern cannot be formed. The problem becomes outstanding in the fabrication of a photomask which is required to be free of defects because of having a tendency of strong development process. In the invention, the dissolution rate of the base polymer in an alkaline developer is a value calculated from the amount of film thickness loss when a film having a film thickness of 1,000 nm is formed by spin coating a 8 inch silicon wafer with a polymer solution (polymer concentration: 16.7 wt%, solvent: propylene glycol monomethyl ether acetate (PGMEA)) and baking the solution at 100°C for 90 seconds, and then the film is developed with a 2.38 wt% tetramethylammonium hydroxide (TMAH) aqueous solution at 23°C for 100 seconds.

The base polymer of a component (A) may contain another polymer other than the above-mentioned polymer. As another polymer, a polymer conventionally known as a base polymer for a resist composition can be used. The content of another polymer is not particularly limited as long as the effect of the invention is not impaired.

### (B) Quencher

The chemically amplified positive resist composition of the invention may contain a quencher as a component (B) as necessary. In the invention, the quencher means a compound that traps an acid generated from an acid generator. This can reduce the diffusion rate when the acid generated from the acid generator diffuses in the resist film, and can prevent the influence of the acid generated in the resist film on the material containing chromium even when a substrate whose outermost surface is made of a material containing chromium is used as the substrate.

Examples of the quencher include conventional basic compounds. Examples of the conventional basic compounds include primary, secondary, and tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amides, imides, and carbamates. In particular, primary, secondary, and tertiary amine compounds, particularly amine compounds having a hydroxy group, an ether bond, an ester bond, a lactone ring, a cyano group, or a sulfonate ester bond described in JP-A 2008-111103, paragraphs [0146] to [0164], compounds having a carbamate group described in JP 3790649, and the like are preferred. Preferred examples thereof include tris[2-(methoxymethoxy)ethyl]amine, tris[2-(methoxymethoxy)ethyl]amine-N-oxide, dibutylaminobenzoic acid, a morpholine derivative, and an imidazole derivative. Addition of such a basic compound can, for example, further reduce the diffusion rate of an acid in the resist film or correct the pattern profile.

Examples of the quencher include onium salts such as sulfonium salts, iodonium salts, and ammonium salts of carboxylic acids which are not fluorinated at the α-position described in JP-A 2008-158339. A sulfonic acid, an imidic acid, or a methidic acid which is not fluorinated at the α-position is necessary for deprotecting the acid labile group, but a carboxylic acid which is not fluorinated at the α-position is released by salt exchange with an onium salt which is not fluorinated at the α-position. The carboxylic acid which is not fluorinated at the α-position hardly causes a deprotection reaction and thus functions as a quencher.

Examples of the onium salt of a carboxylic acid which is not fluorinated at the α-position include a compound having the formula (B1).

R¹⁰¹-CO₂⁻ Mq_{A}⁺ (B1)

In the formula (B1), R¹⁰¹ is a hydrogen atom or a C₁-C₄₀ hydrocarbyl group which may contain a heteroatom, exclusive of a group in which a hydrogen atom bonded to the carbon atom at the α-position of a carboxy group is substituted with a fluorine atom or a fluoroalkyl group.

The hydrocarbyl group of R¹⁰¹ may be saturated or unsaturated and straight, branched, or cyclic. Specific examples thereof include C₁-C₄₀ alkyl groups such as a methyl group, an ethyl group, a n-propyl group, an isopropyl group, a n-butyl group, a sec-butyl group, a tert-butyl group, a n-pentyl group, a tert-pentyl group, a n-hexyl group, a n-octyl group, a 2-ethylhexyl group, a n-nonyl group, and a n-decyl group; C₃-C₄₀ cyclic saturated hydrocarbyl groups such as a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a norbornyl group, a tricyclo[5.2.1.0^{2,6}]decyl group, an adamantyl group, and an adamantylmethyl group; C₂-C₄₀ alkenyl groups such as a vinyl group, an allyl group, a propenyl group, a butenyl group, and a hexenyl group; C₃-C₄₀ cyclic unsaturated aliphatic hydrocarbyl groups such as a cyclohexenyl group; C₆-C₄₀ aryl groups such as a phenyl group, a naphthyl group, an alkylphenyl group (such as a 2-methylphenyl group, a 3-methylphenyl group, a 4-methylphenyl group, a 4-ethylphenyl group, a 4-tert-butylphenyl group, or a 4-n-butylphenyl group), a di- or tri-alkylphenyl group (such as a 2,4-dimethylphenyl group or a 2,4,6-triisopropylphenyl group), an alkylnaphthyl group (such as a methylnaphthyl group or an ethylnaphthyl group), and a dialkylnaphthyl group (such as a dimethylnaphthyl group or a diethylnaphthyl group); and C₇-C₄₀ aralkyl groups such as a benzyl group, a 1-phenylethyl group, and a 2-phenylethyl group.

Some or all hydrogen atoms in the hydrocarbyl group may be substituted with a group containing a heteroatom such as an oxygen atom, a sulfur atom, a nitrogen atom, or a halogen atom, and some -CH₂- in the hydrocarbyl group may be replaced by a group containing a heteroatom such as an oxygen atom, a sulfur atom, or a nitrogen atom, so that the hydrocarbyl group may contain a hydroxy group, a cyano group, a carbonyl group, an ether bond, a thioether bond, an ester bond, a sulfonate ester bond, a carbonate bond, a lactone ring, a sultone ring, a carboxylic anhydride (-C(=O)-O-C(=O)-), a haloalkyl group, or the like. Examples of the hydrocarbyl group containing a heteroatom include heteroaryl groups such as a thienyl group; alkoxyphenyl groups such as a 4-hydroxyphenyl group, a 4-methoxyphenyl group, a 3-methoxyphenyl group, a 2-methoxyphenyl group, a 4-ethoxyphenyl group, a 4-tert-butoxyphenyl group, and a 3-tert-butoxyphenyl group; alkoxynaphthyl groups such as a methoxynaphthyl group, an ethoxynaphthyl group, a n-propoxynaphthyl group, and a n-butoxynaphthyl group; dialkoxynaphthyl groups such as a dimethoxynaphthyl group and a diethoxynaphthyl group; and aryloxoalkyl groups such as 2-aryl-2-oxoethyl groups such as a 2-phenyl-2-oxoethyl group, a 2-(1-naphthyl)-2-oxoethyl group, and a 2-(2-naphthyl)-2-oxoethyl group.

In the formula (B1), Mq_{A}⁺ is an onium cation. As the onium cation, a sulfonium cation, an iodonium cation, and an ammonium cation are preferred, and a sulfonium cation and an iodonium cation are more preferred. Specific examples of the sulfonium cation include those described in JP-A 2024-003744, paragraphs [0102] to [0125], those described in JP-A 2023-169812, paragraphs [0070] to [0085], and those having the formula (A2), but are not limited thereto. Specific examples of the iodonium cation include those described in JP-A 2024-000259, paragraph [0181], but are not limited thereto.

Specific examples of the anion in the onium salt having the formula (B1) are shown below, but not limited thereto.

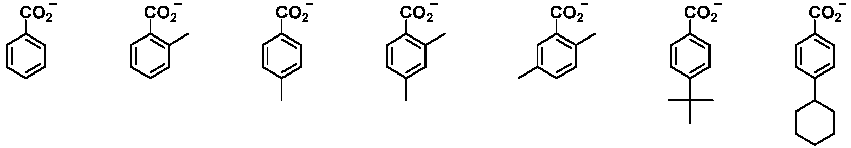

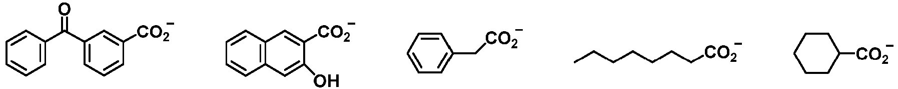

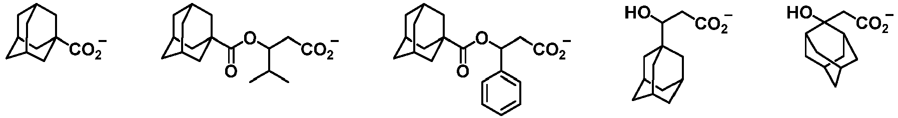

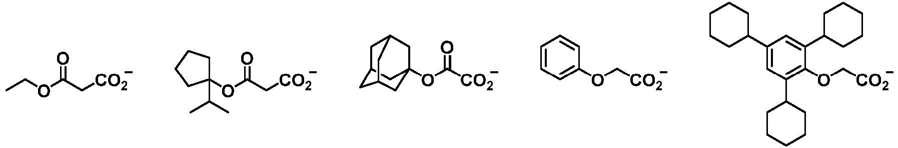

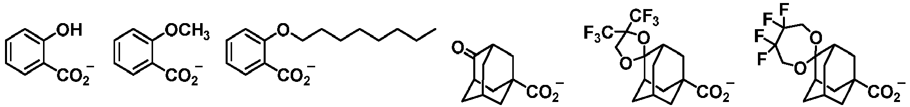

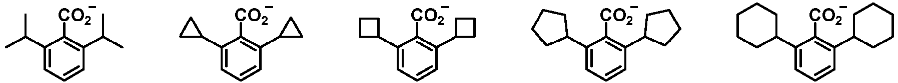

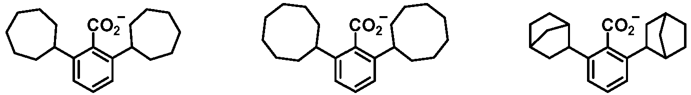

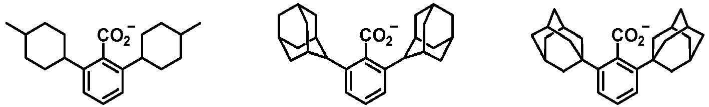

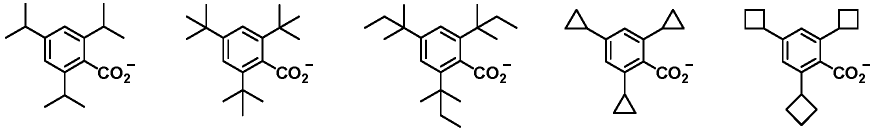

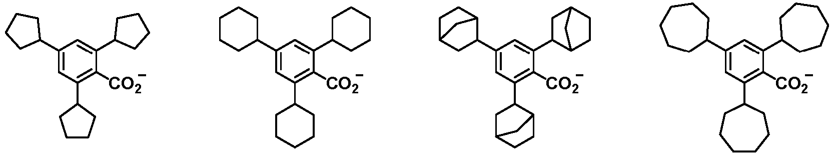

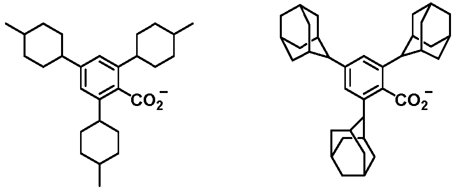

As the quencher, a sulfonium salt of an iodinated benzene ring-containing carboxylic acid having the formula (B2) can also be suitably used.

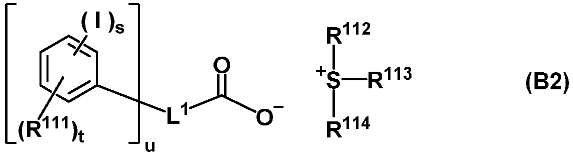

In the formula (B2), s is 1, 2, 3, 4, or 5, t is 0, 1, 2, or 3, meeting 1 ≤ s+t ≤ 5, and u is 1, 2, or 3.

In the formula (B2), R¹¹¹ is a hydroxy group, a fluorine atom, a chlorine atom, a bromine atom, an amino group, a nitro group, a cyano group, a C₁-C₆ saturated hydrocarbyl group, a C₁-C₆ saturated hydrocarbyloxy group, a C₂-C₆ saturated hydrocarbylcarbonyloxy group, a C₁-C₄ saturated hydrocarbylsulfonyloxy group, in which some or all hydrogen atoms may be substituted with a halogen atom, or -N(R^{111A})-C(=O)-R^{111B} or -N(R^{111A})-C(=O)-O-R^{111B}. R^{111A} is a hydrogen atom or a C₁-C₆ saturated hydrocarbyl group. R^{111B} is a C₁-C₆ saturated hydrocarbyl group or a C₂-C₈ unsaturated aliphatic hydrocarbyl group. When t and/or u is 2 or more, a plurality of R¹¹¹'s may be identical or different.

In the formula (B2), L¹ is a single bond or a C₁-C₂₀ (u+1)-valent linking group, and may contain at least one selected from an ether bond, a carbonyl group, an ester bond, an amide bond, a sultone ring, a lactam ring, a carbonate bond, a halogen atom, a hydroxy group, and a carboxy group. The saturated hydrocarbyl group, the saturated hydrocarbyloxy group, the saturated hydrocarbylcarbonyloxy group, and the saturated hydrocarbylsulfonyloxy group may be straight, branched, or cyclic.

In the formula (B2), R¹¹², R¹¹³, and R¹¹⁴ are each independently a halogen atom or a C₁-C₂₀ hydrocarbyl group which may contain a heteroatom. The hydrocarbyl group may be saturated or unsaturated and straight, branched, or cyclic. Specific examples thereof include a C₁-C₂₀ alkyl group, a C₂-C₂₀ alkenyl group, a C₆-C₂₀ aryl group, and a C₇-C₂₀ aralkyl group. Some or all hydrogen atoms in the hydrocarbyl group may be substituted with a hydroxy group, a carboxy group, a halogen atom, an oxo group, a cyano group, a nitro group, a sultone ring, a sulfo group, or a sulfonium salt-containing group, and some -CH₂-in the hydrocarbyl group may be replaced by an ether bond, an ester bond, a carbonyl group, an amide bond, a carbonate bond, or a sulfonate ester bond. R¹¹² and R¹¹³ may bond together to form a ring with the sulfur atom to which they are attached.

Specific examples of the compound having the formula (B2) include compounds described in JP-A 2017-219836. The compound having the formula (B2) exhibits high absorption and a high sensitizing effect, and also exhibits a high acid diffusion controlling effect.

As the quencher, a nitrogen atom-containing carboxylate compound having the formula (B3) can also be used.

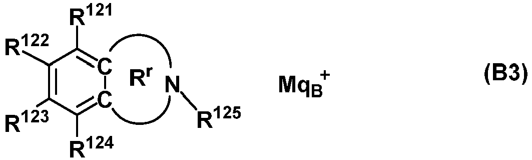

In the formula (B3), R¹²¹ to R¹²⁴ are each independently a hydrogen atom, -L²-CO₂⁻, or a C₁-C₂₀ hydrocarbyl group which may contain a heteroatom. R¹²¹ and R¹²², R¹²² and R¹²³, or R¹²³ and R¹²⁴ may bond together to form a ring with the carbon atom to which they are attached. L² is a single bond or a C₁-C₂₀ hydrocarbylene group which may contain a heteroatom. R¹²⁵ is a hydrogen atom or a C₁-C₂₀ hydrocarbyl group which may contain a heteroatom.

In the formula (B3), the ring R^{r} is a C₂-C₆ ring containing a carbon atom and a nitrogen atom in the formula, and some or all hydrogen atoms bonded to the carbon atom in the ring may be substituted with a C₁-C₂₀ hydrocarbyl group or -L²-CO₂⁻, and some carbon atoms in the ring may be substituted with a sulfur atom, an oxygen atom, or a nitrogen atom. The ring may be alicyclic or aromatic and is preferably a 5- or 6-membered ring, and specific examples thereof include a pyridine ring, a pyrrole ring, a pyrrolidine ring, a piperidine ring, a pyrazole ring, an imidazoline ring, a pyridazine ring, a pyrimidine ring, a pyrazine ring, an imidazoline ring, an oxazole ring, a thiazole ring, a morpholine ring, a thiazine ring, and a triazole ring.

The onium carboxylate having the formula (B3) has at least one -L²-CO₂⁻ group. That is, at least one of R¹²¹ to R¹²⁴ is -L²-CO₂⁻ and/or at least one of hydrogen atoms bonded to the carbon atom in the ring R is substituted with -L²-CO₂⁻.

In the formula (B3), Mq_{B}⁺ is a sulfonium cation, an iodonium cation, or an ammonium cation, and a sulfonium cation is preferred. Specific examples of the sulfonium cation include those described in JP-A 2024-003744, paragraphs [0102] to [0125], those described in JP-A 2023-169812, paragraphs [0070] to [0085], and those having the formula (A2), but are not limited thereto.

Examples of the anion in the compound having the formula (B3) are shown below, but not limited thereto.

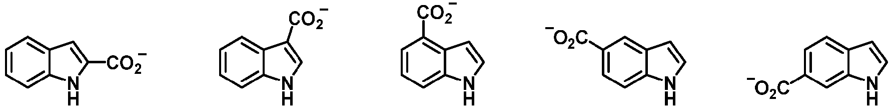

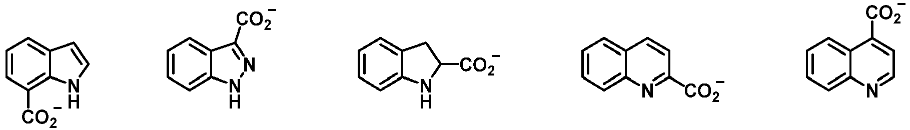

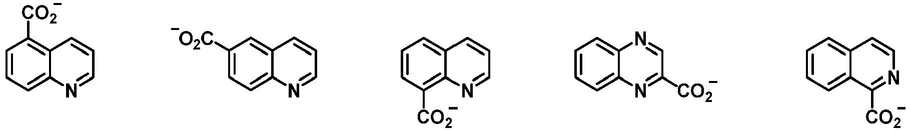

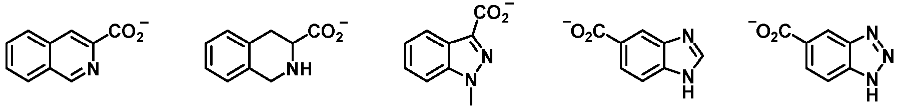

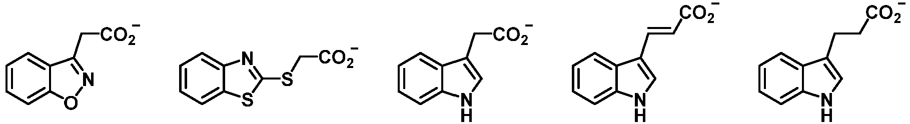

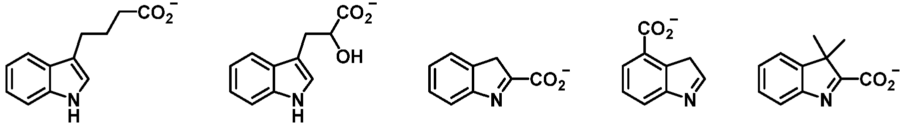

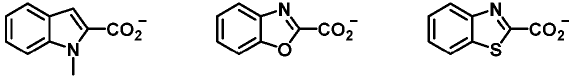

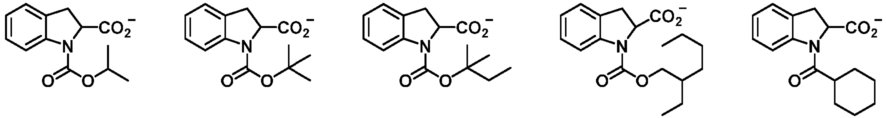

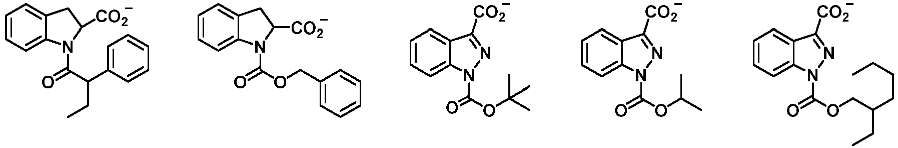

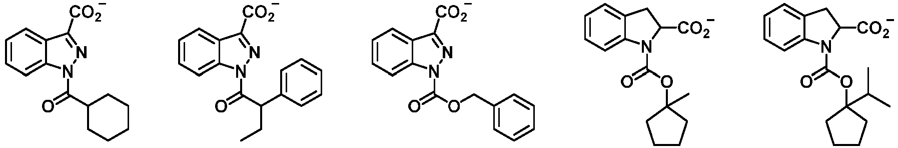

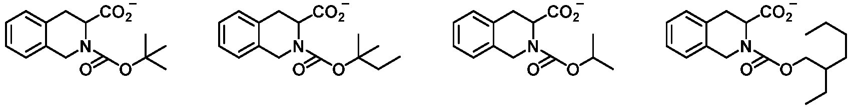

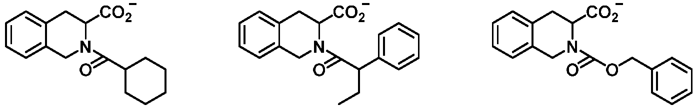

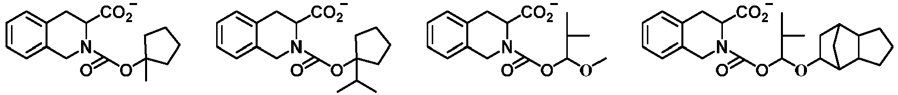

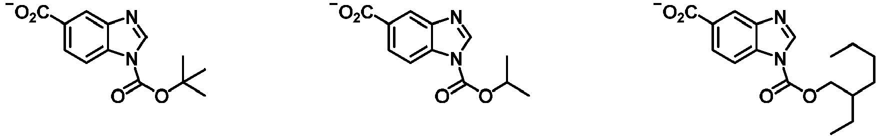

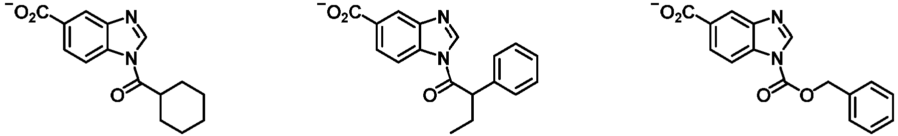

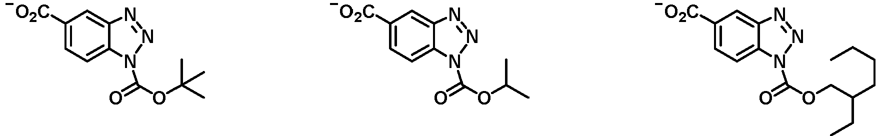

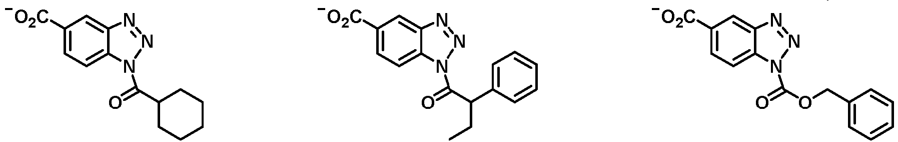

As the quencher, a weak acid betaine compound can also be used. Specific examples thereof are shown below, but not limited thereto.

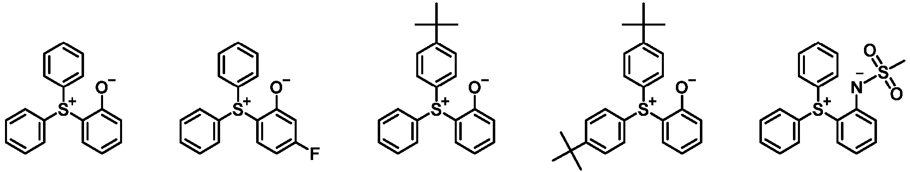

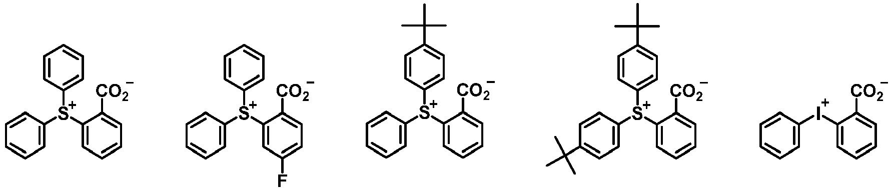

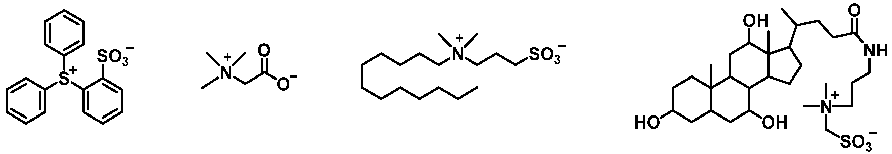

Examples of the quencher further include a polymeric quencher described in JP-A 2008-239918. This enhances the rectangularity of the resist pattern by orientation on the surface of the resist film. The polymeric quencher also has an effect of preventing film thickness loss of a pattern and rounding of a pattern top when a protective film for immersion exposure is applied.

When the chemically amplified positive resist composition of the invention contains the quencher, the content thereof is preferably 0 to 50 parts by weight, and more preferably 0.1 to 40 parts by weight per 80 parts by weight of the base polymer (A). As the quencher, one type may be used alone or two or more types may be combined and used.

### (C) Organic solvent

The resist composition of the invention may contain an organic solvent as a component (C). The organic solvent is not particularly limited as long as it can dissolve each component. Examples of such an organic solvent include ketones such as cyclohexanone, cyclopentanone, methyl-2-n-pentyl ketone, and 2-heptanone; alcohols such as 3-methoxybutanol, 3 methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as PGMEA, propylene glycol monoethyl ether acetate, ethyl lactate (EL), ethyl pyruvate, butyl acetate, methyl 3-methoxypropionate, ethyl 3-ethoxypropionate, tert-butyl acetate, tert-butyl propionate, and propylene glycol mono-tert-butyl ether acetate; lactones such as γ-butyrolactone; and mixed solvents thereof described in JP-A 2008-111103, paragraphs [0144] to [0145]. When an acetal-based acid labile group is used, in order to accelerate the deprotection reaction of acetal, a high-boiling alcohol-based solvent, specifically, diethylene glycol, propylene glycol, glycerin, 1,4-butanediol, 1,3-butanediol, or the like can also be added.

Among these organic solvents, 1-ethoxy-2-propanol, PGMEA, PGME, cyclohexanone, EL, γ-butyrolactone, and mixed solvents thereof are preferred.

When the chemically amplified positive resist composition of the invention contains the organic solvent (C), the content thereof is preferably 200 to 10,000 parts by weight, and more preferably 400 to 5,000 parts by weight per 80 parts by weight of the base polymer (A). As the organic solvent (C), one type may be used alone or two or more types may be mixed and used.

### (D) Fluorine atom-containing polymer

The chemically amplified positive resist composition of the invention may contain, as a component (D), a fluorine atom-containing polymer containing at least one repeat unit selected from a repeat unit having the formula (D1) (hereinafter also referred to as repeat unit D1), a repeat unit having the formula (D2) (hereinafter also referred to as repeat unit D2), a repeat unit having the formula (D3) (hereinafter also referred to as repeat unit D3), and a repeat unit having the formula (D4) (hereinafter also referred to as repeat unit D4) for the purpose of increasing contrast, preventing a chemical flare phenomenon of an acid upon irradiation with high-energy radiation, blocking mixing of an acid from an antistatic film in a process of applying an antistatic film material onto a resist film, and preventing unexpected and unnecessary pattern deterioration. The fluorine atom-containing polymer also has the function of a surfactant, and therefore can prevent insoluble matter that may be generated during the development process from readhering to the substrate, and thus also exhibits an effect on development defects.

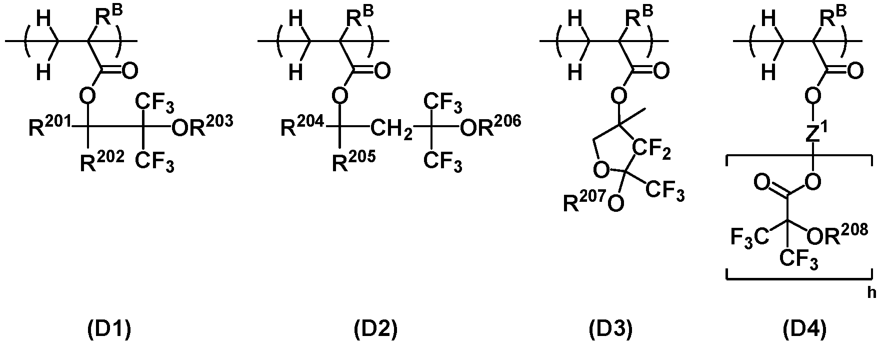

In the formulae (D1) to (D4), h is 1, 2, or 3. R^{B}'s are each independently a hydrogen atom, a fluorine atom, a methyl group, or a trifluoromethyl group. R²⁰¹, R²⁰², R²⁰⁴, and R²⁰⁵ are each independently a hydrogen atom or a C₁-C₁₀ saturated hydrocarbyl group. R²⁰³, R²⁰⁶, R²⁰⁷, and R²⁰⁸ are each independently a hydrogen atom, a C₁-C₁₅ hydrocarbyl group, a C₁-C₁₅ fluorinated hydrocarbyl group, or an acid labile group, and when R²⁰³, R²⁰⁶, R²⁰⁷, and R²⁰⁸ are a hydrocarbyl group or a fluorinated hydrocarbyl group, an ether bond or a carbonyl group may intervene in a carbon-carbon bond. Z¹ is a C₁-C₂₀ (h+1)-valent hydrocarbon group or a C₁-C₂₀ (h+1)-valent fluorinated hydrocarbon group. * designates a point of attachment to the carbon atom in the backbone.

The C₁-C₁₀ saturated hydrocarbyl group of R²⁰¹, R²⁰², R²⁰⁴, and R²⁰⁵ may be straight, branched, or cyclic, and specific examples thereof include C₁-C₁₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-heptyl group, a n-octyl group, a n-nonyl group, and a n-decyl group; and C₃-C₁₀ cyclic saturated hydrocarbyl groups such as a cyclopropyl group, a cyclobutyl group, a cyclopentyl group, a cyclohexyl group, an adamantyl group, and a norbornyl group. Among them, a C₁-C₆ saturated hydrocarbyl group is preferred.

The C₁-C₁₅ hydrocarbyl group of R²⁰³, R²⁰⁶, R²⁰⁷, and R²⁰⁸ may be straight, branched, or cyclic, and specific examples thereof include a C₁-C₁₅ alkyl group, a C₂-C₁₅ alkenyl group, and a C₂-C₁₅ alkynyl group, and a C₁-C₁₅ alkyl group is preferred. Examples of the alkyl group include, in addition to those described above, a methyl group, an ethyl group, a n-propyl group, an isopropyl group, a n-butyl group, an isobutyl group, a sec-butyl group, a n-pentyl group, a n-hexyl group, a n-heptyl group, a n-octyl group, a n-nonyl group, a n-decyl group, a n-undecyl group, a n-dodecyl group, a n-tridecyl group, a n-tetradecyl group, and a n-pentadecyl group. Examples of the fluorinated hydrocarbyl group include groups in which some or all hydrogen atoms bonded to the carbon atom in the above-mentioned hydrocarbyl group are substituted with a fluorine atom.

Examples of the C₁-C₂₀ (h+1)-valent hydrocarbon group of Z¹ include a group obtained by further removing k number of hydrogen atoms from a C₁-C₂₀ alkyl group or a C₃-C₂₀ cyclic saturated hydrocarbyl group. Examples of the C₁-C₂₀ (h+1)-valent fluorinated hydrocarbon group of Z¹ include a group in which at least one hydrogen atom in the (h+1)-valent hydrocarbon group described above is substituted with a fluorine atom.

Specific examples of the repeat units D1 to D4 are shown below, but not limited thereto. In the following formulae, R^{B} is as defined above.

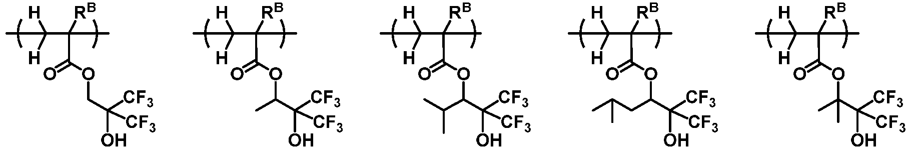

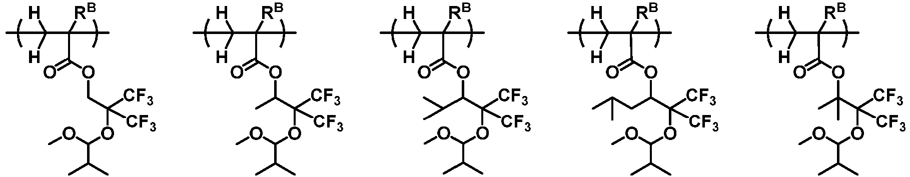

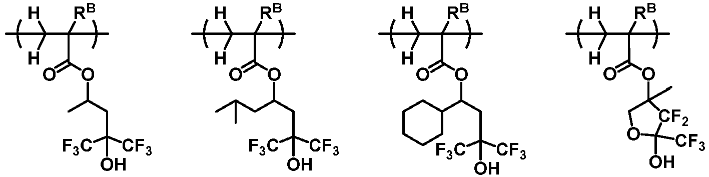

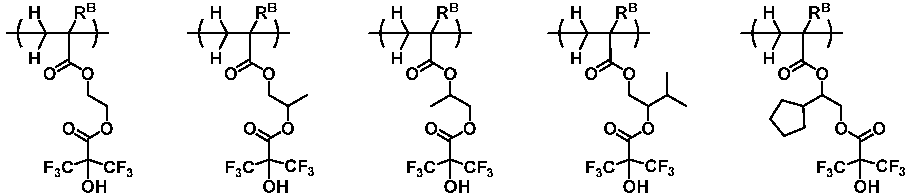

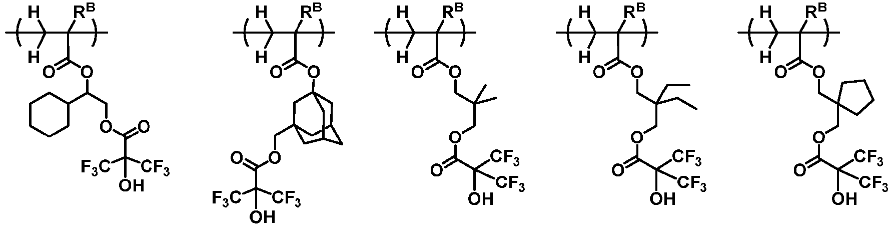

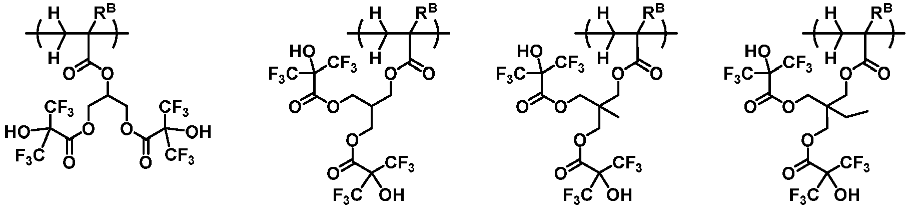

The fluorine atom-containing polymer preferably contains at least one repeat unit selected from a repeat unit having the formula (D5) (hereinafter also referred to as repeat unit D5) and a repeat unit having the formula (D6) (hereinafter also referred to as repeat unit D6).

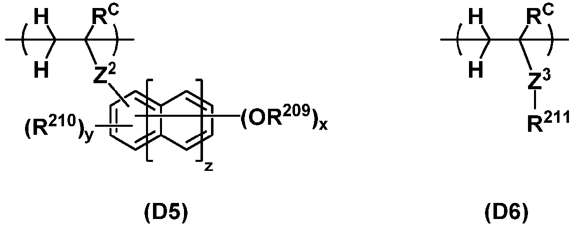

In the formulae (D5) and (D6), x is 1, 2, or 3. y is an integer meeting 0 ≤ y ≤ 5+2z-x. z is 0 or 1. R^{C}'s are each independently a hydrogen atom or a methyl group. R²⁰⁹ is a hydrogen atom or a C₁-C₅ straight or branched hydrocarbyl group in which a heteroatom-containing group may intervene in a carbon-carbon bond. R²¹⁰ is a C₁-C₅ straight or branched hydrocarbyl group in which a heteroatom-containing group may intervene in a carbon-carbon bond. R²¹¹ is a C₁-C₂₀ saturated hydrocarbyl group in which at least one hydrogen atom is substituted with a fluorine atom, and some -CH₂- in the saturated hydrocarbyl group may be substituted with an ester bond or an ether bond. Z² is a single bond, *-C(=O)-O- or *-C(=O)-NH-. Z³ is a single bond, -O-, *-C(=O)-O-Z³¹-Z³²-, or *-C(=O)-NH-Z³¹-Z³²-. Z³¹ is a single bond or a C₁-C₁₀ saturated hydrocarbylene group. Z³² is a single bond, an ester bond, an ether bond, or a sulfonamide bond. * is a point of attachment to the carbon atom in the backbone.

Examples of the C₁-C₅ hydrocarbyl group of R²⁰⁹ and R²¹⁰ include an alkyl group, an alkenyl group, and an alkynyl group, and an alkyl group is preferred. Examples of the alkyl group include a methyl group, an ethyl group, a n-propyl group, an isopropyl group, a n-butyl group, an isobutyl group, a sec-butyl group, and a n-pentyl group. In addition, a group containing a heteroatom such as an oxygen atom, a sulfur atom, or a nitrogen atom may intervene in a carbon-carbon bond in the hydrocarbyl group.

-OR²⁰⁹ in the formula (D5) is preferably a hydrophilic group. In this case, R²⁰⁹ is preferably a hydrogen atom, a C₁-C₅ alkyl group in which an oxygen atom intervenes in a carbon-carbon bond, or the like.

The C₁-C₂₀ saturated hydrocarbyl group in which at least one hydrogen atom is substituted with a fluorine atom of R²¹¹ may be straight, branched, or cyclic, and specific examples thereof include C₁-C₂₀ alkyl groups and C₃-C₂₀ cyclic saturated hydrocarbyl groups in which at least one hydrogen atom is substituted with a fluorine atom.

Z² is preferably *-C(=O)-O- or *-C(=O)-NH-. Further, R^{C} is preferably a methyl group. The presence of a carbonyl group in Z² improves the trapping ability of an acid derived from an antistatic film. In addition, when R^{C} is a methyl group, a rigid polymer having a higher glass transition temperature (Tg) is obtained, so that acid diffusion is prevented. As a result, the stability with time of the resist film is improved, and neither resolution nor pattern profile is degraded.

The C₁-C₁₀ saturated hydrocarbylene group of Z³ may be straight, branched, or cyclic, and specific examples thereof include a methanediyl group, an ethane-1,1-diyl group, an ethane-1,2-diyl group, a propane-1,1-diyl group, a propane-1,2-diyl group, a propane-1,3-diyl group, a propane-2,2-diyl group, a butane-1,1-diyl group, a butane-1,2-diyl group, a butane-1,3-diyl group, a butane-2,3-diyl group, a butane-1,4-diyl group, and a 1,1-dimethylethane-1,2-diyl group.

Examples of the repeat unit D5 are shown below, but not limited thereto. In the following formulae, R^{C} is as defined above.

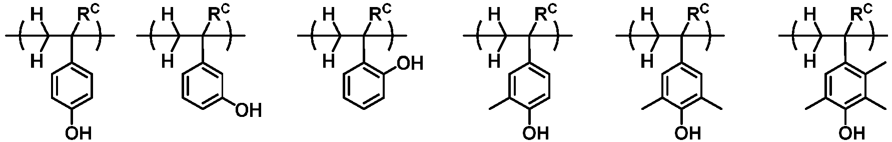

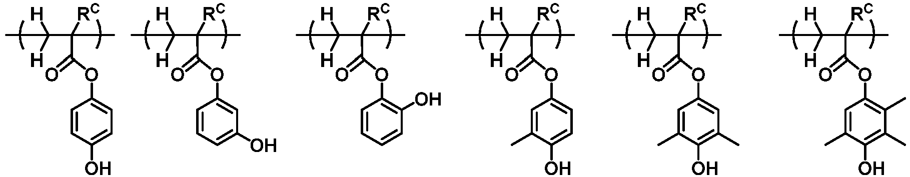

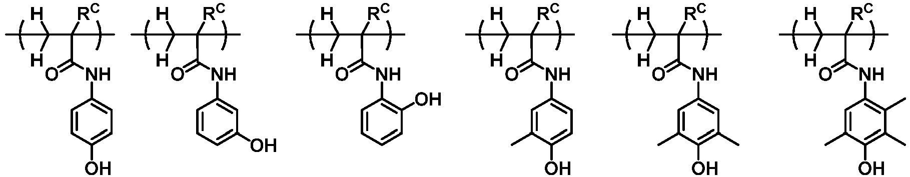

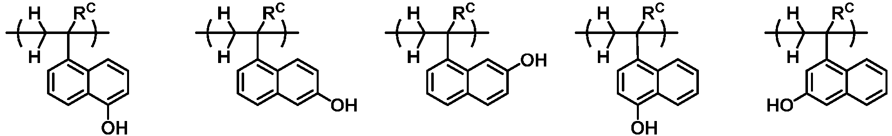

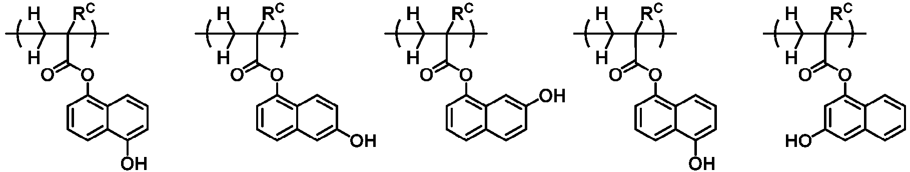

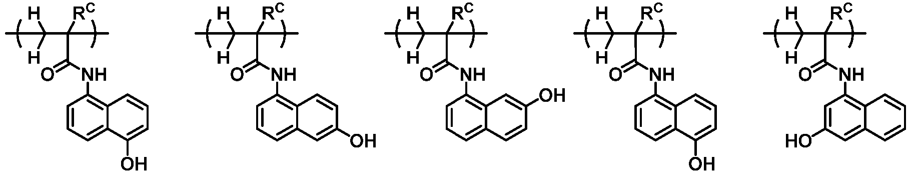

Examples of the repeat unit D6 are shown below, but not limited thereto. In the following formulae, R^{C} is as defined above.

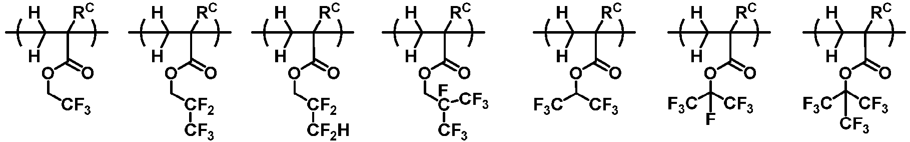

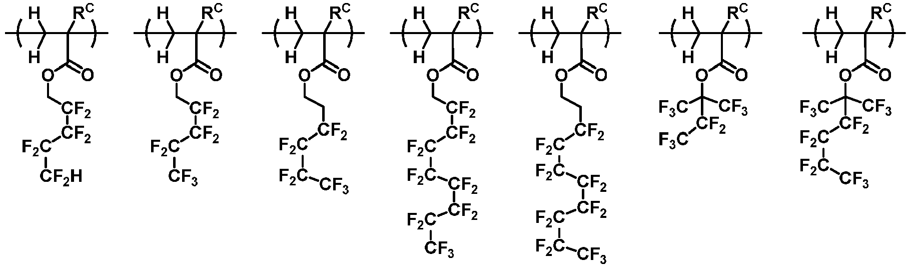

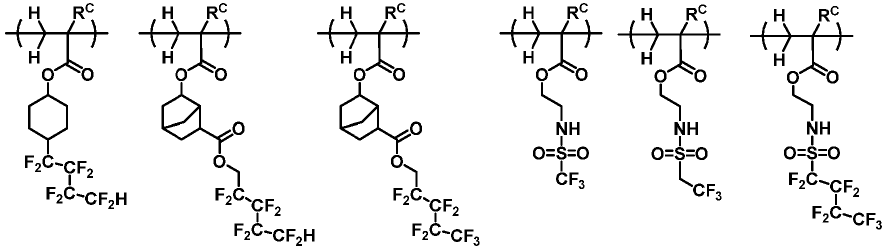

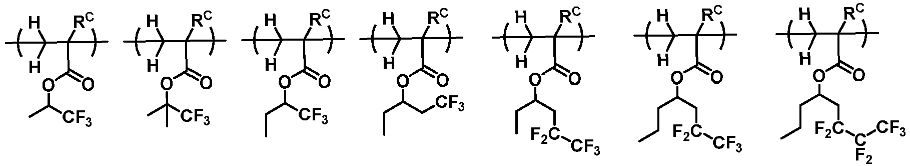

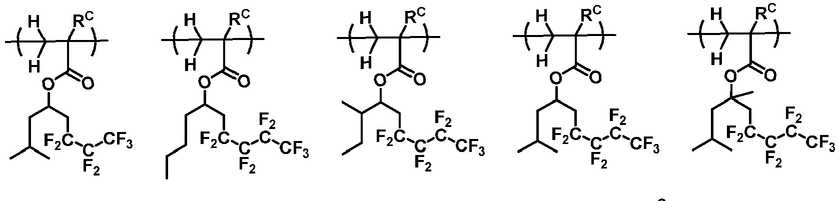

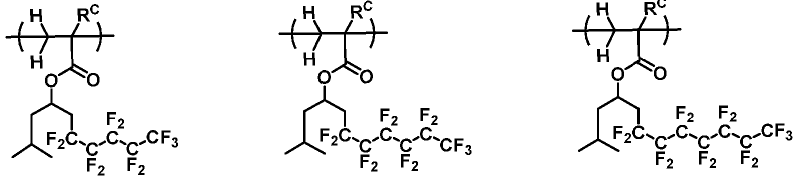

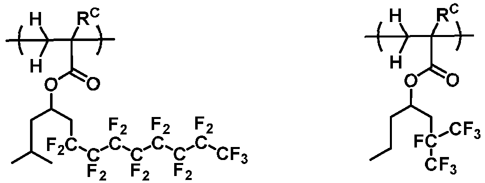

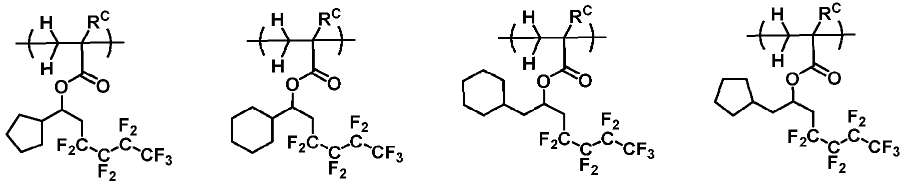

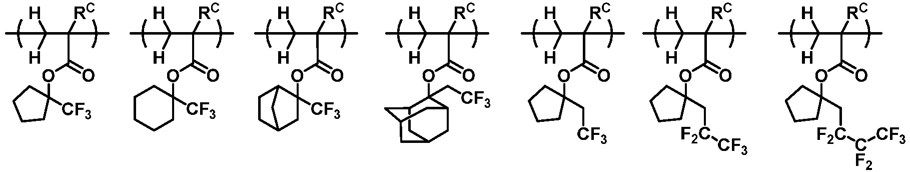

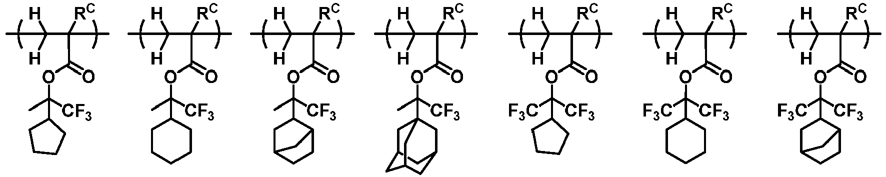

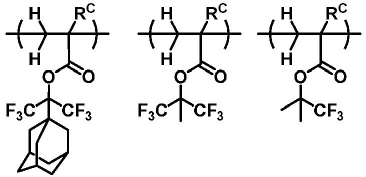

The content of the repeat units D1 to D4 is preferably 15 to 95 mol% and more preferably 20 to 85 mol% of the overall repeat units of the fluorine atom-containing polymer. The content of the repeat units D5 and/or D6 is preferably 5 to 85 mol% and more preferably 15 to 80 mol% of the overall repeat units of the fluorine atom-containing polymer. As the repeat units D1 to D6, one type may be used alone or two or more types may be combined and used.

The fluorine atom-containing polymer (D) may contain another repeat unit other than the repeat units described above. Examples of such a repeat unit include those described in JP-A 2014-177407, paragraphs [0046] to [0078]. When the fluorine atom-containing polymer (D) contains another repeat unit, the content thereof is preferably 50 mol% or less of the overall repeat units of the fluorine atom-containing polymer.

The fluorine atom-containing polymer (D) can be synthesized by copolymerizing suitable monomers protected with a protective group as necessary by a known method, and then performing a deprotection reaction as necessary. The copolymerization reaction is not particularly limited, but is preferably radical polymerization or anionic polymerization. With respect to these methods, reference may be made to JP-A 2004-115630.

The fluorine atom-containing polymer (D) preferably has a Mw of 2,000 to 50,000, and more preferably 3,000 to 20,000. When the Mw is 2,000 or more, the acid does not diffuse, the resolution does not deteriorate, and the stability with time is not impaired. When the Mw is 50,000 or less, the solubility in a solvent is sufficient, and coating defects do not occur. The fluorine atom-containing polymer (D) preferably has a Mw/Mn of 1.0 to 2.2, more preferably 1.0 to 1.7.

When the chemically amplified positive resist composition of the invention contains the fluorine atom-containing polymer (D), the content thereof is preferably 0.01 to 30 parts by weight, and more preferably 0.1 to 20 parts by weight per 80 parts by weight of the base polymer (A). As the fluorine atom-containing polymer (D), one type may be used alone or two or more types may be combined and used.

### (E) Photoacid generator

The chemically amplified positive resist composition of the invention may contain a photoacid generator as a component (E). The photoacid generator is not particularly limited as long as it is a compound that generates an acid by irradiation with high-energy radiation. Suitable photoacid generators include a sulfonium salt, an iodonium salt, sulfonyldiazomethane, N-sulfonyloxyimide, an oxime-O-sulfonate acid generator, and the like.

Specific examples of the photoacid generator include nonafluorobutane sulfonate, partially fluorinated sulfonates described in JP-A 2012-189977, paragraphs [0247] to [0251], partially fluorinated sulfonates described in JP-A 2013-101271, paragraphs [0261] to [0265], and those described in JP-A 2008-111103, paragraphs[0122] to[0142] and JP-A 2010-215608, paragraphs [0080] to [0081]. Among the above specific examples, an arenesulfonate type or alkanesulfonate type photoacid generator is preferred because it generates an acid having an appropriate strength for deprotecting the acid labile group in the repeat unit A3.

As such a photoacid generator, a salt compound containing an anion shown below is preferred.

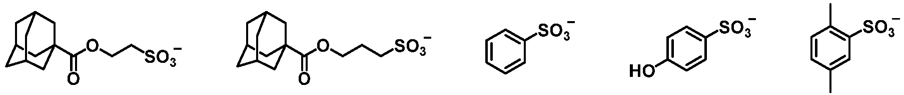

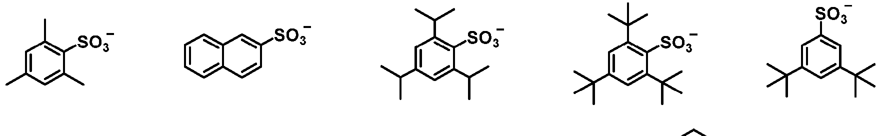

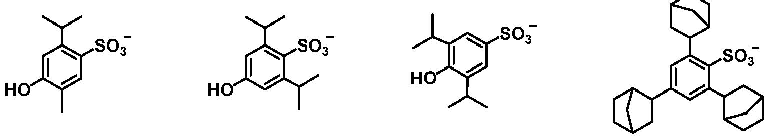

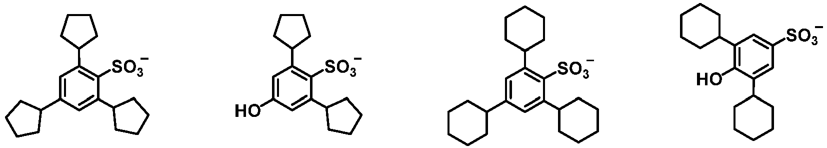

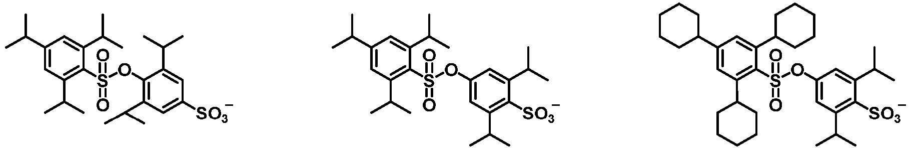

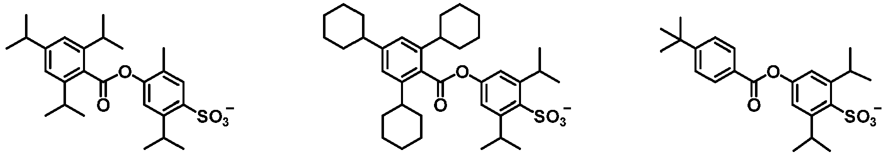

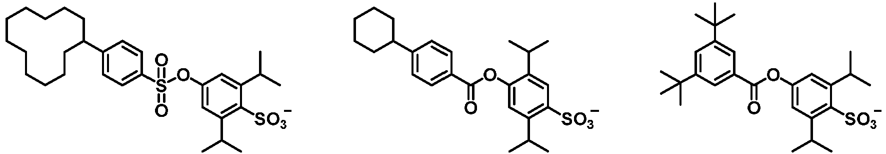

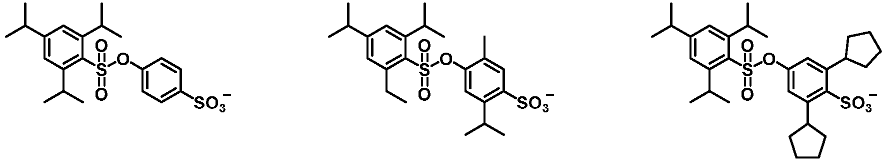

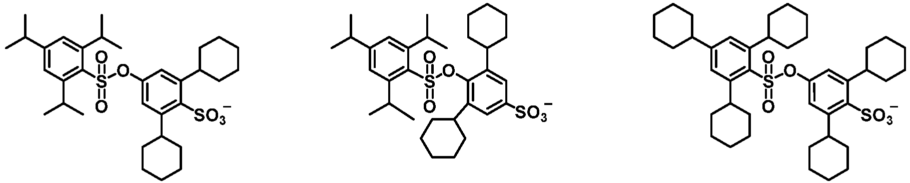

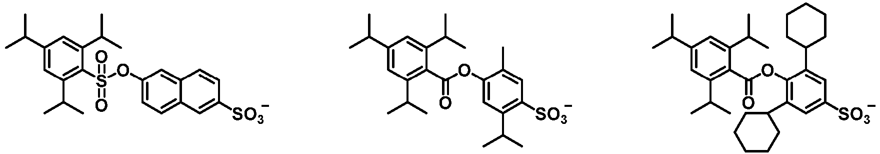

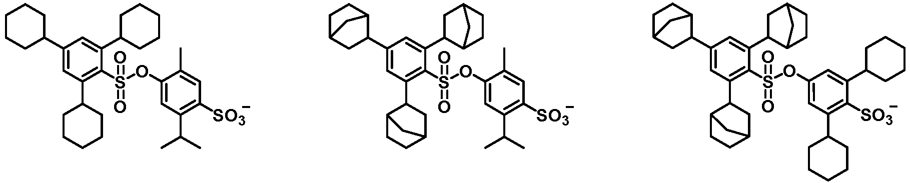

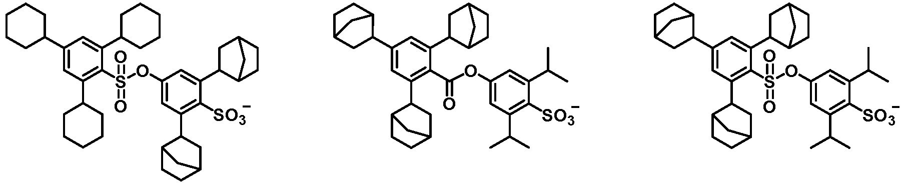

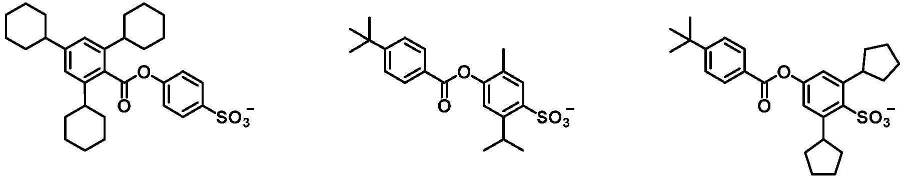

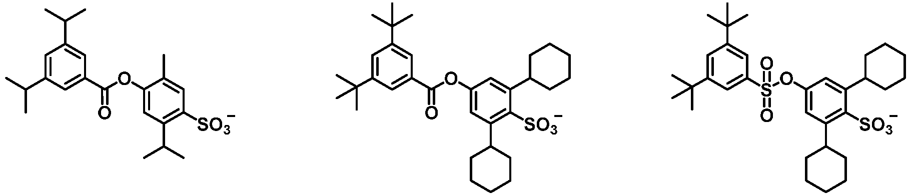

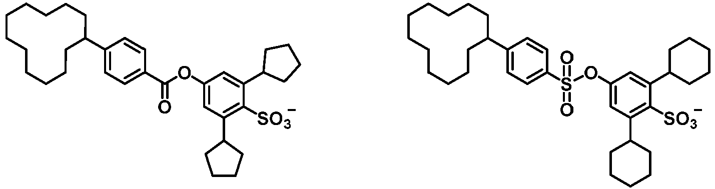

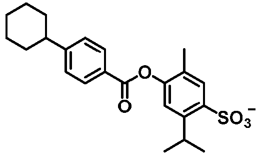

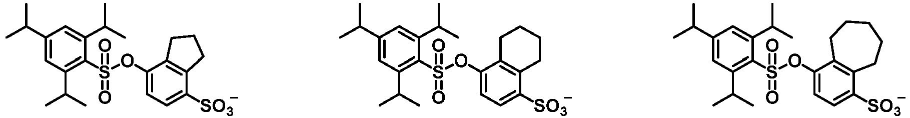

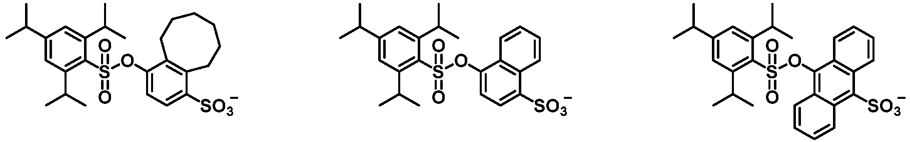

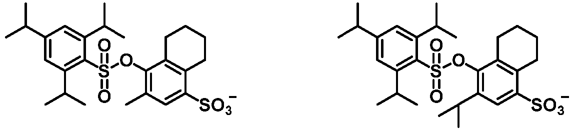

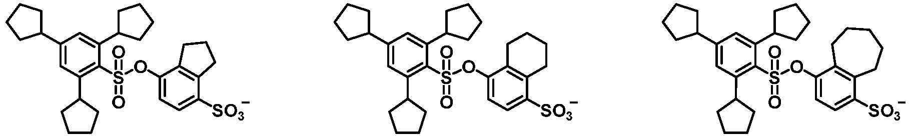

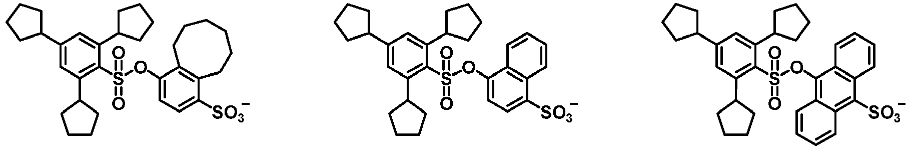

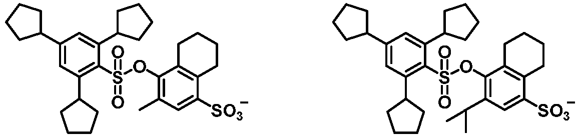

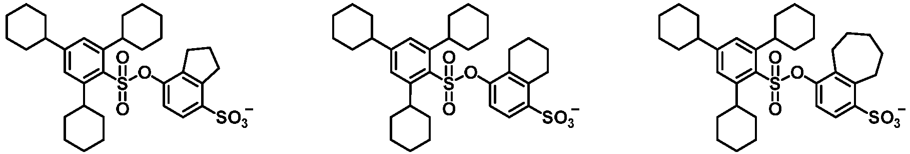

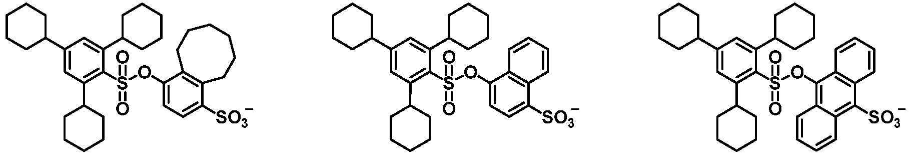

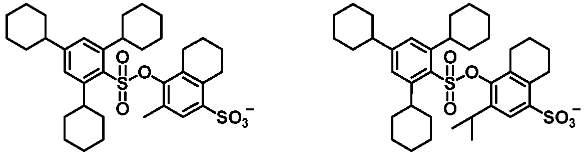

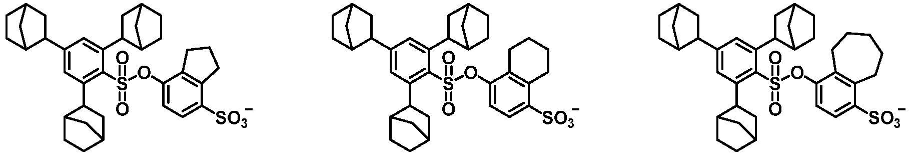

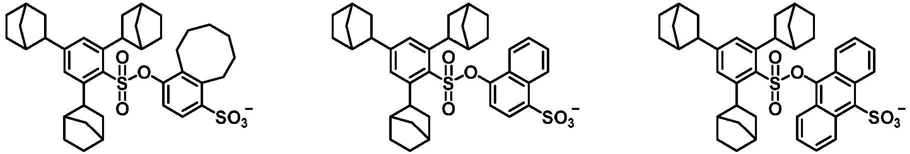

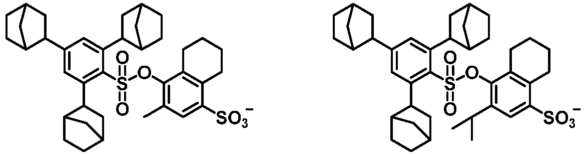

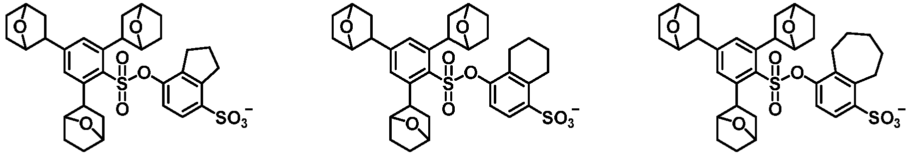

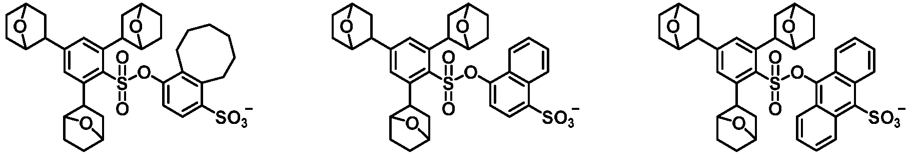

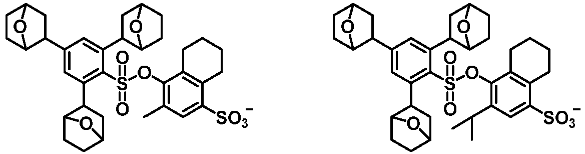

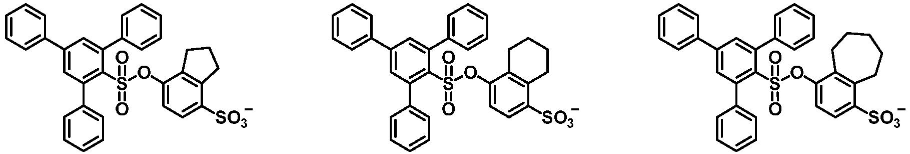

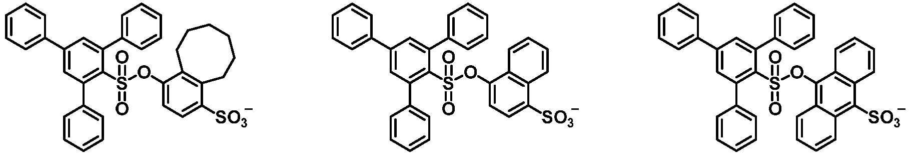

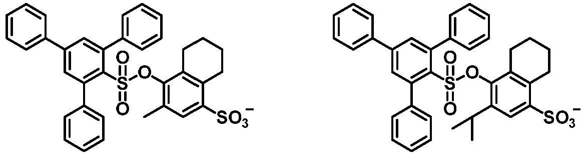

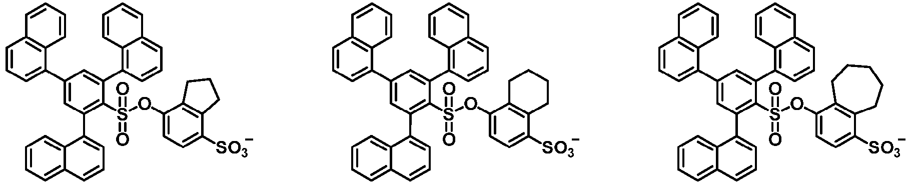

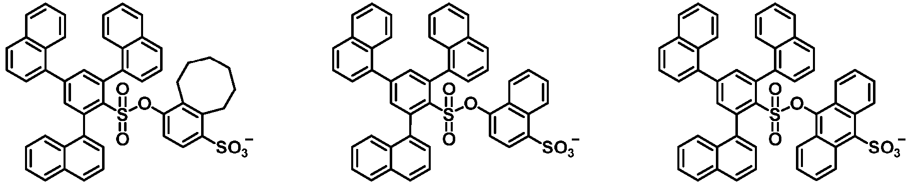

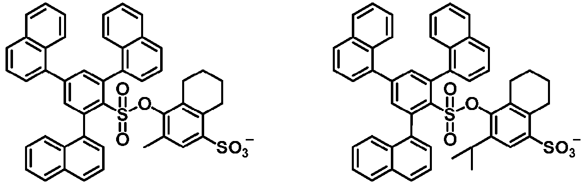

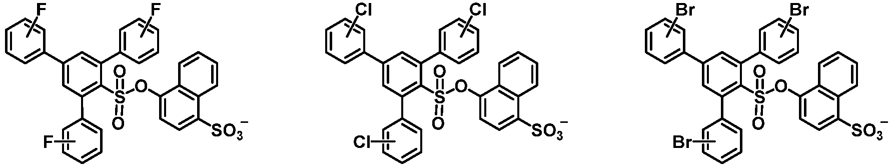

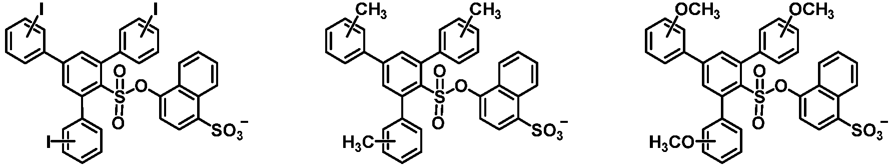

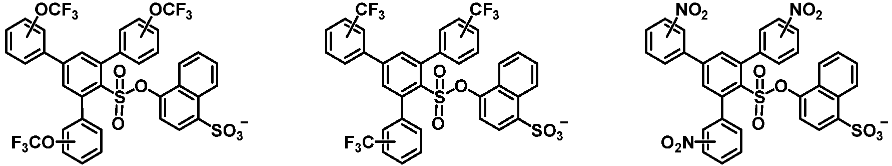

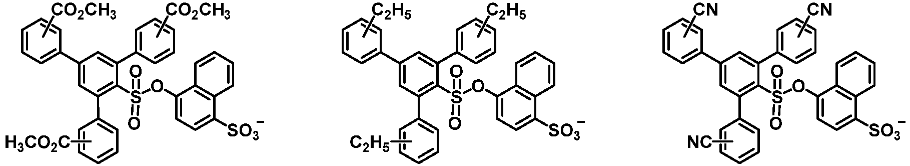

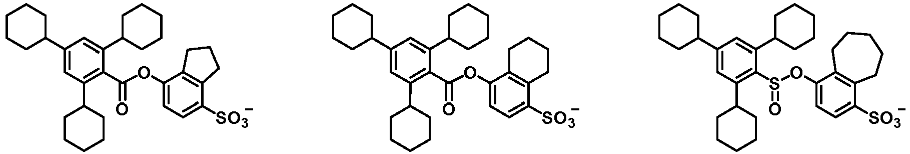

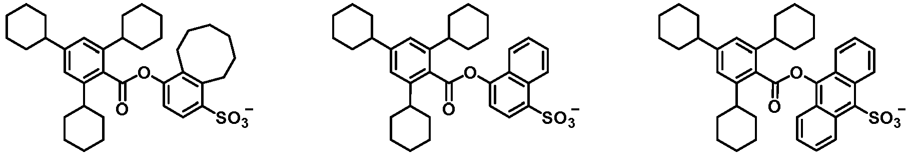

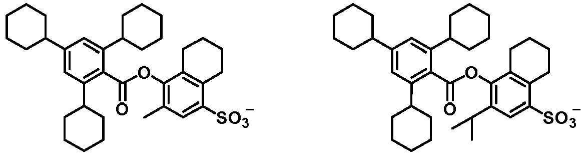

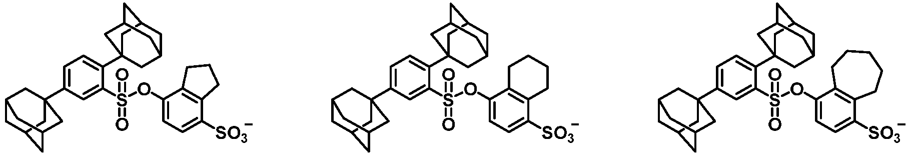

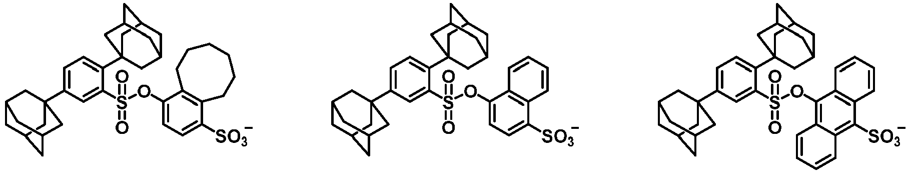

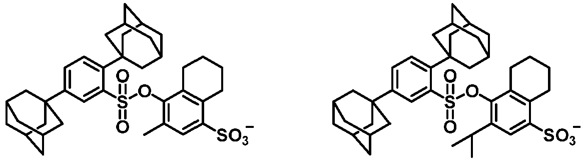

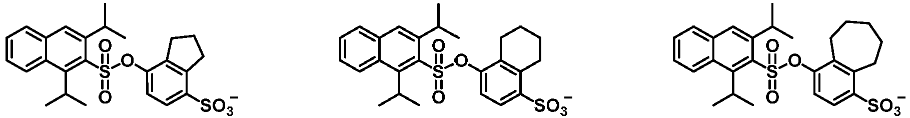

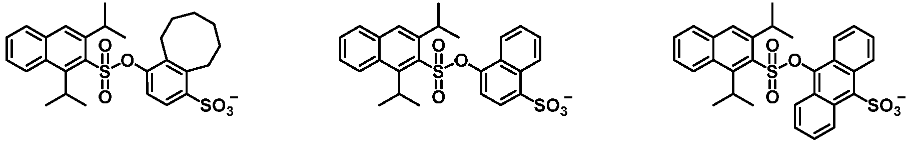

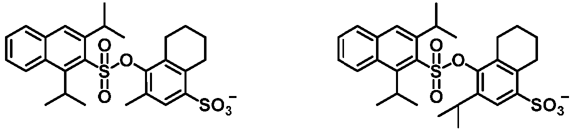

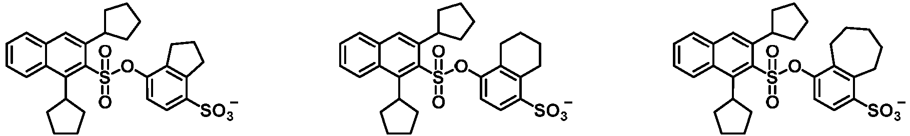

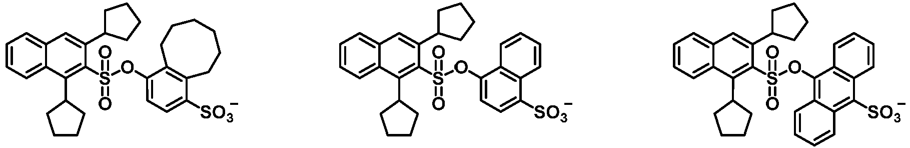

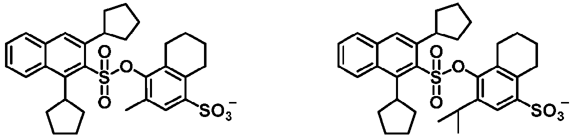

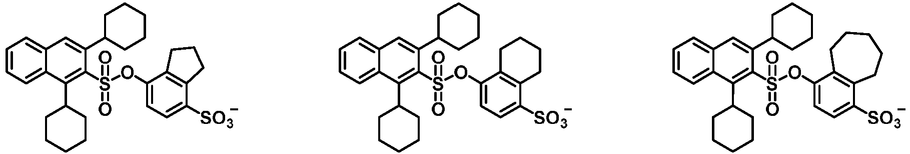

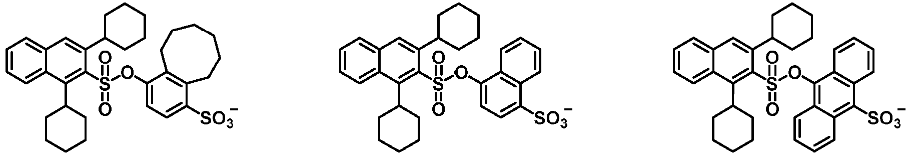

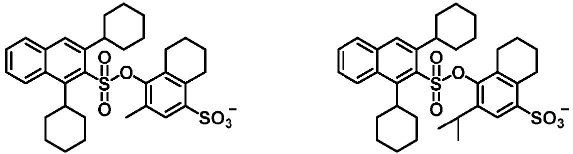

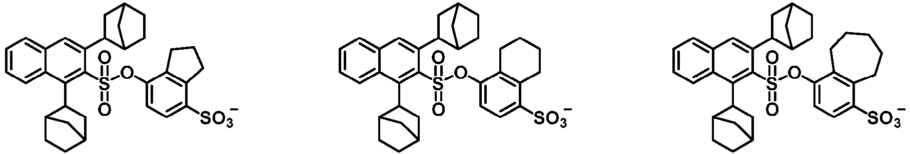

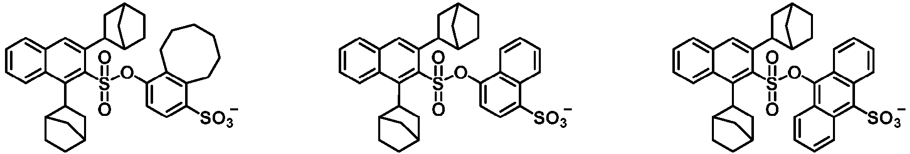

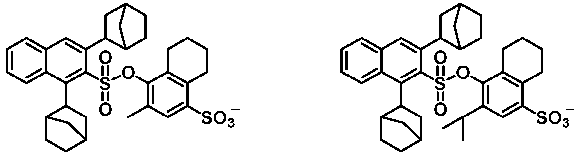

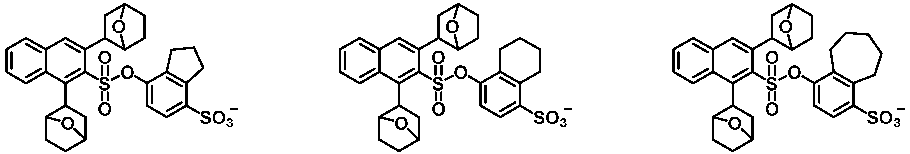

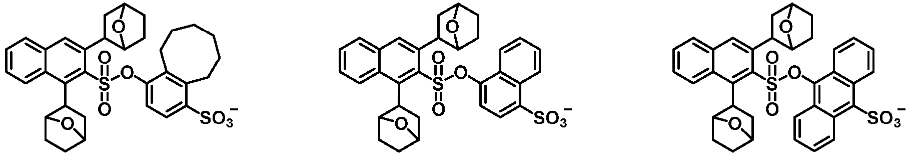

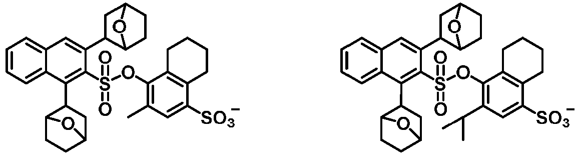

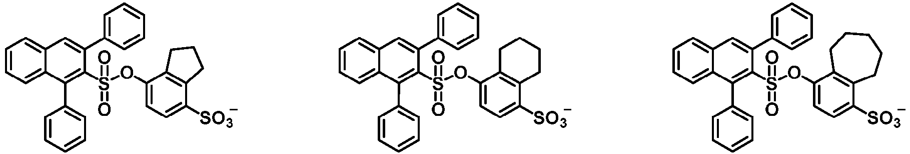

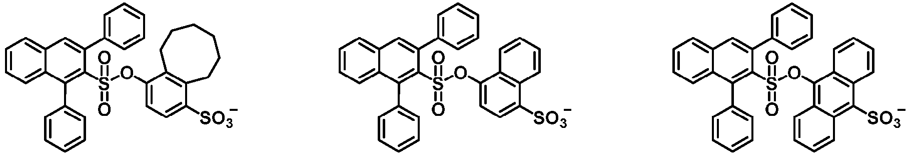

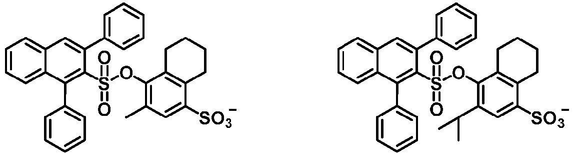

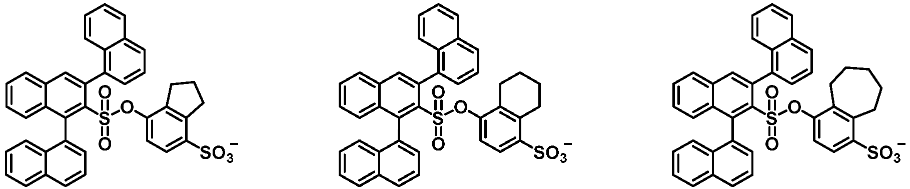

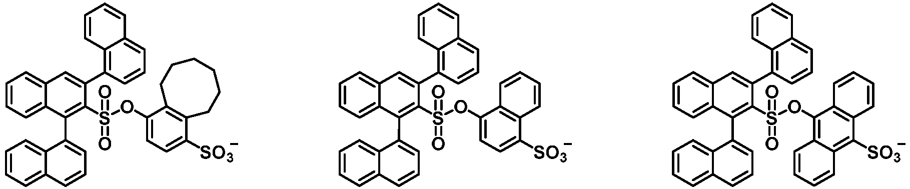

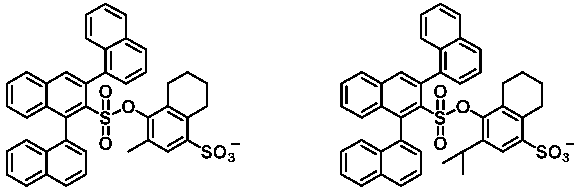

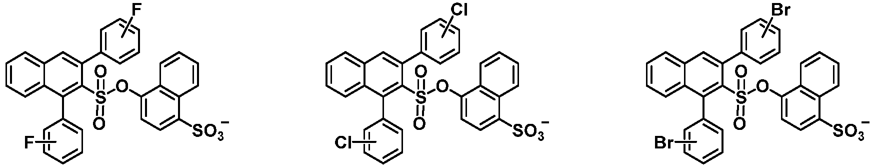

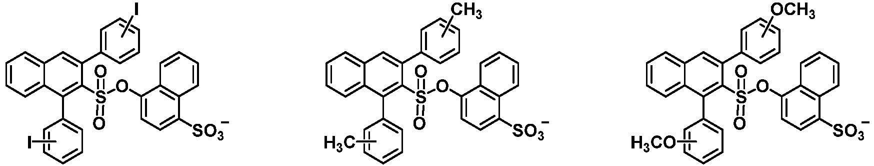

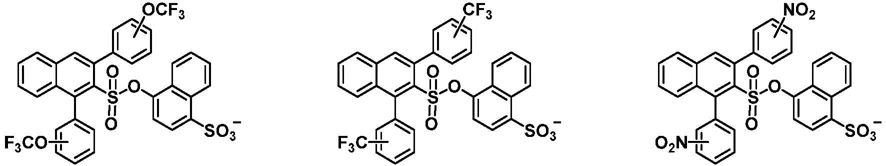

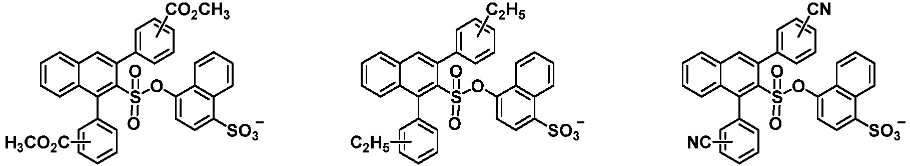

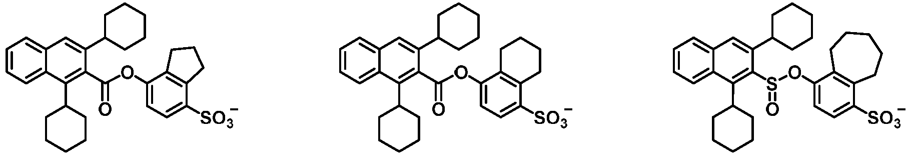

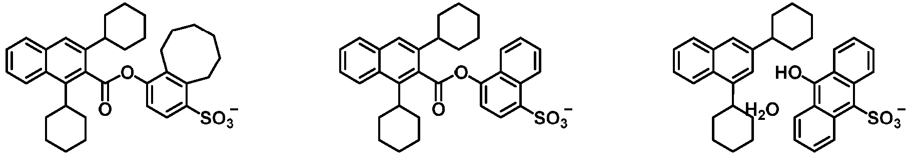

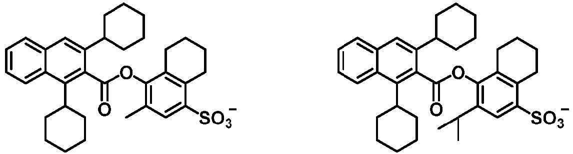

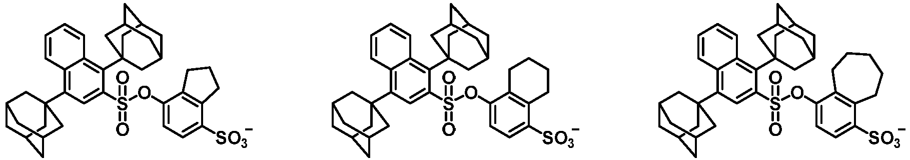

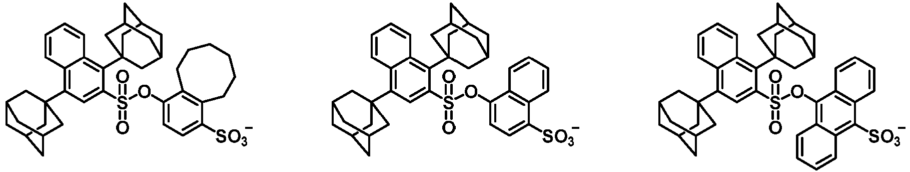

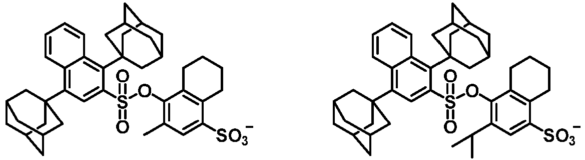

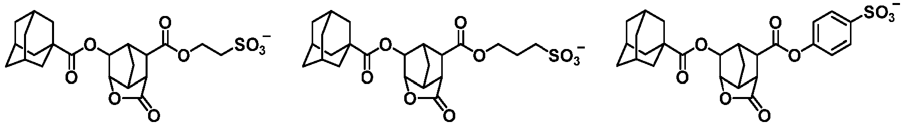

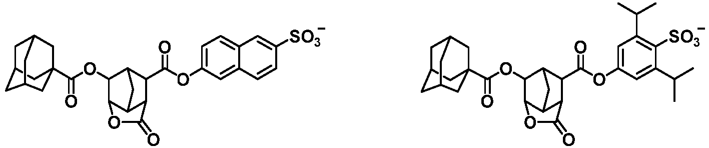

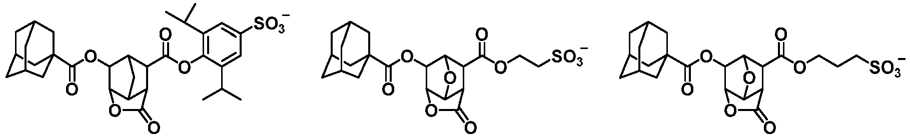

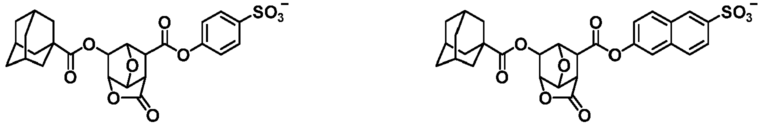

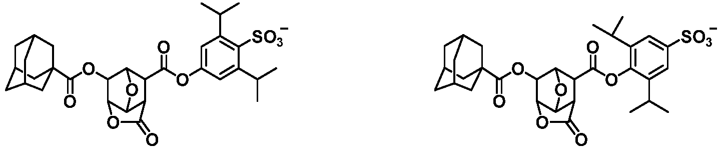

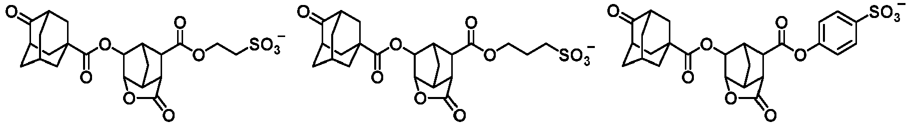

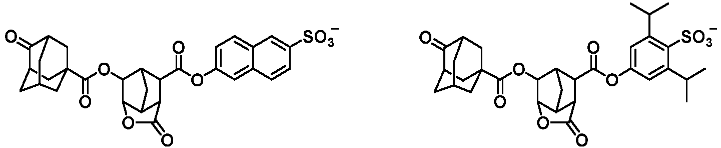

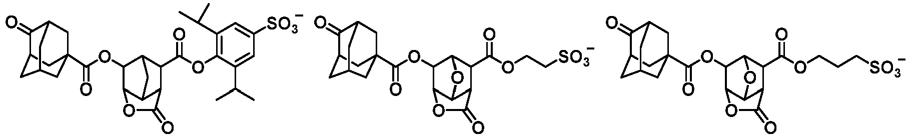

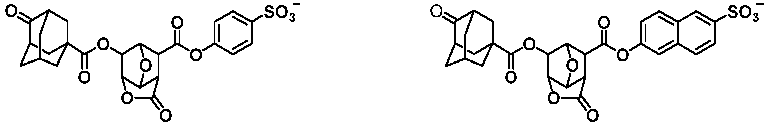

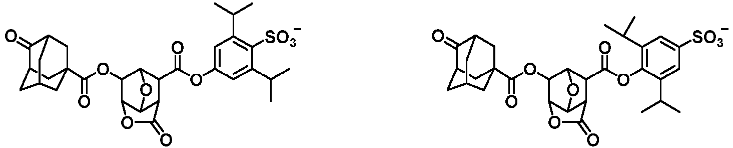

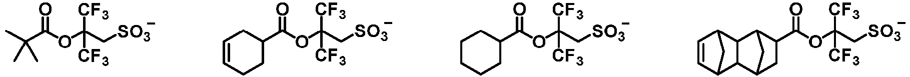

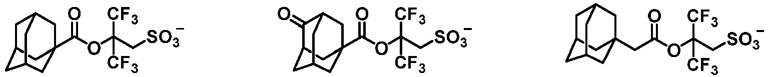

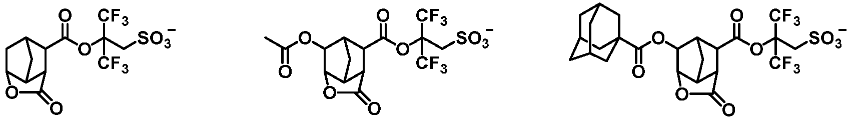

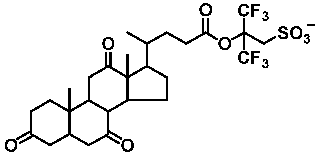

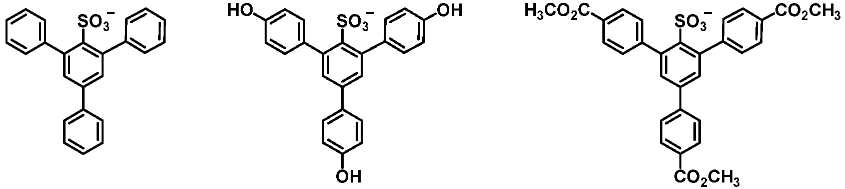

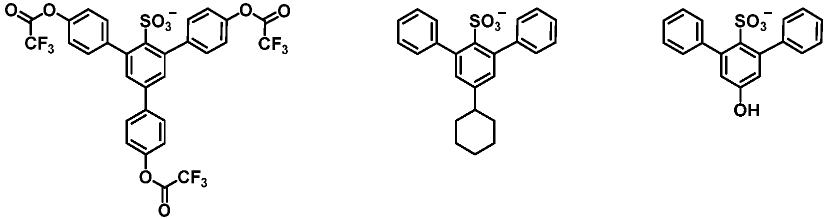

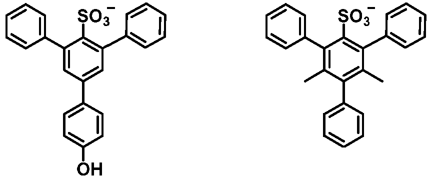

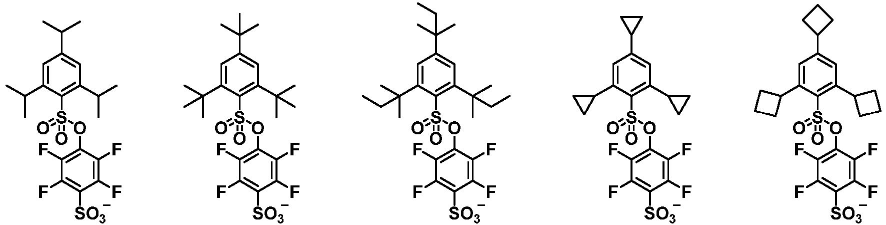

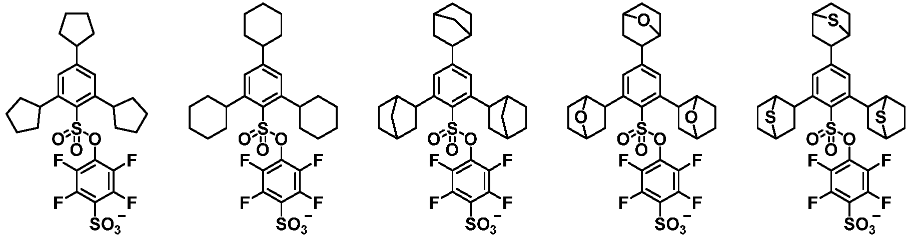

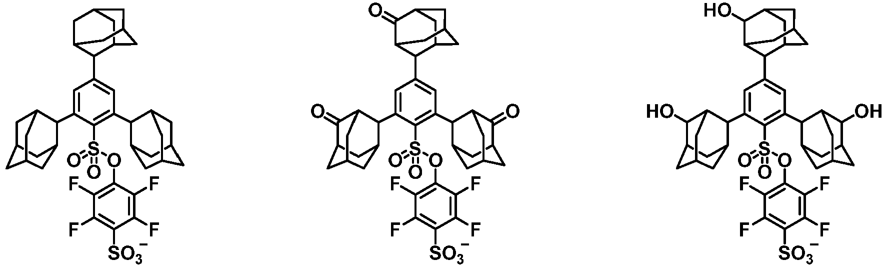

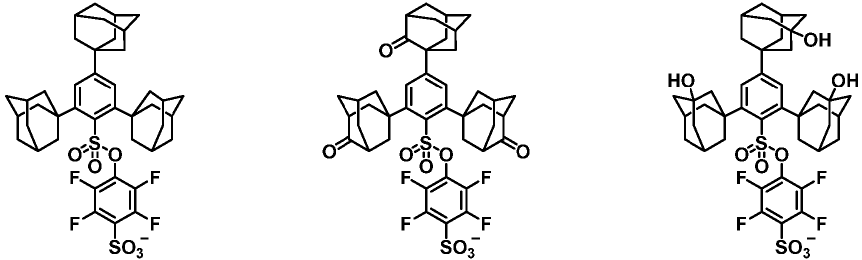

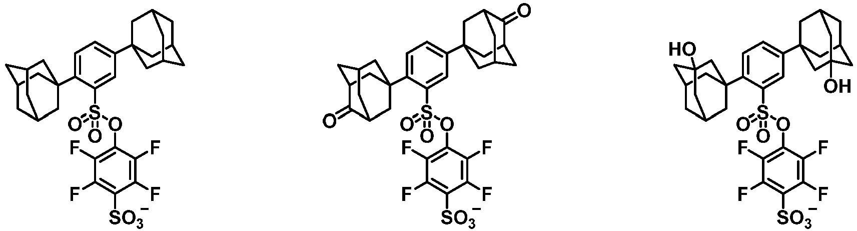

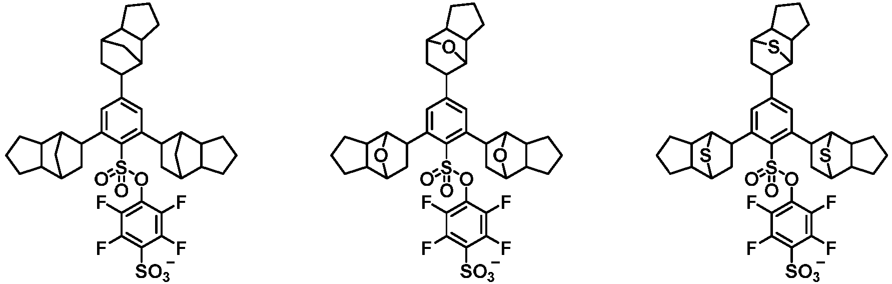

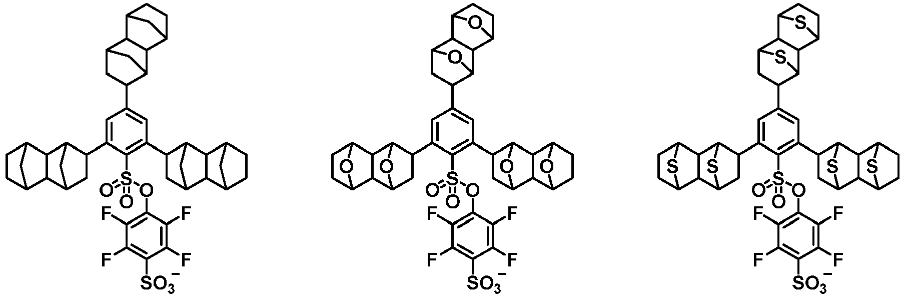

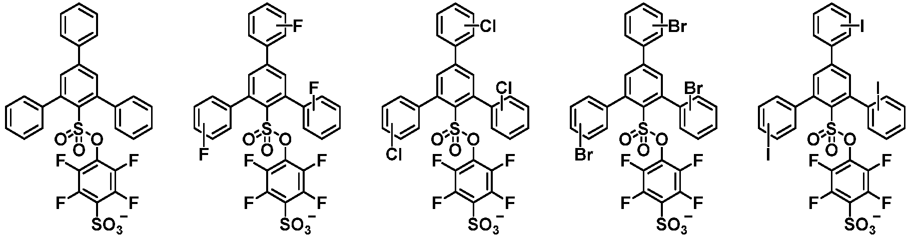

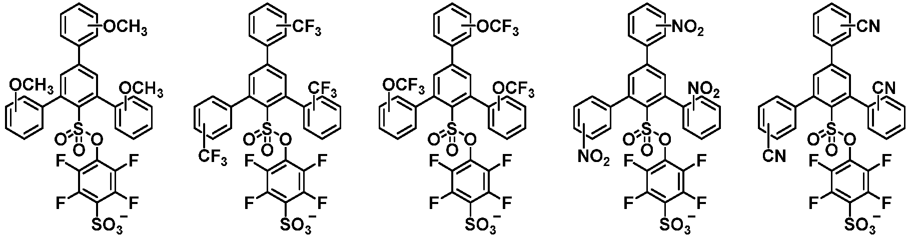

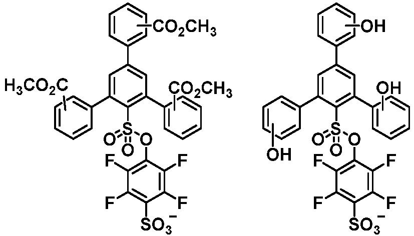

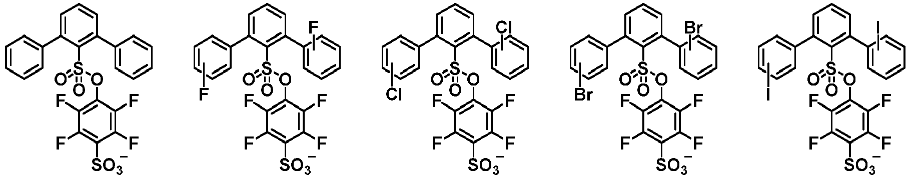

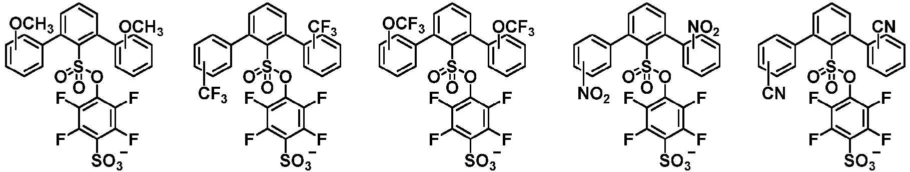

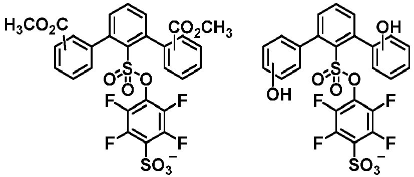

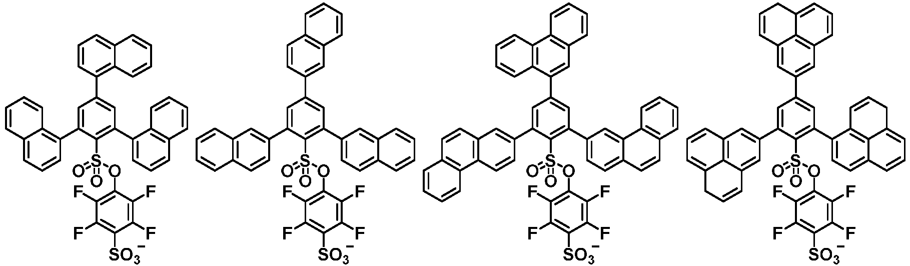

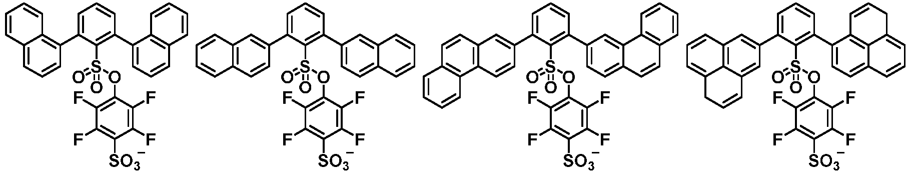

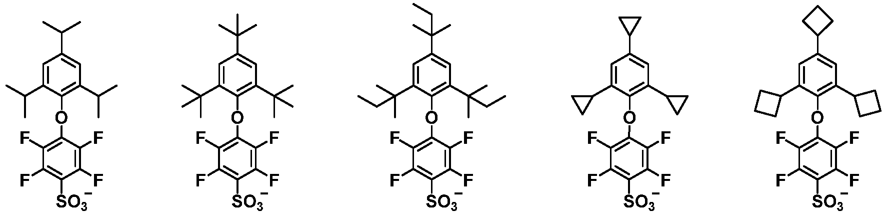

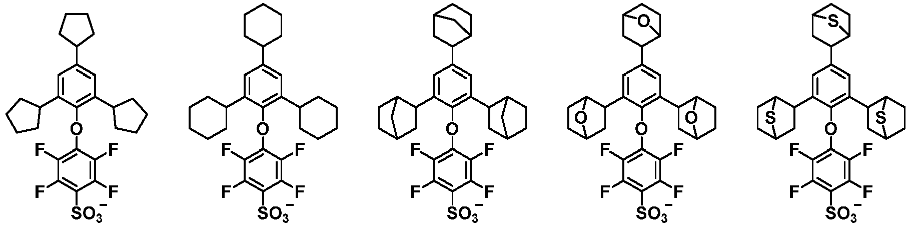

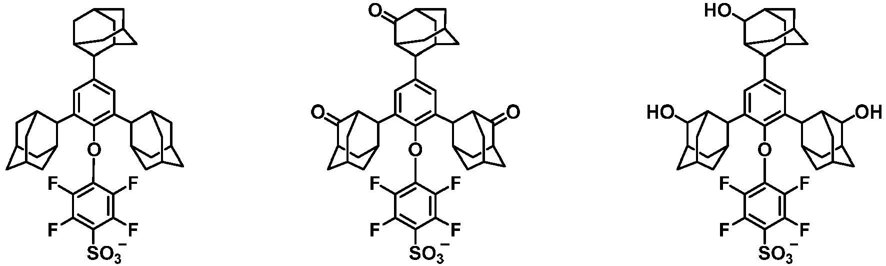

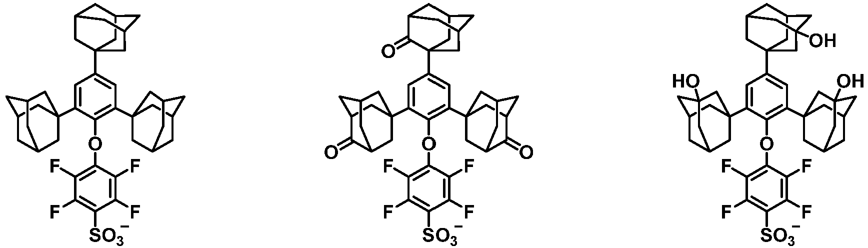

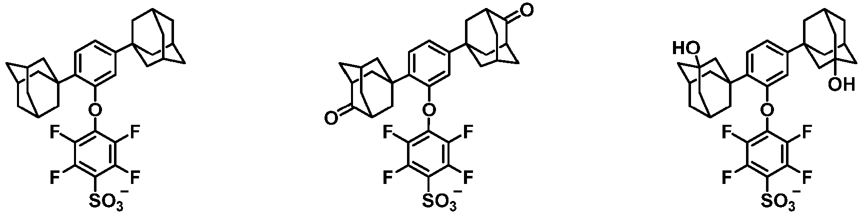

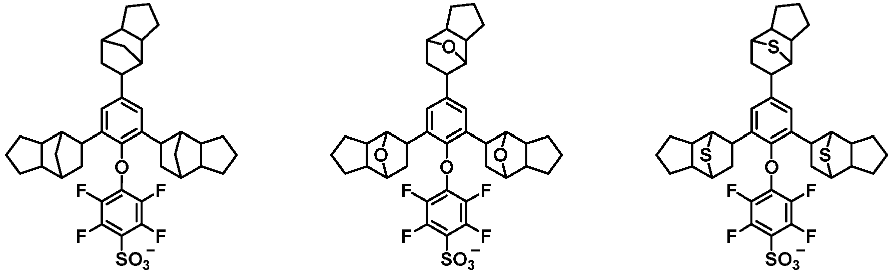

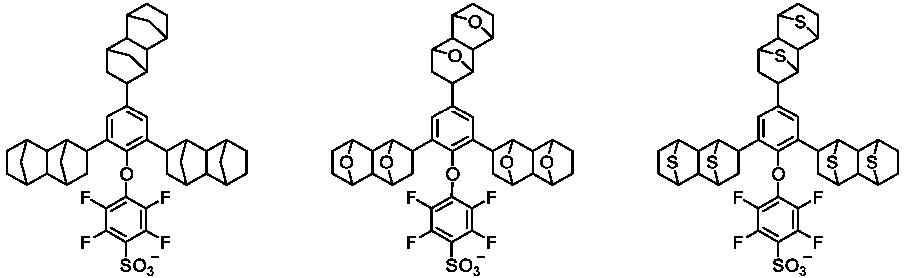

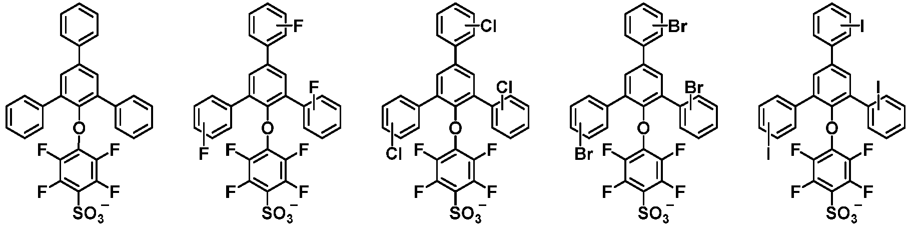

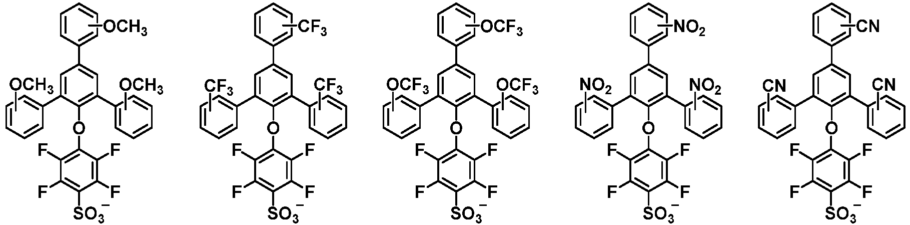

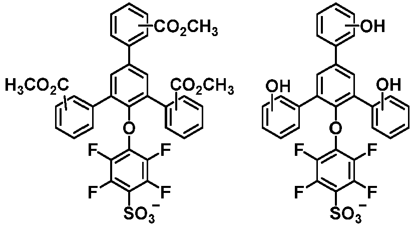

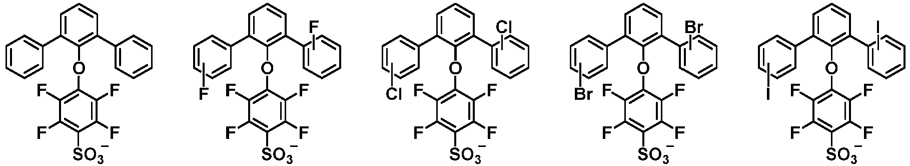

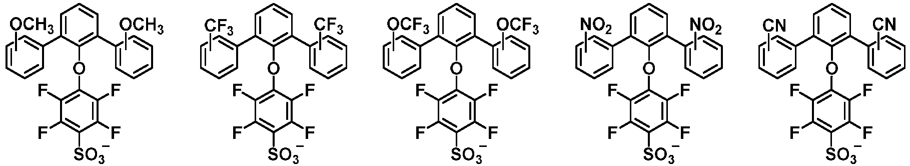

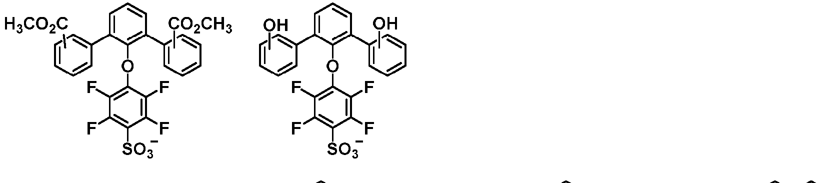

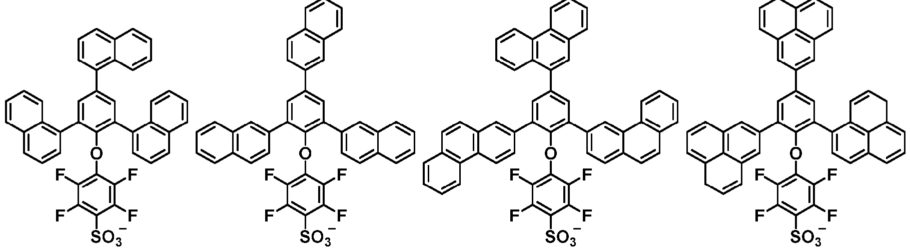

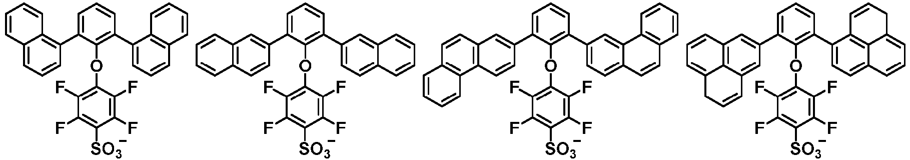

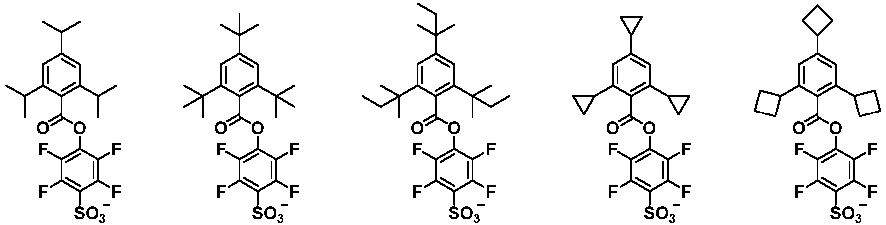

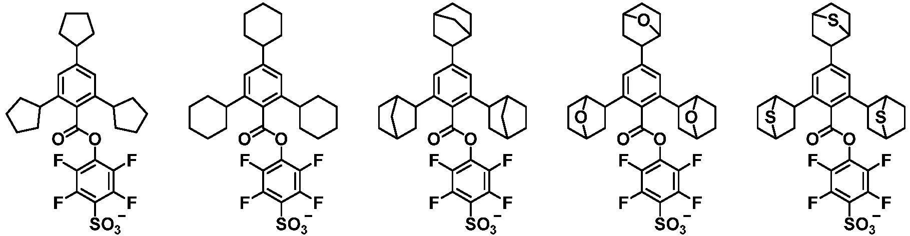

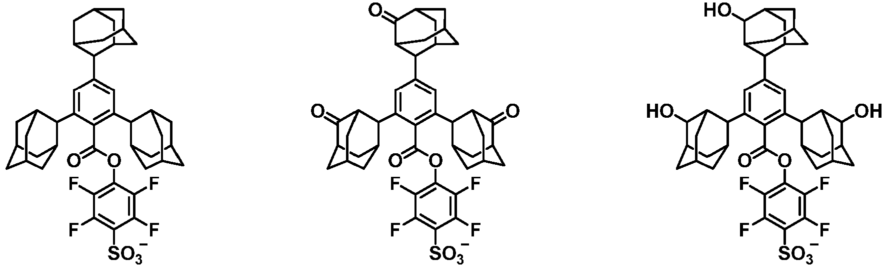

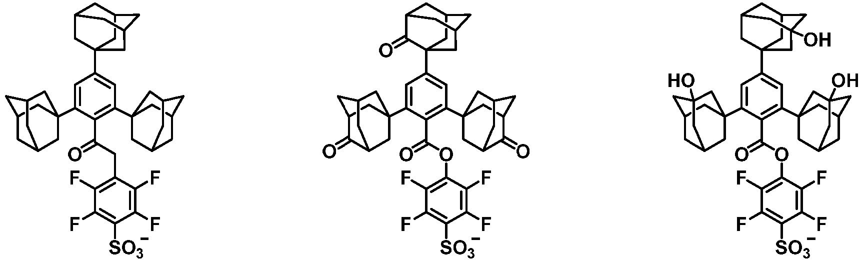

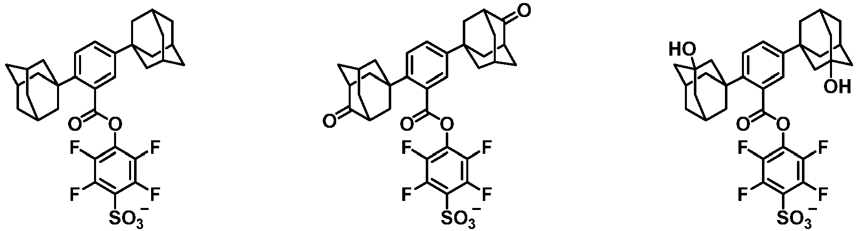

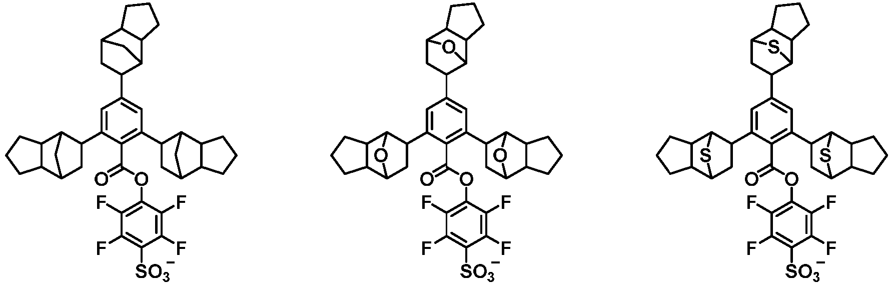

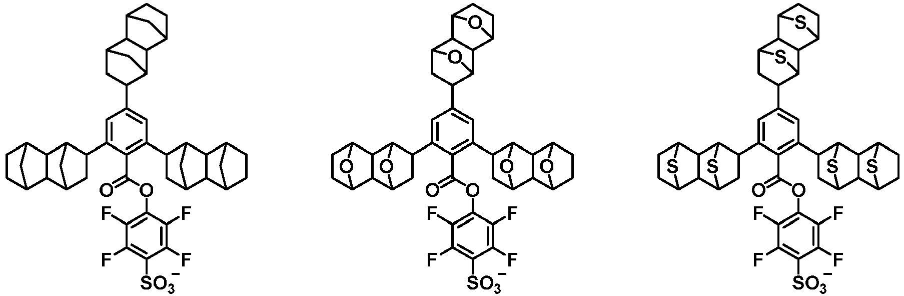

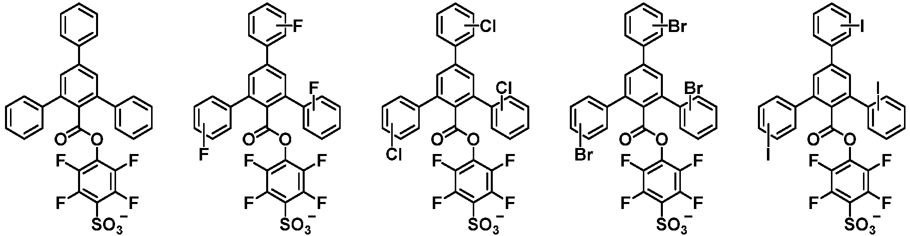

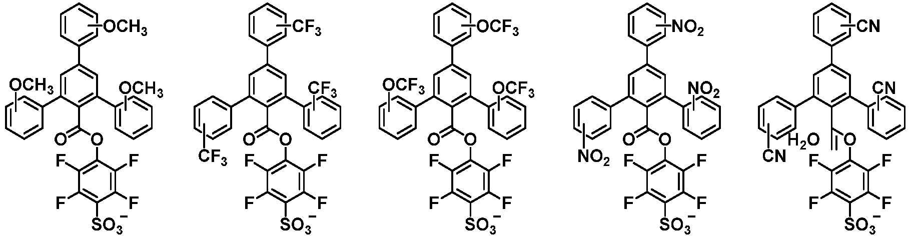

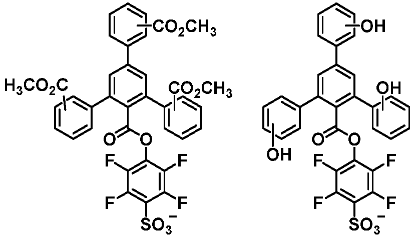

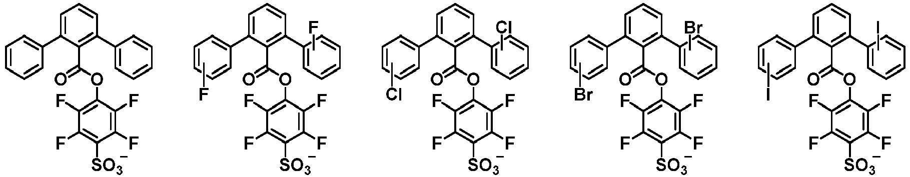

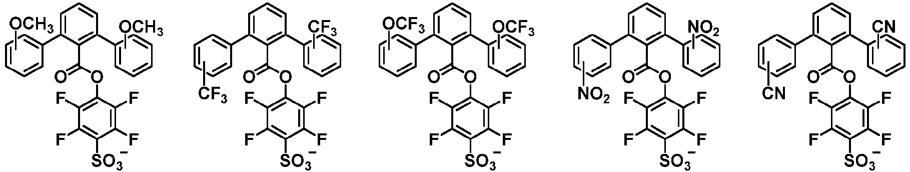

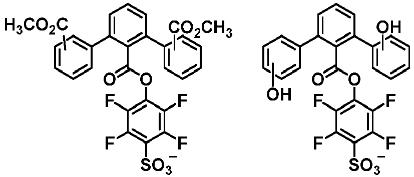

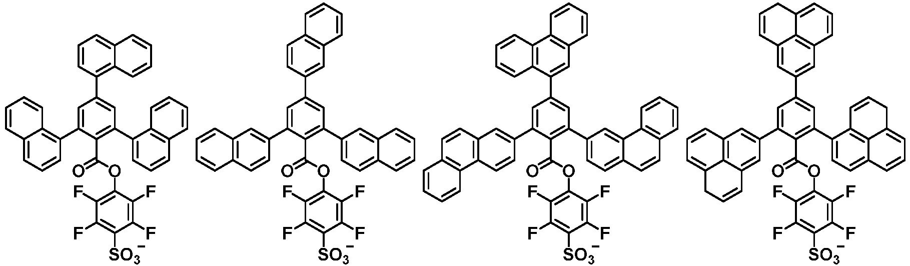

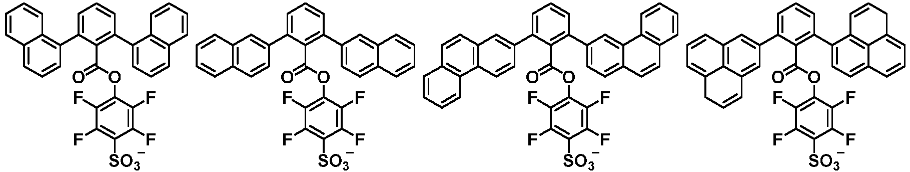

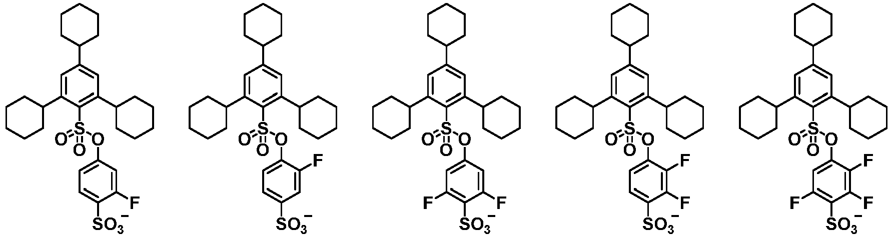

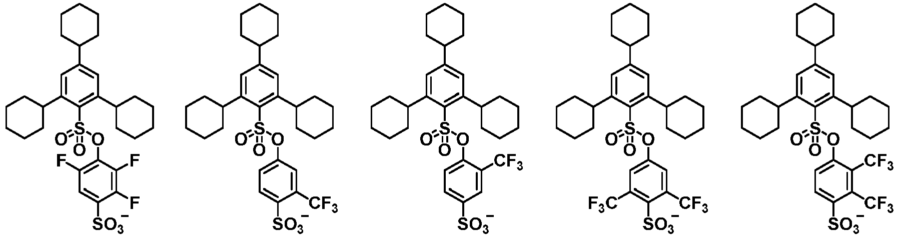

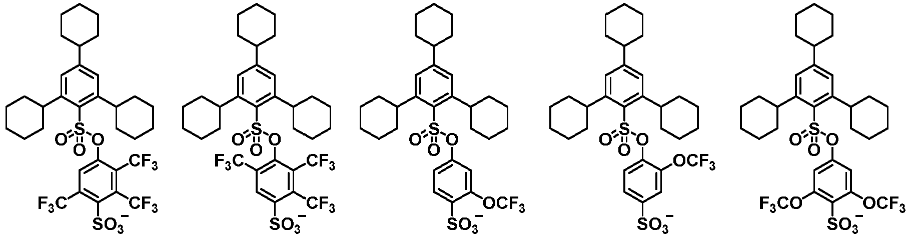

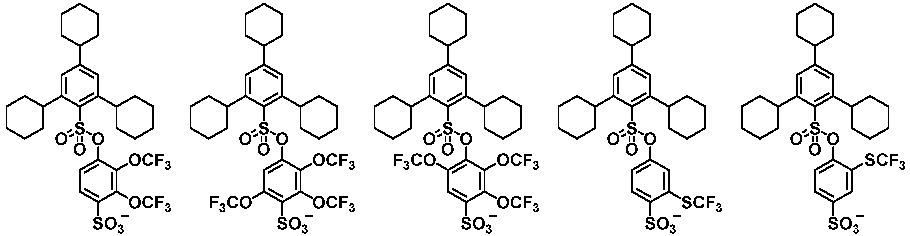

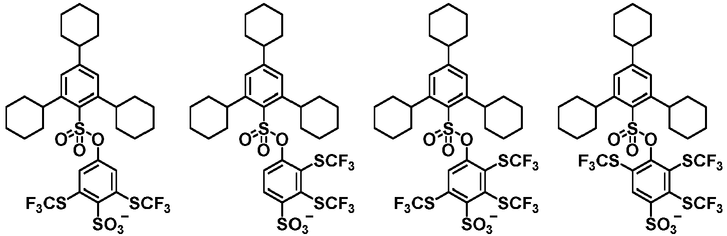

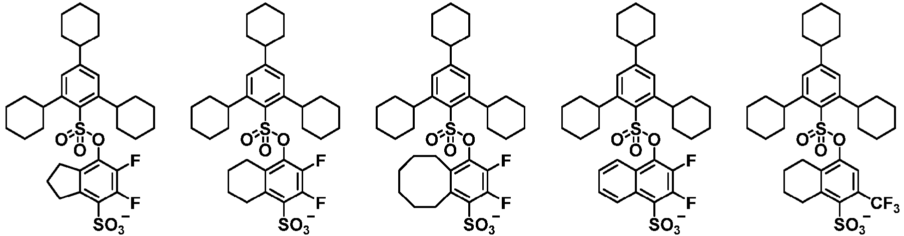

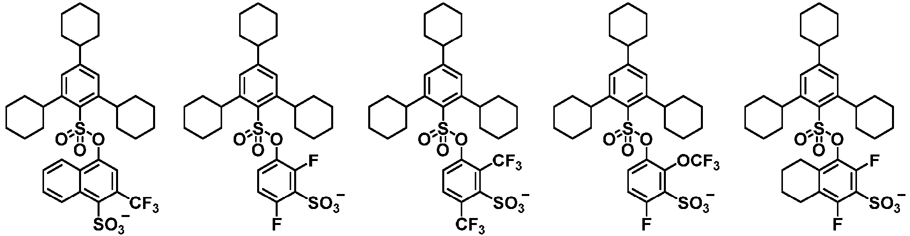

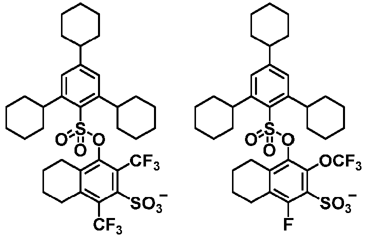

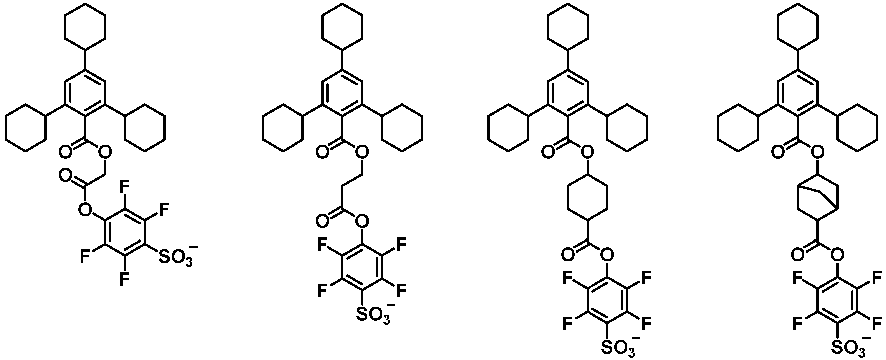

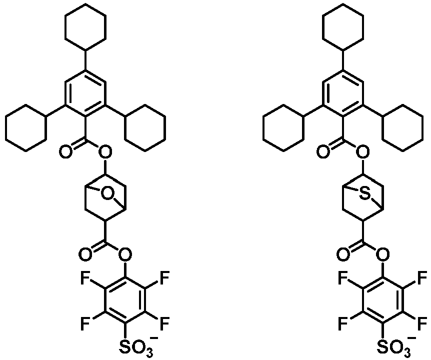

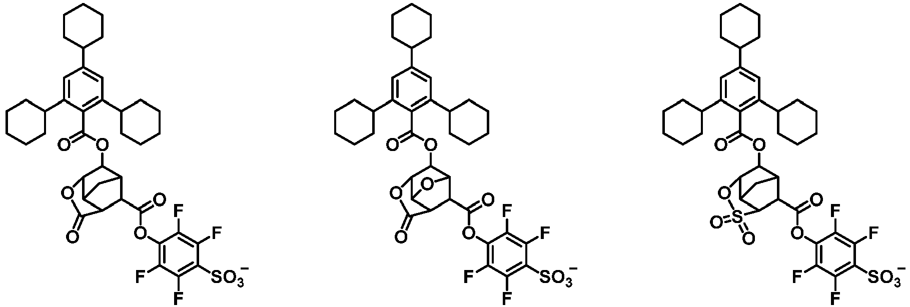

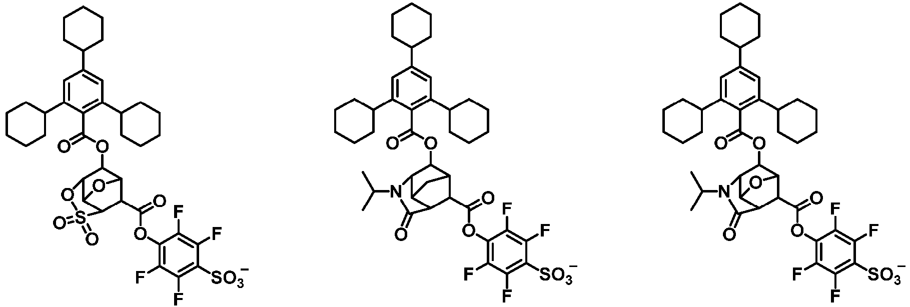

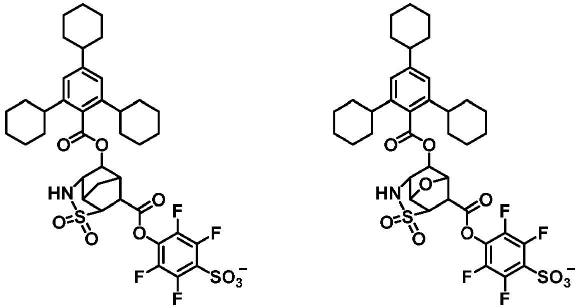

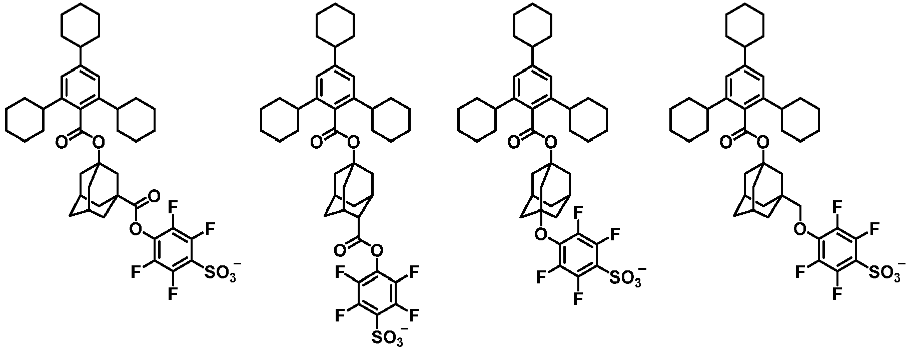

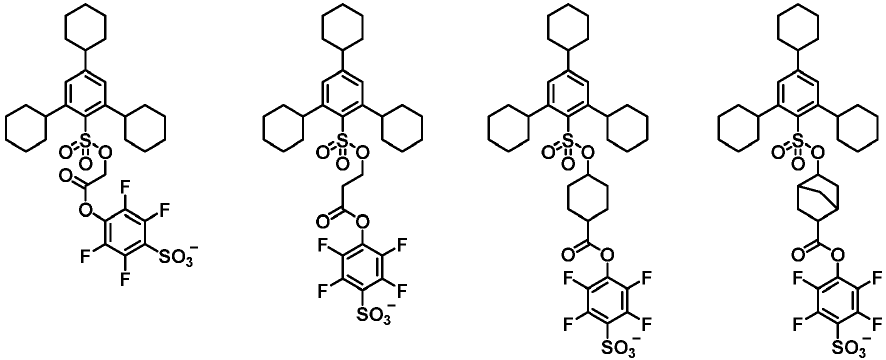

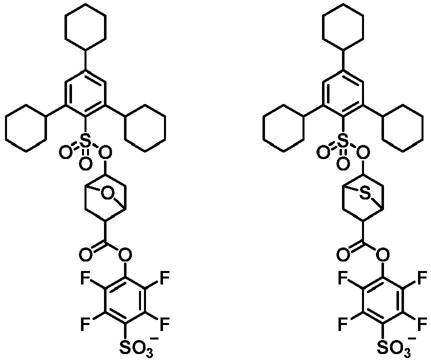

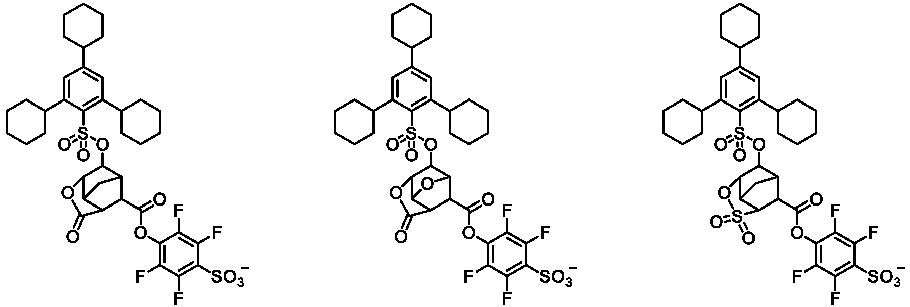

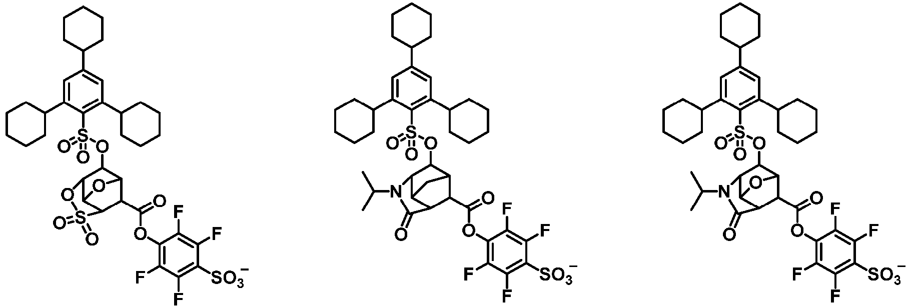

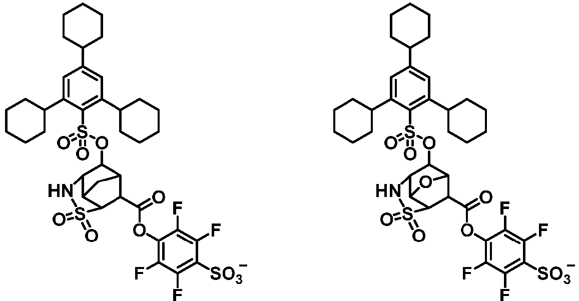

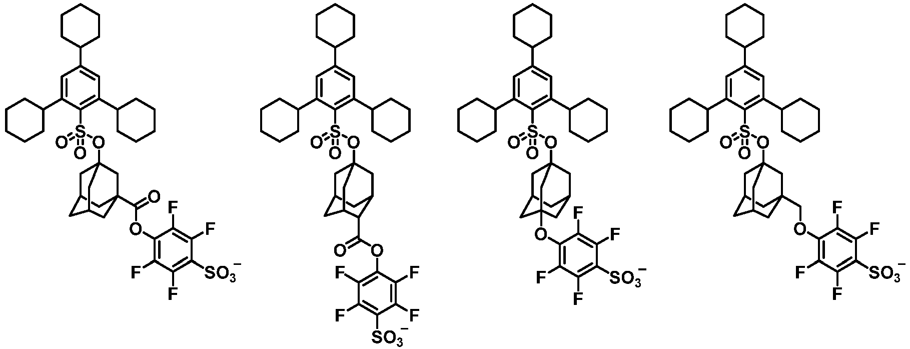

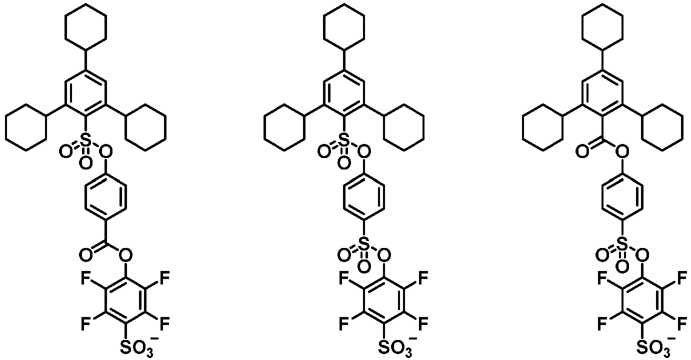

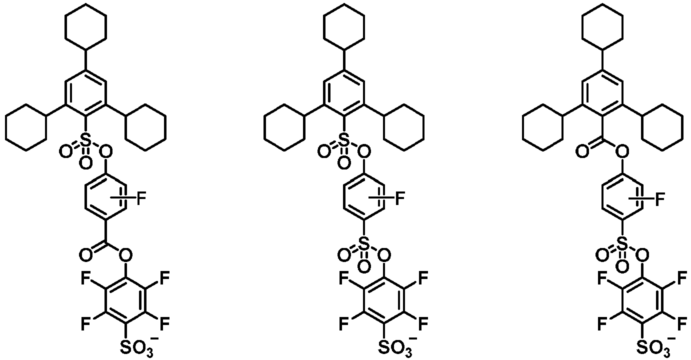

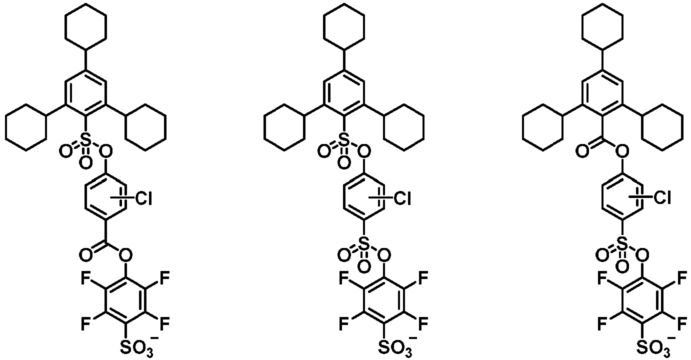

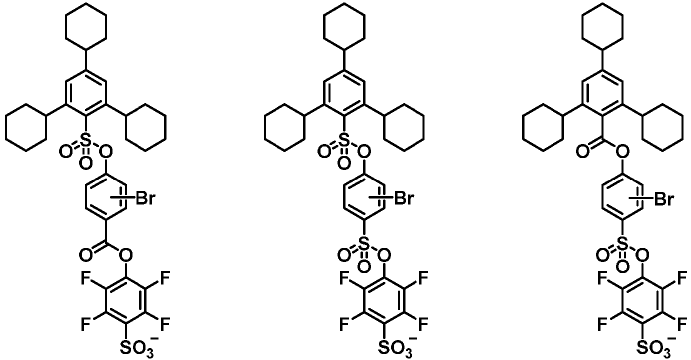

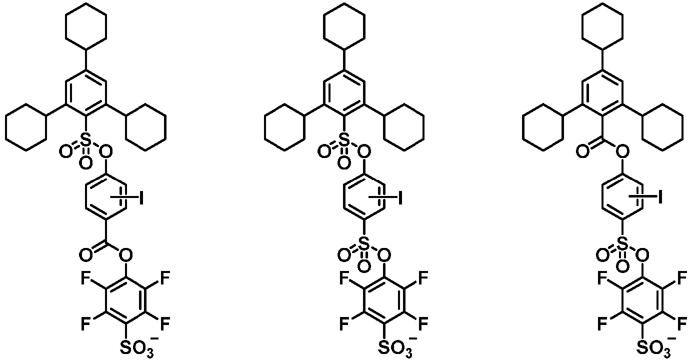

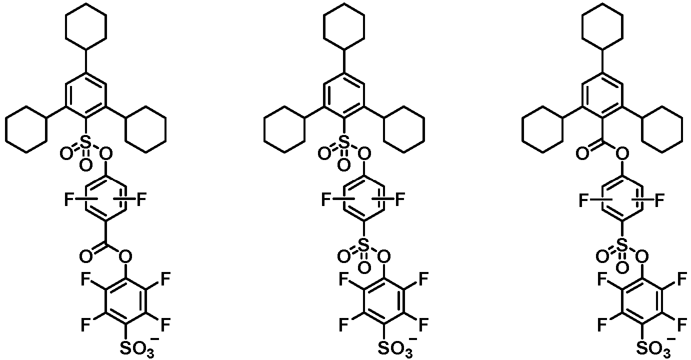

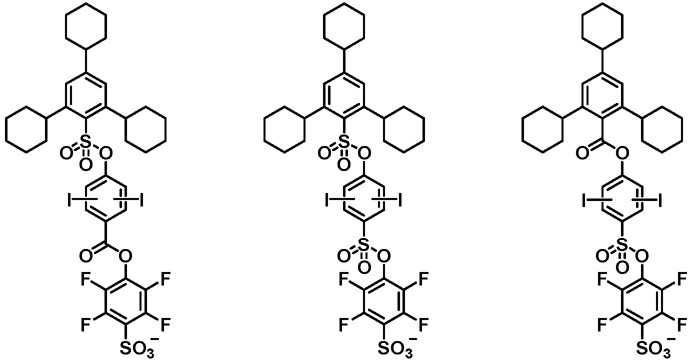

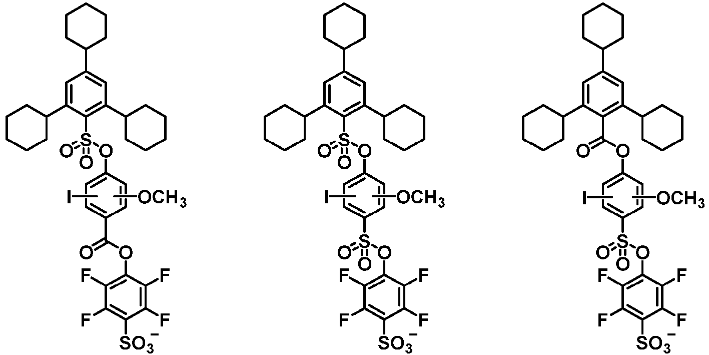

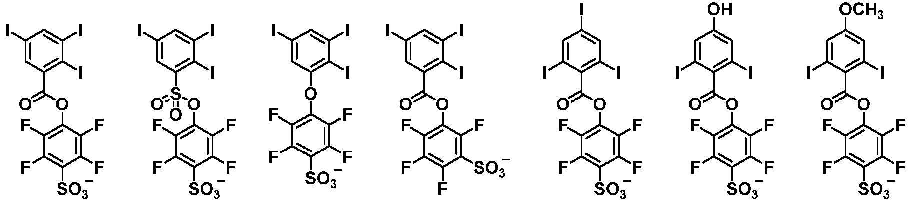

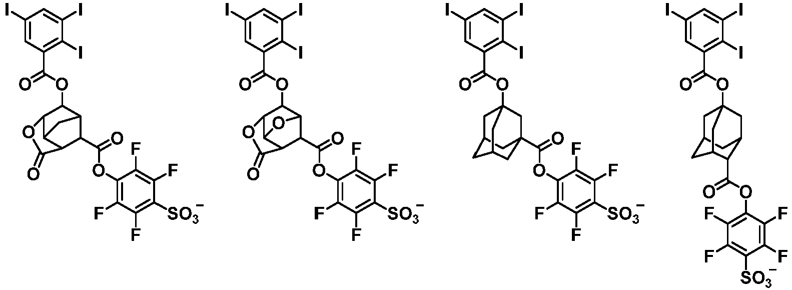

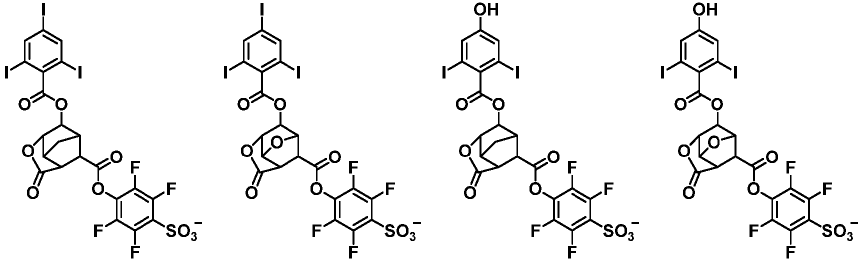

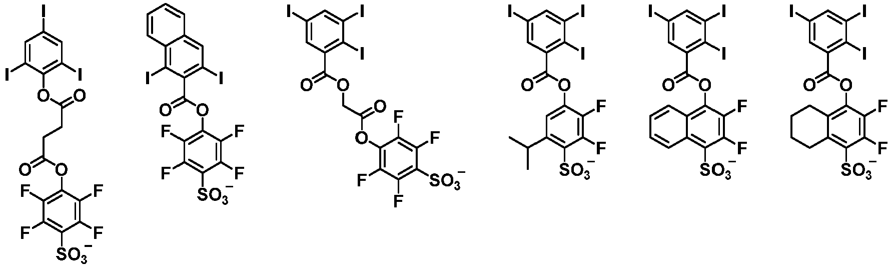

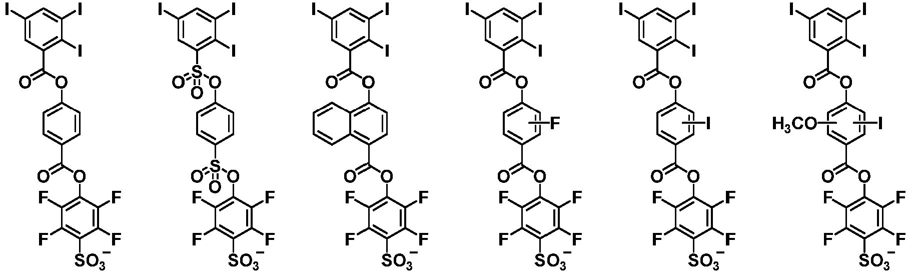

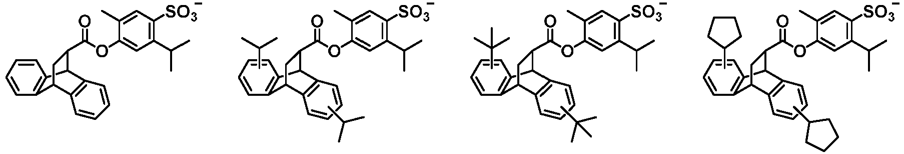

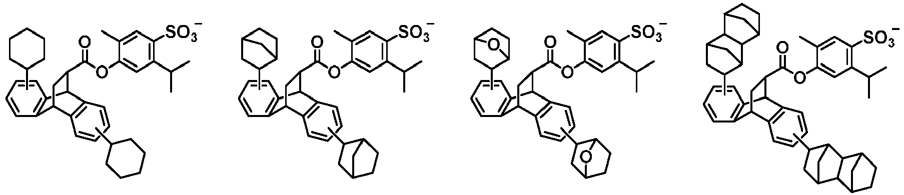

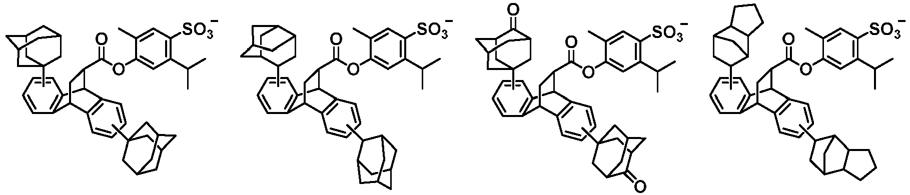

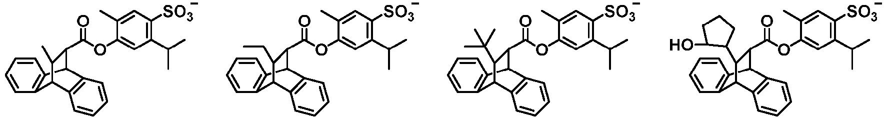

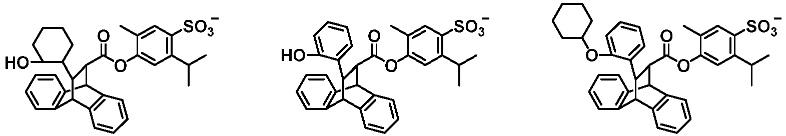

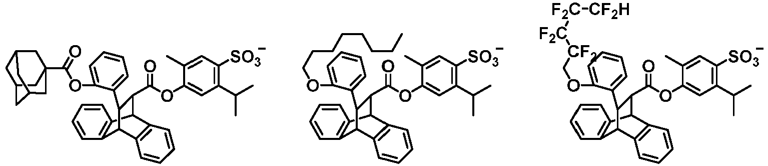

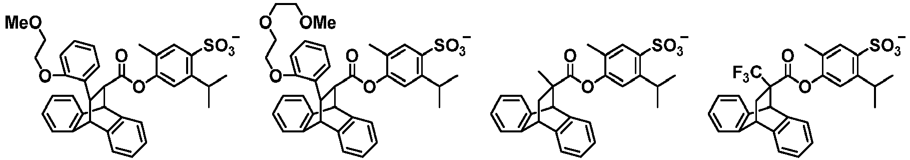

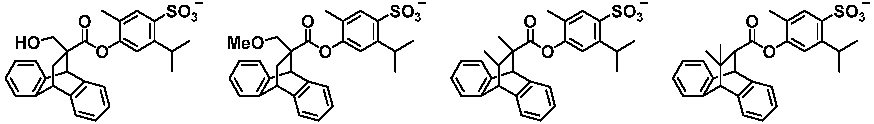

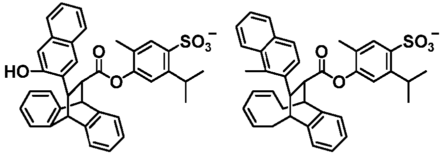

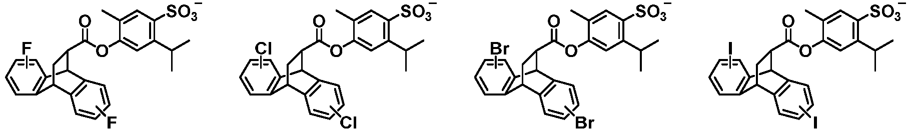

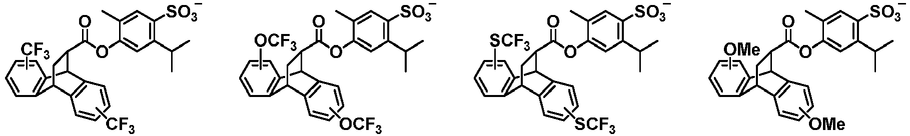

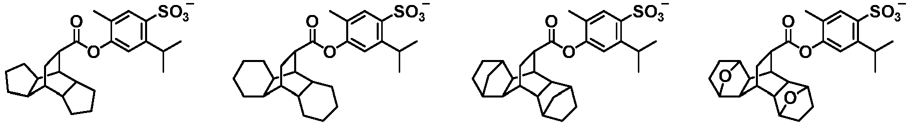

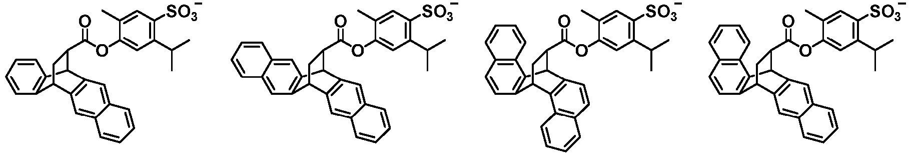

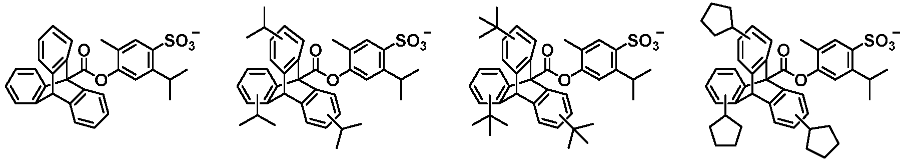

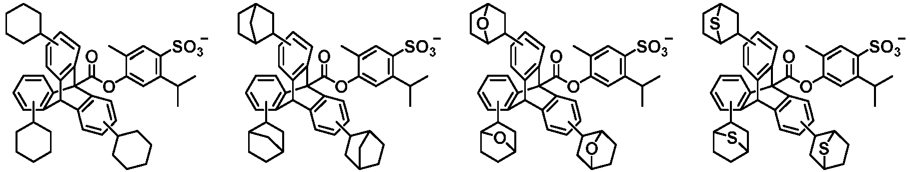

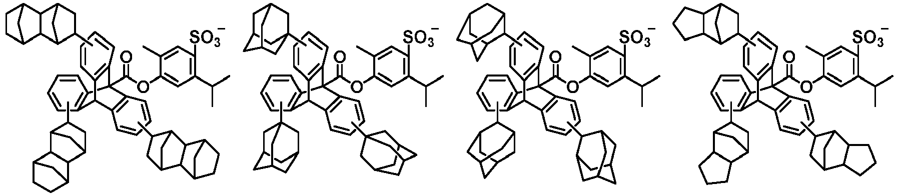

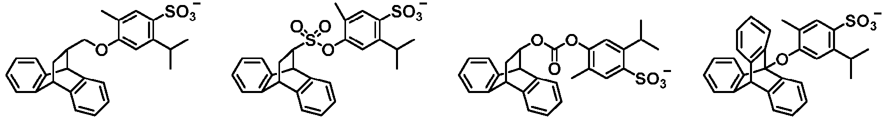

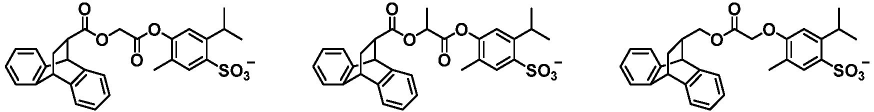

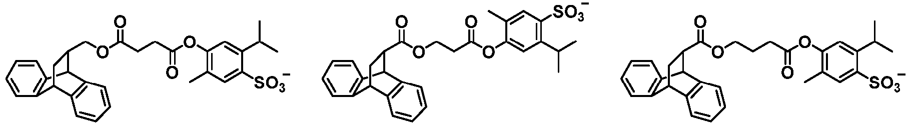

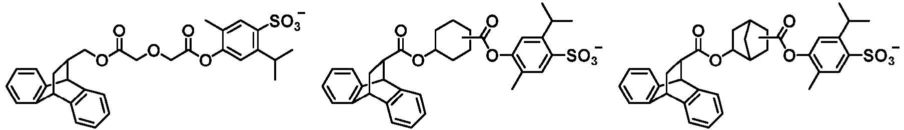

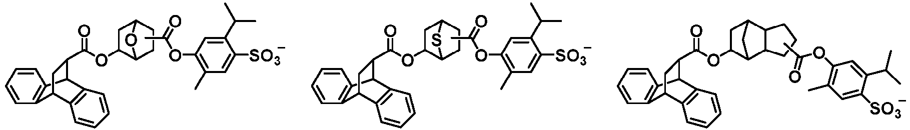

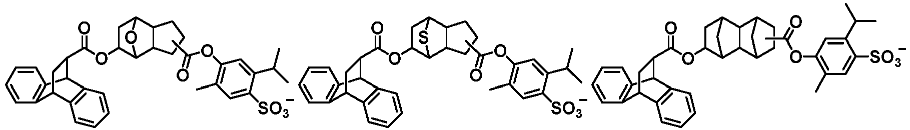

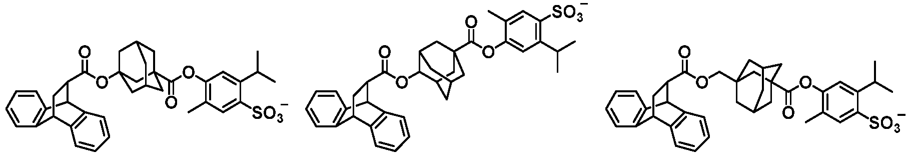

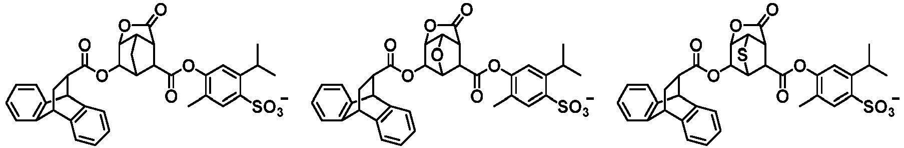

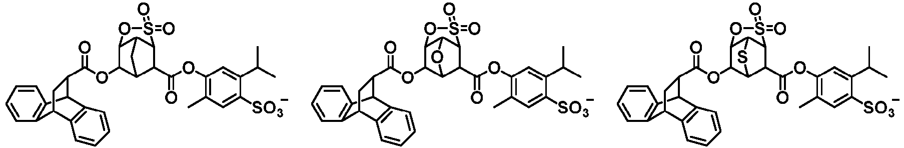

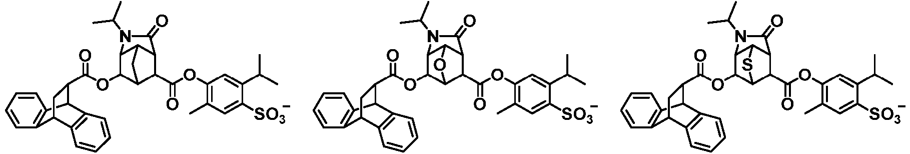

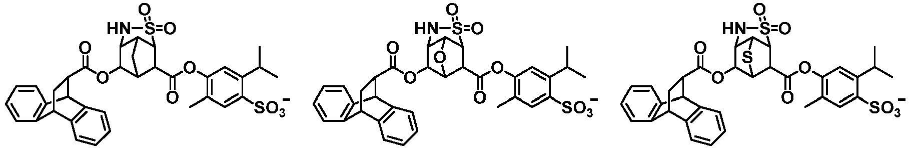

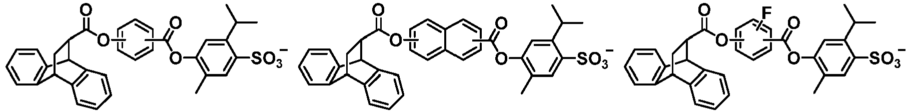

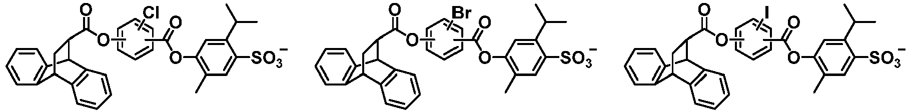

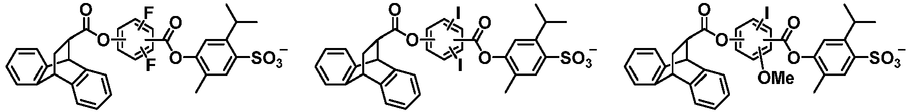

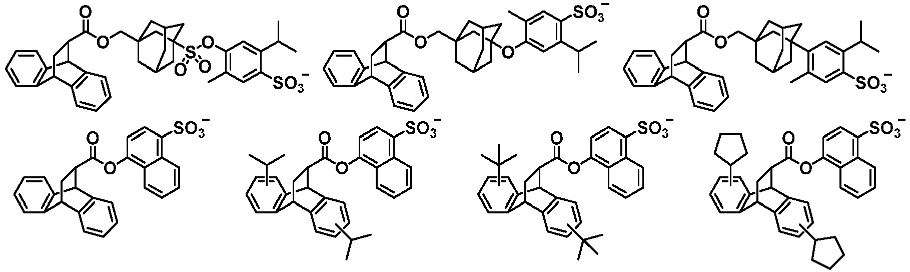

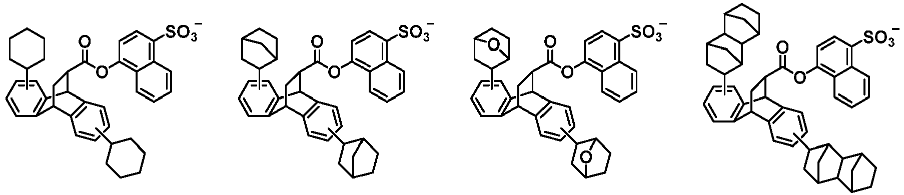

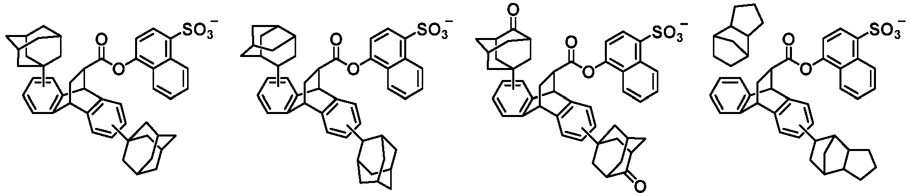

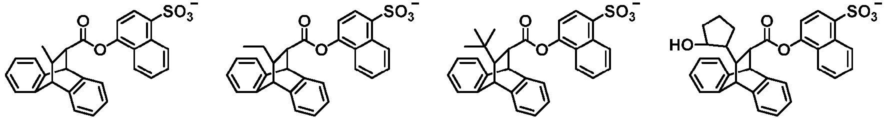

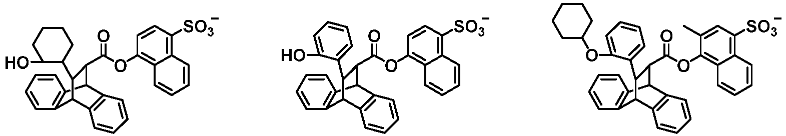

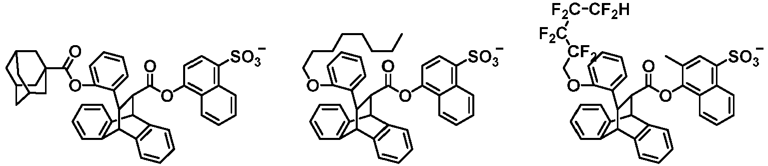

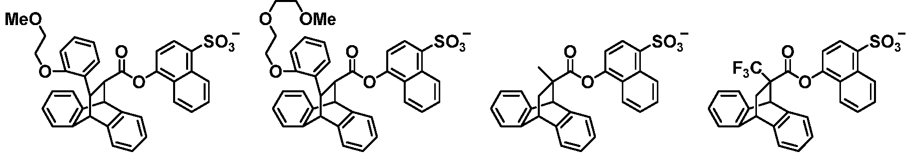

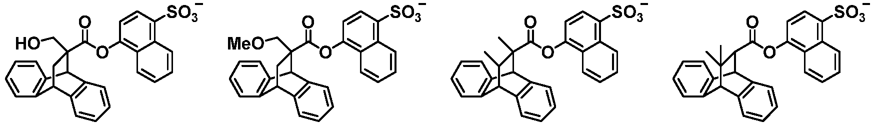

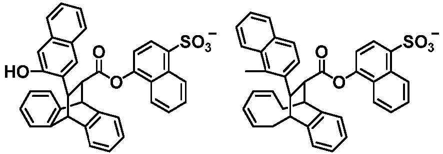

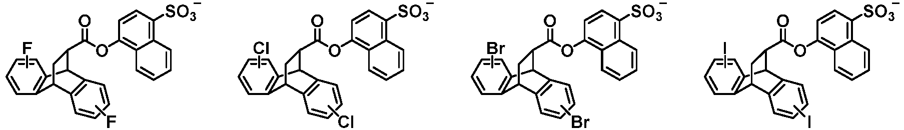

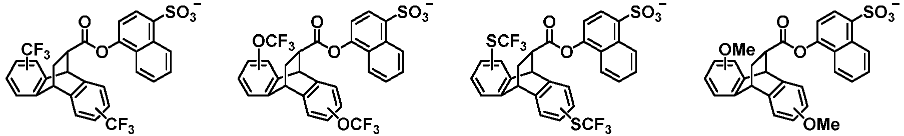

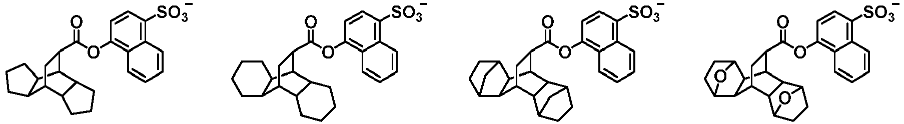

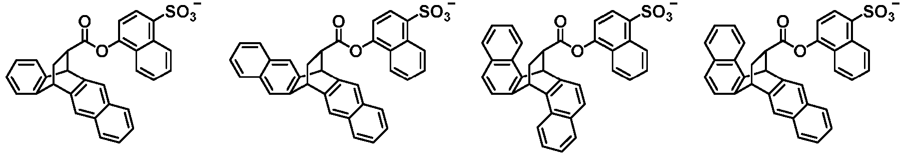

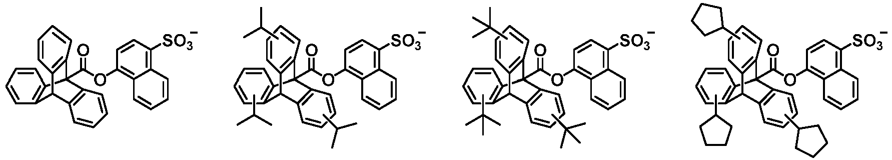

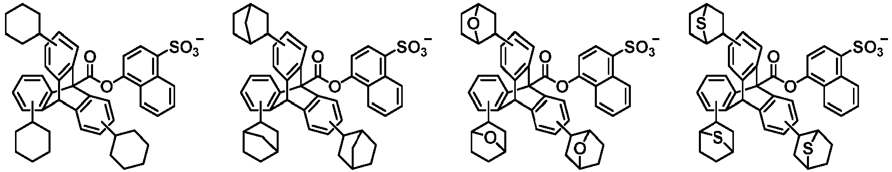

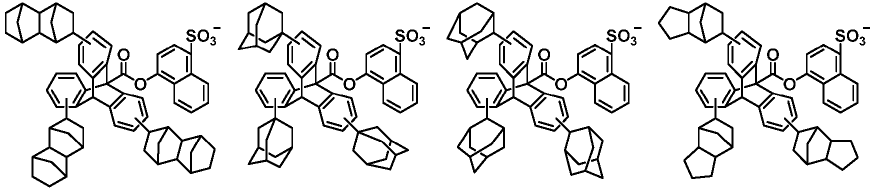

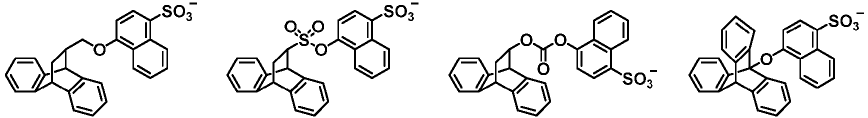

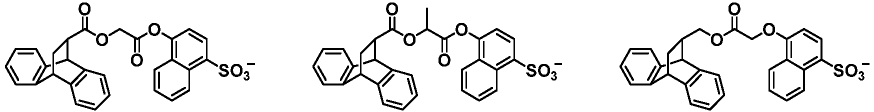

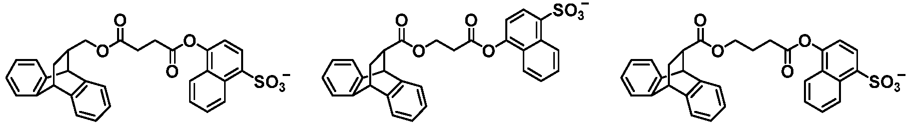

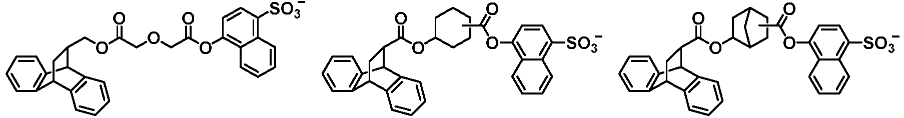

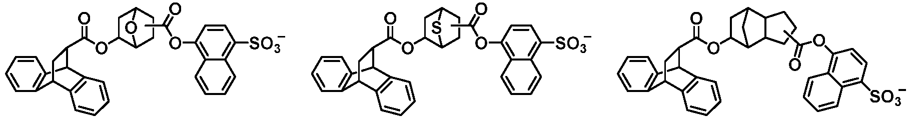

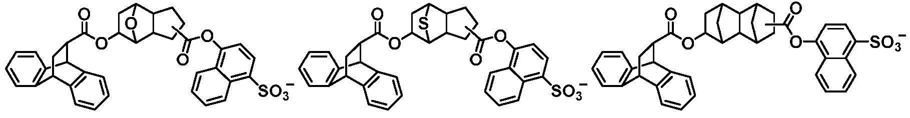

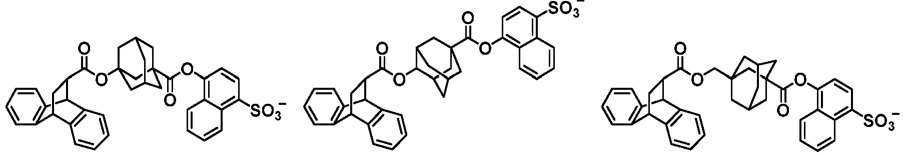

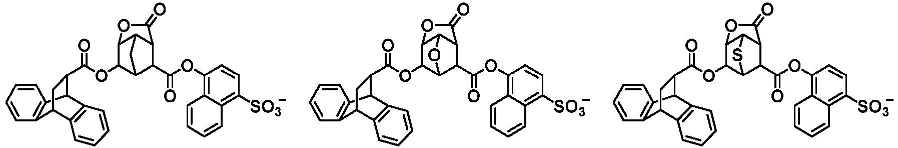

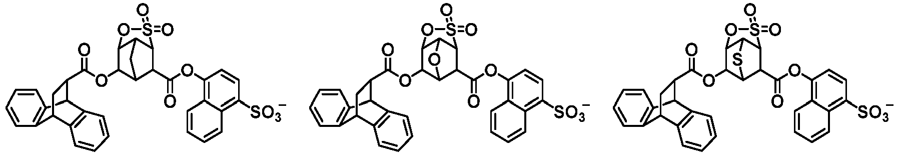

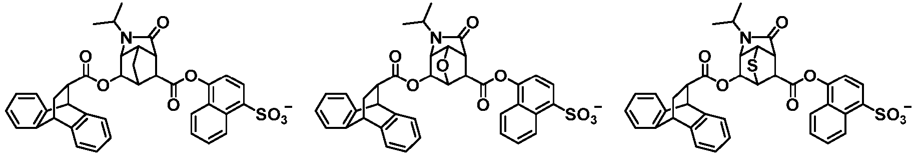

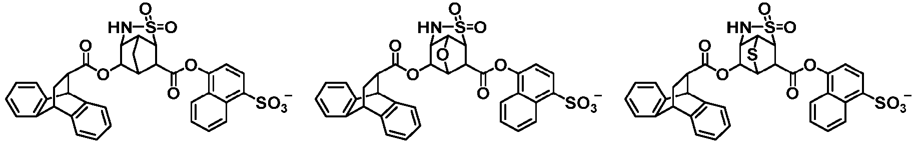

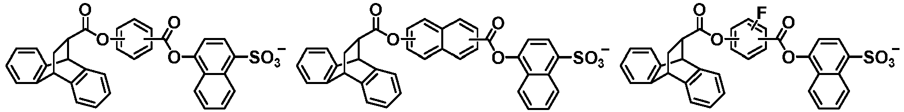

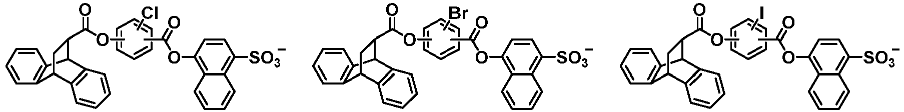

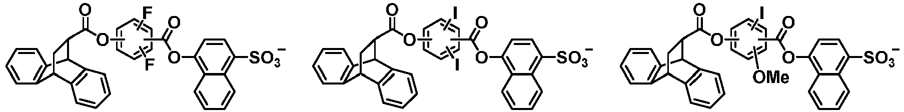

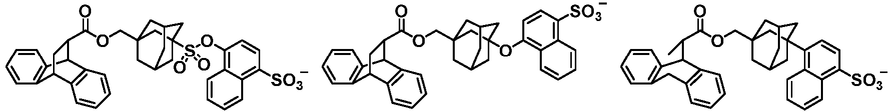

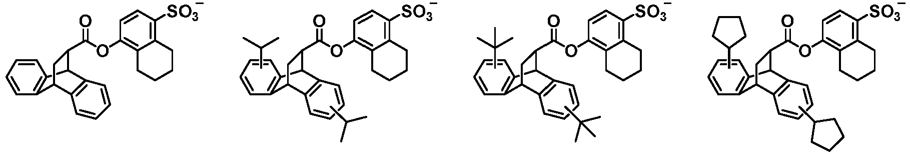

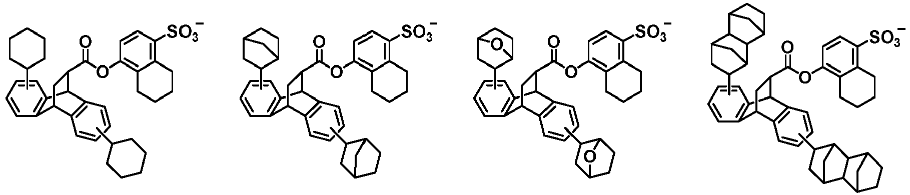

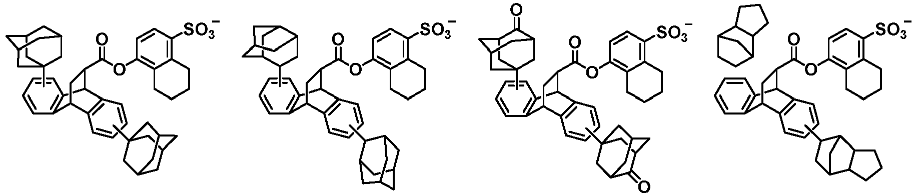

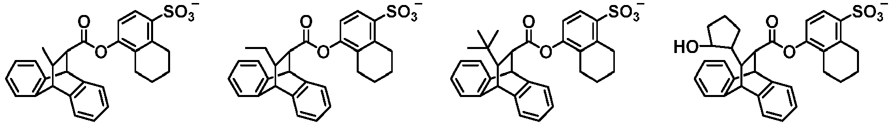

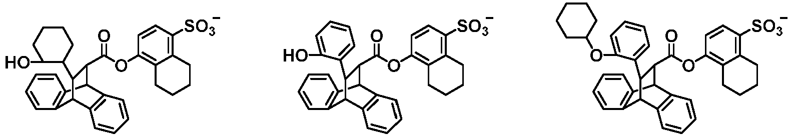

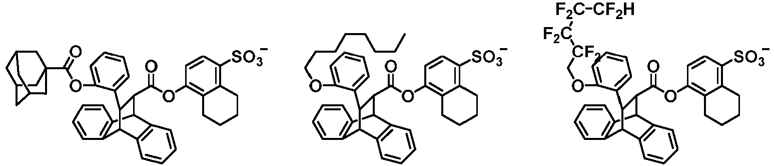

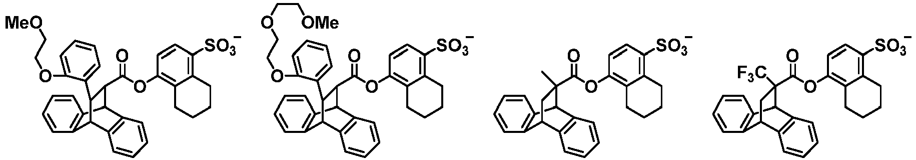

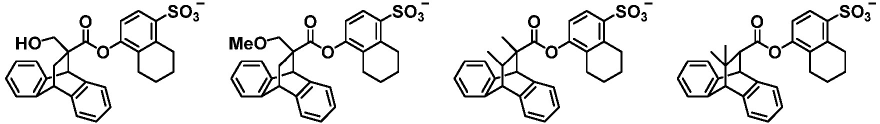

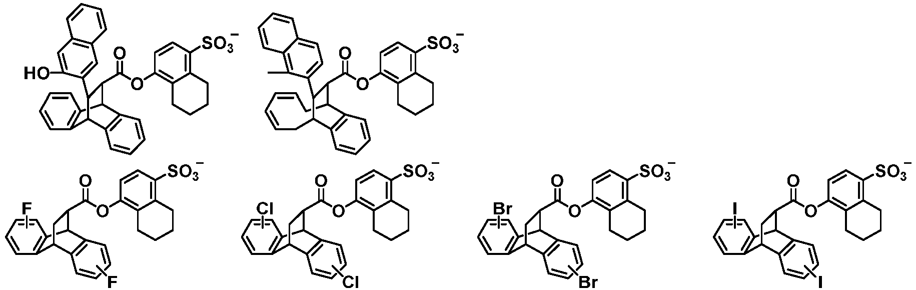

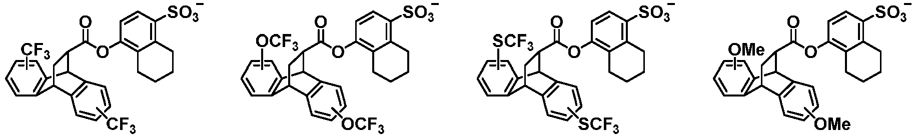

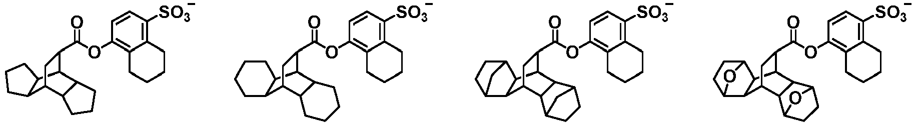

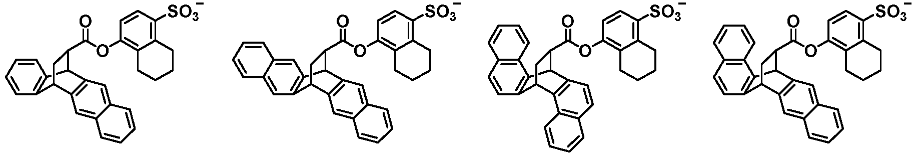

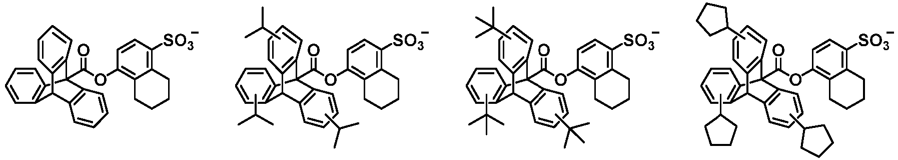

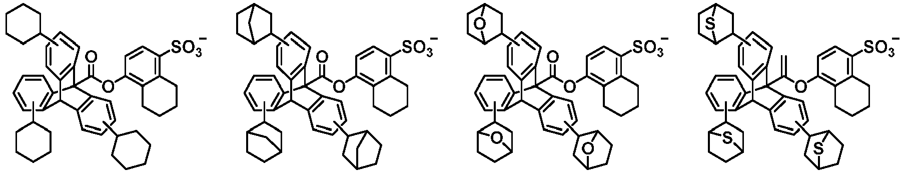

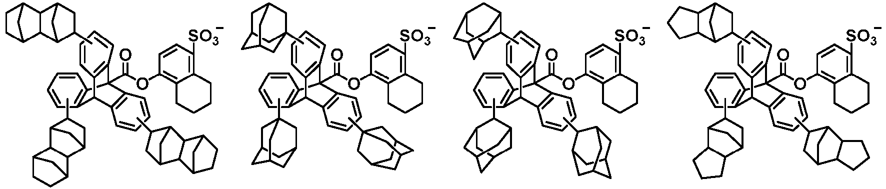

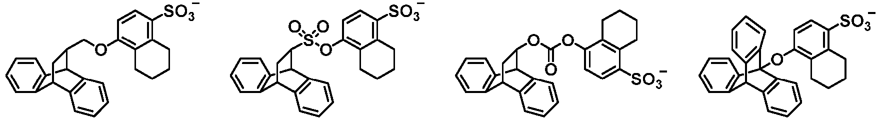

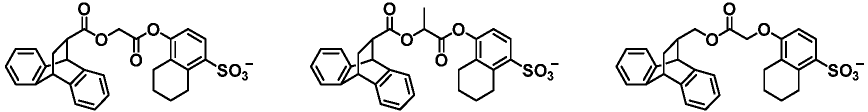

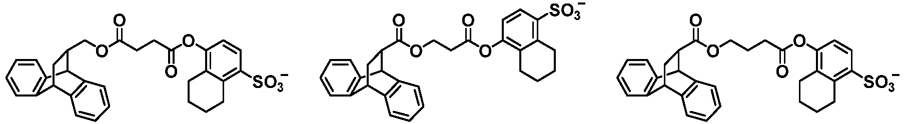

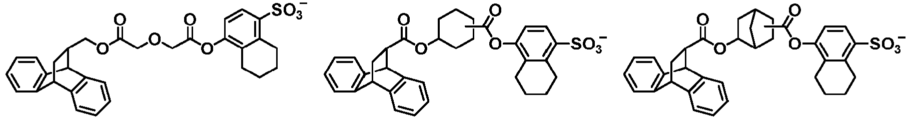

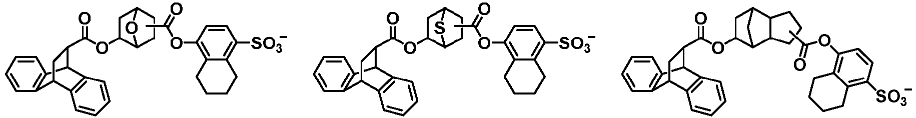

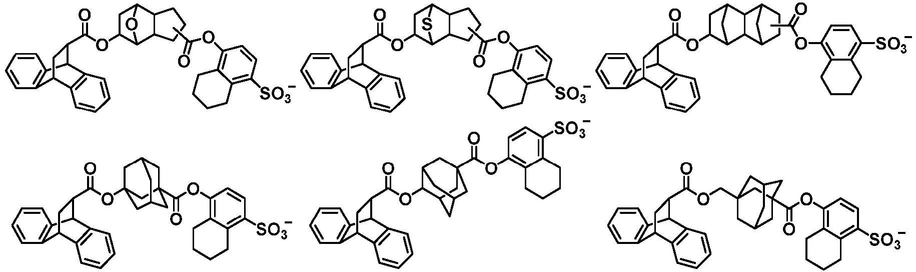

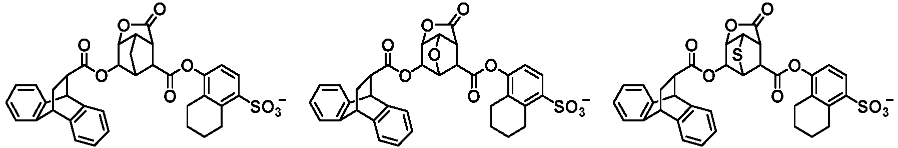

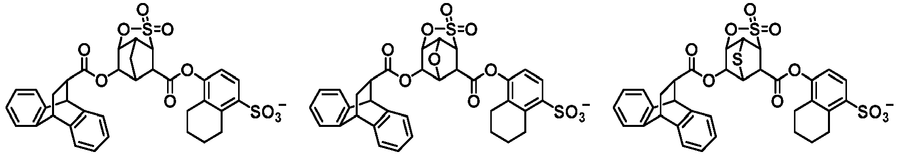

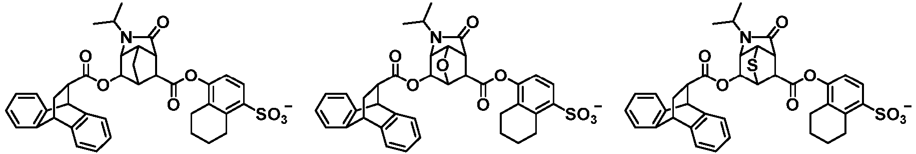

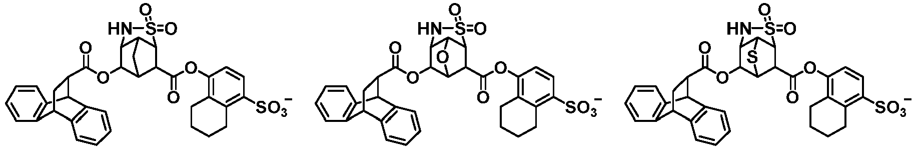

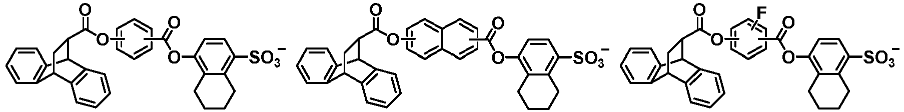

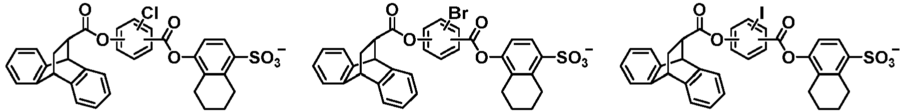

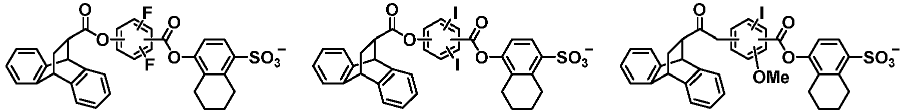

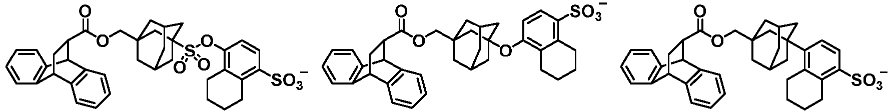

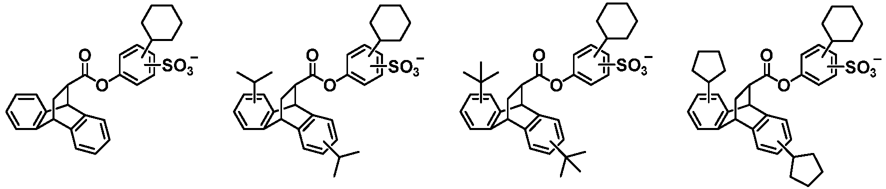

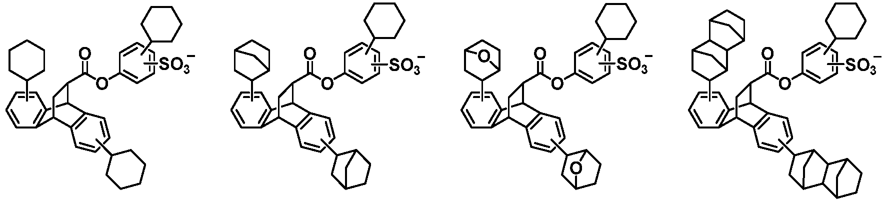

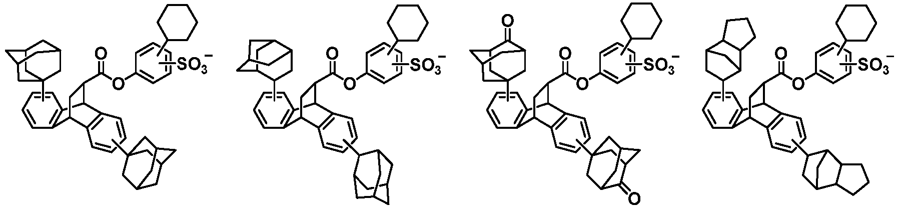

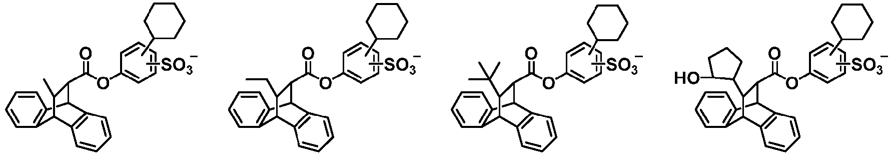

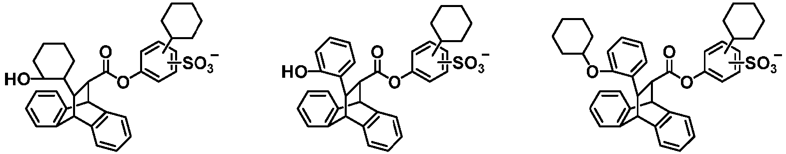

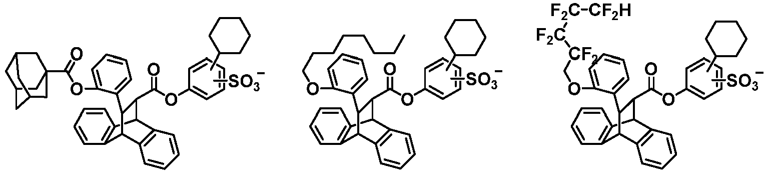

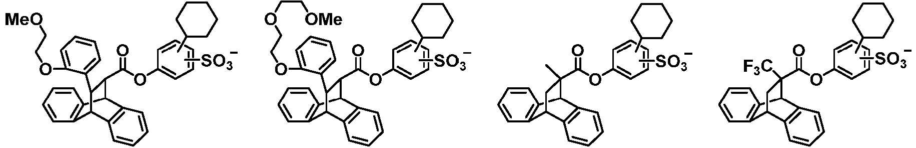

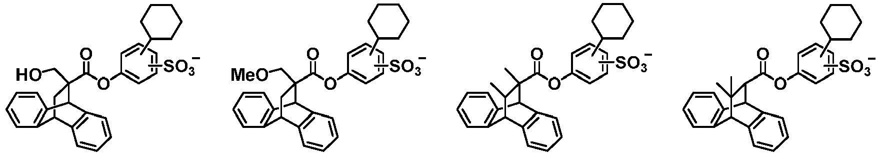

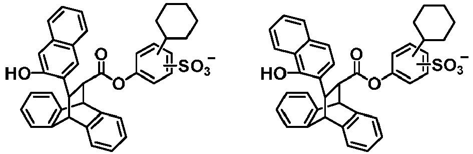

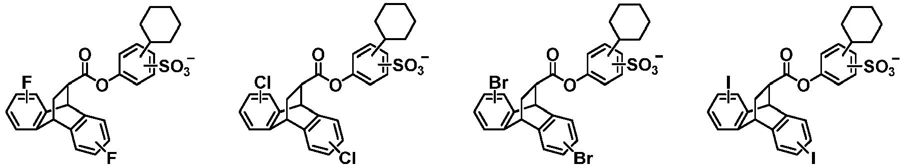

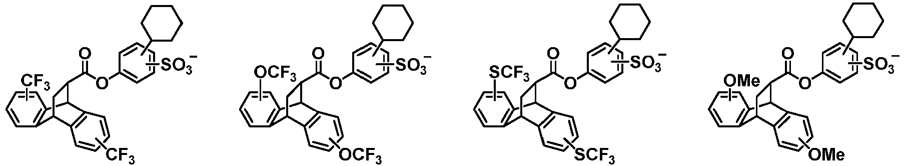

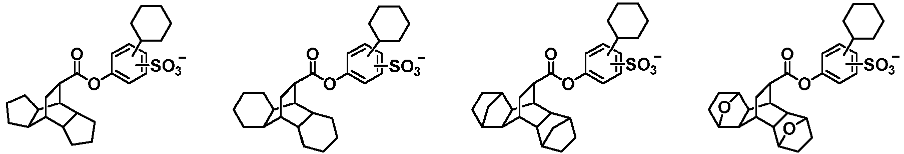

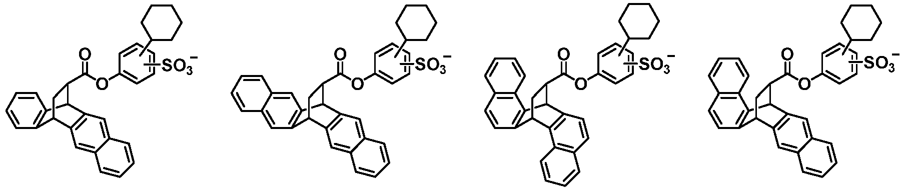

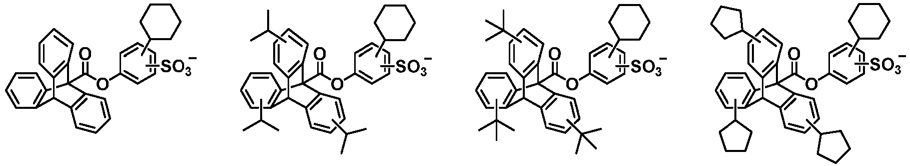

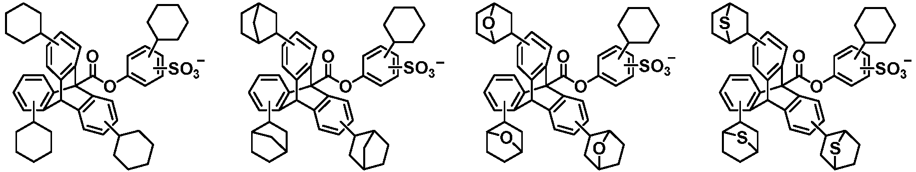

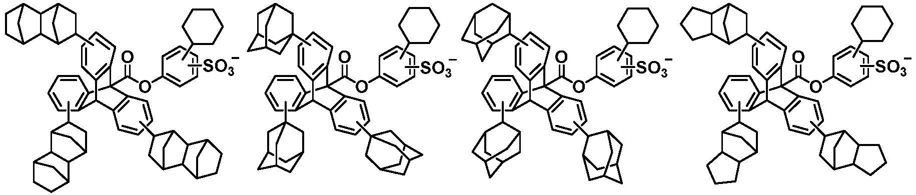

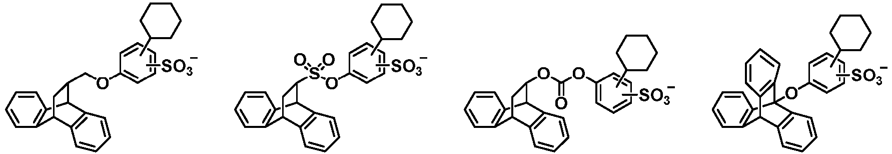

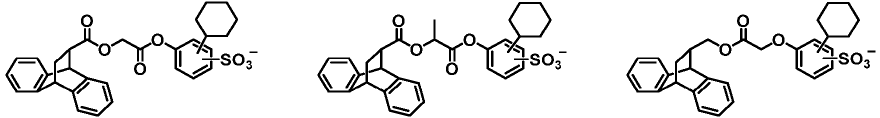

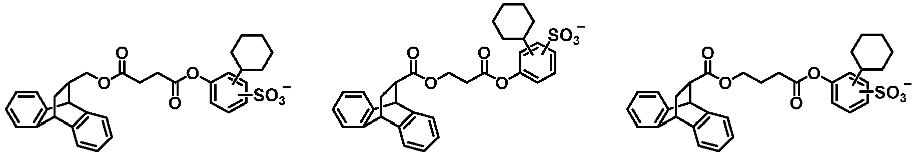

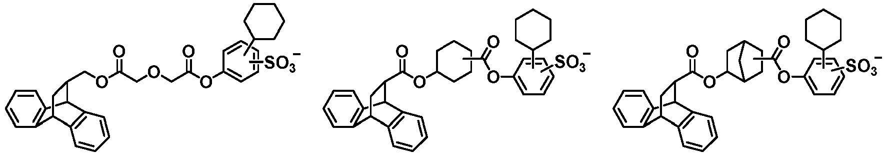

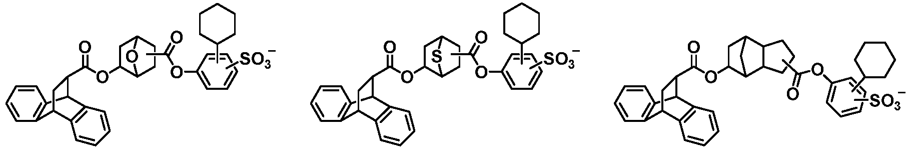

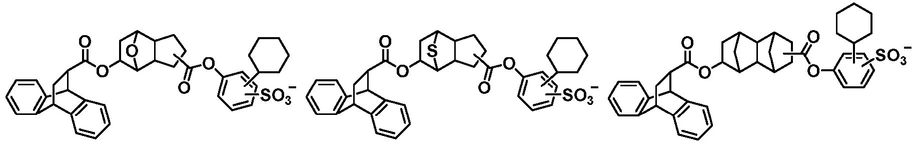

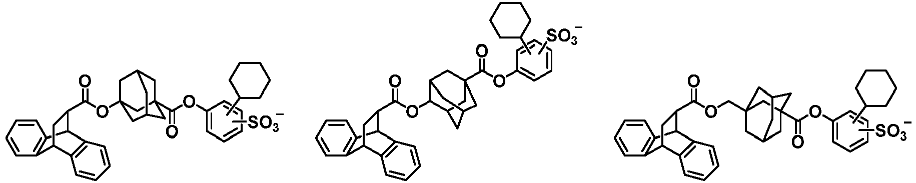

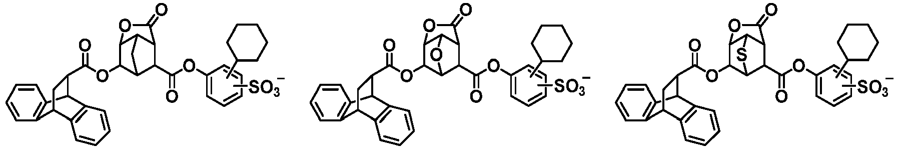

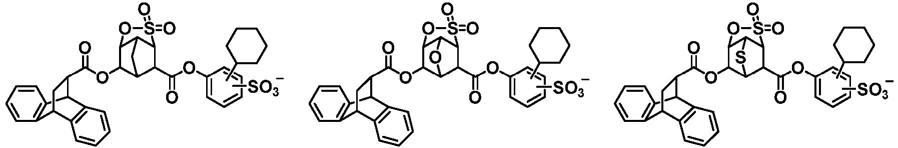

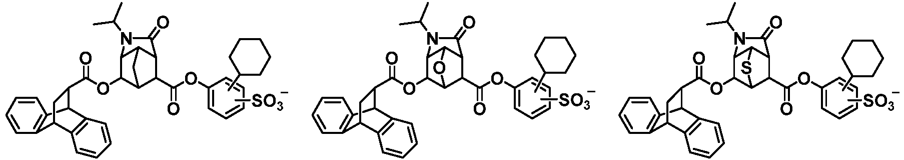

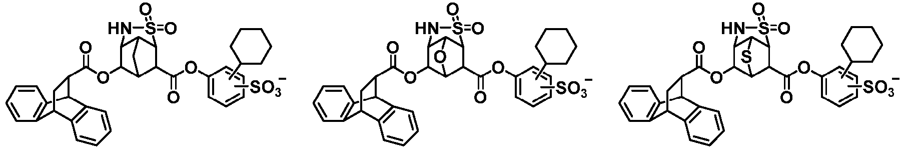

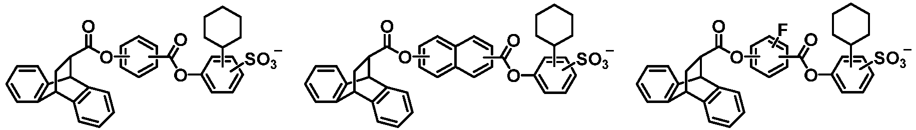

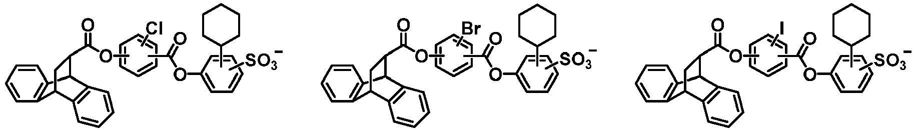

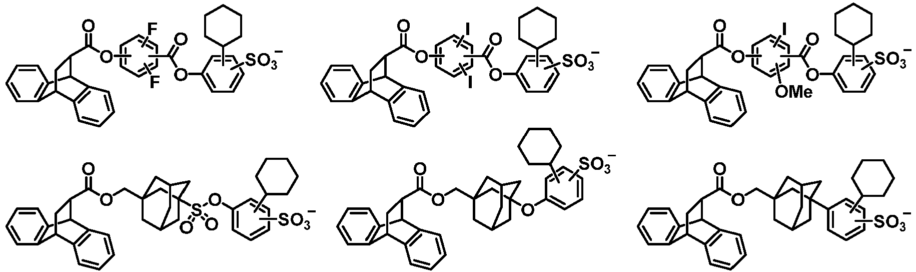

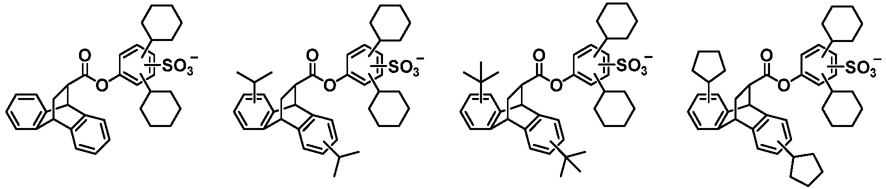

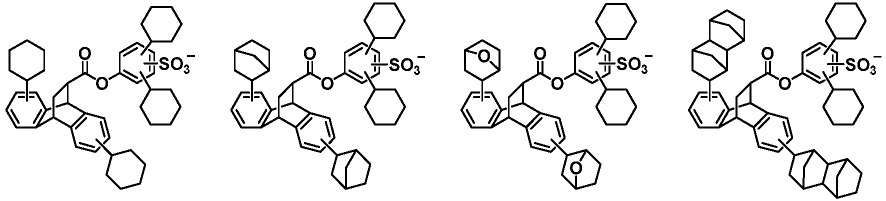

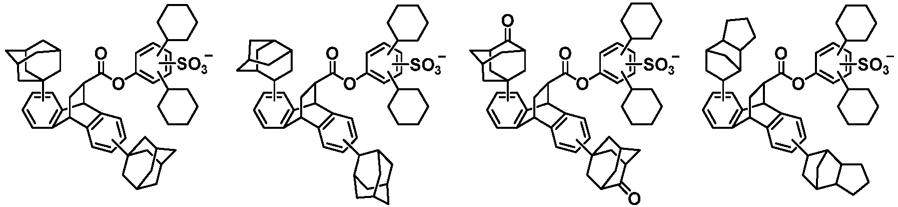

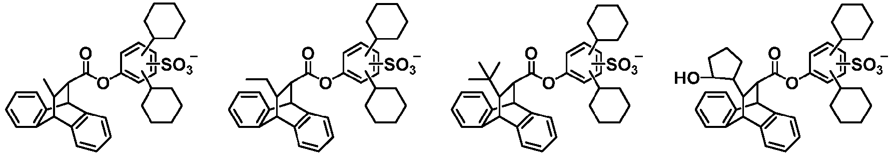

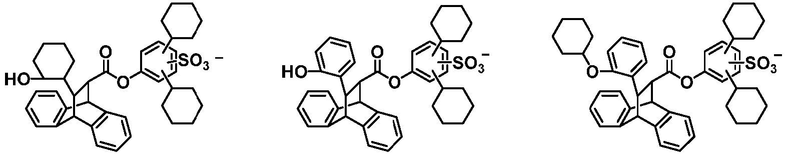

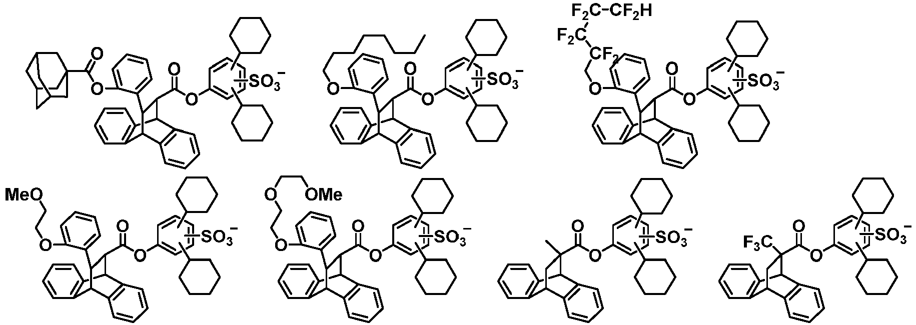

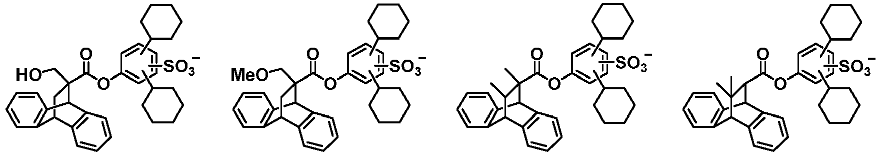

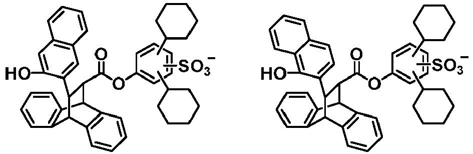

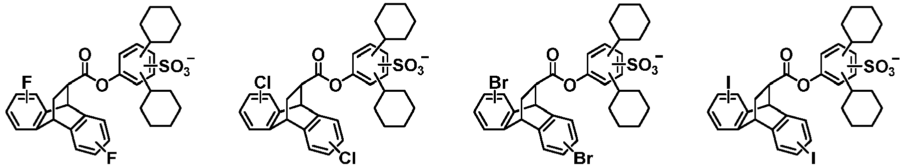

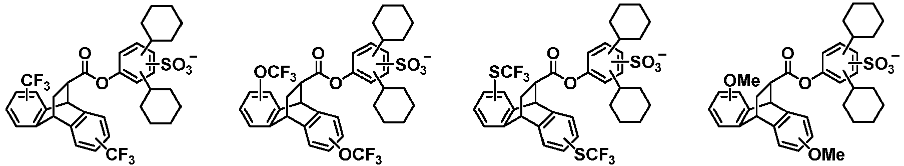

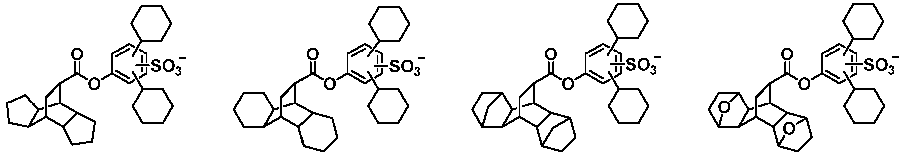

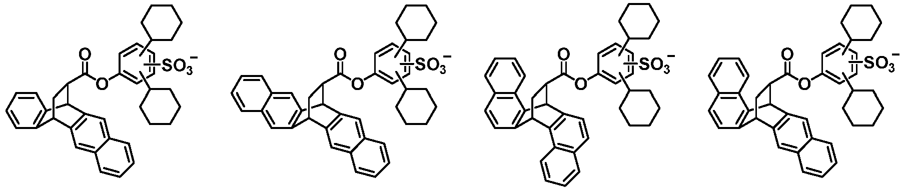

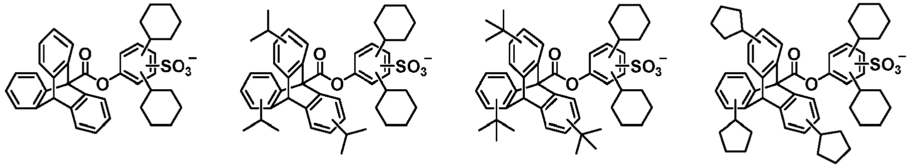

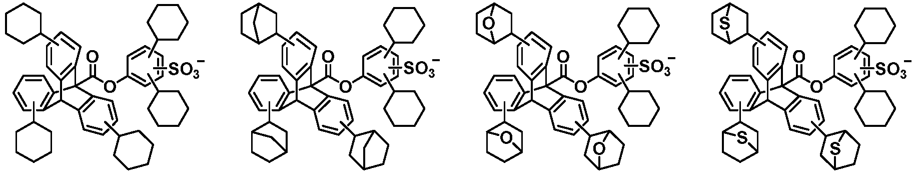

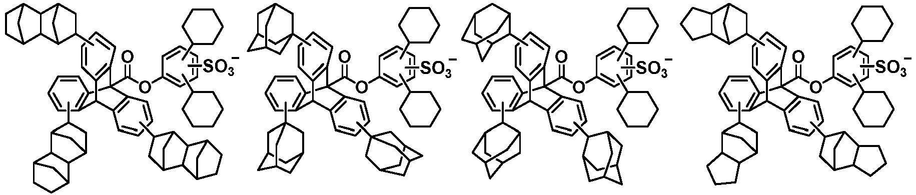

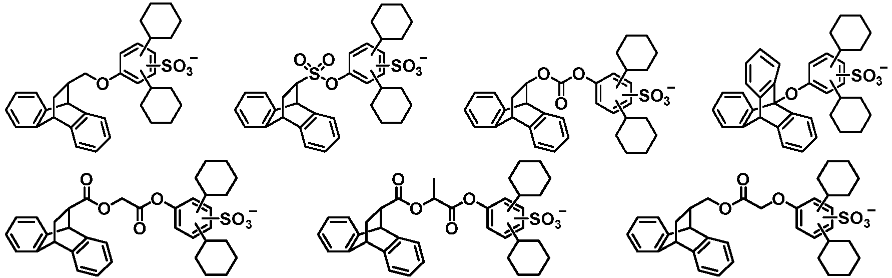

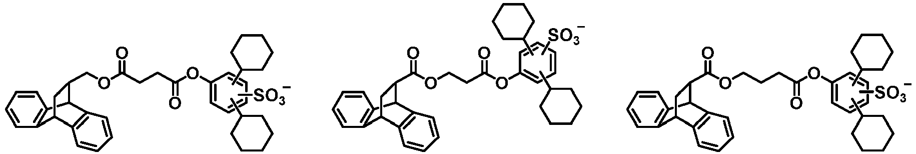

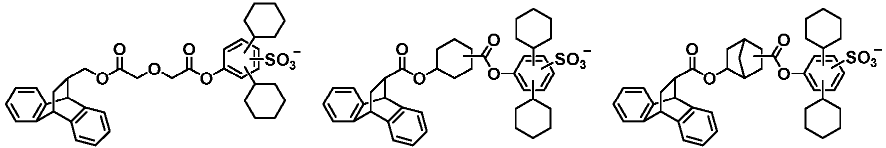

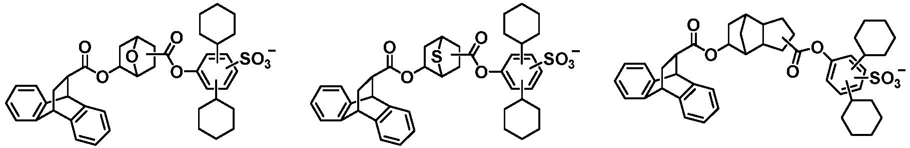

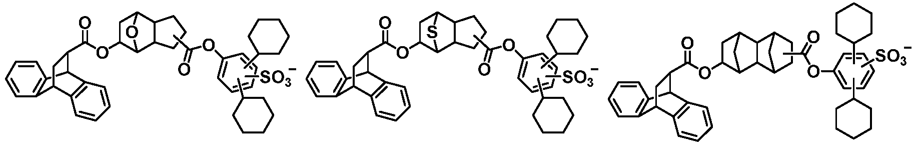

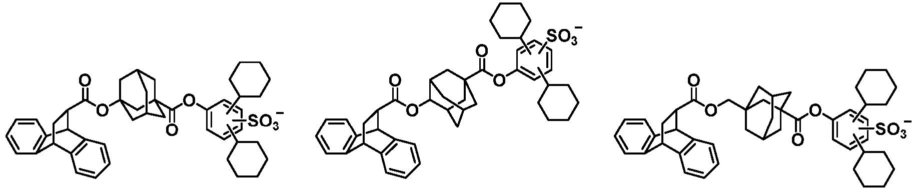

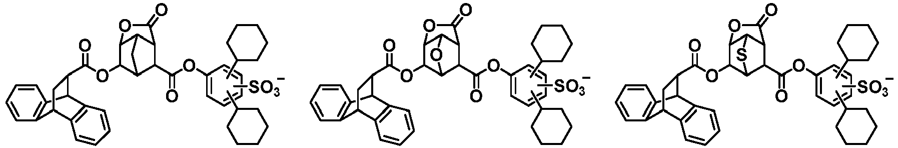

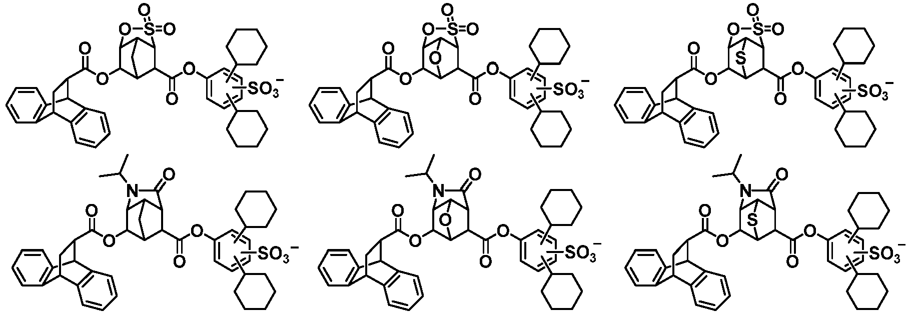

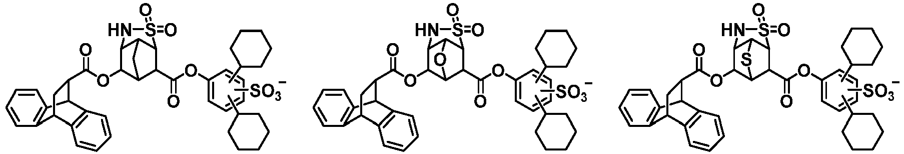

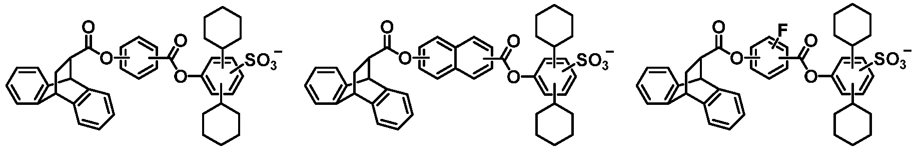

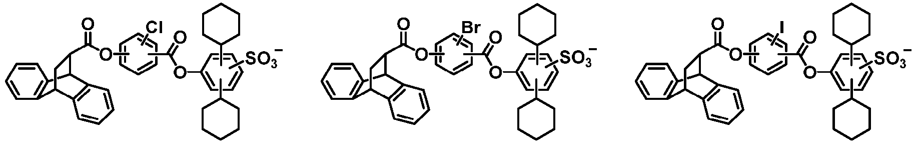

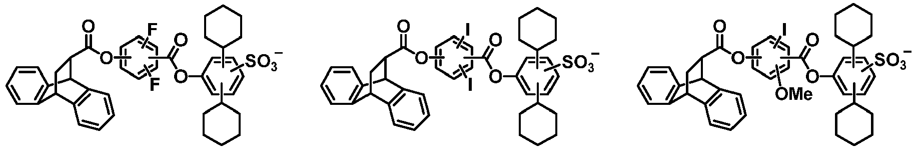

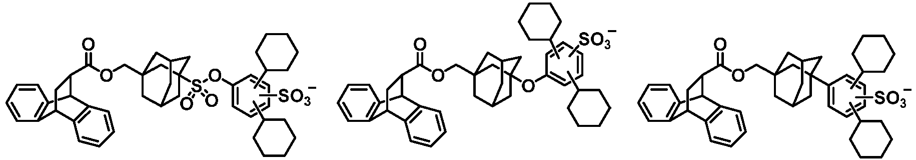

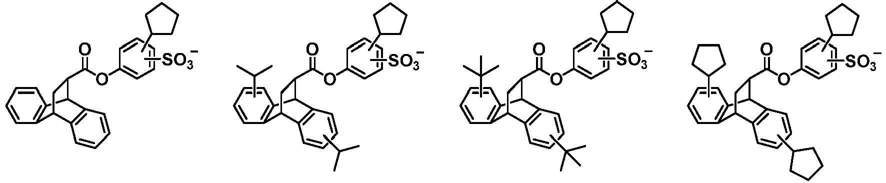

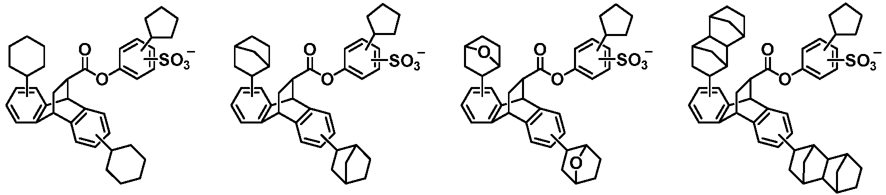

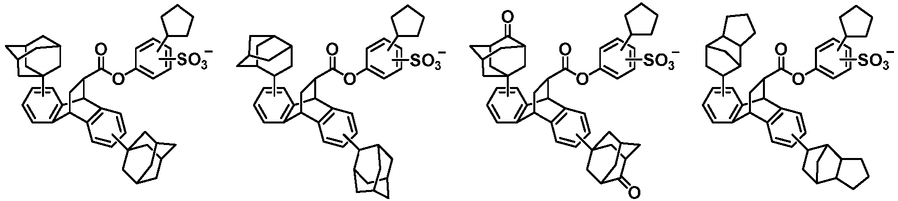

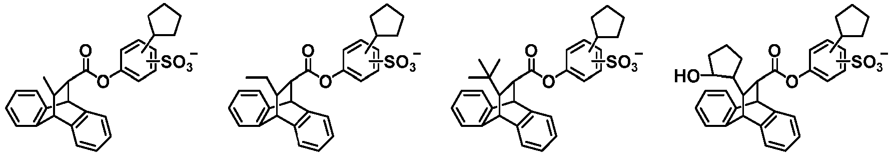

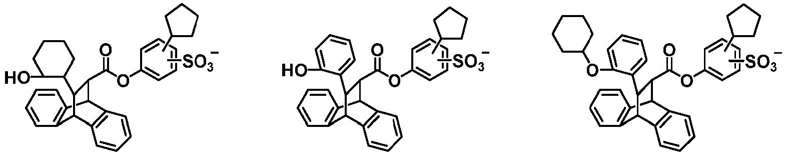

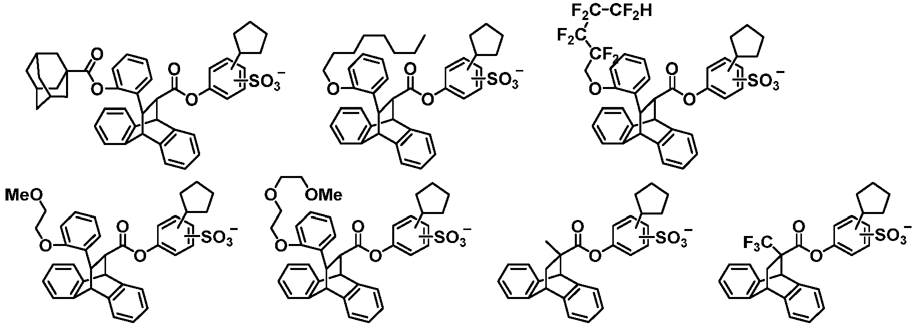

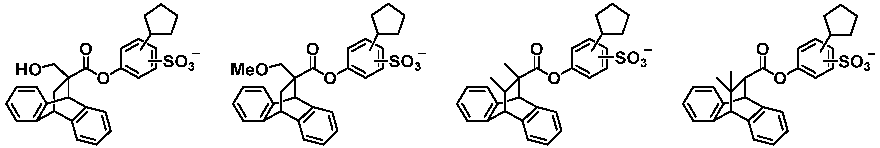

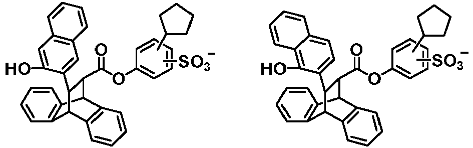

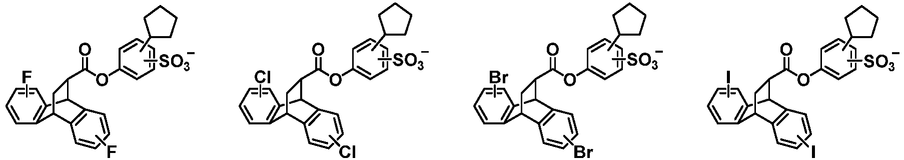

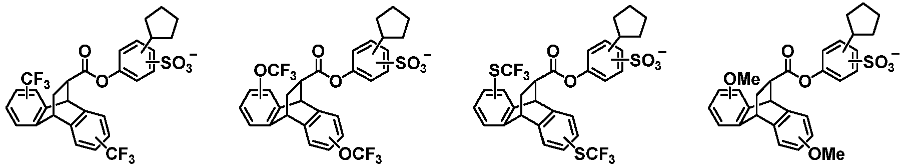

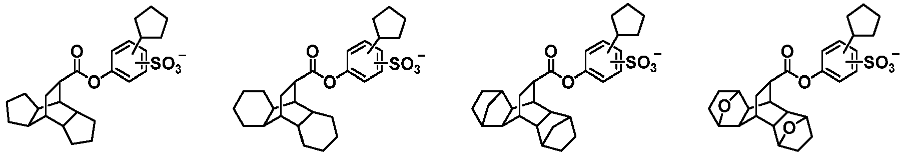

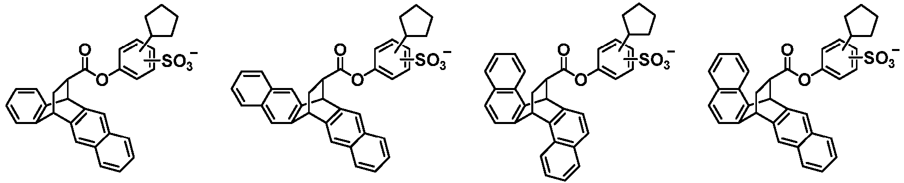

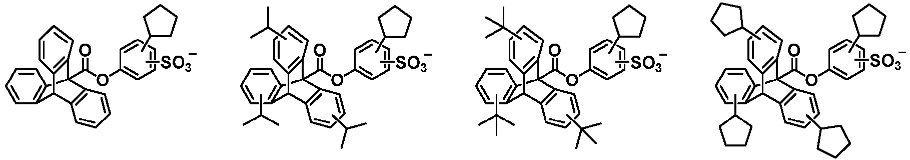

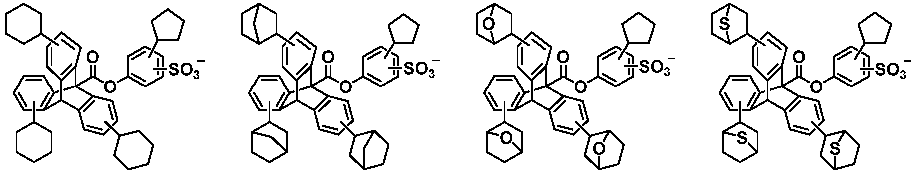

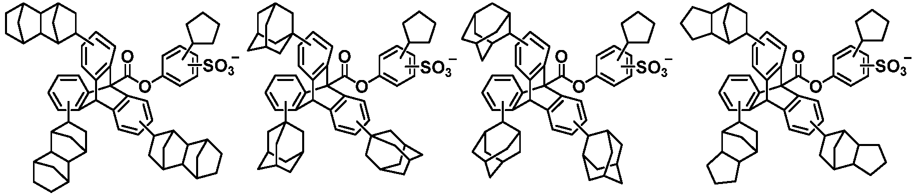

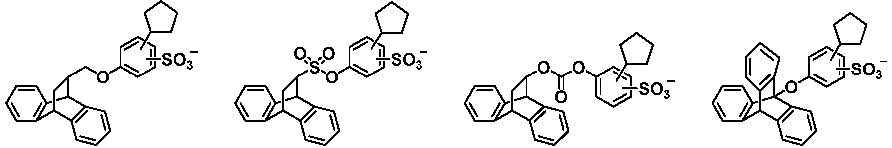

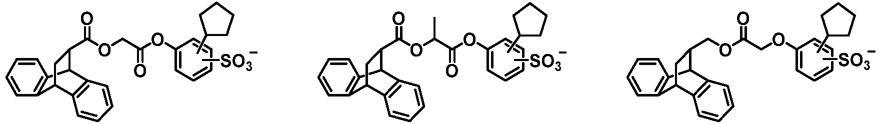

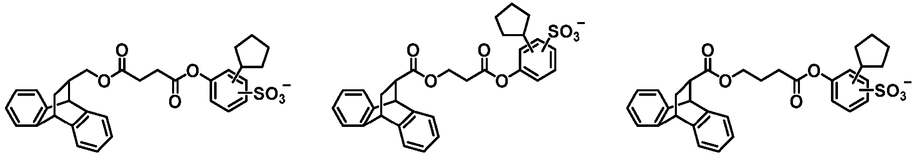

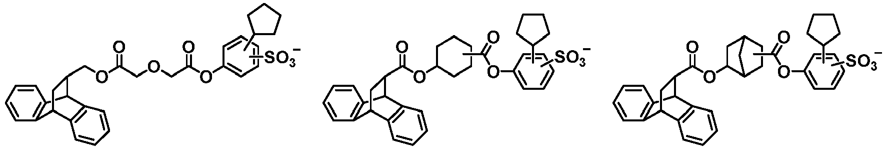

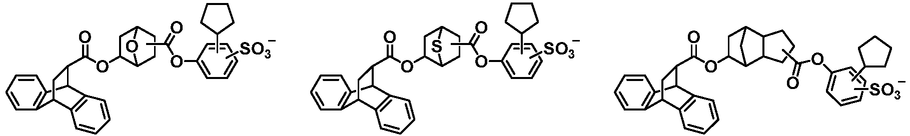

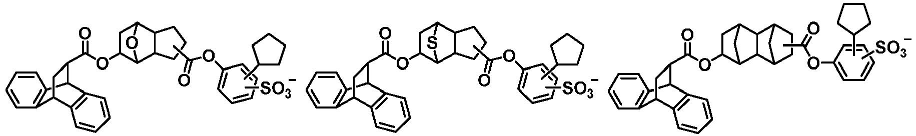

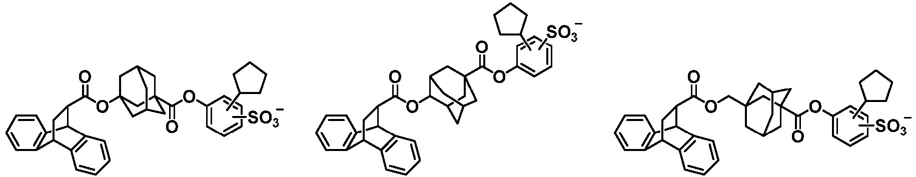

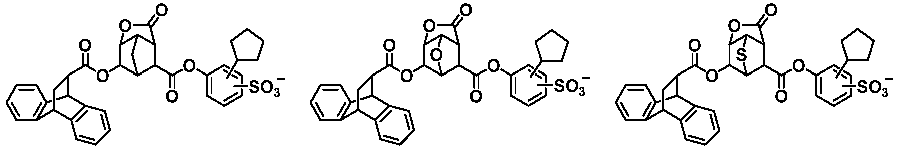

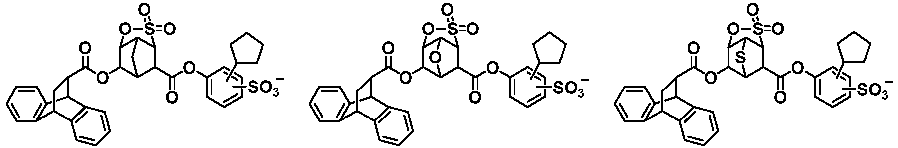

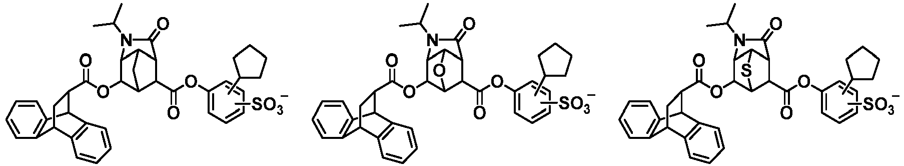

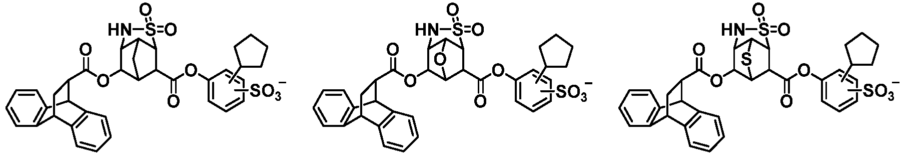

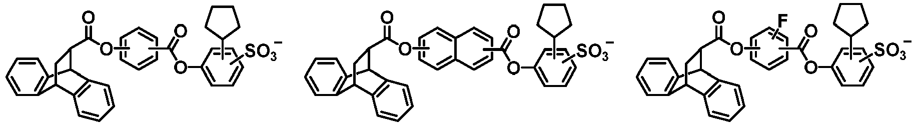

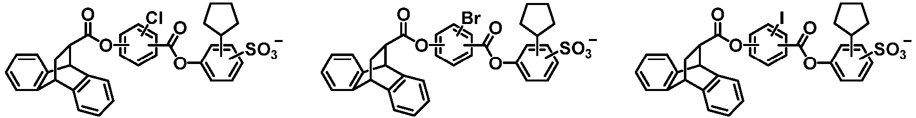

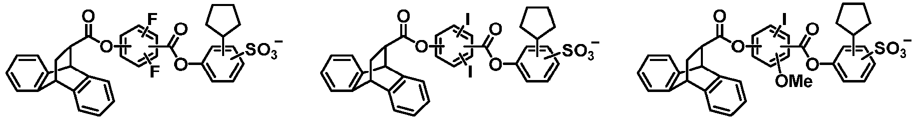

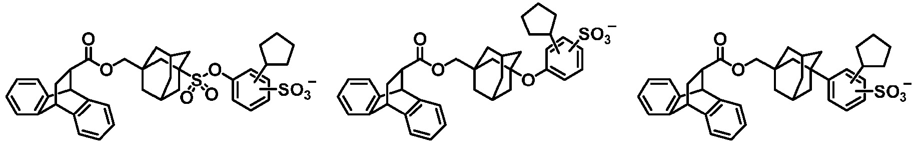

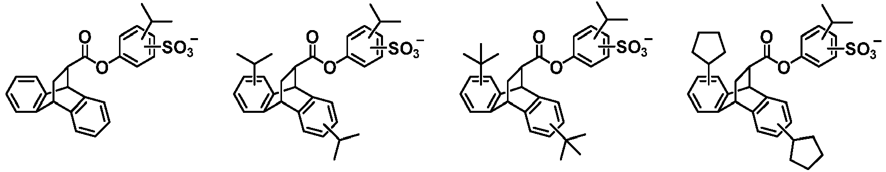

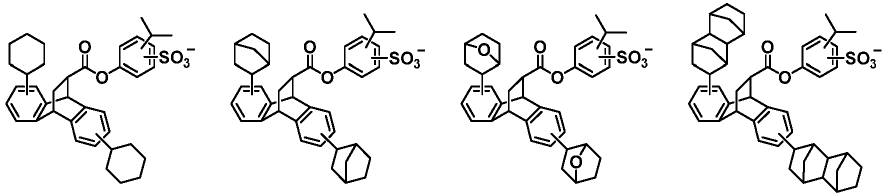

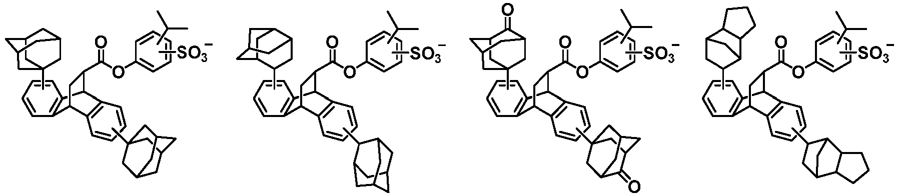

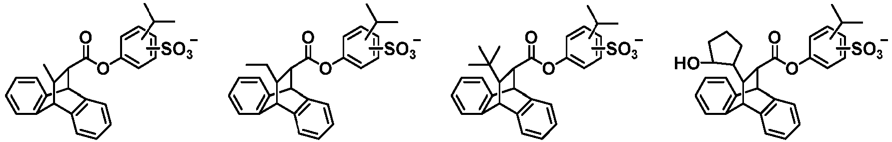

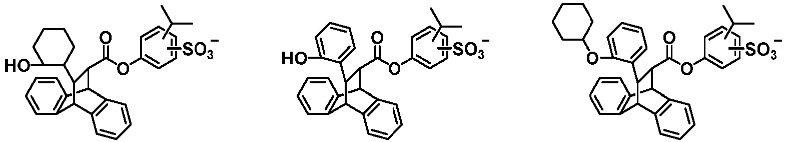

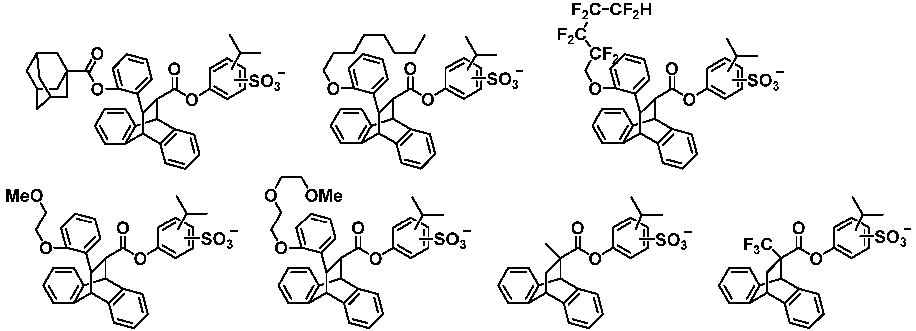

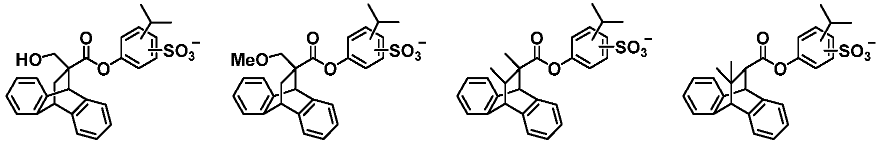

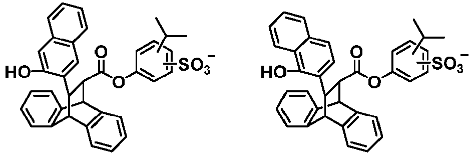

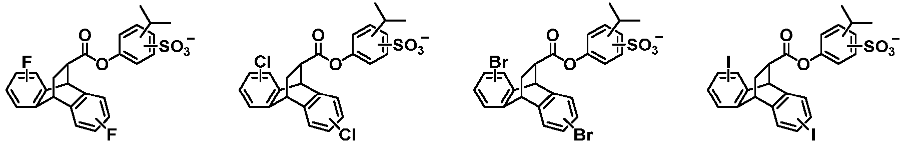

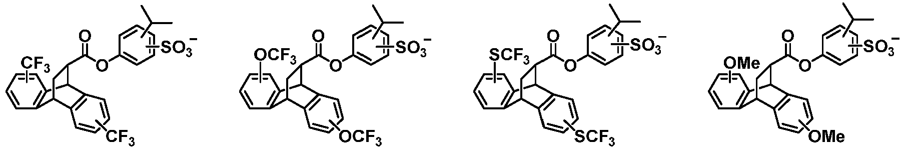

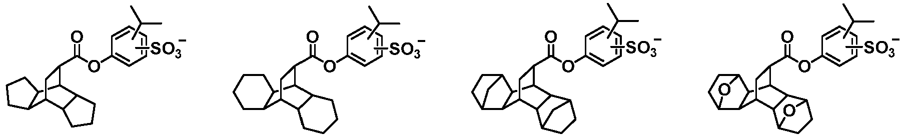

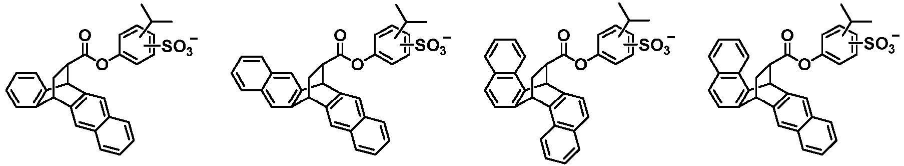

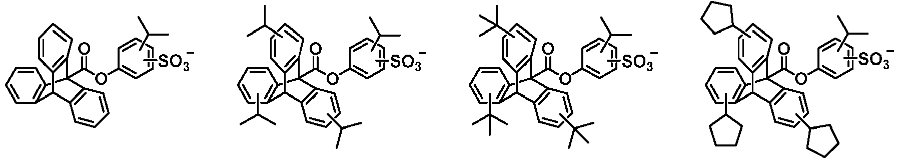

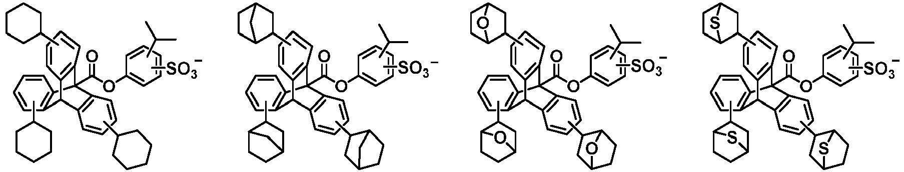

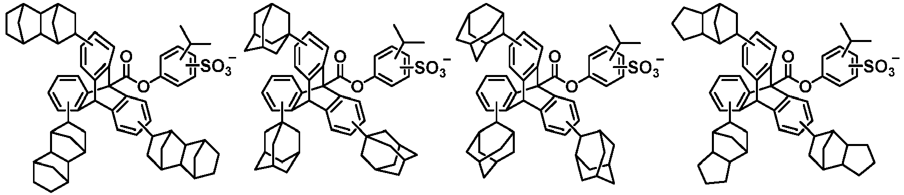

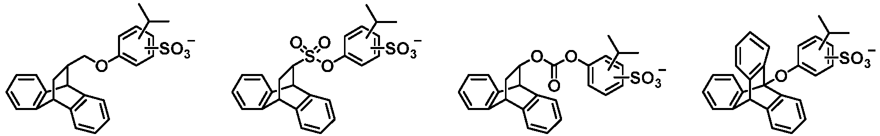

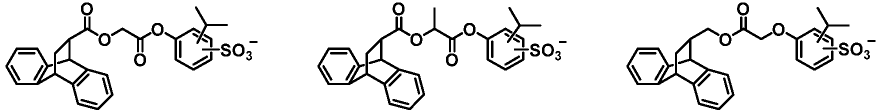

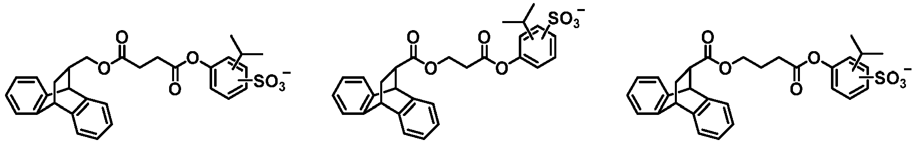

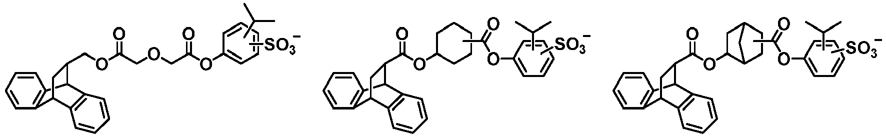

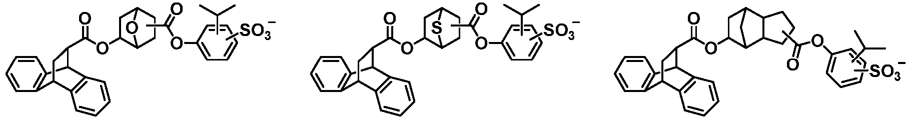

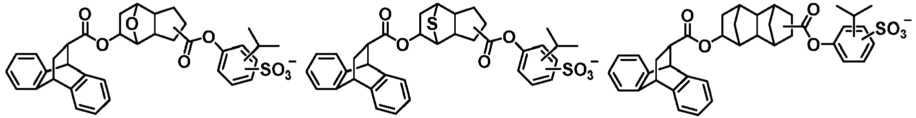

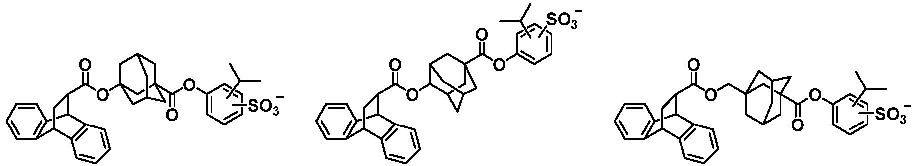

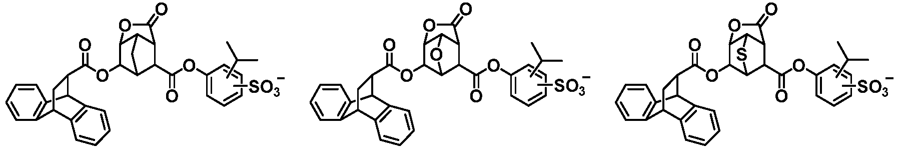

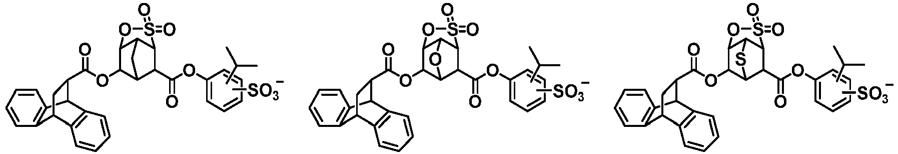

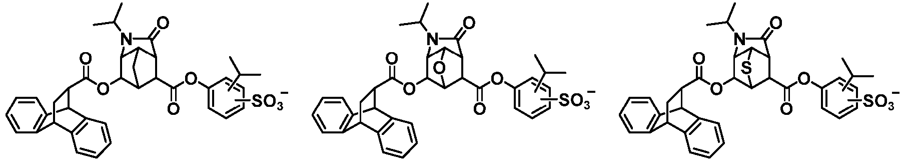

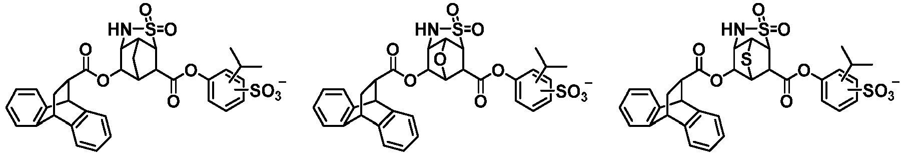

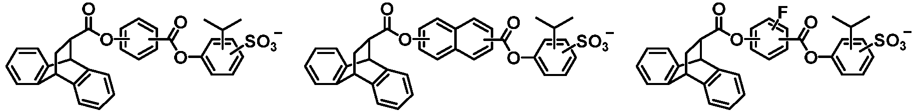

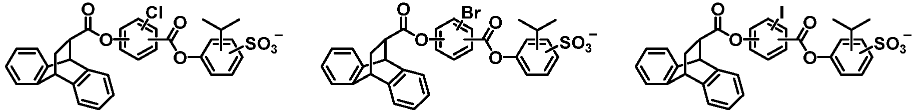

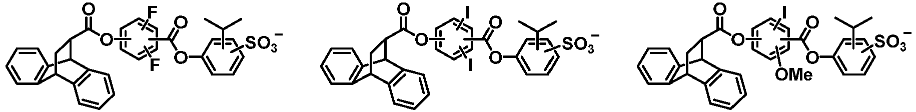

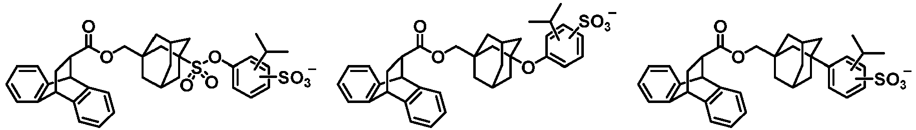

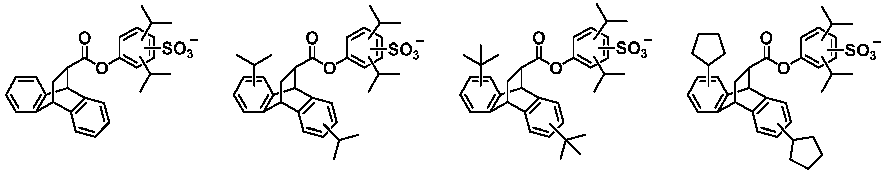

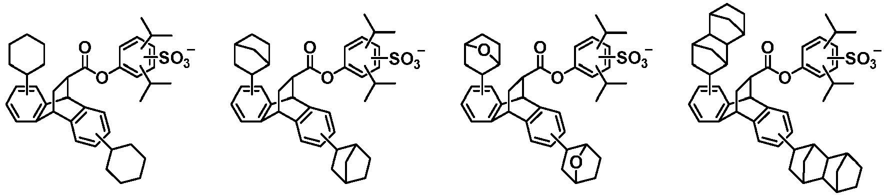

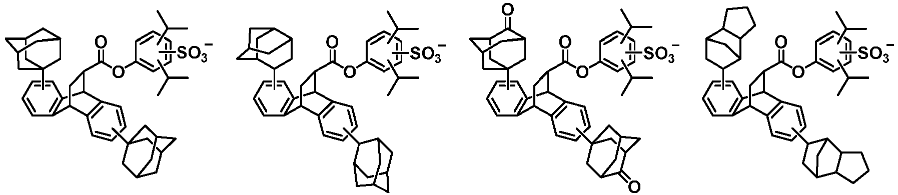

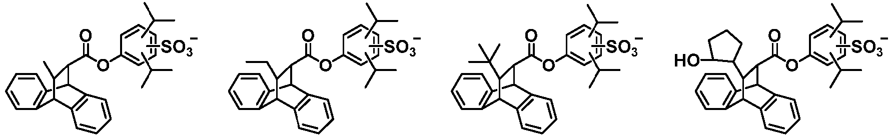

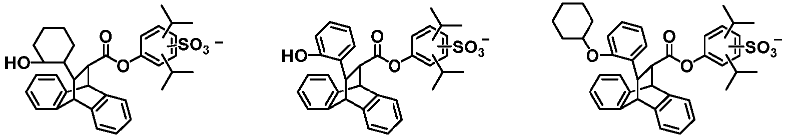

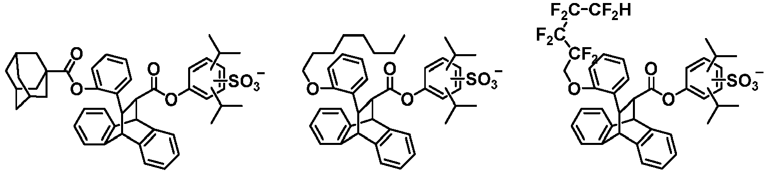

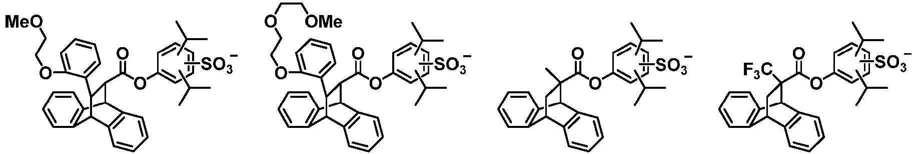

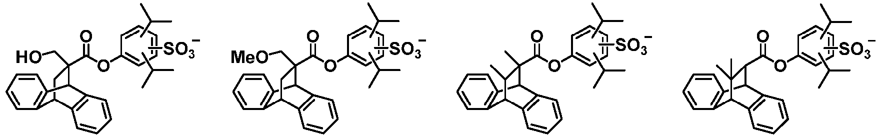

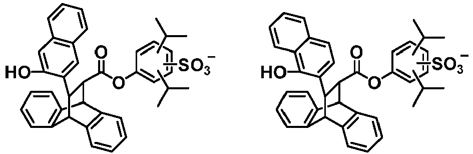

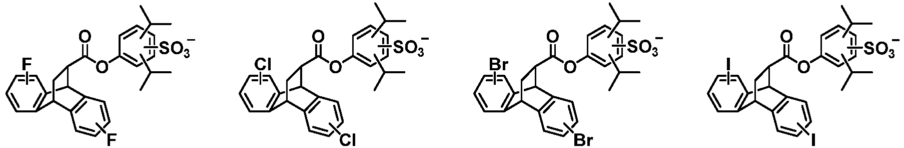

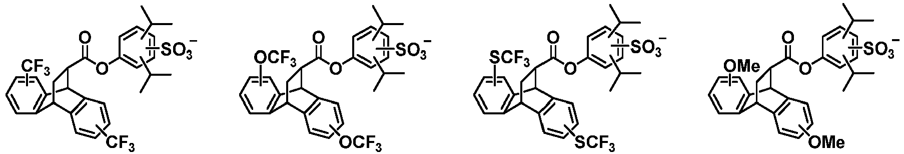

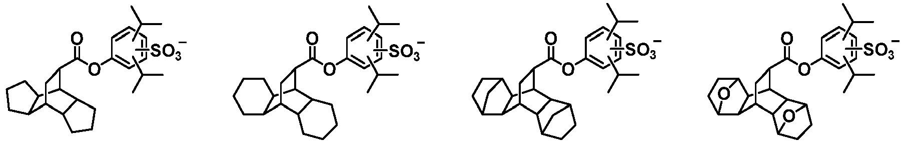

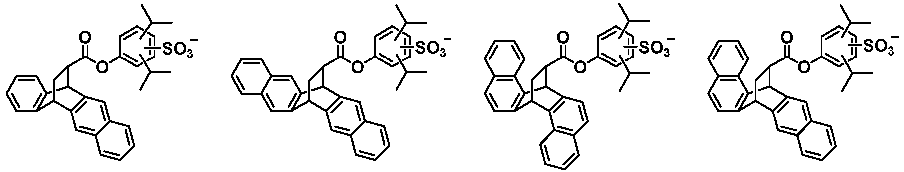

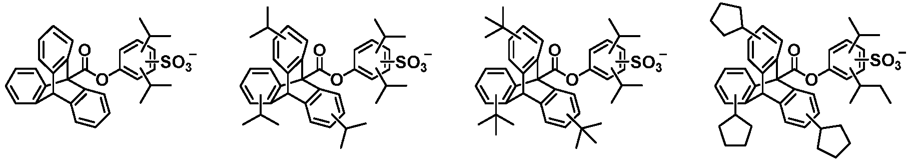

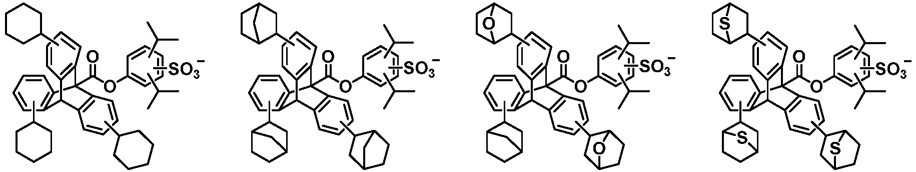

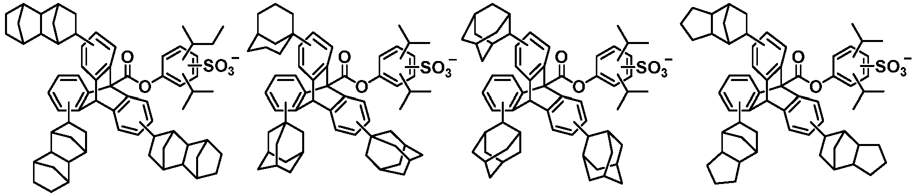

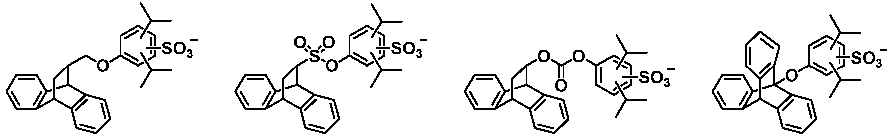

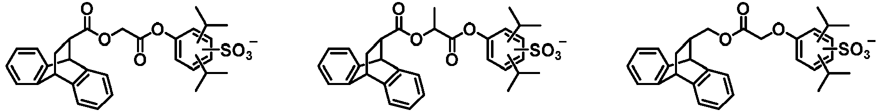

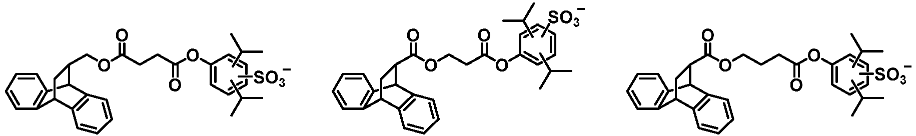

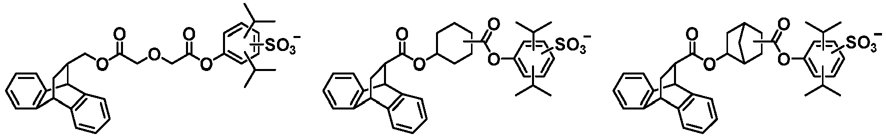

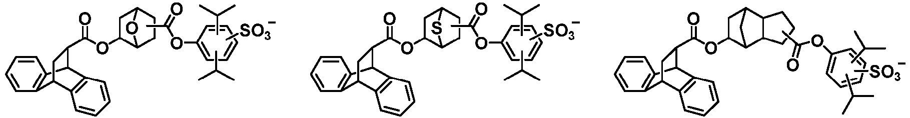

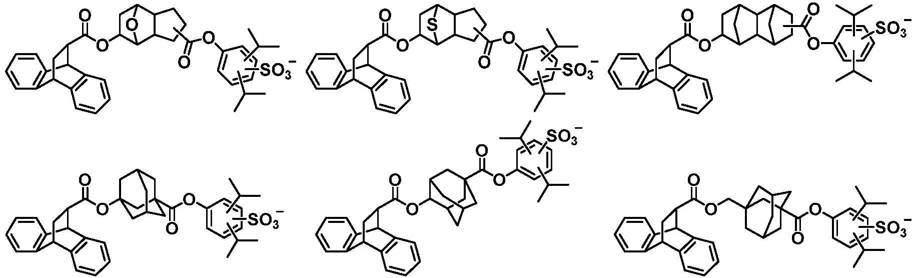

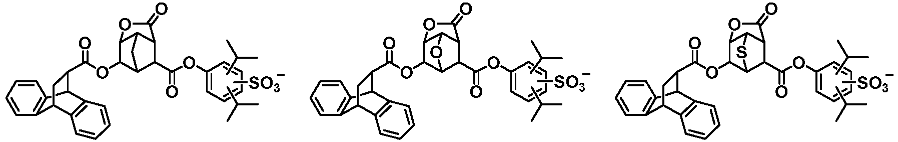

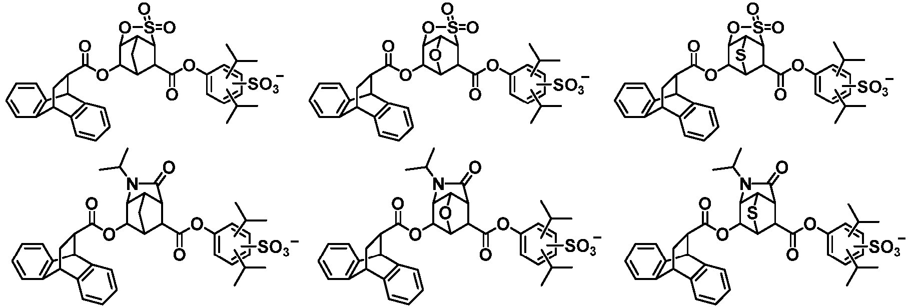

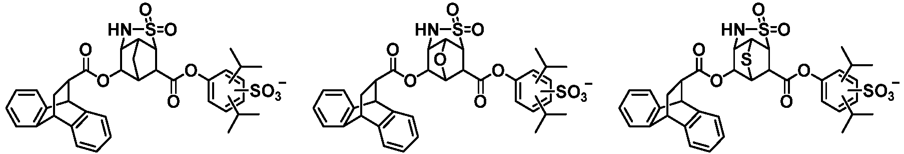

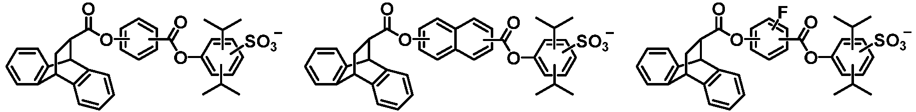

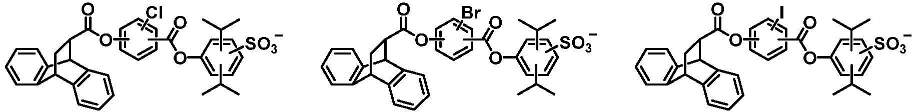

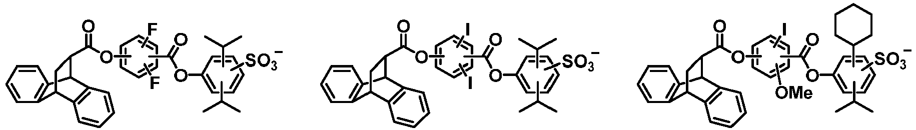

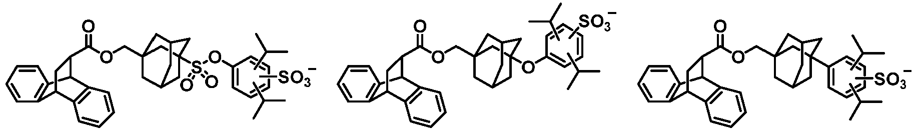

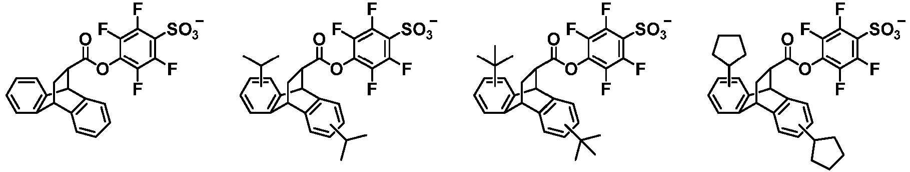

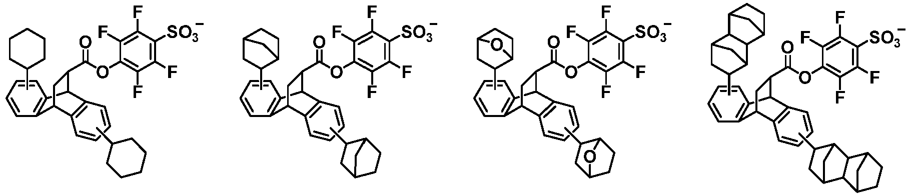

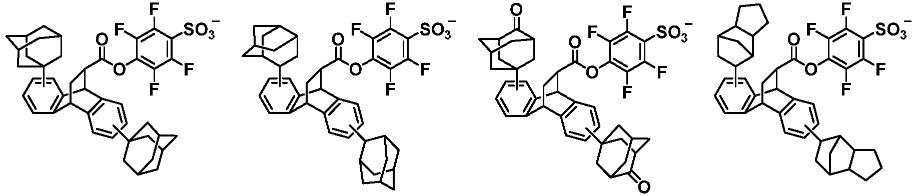

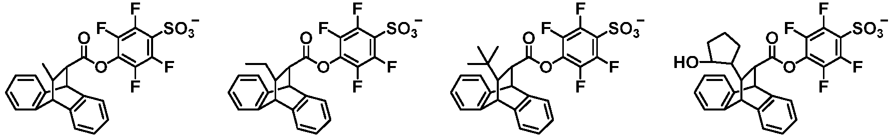

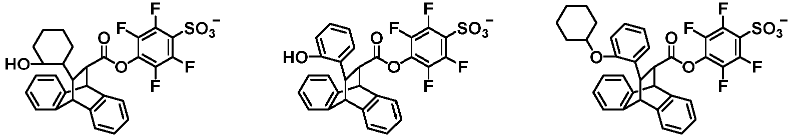

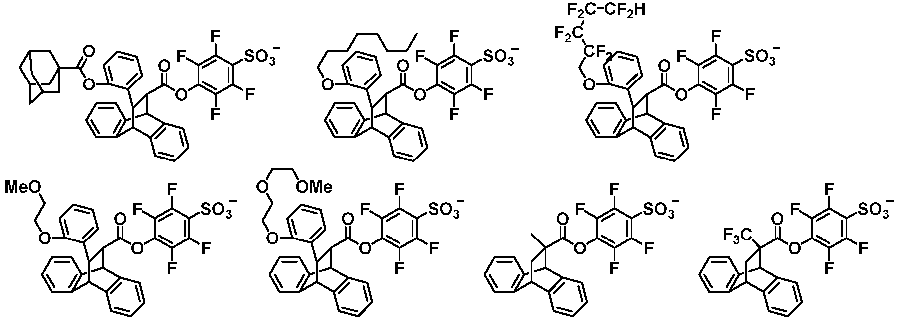

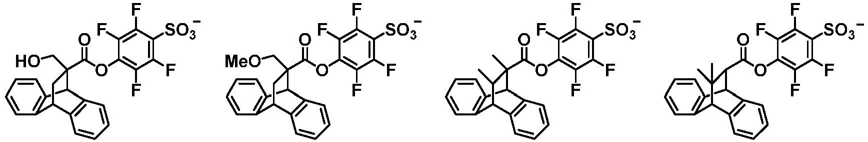

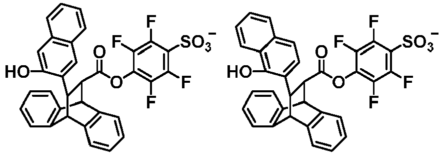

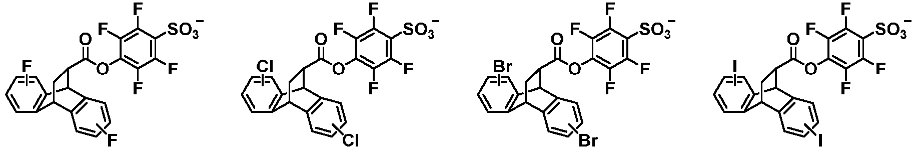

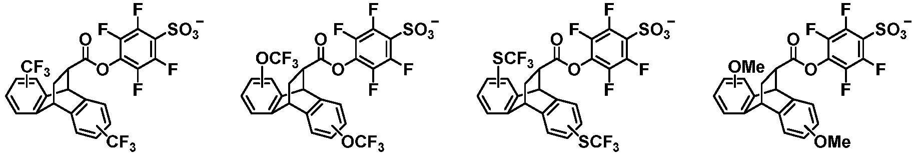

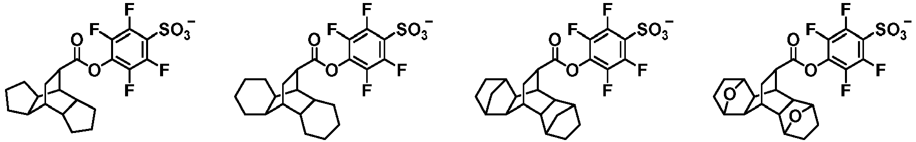

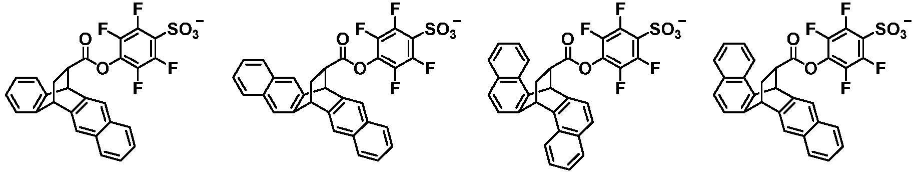

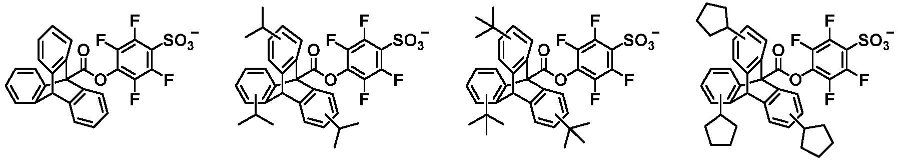

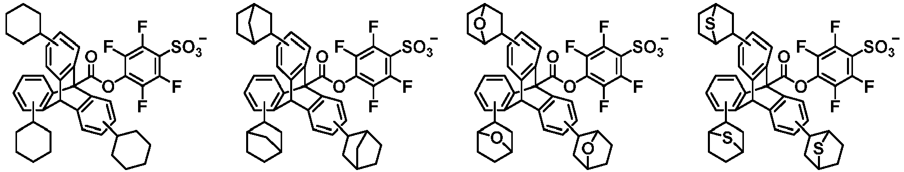

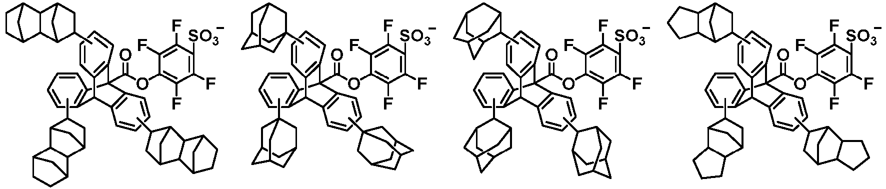

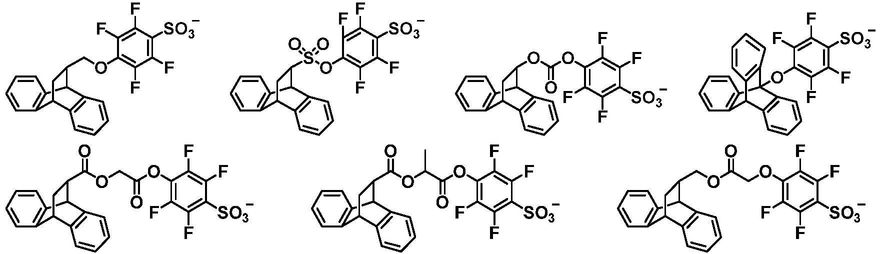

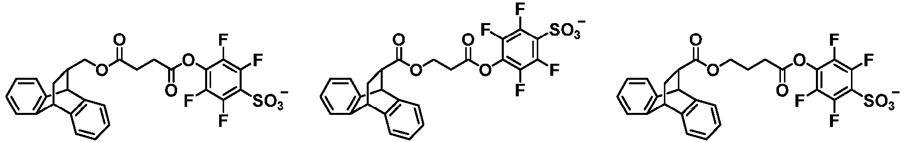

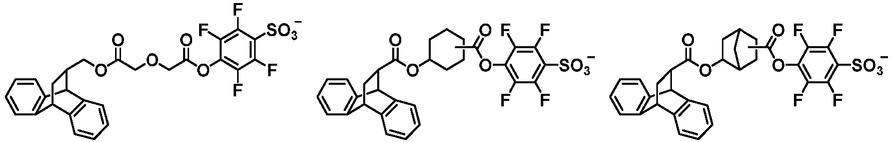

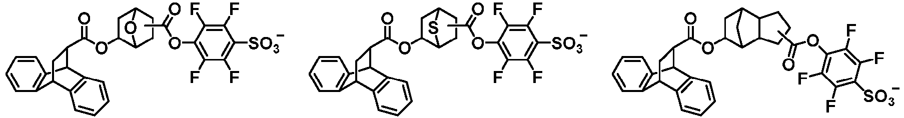

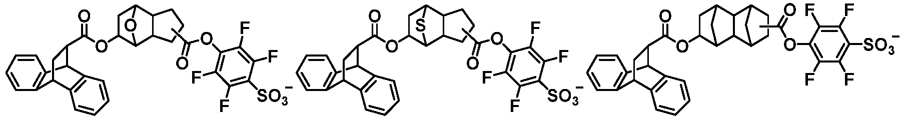

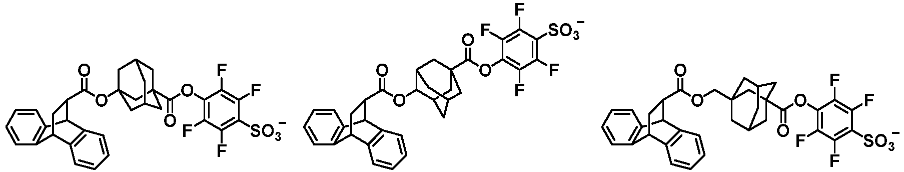

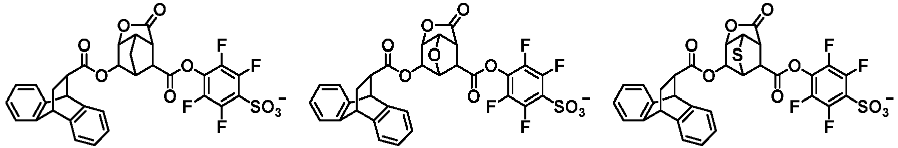

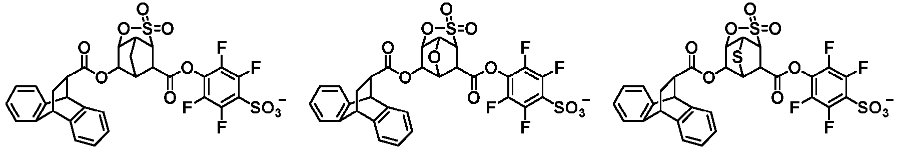

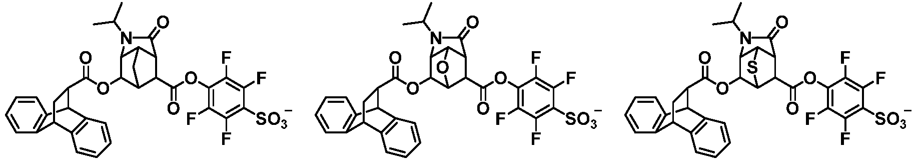

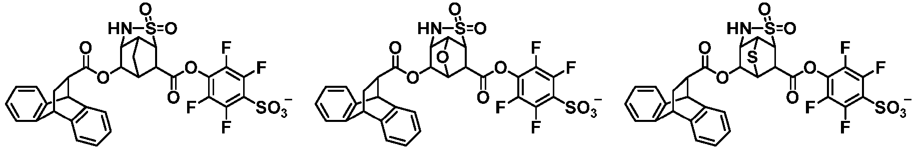

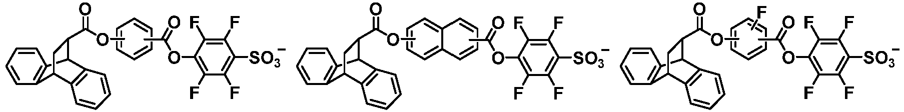

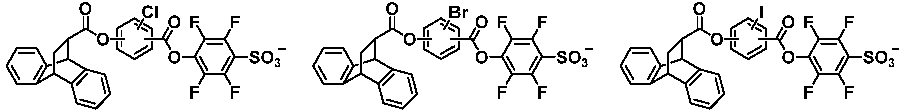

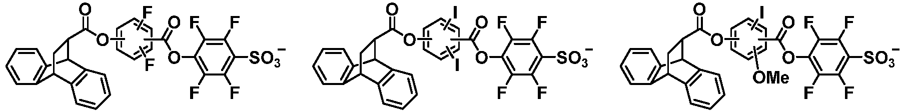

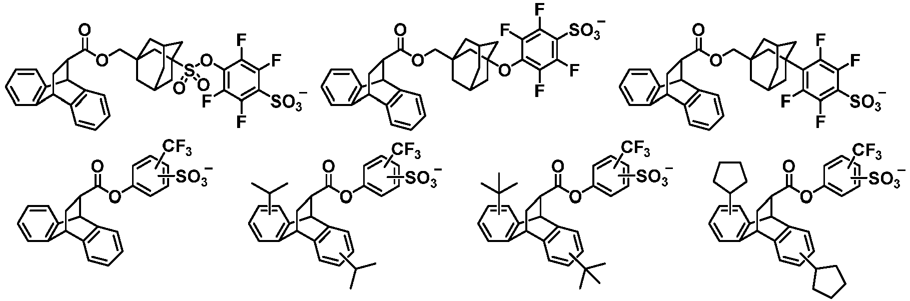

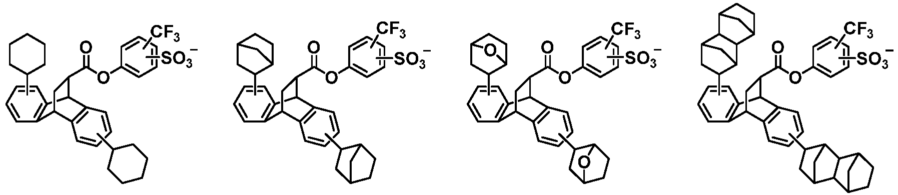

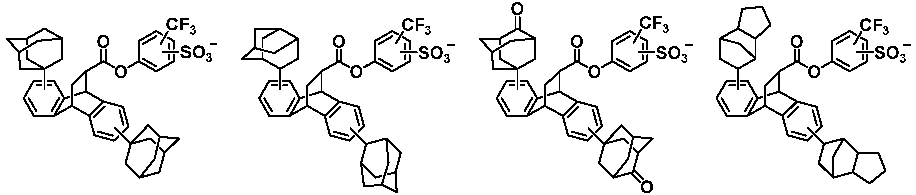

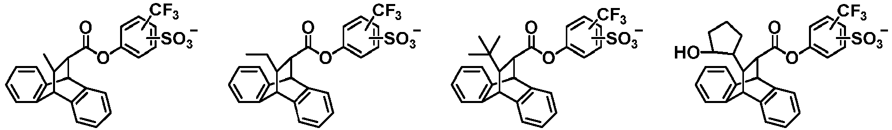

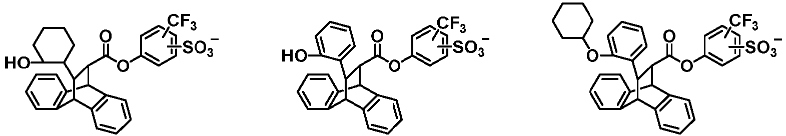

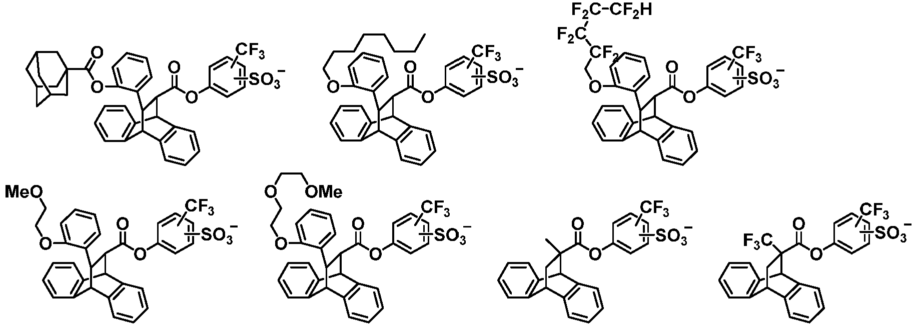

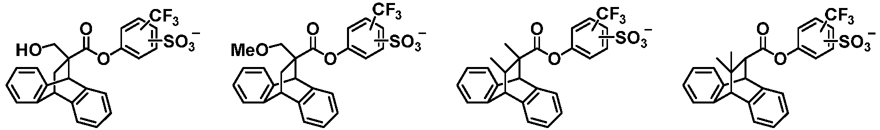

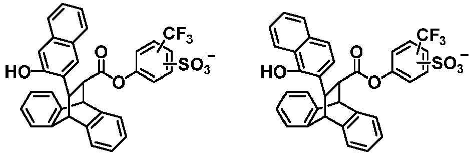

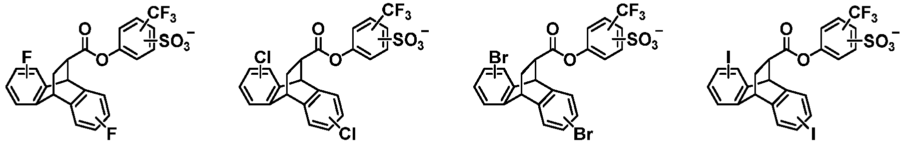

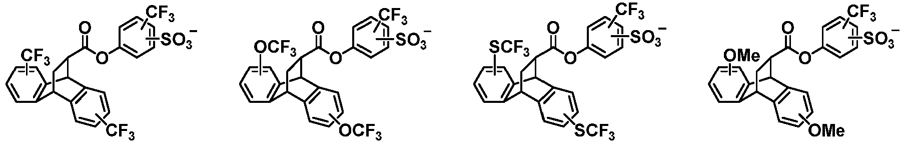

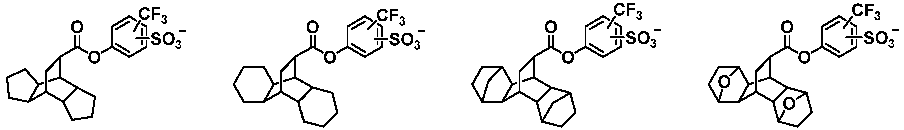

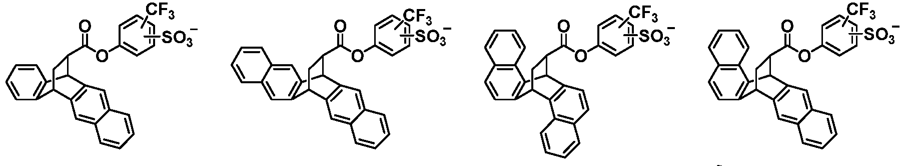

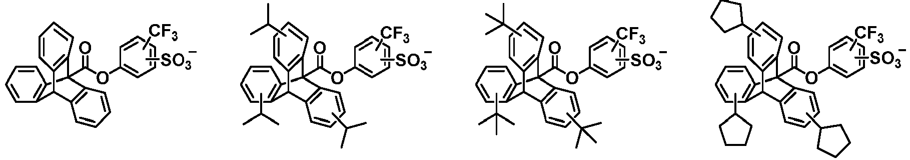

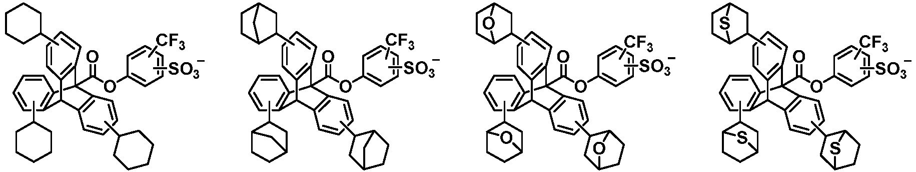

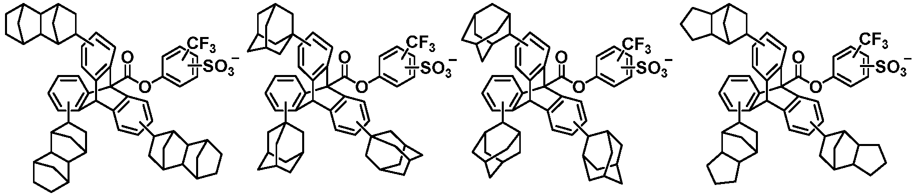

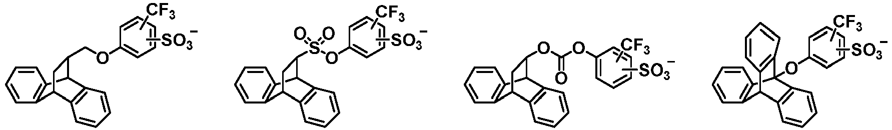

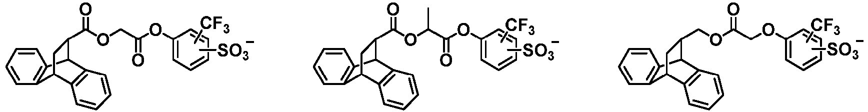

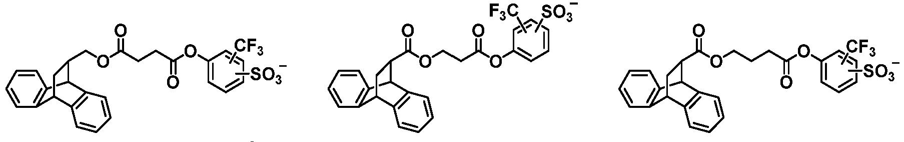

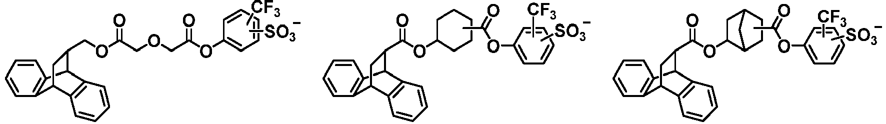

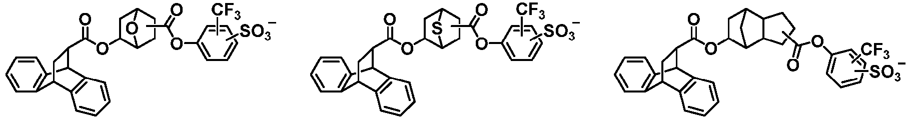

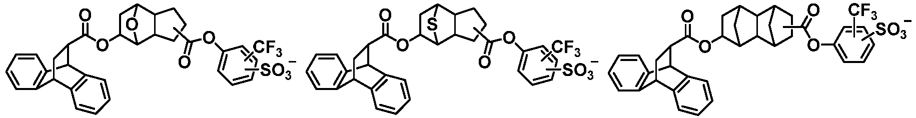

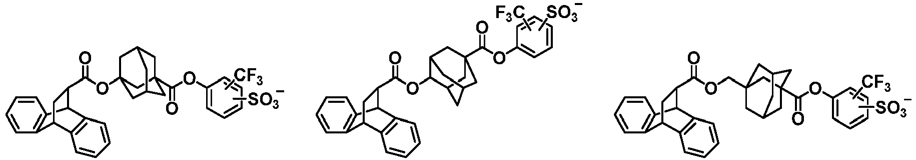

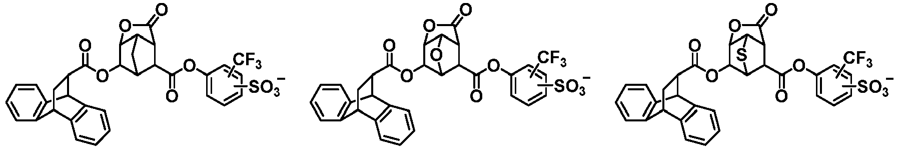

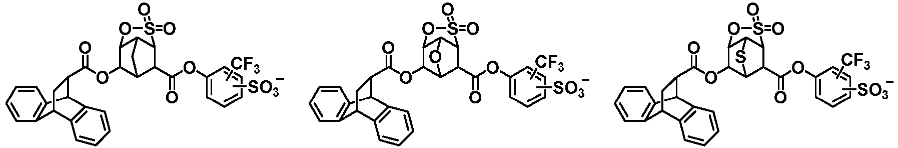

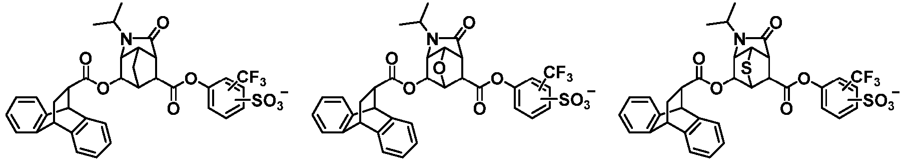

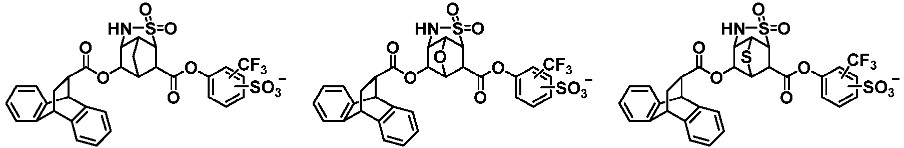

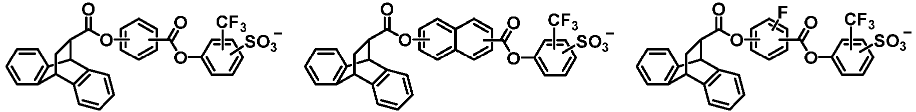

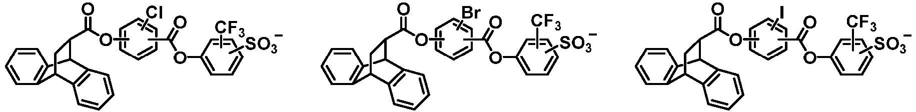

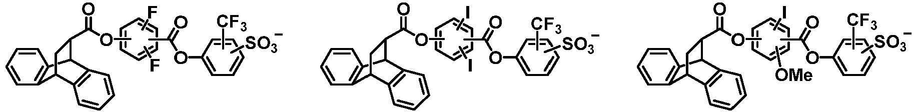

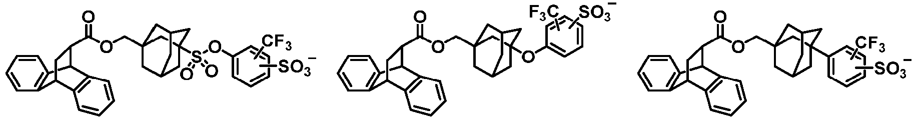

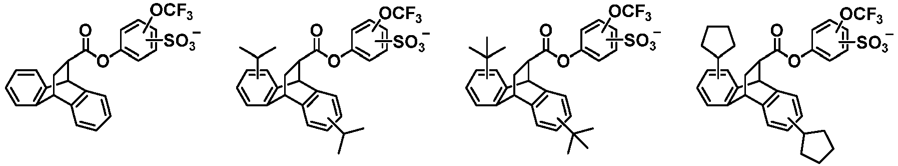

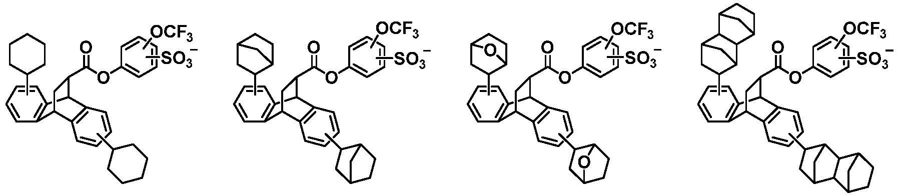

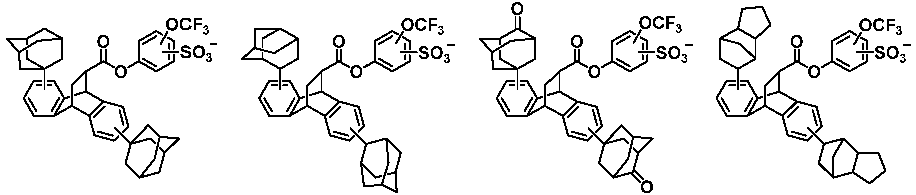

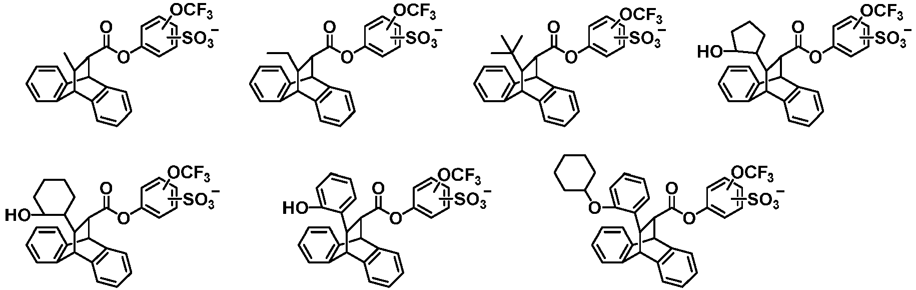

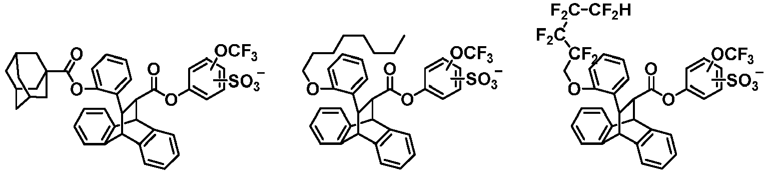

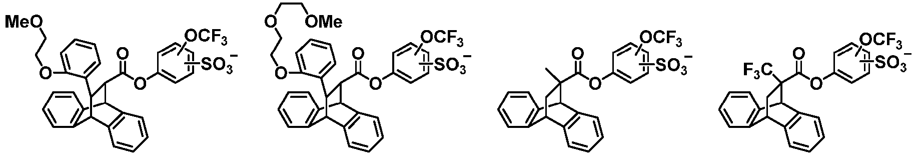

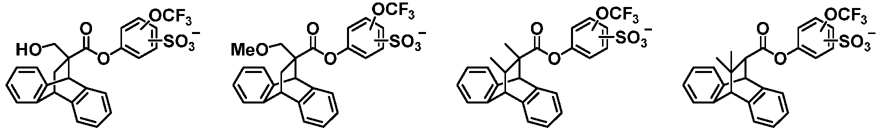

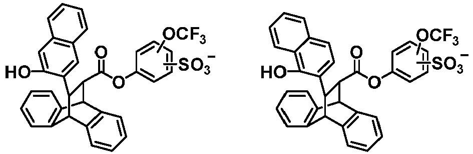

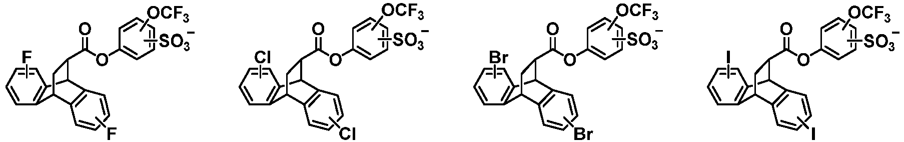

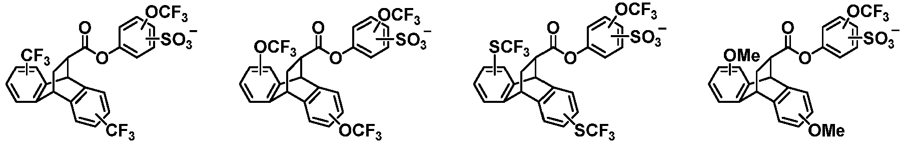

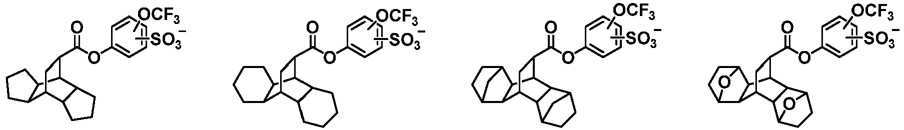

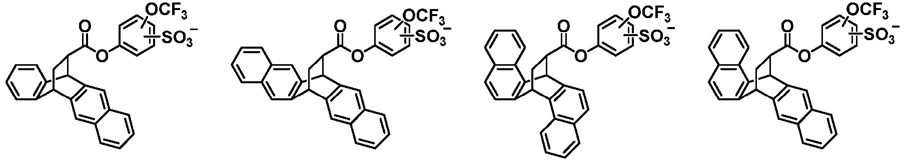

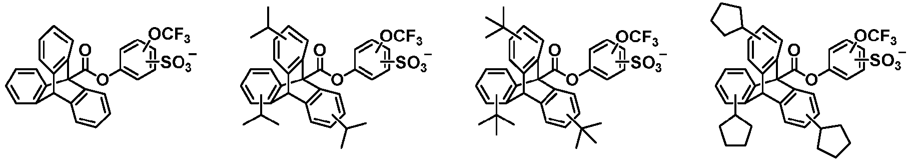

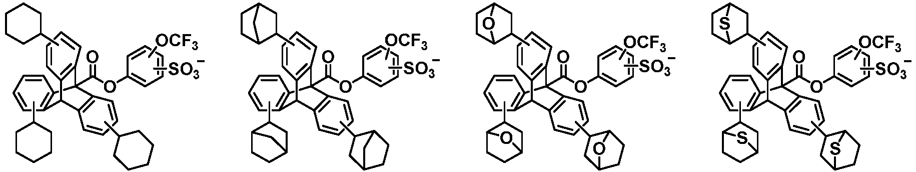

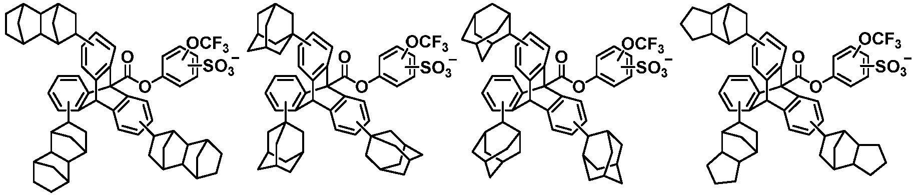

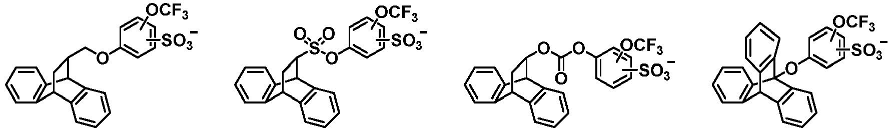

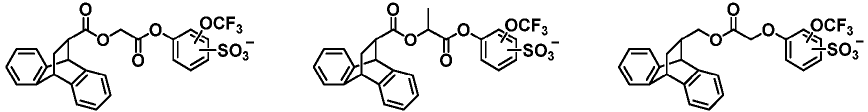

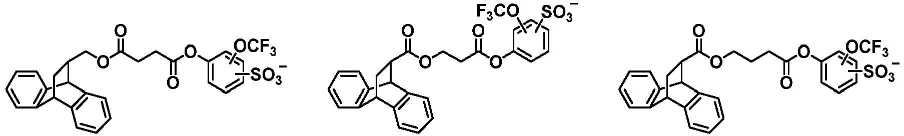

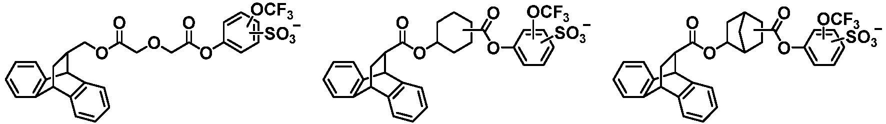

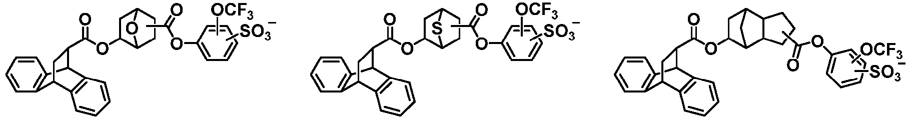

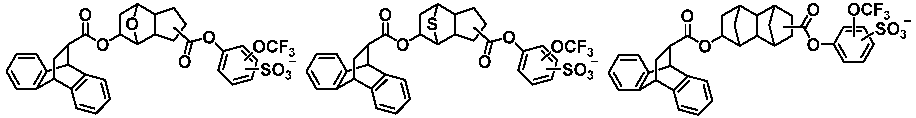

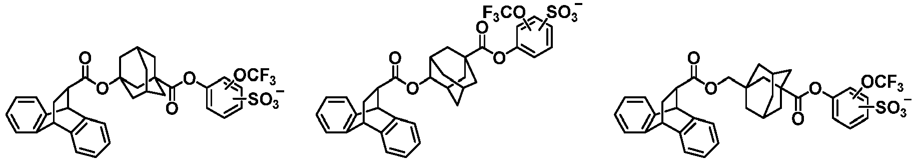

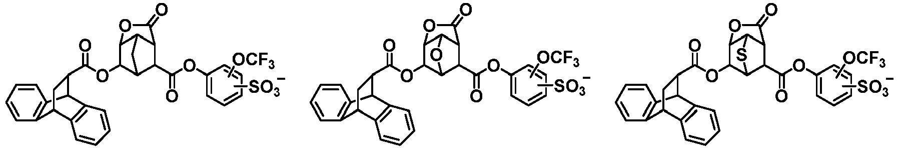

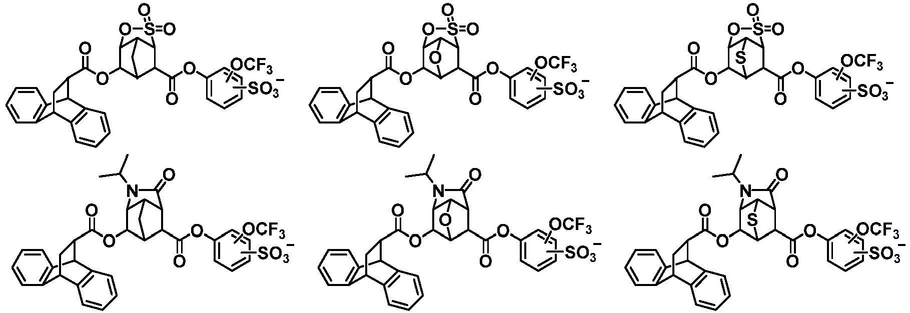

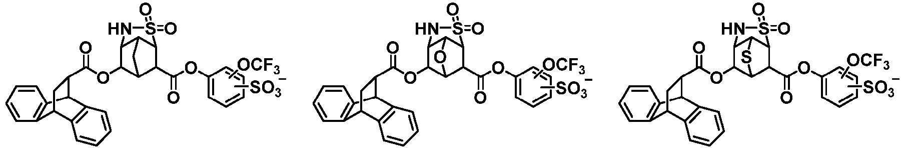

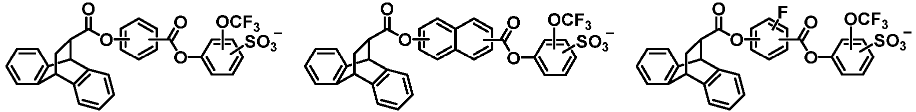

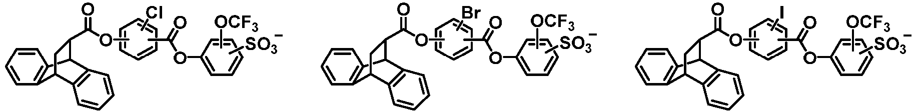

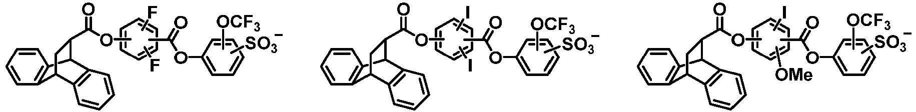

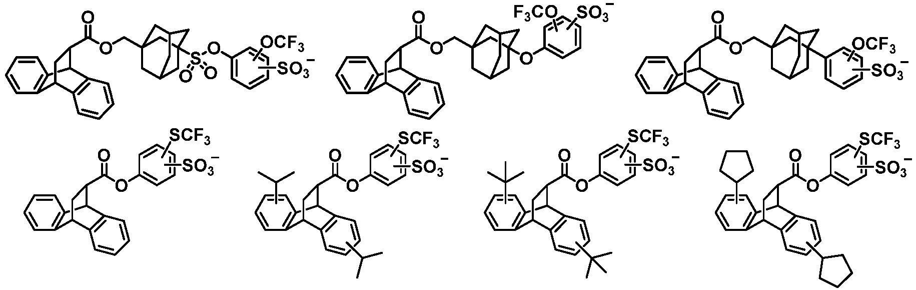

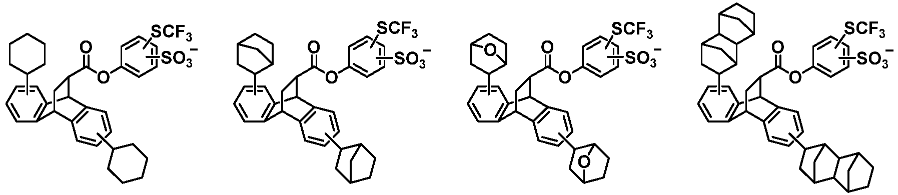

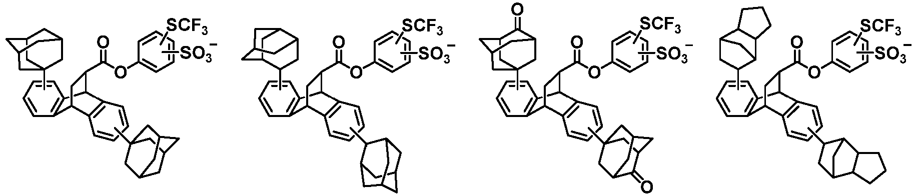

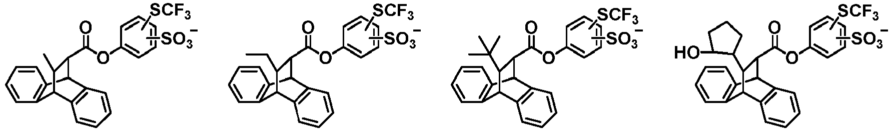

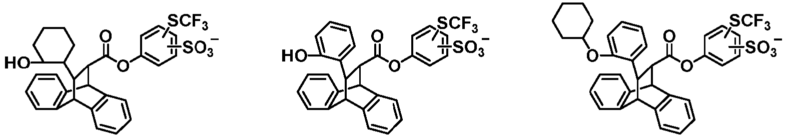

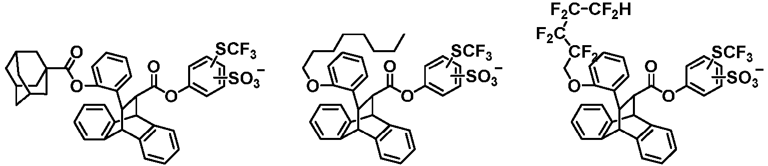

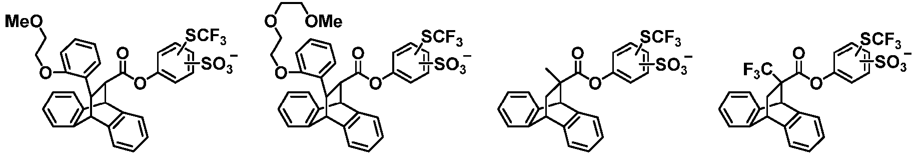

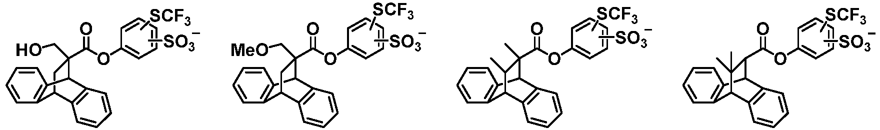

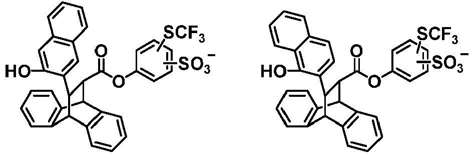

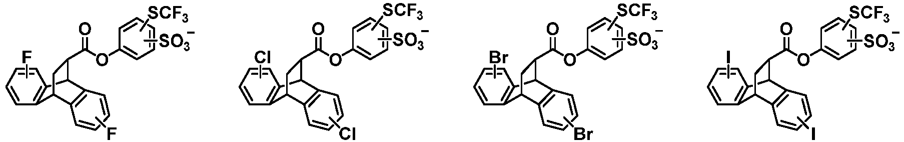

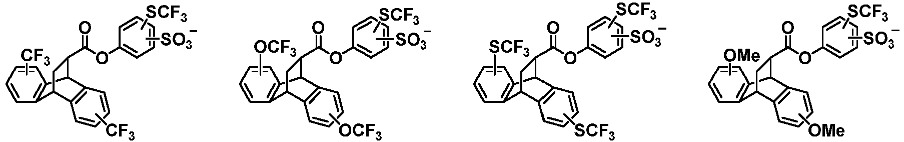

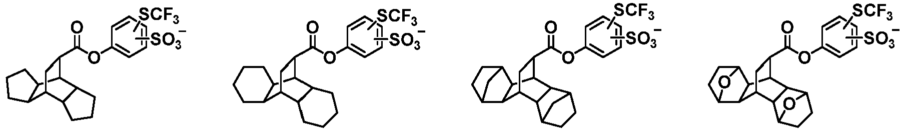

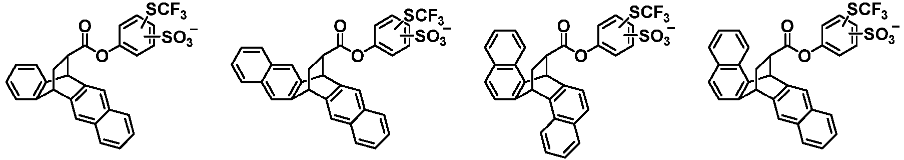

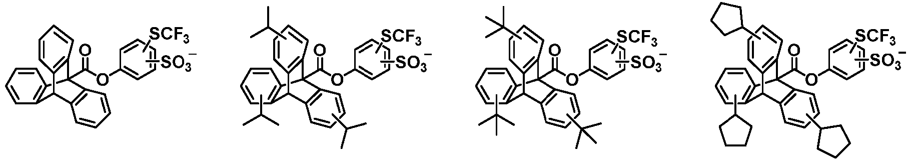

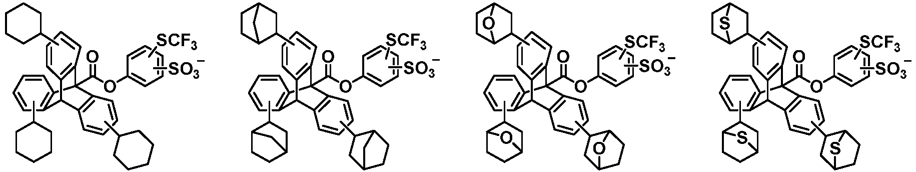

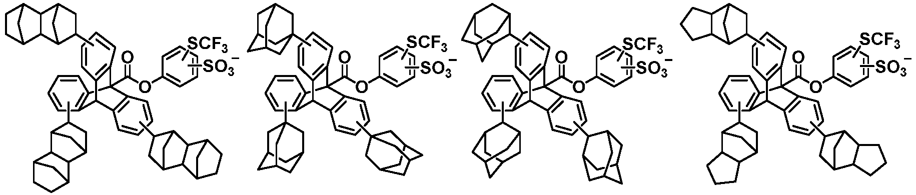

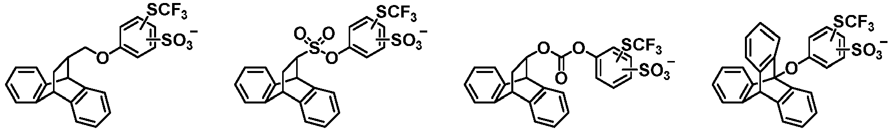

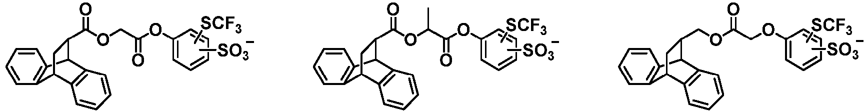

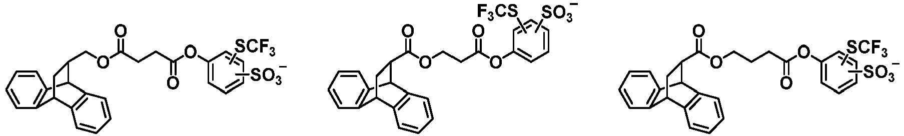

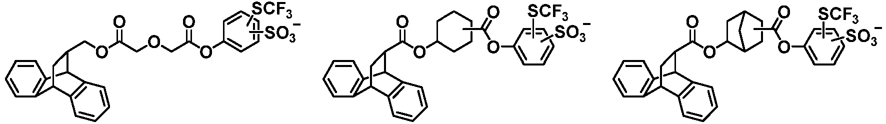

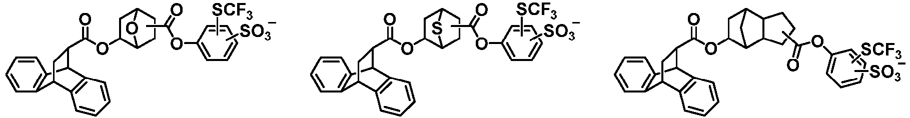

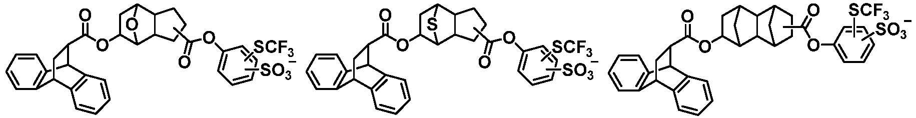

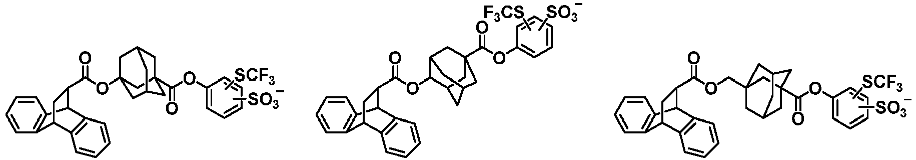

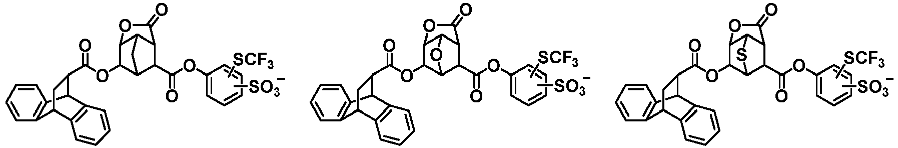

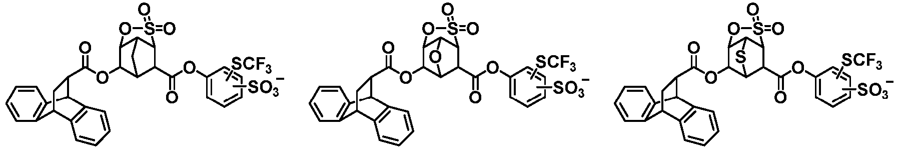

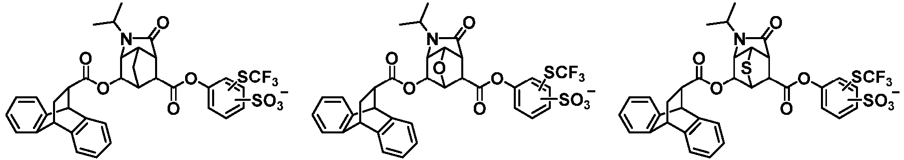

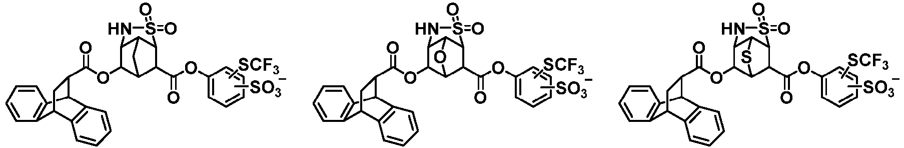

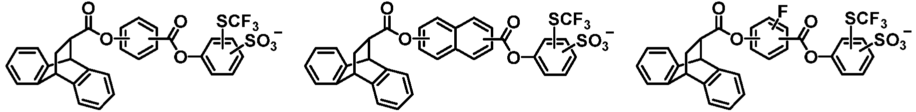

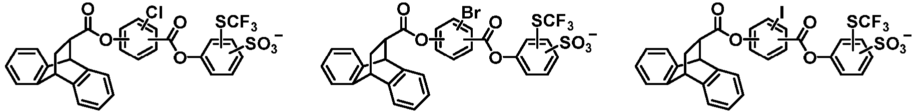

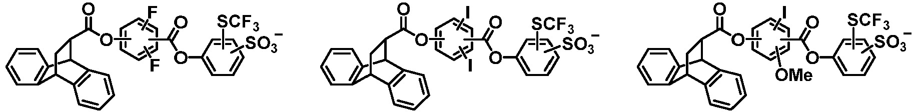

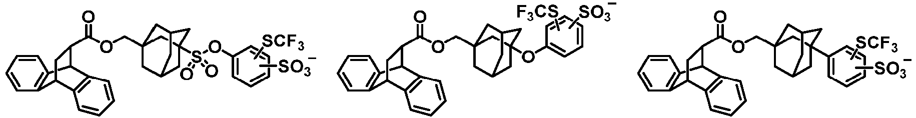

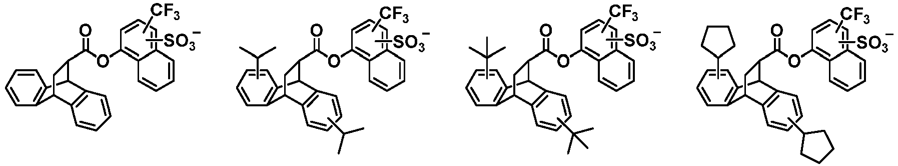

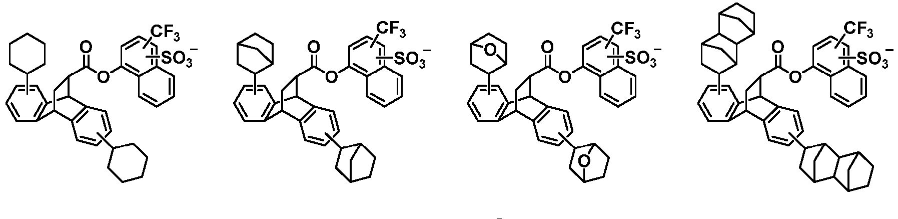

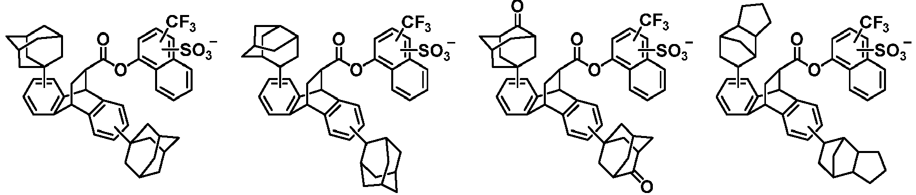

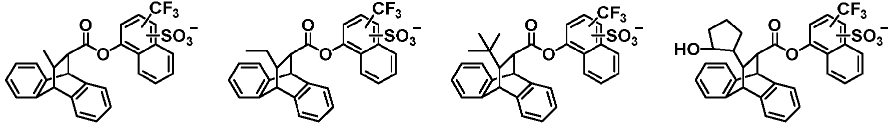

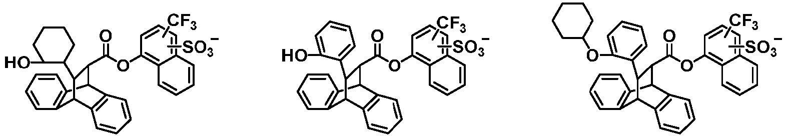

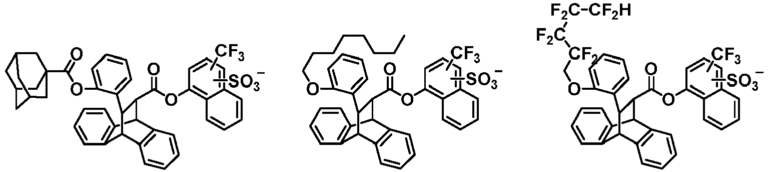

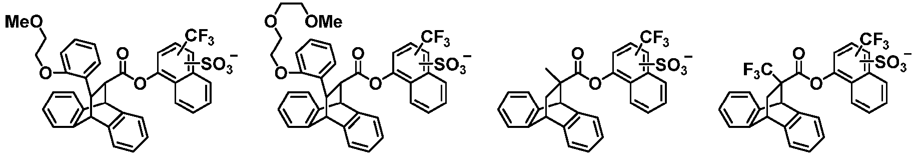

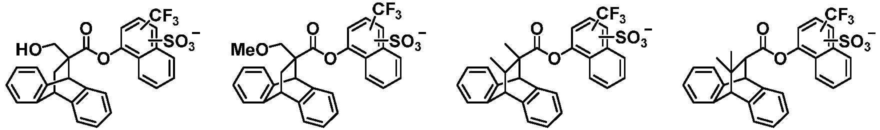

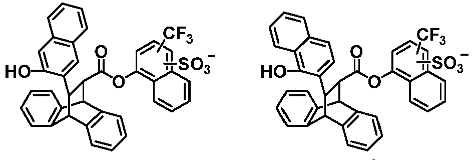

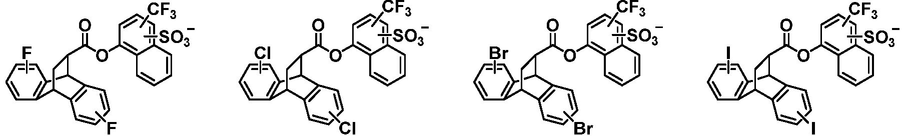

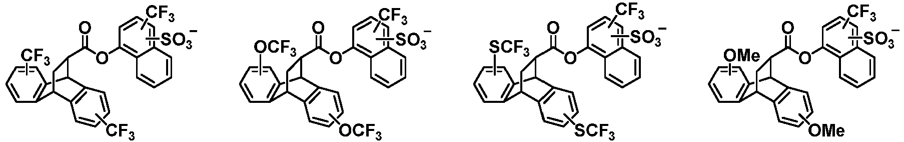

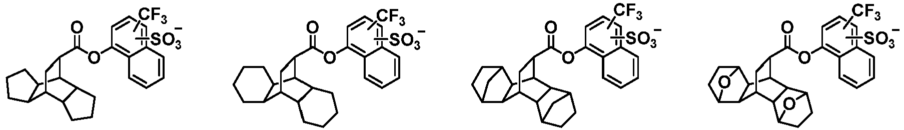

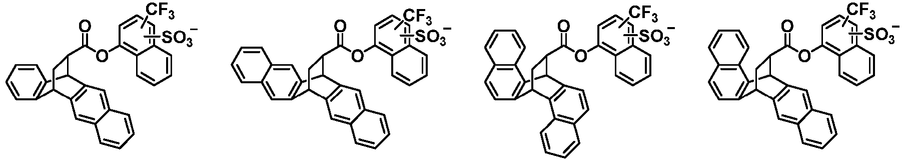

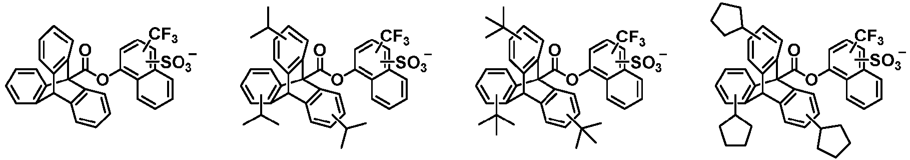

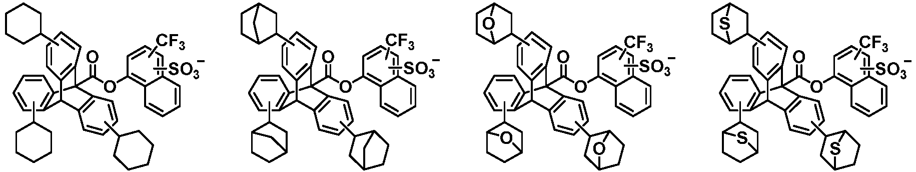

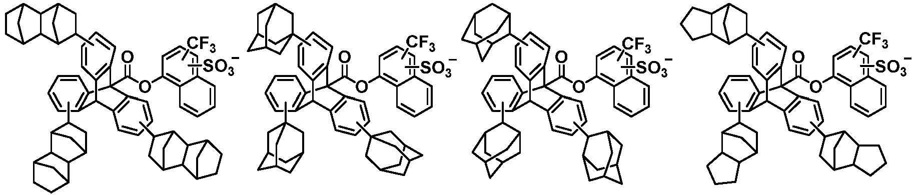

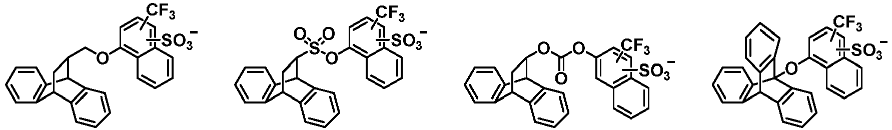

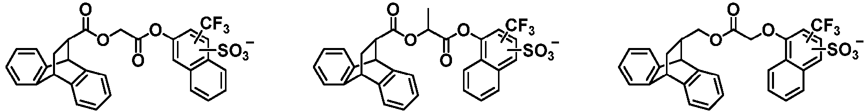

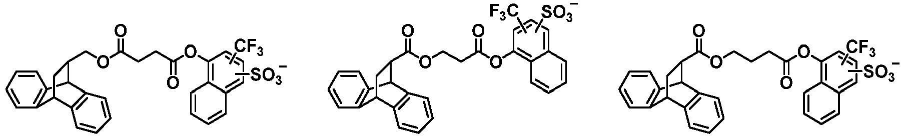

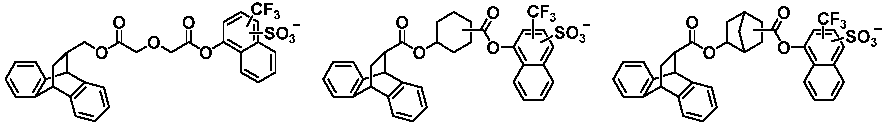

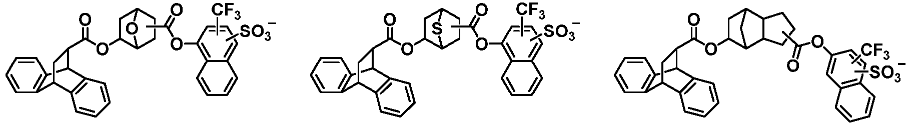

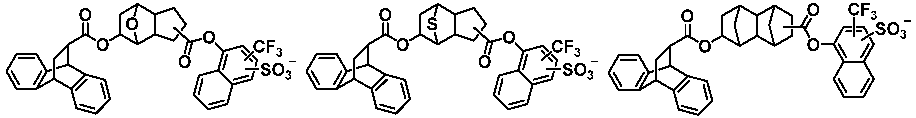

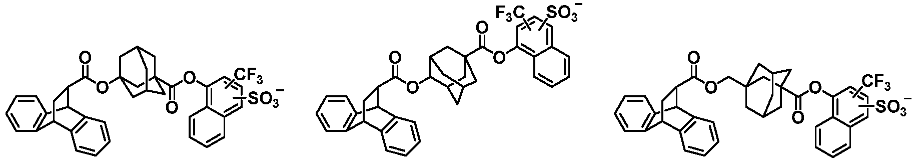

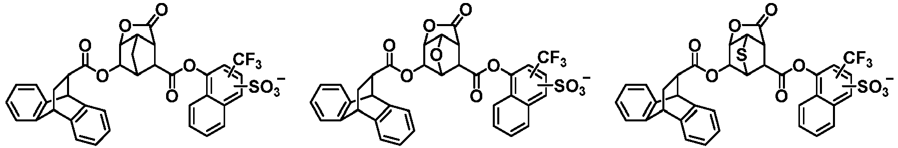

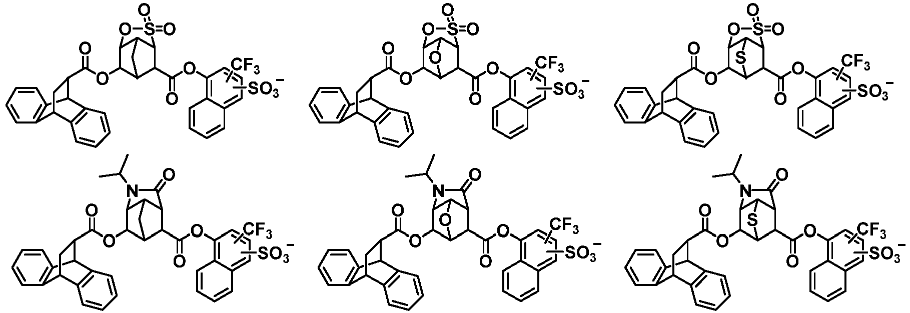

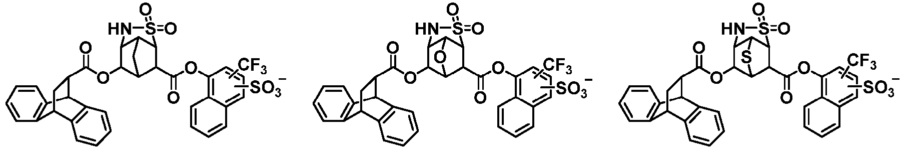

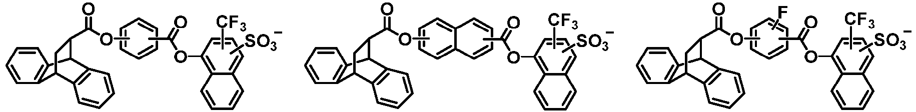

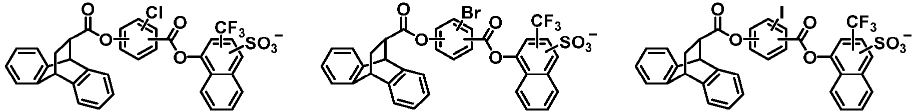

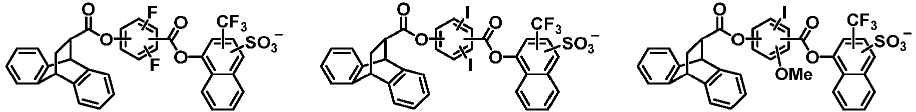

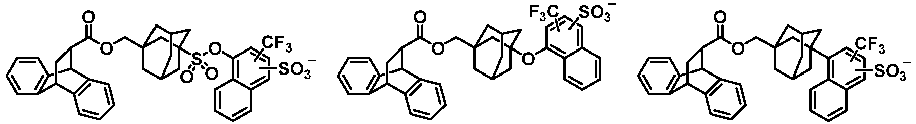

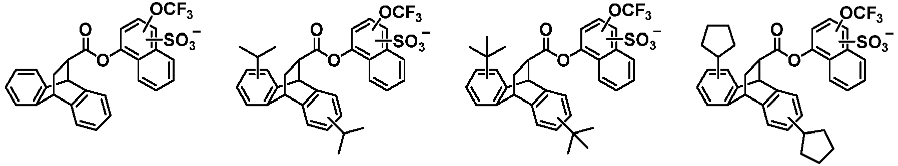

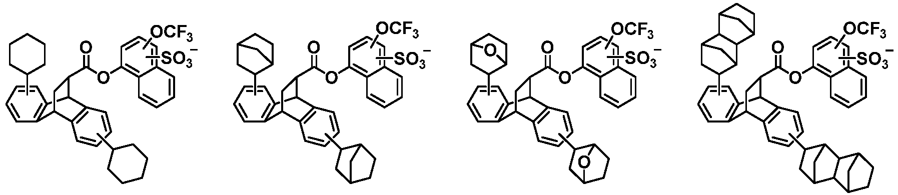

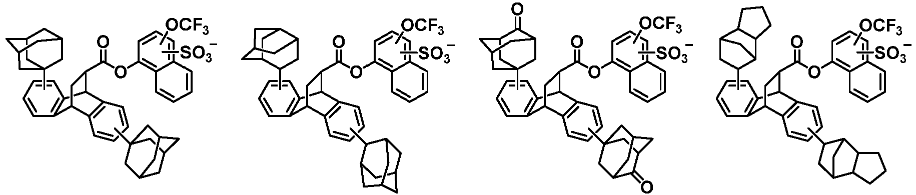

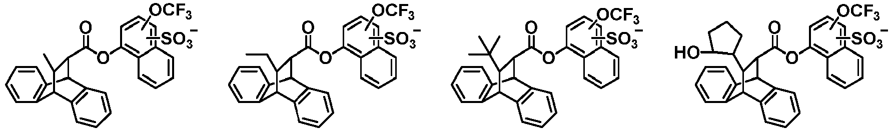

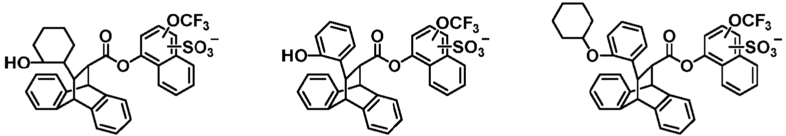

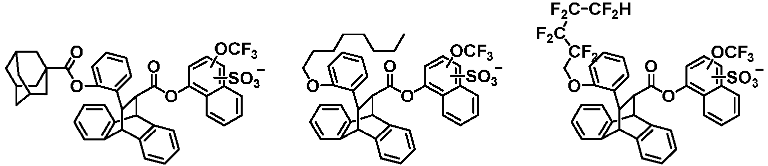

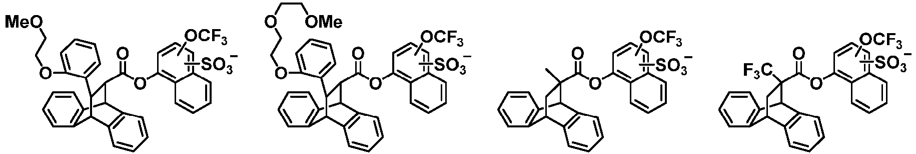

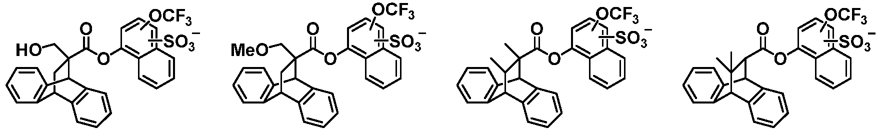

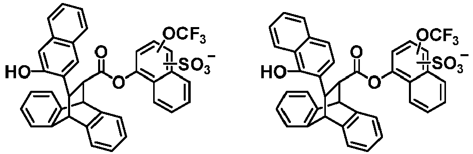

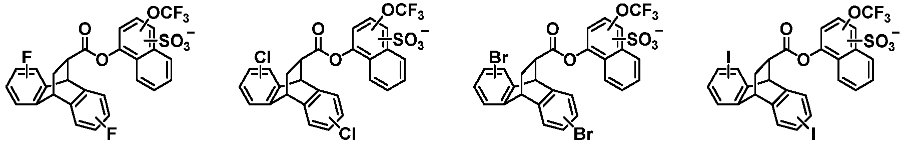

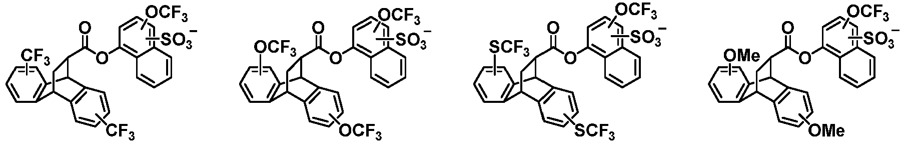

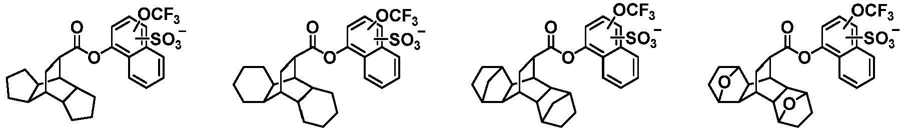

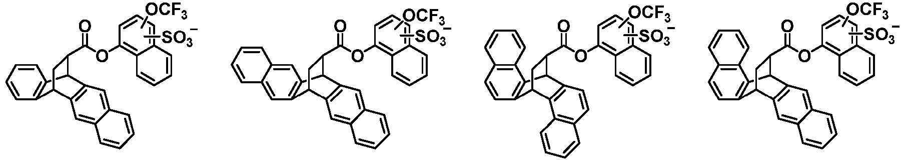

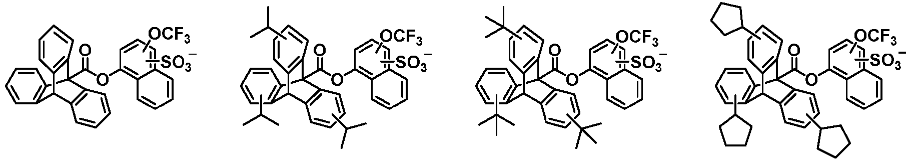

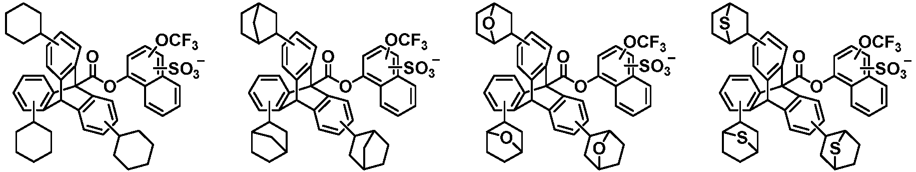

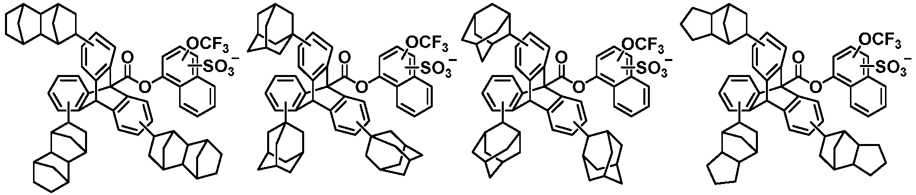

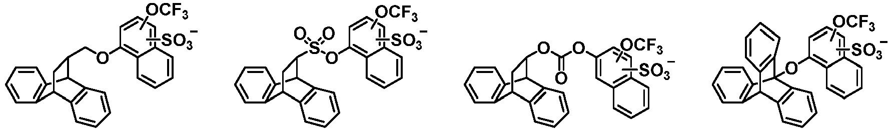

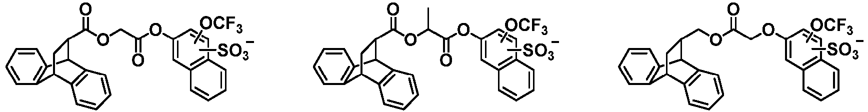

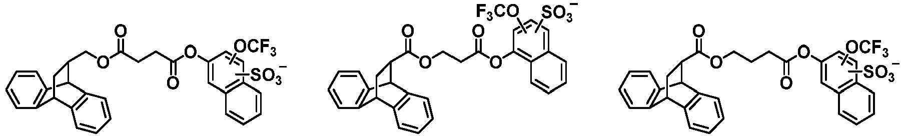

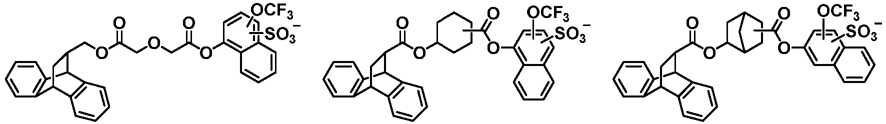

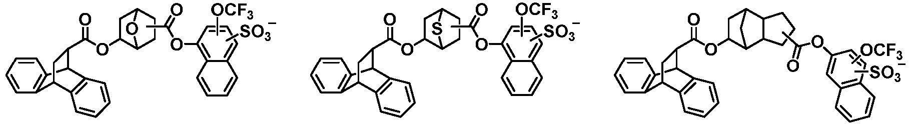

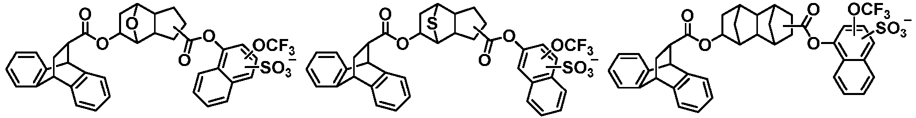

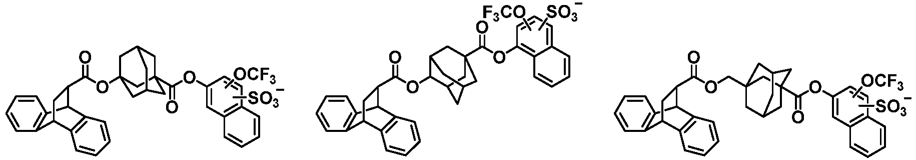

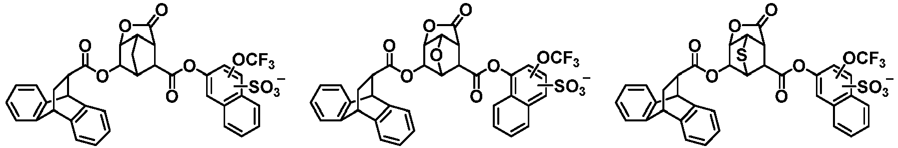

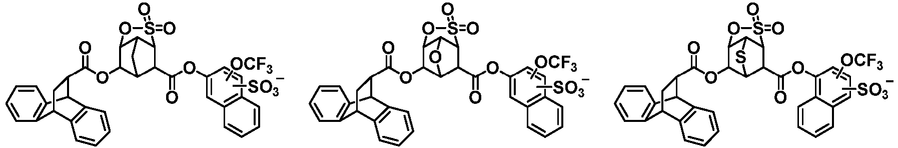

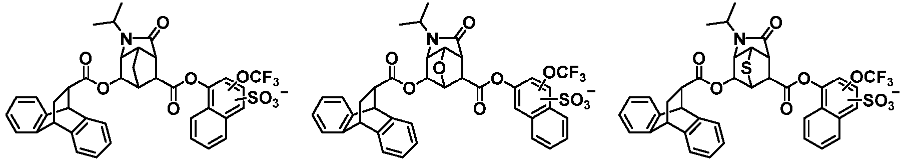

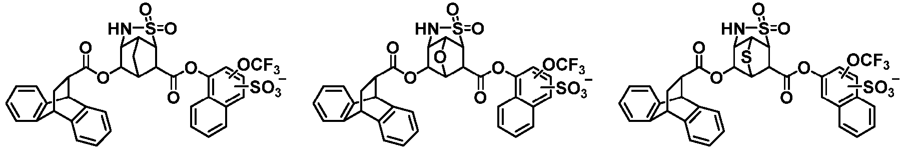

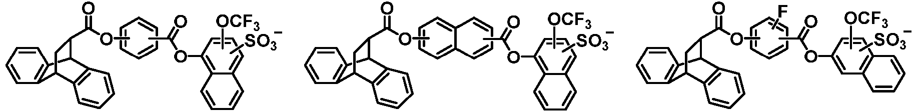

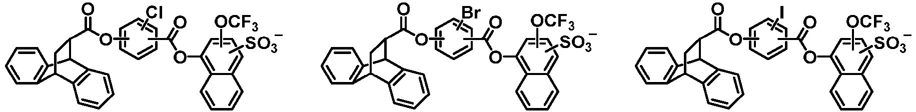

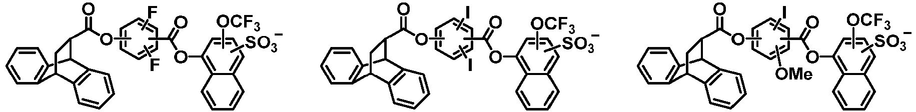

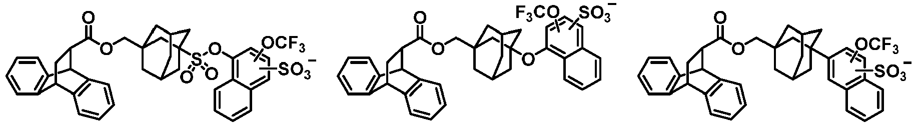

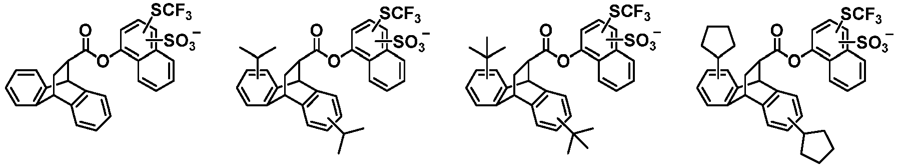

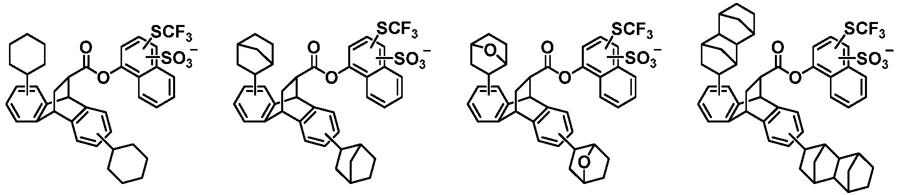

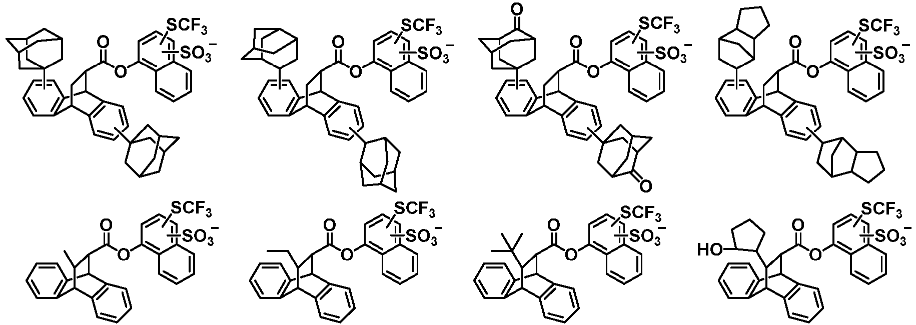

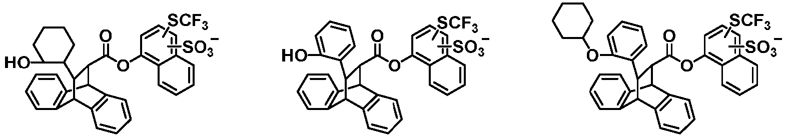

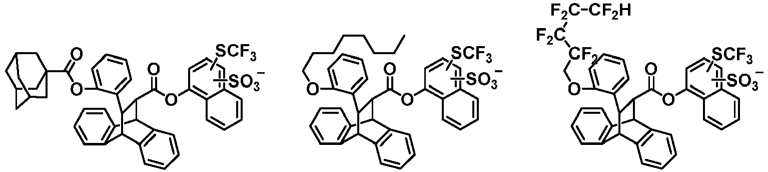

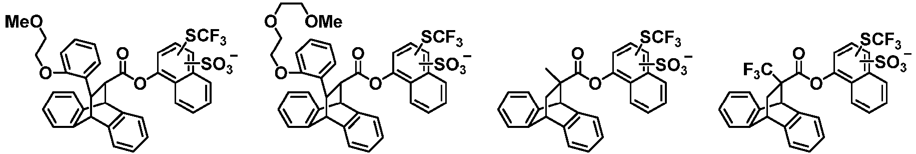

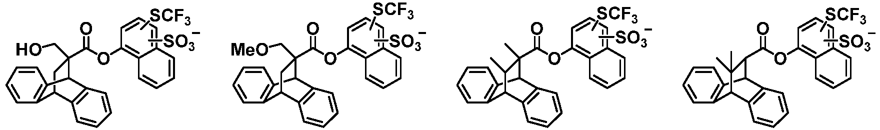

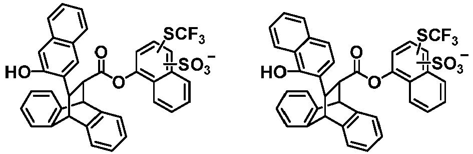

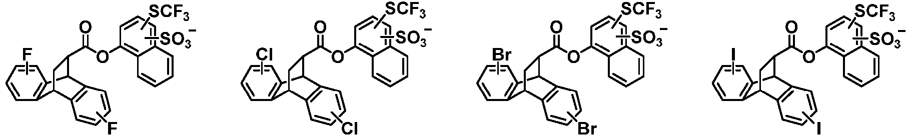

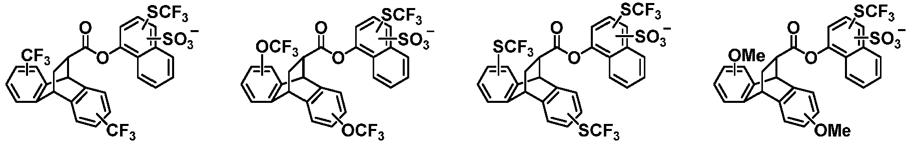

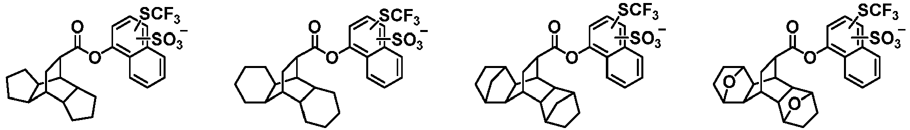

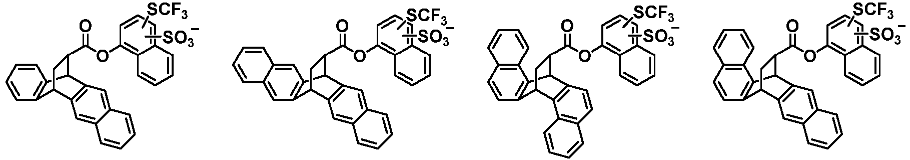

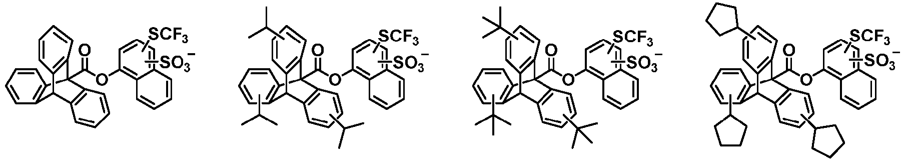

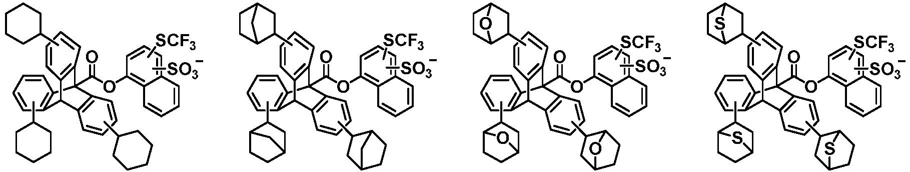

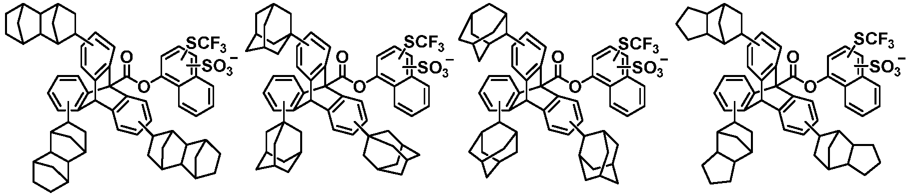

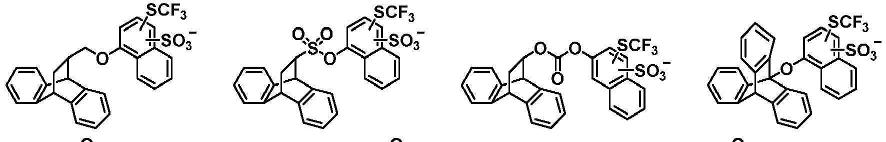

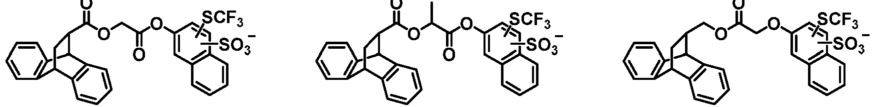

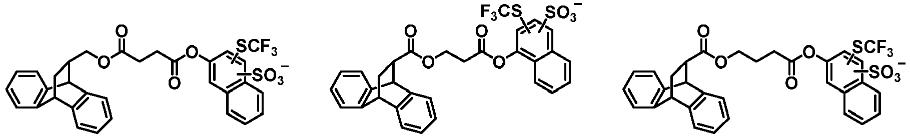

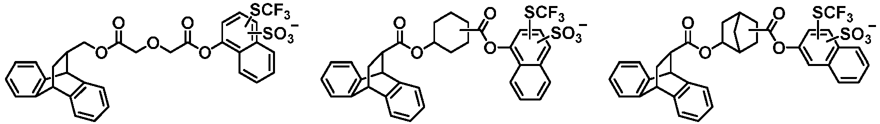

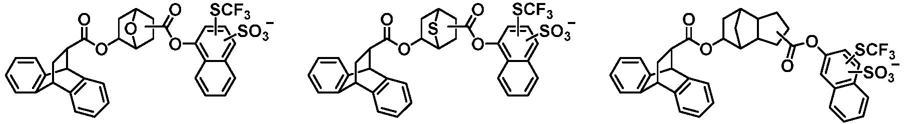

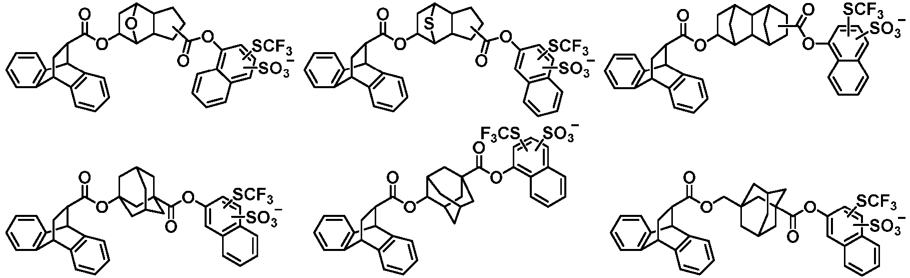

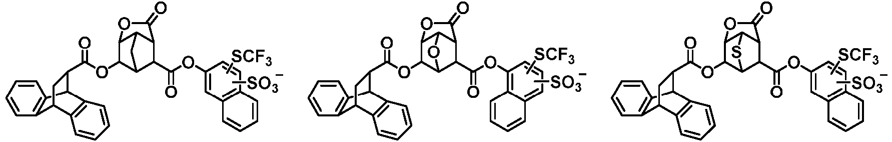

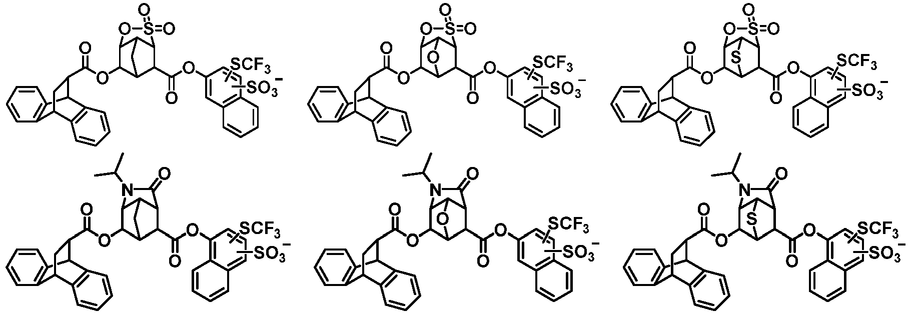

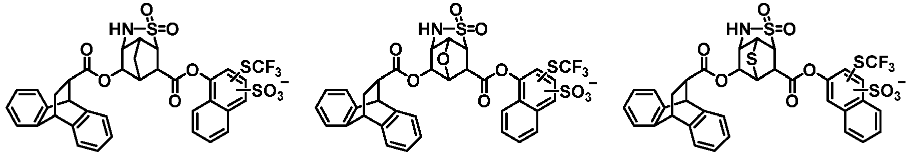

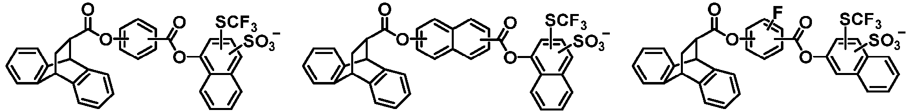

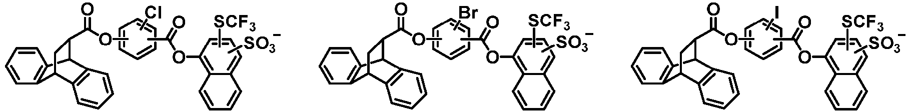

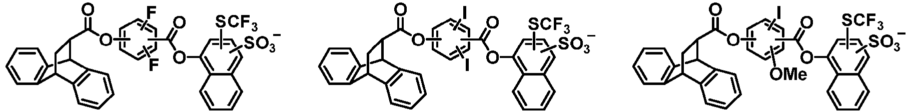

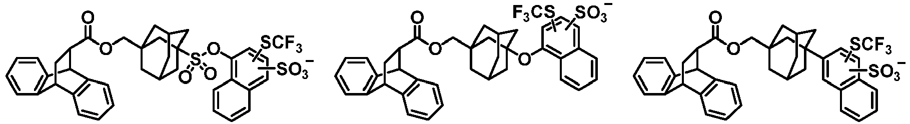

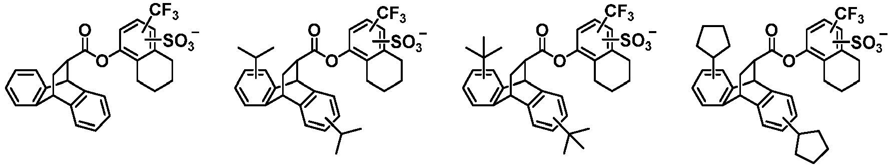

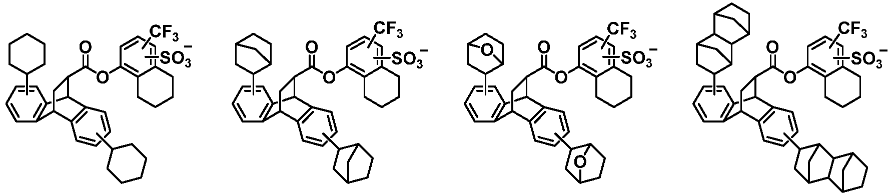

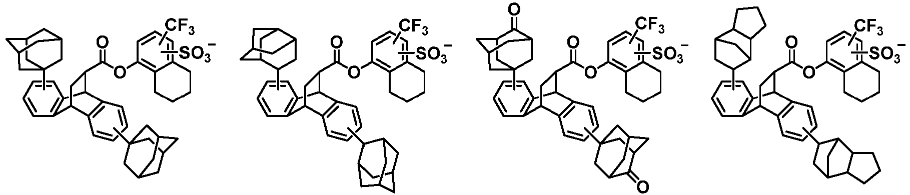

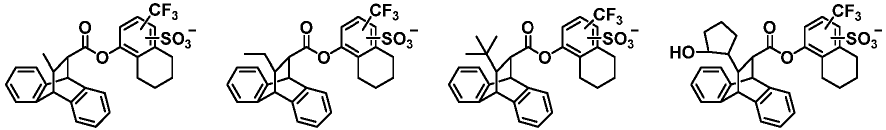

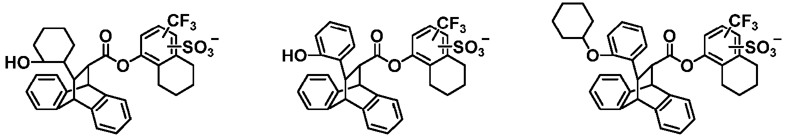

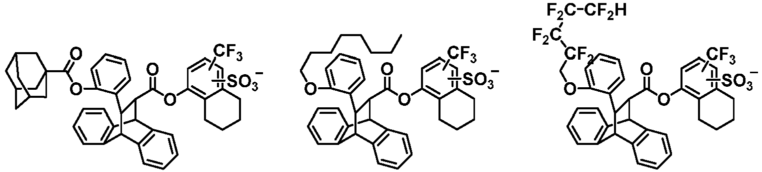

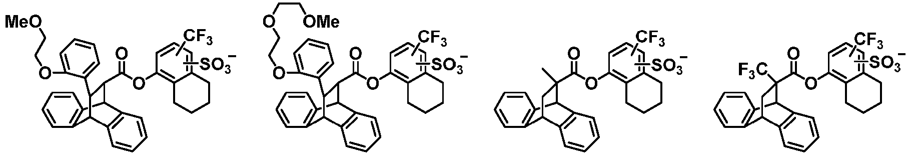

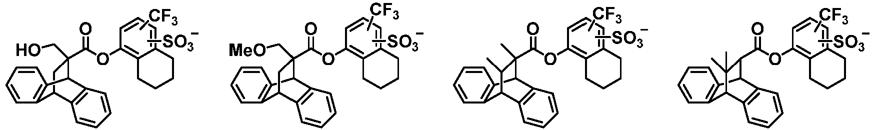

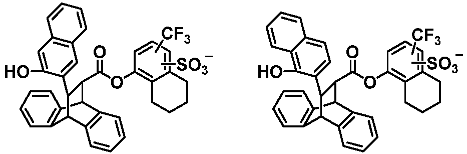

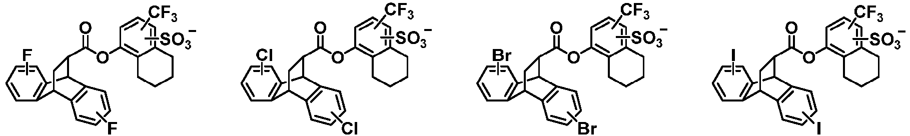

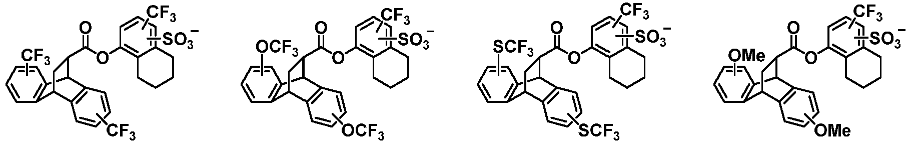

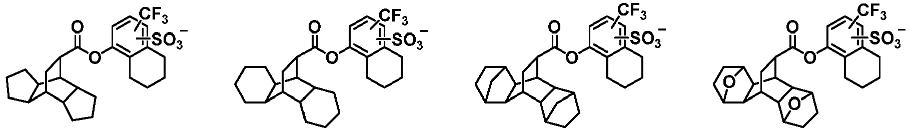

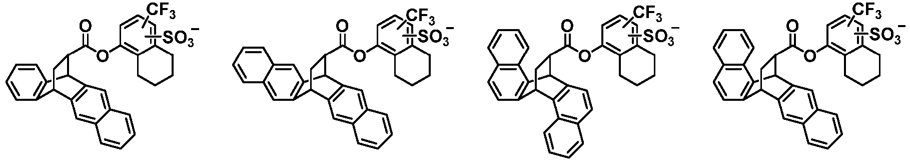

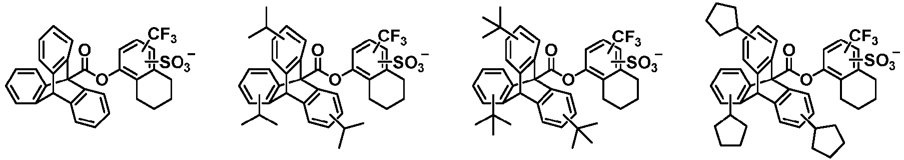

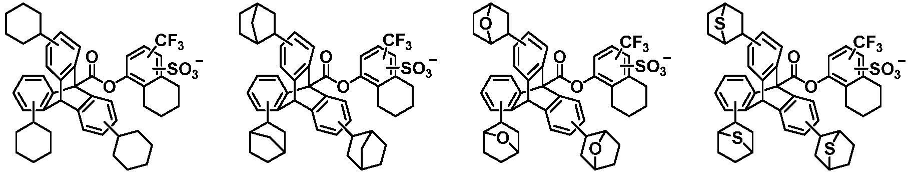

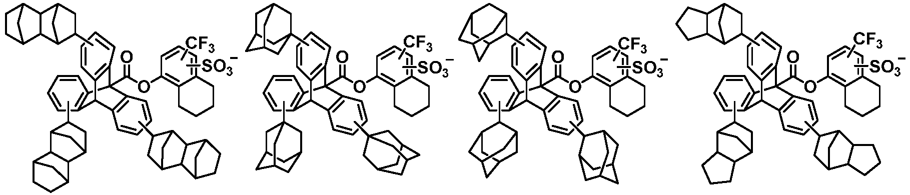

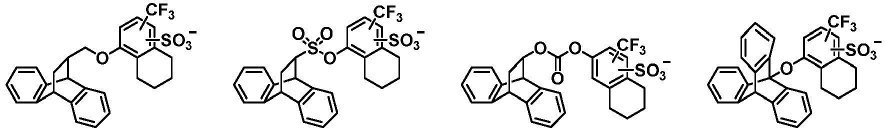

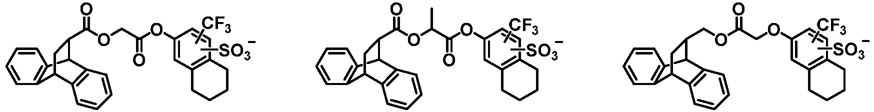

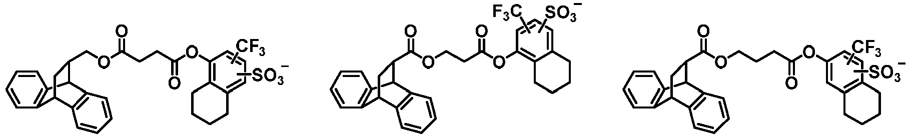

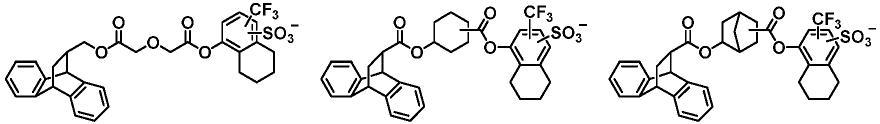

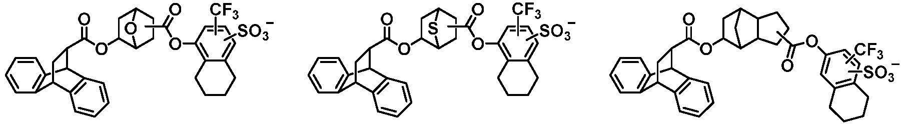

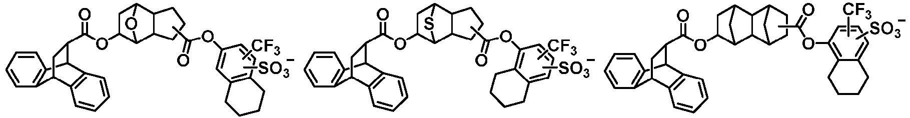

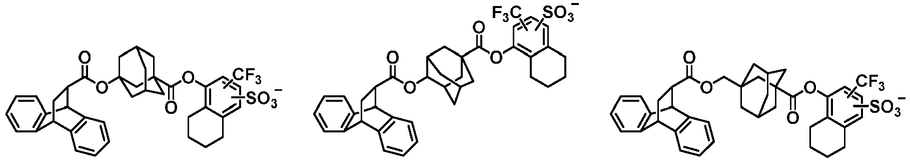

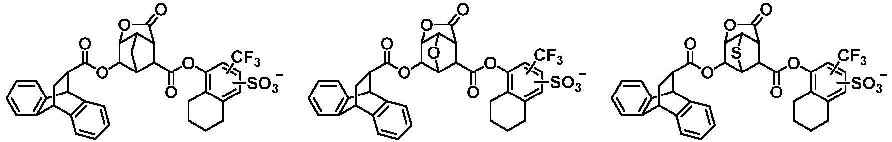

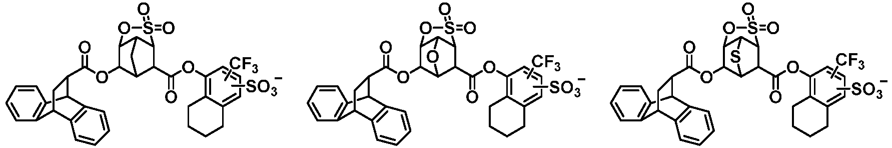

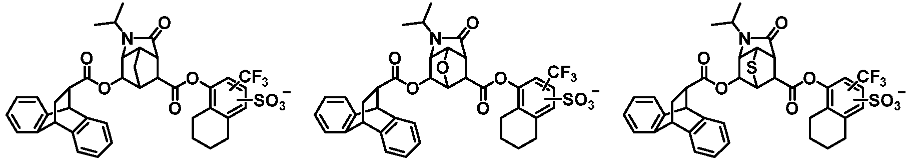

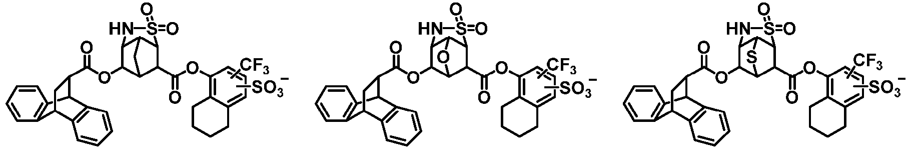

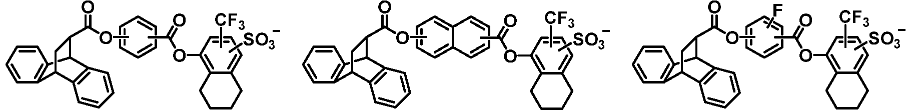

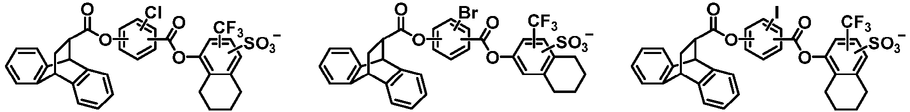

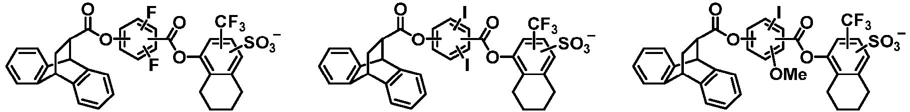

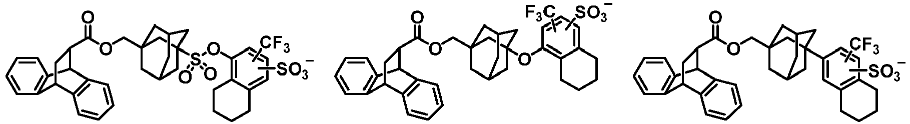

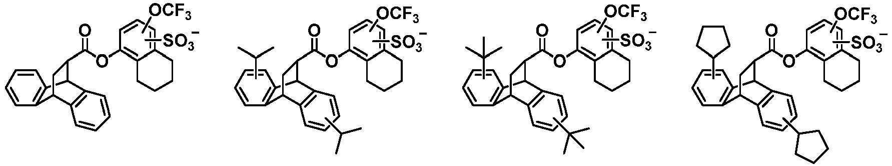

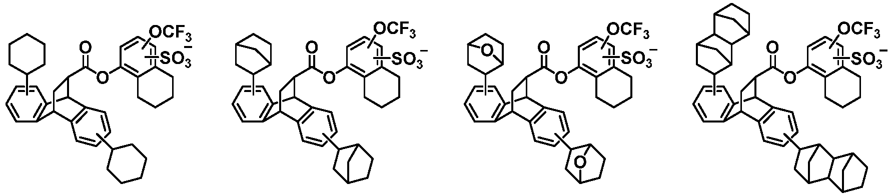

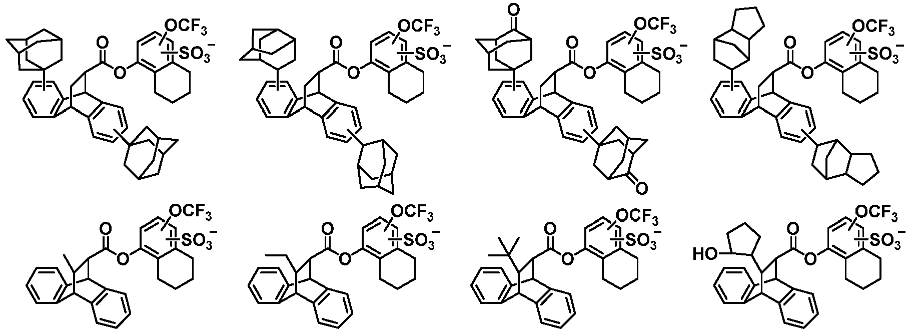

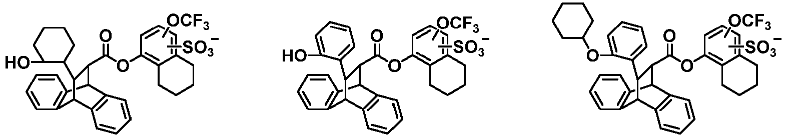

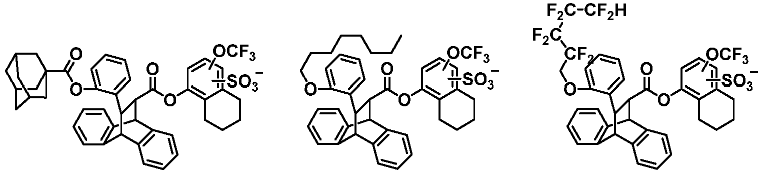

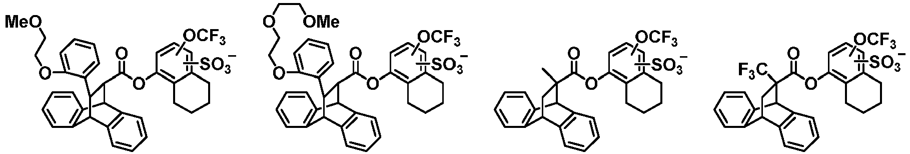

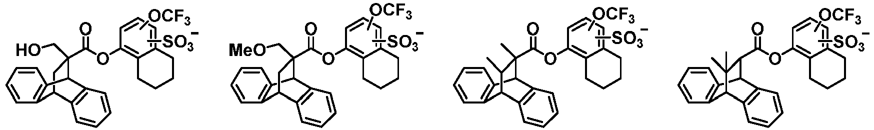

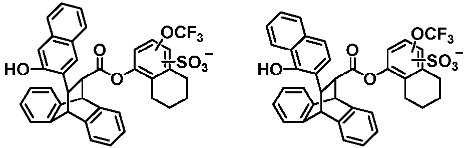

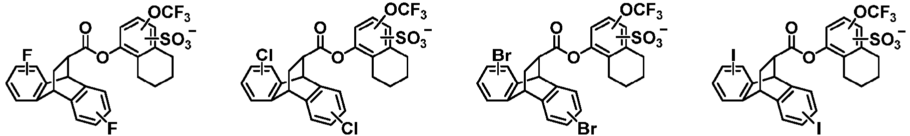

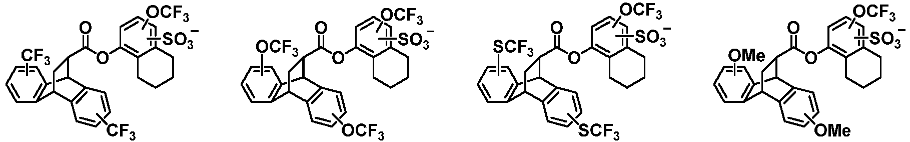

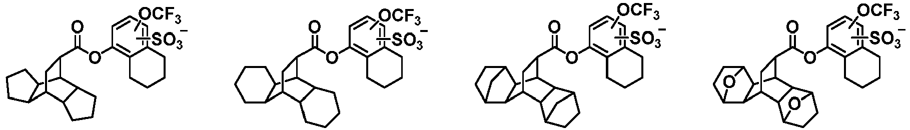

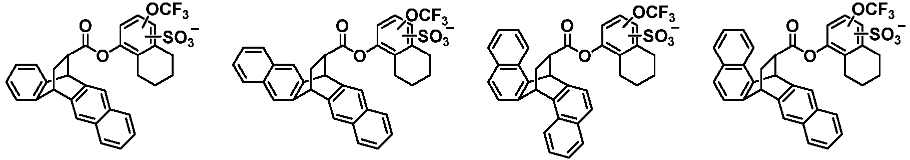

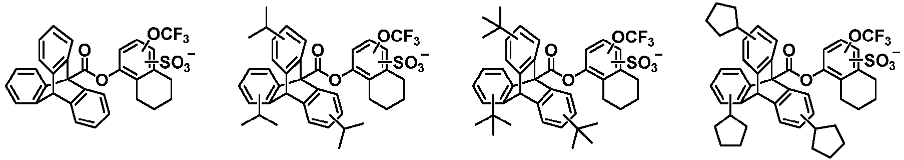

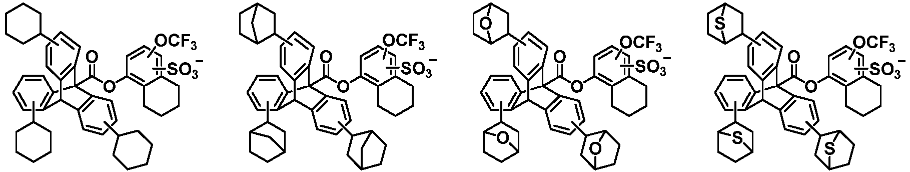

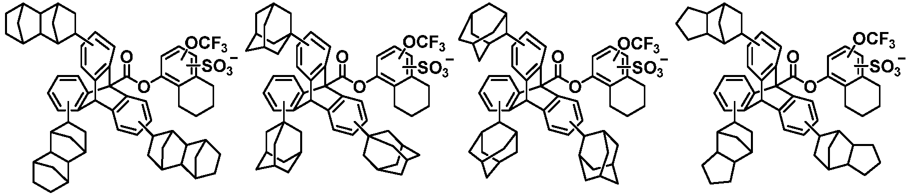

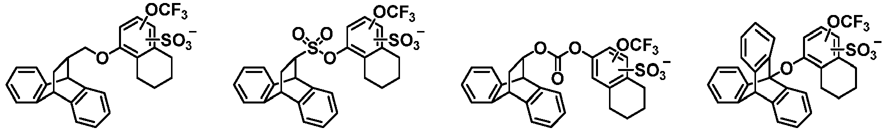

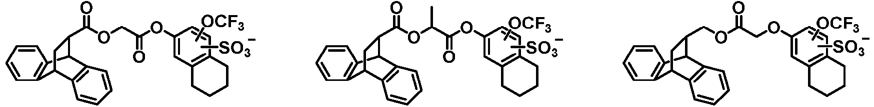

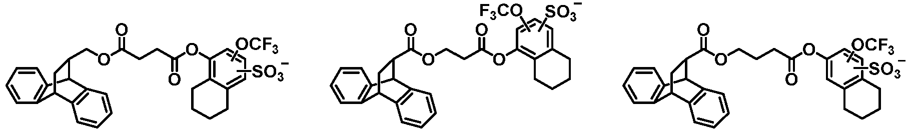

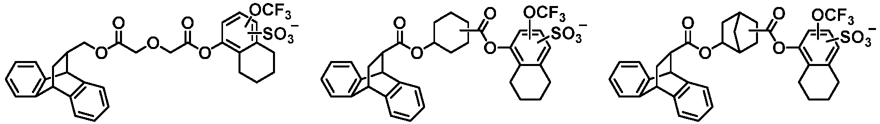

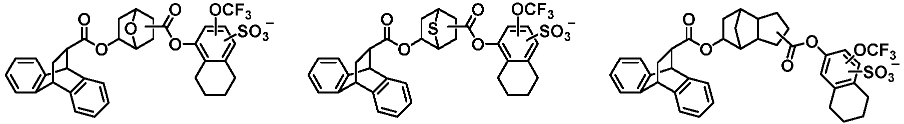

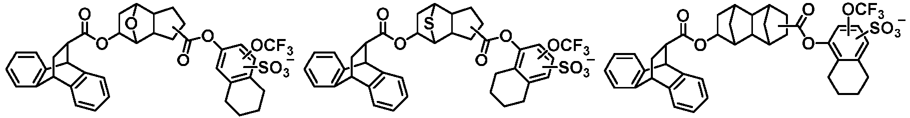

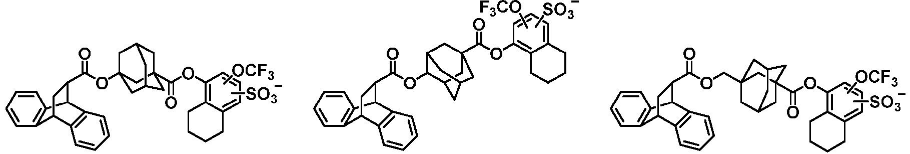

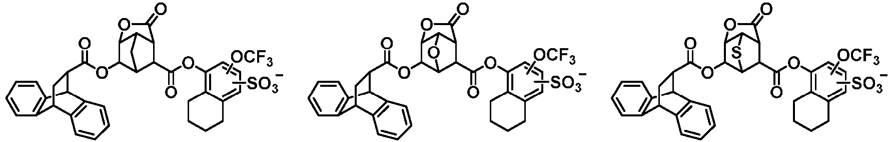

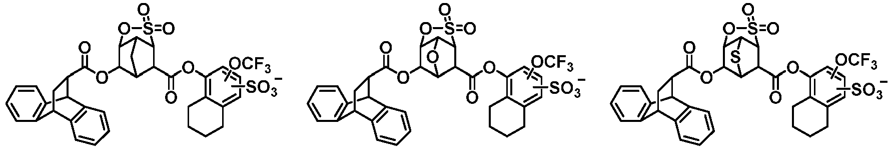

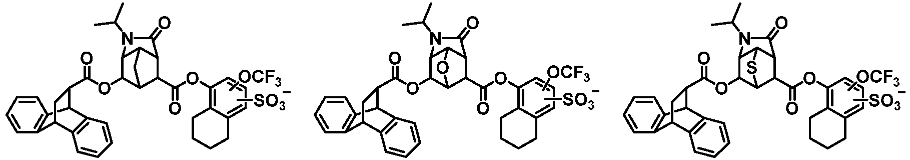

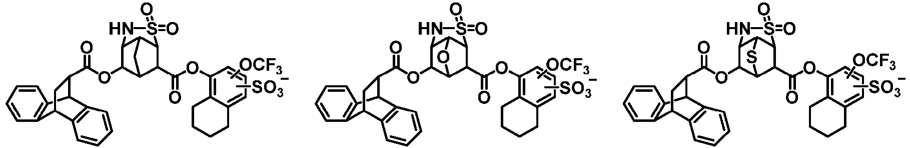

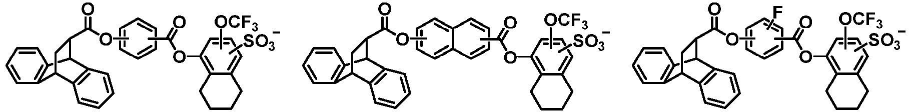

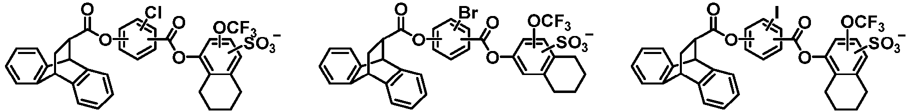

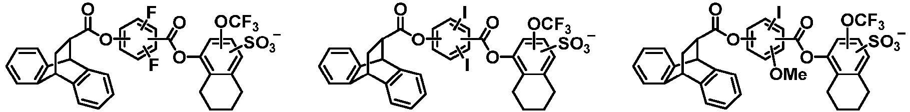

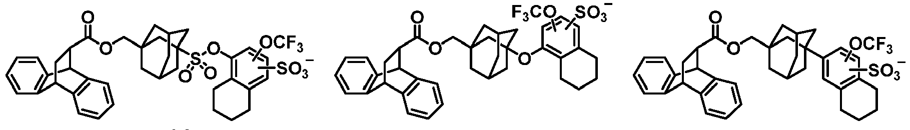

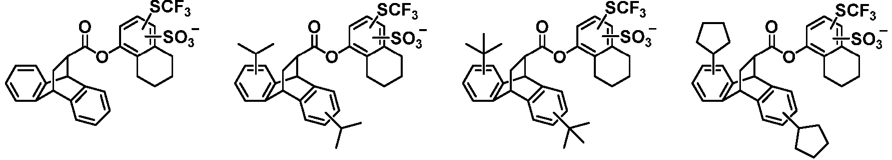

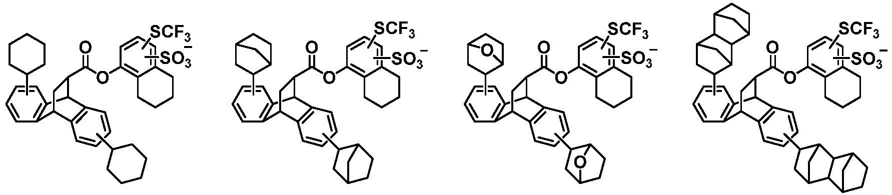

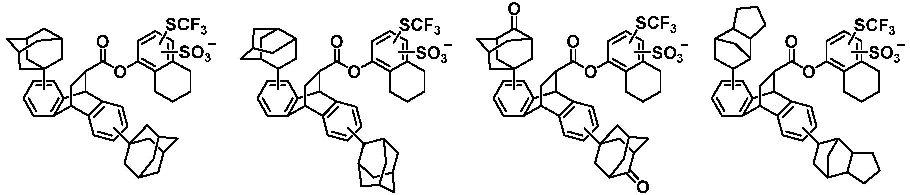

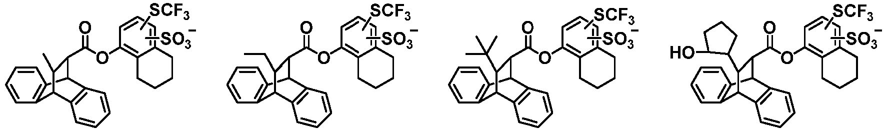

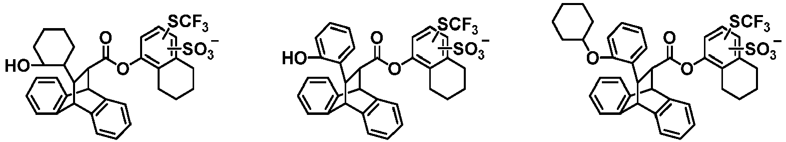

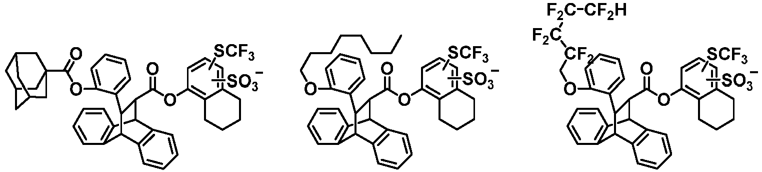

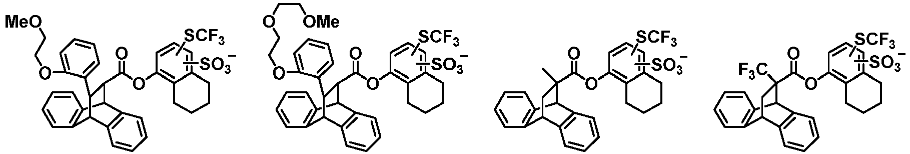

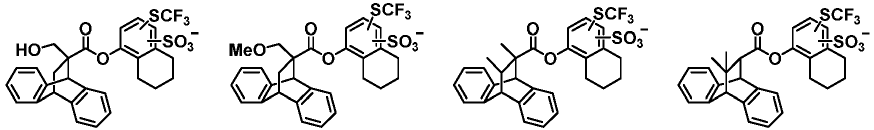

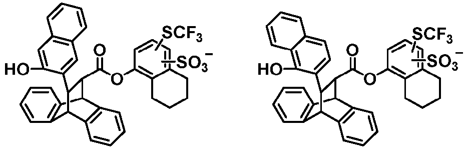

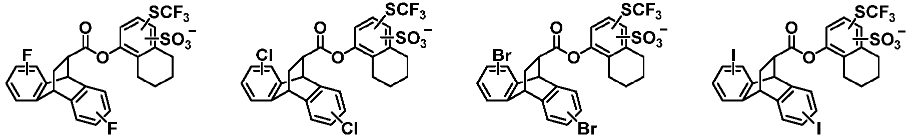

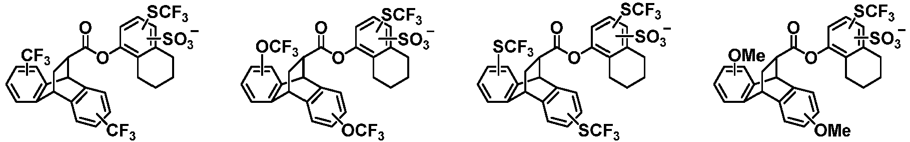

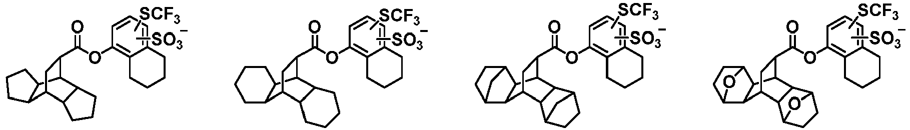

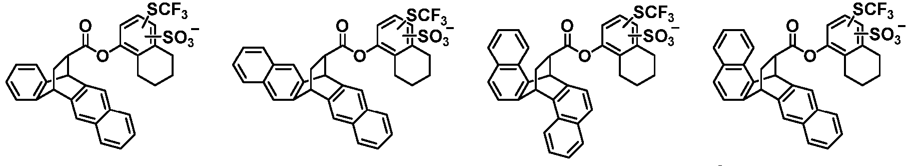

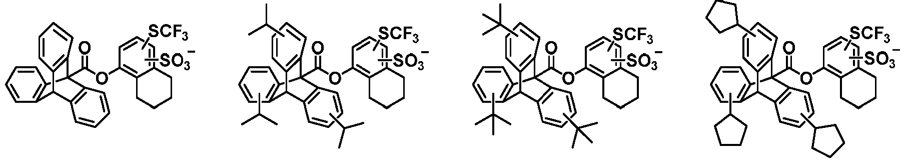

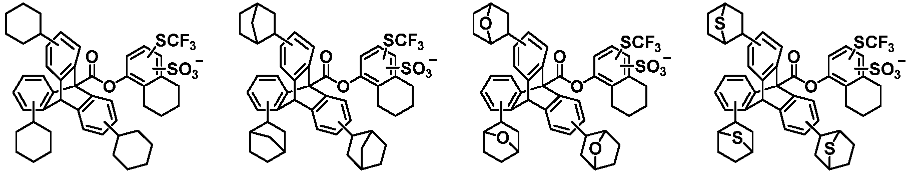

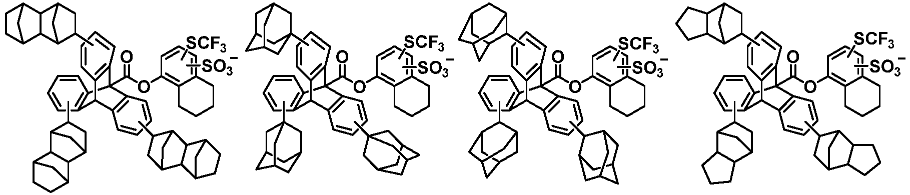

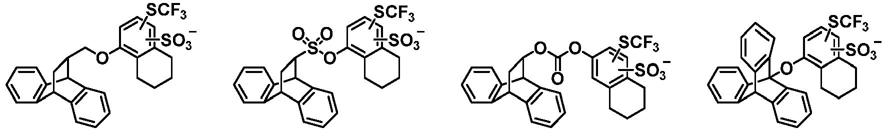

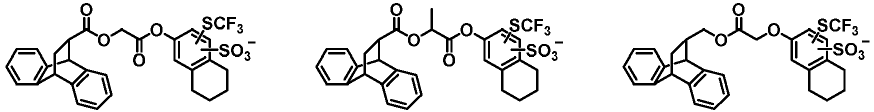

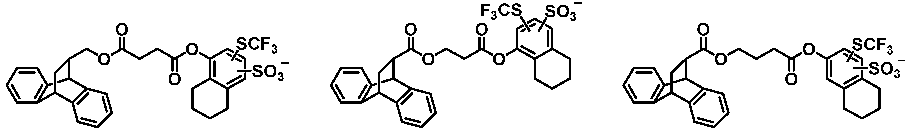

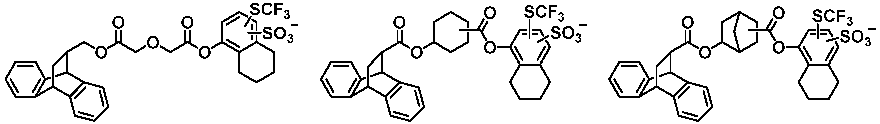

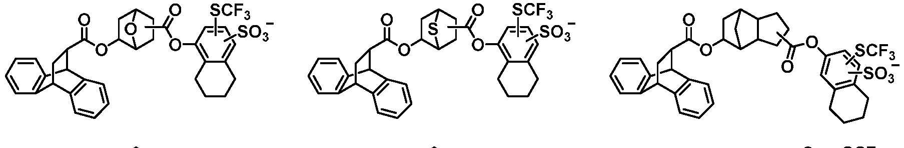

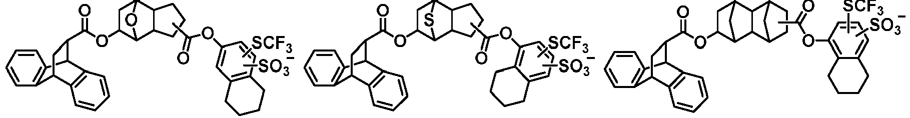

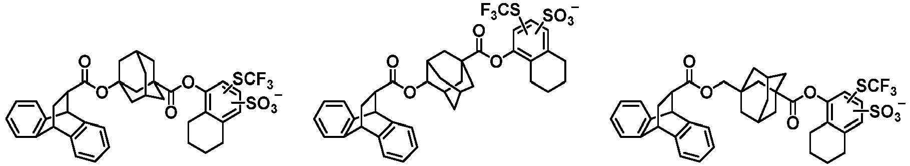

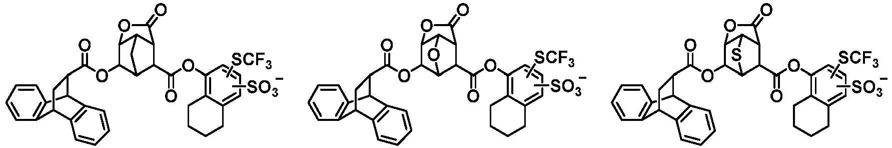

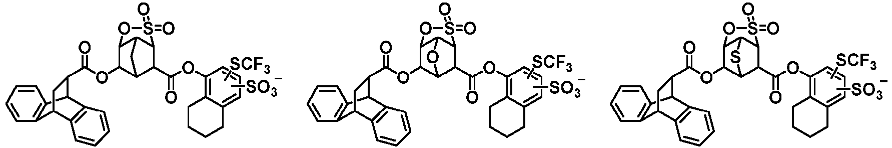

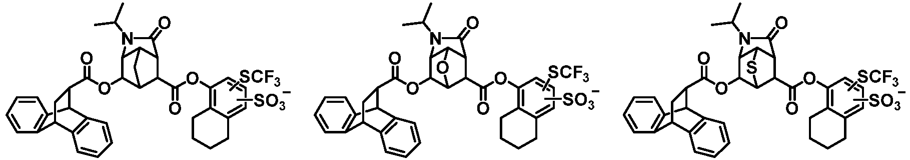

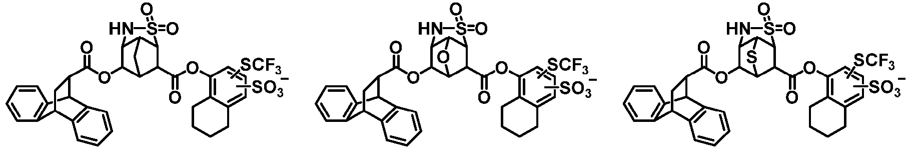

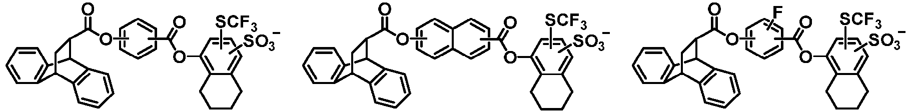

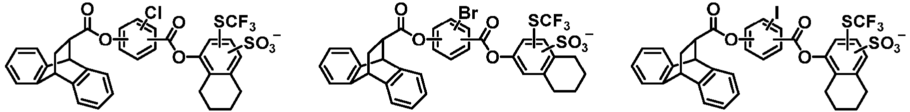

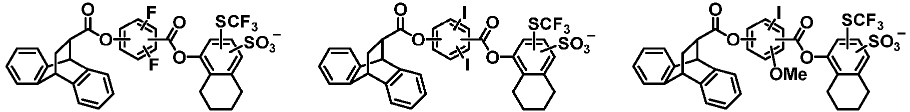

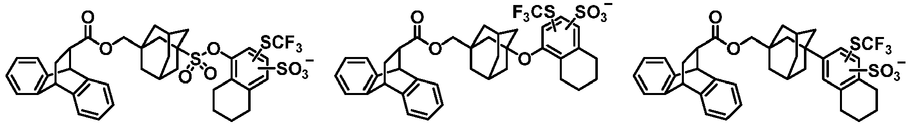

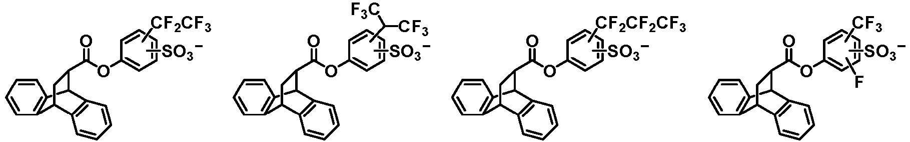

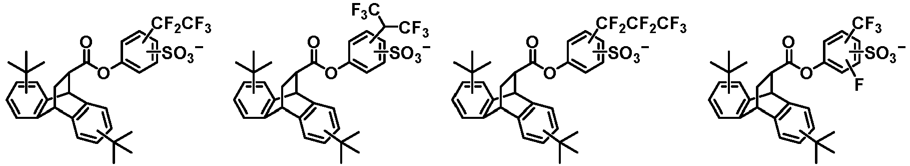

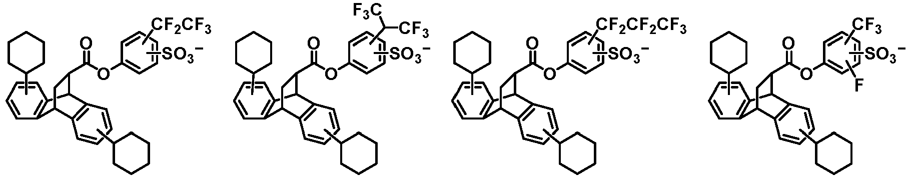

In addition, as the photoacid generator, a salt compound containing an anion having the formula (E1) is also preferred.

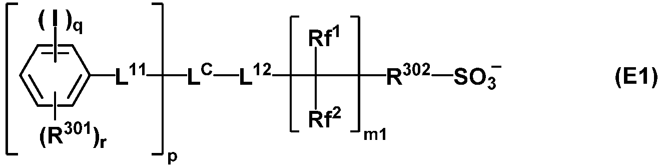

In the formula (E1), m1 is 0 or 1, p is 1, 2, or 3, q is 1, 2, 3, 4, or 5, r is 0, 1, 2, or 3, meeting 1 ≤ q+r ≤ 5.

In the formula (E1), L¹¹ is a single bond, an ether bond, an ester bond, a sulfonate ester bond, a carbonate bond, or a carbamate bond.

In the formula (E1), L¹² is an ether bond, an ester bond, a sulfonate ester bond, a carbonate bond, or a carbamate bond.

In the formula (E1), L^{C} is a single bond or a C₁-C₂₀ hydrocarbylene group when p is 1, and is a C₁-C₂₀ (p+1)-valent hydrocarbon group when p is 2 or 3, and the hydrocarbylene group and the (p+1)-valent hydrocarbon group may contain at least one selected from an ether bond, a carbonyl group, an ester bond, an amide bond, a sultone ring, a lactam ring, a carbonate bond, a halogen atom, a hydroxy group, and a carboxy group.

The C₁-C₂₀ hydrocarbylene group of L^{C} may be saturated or unsaturated and straight, branched, or cyclic. Specific examples thereof include C₁-C₂₀ alkanediyl groups such as a methanediyl group, an ethane-1,1-diyl group, an ethane-1,2-diyl group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, and a dodecane-1,12-diyl group; C₃-C₂₀ cyclic saturated hydrocarbylene groups such as a cyclopentanediyl group, a cyclohexanediyl group, a norbornanediyl group, and an adamantanediyl group; C₂-C₂₀ unsaturated aliphatic hydrocarbylene groups such as a vinylene group and a propene-1,3-diyl group; C₆-C₂₀ arylene groups such as a phenylene group and a naphthylene group; and a group obtained by combining these groups. The C₁-C₂₀ (p+1)-valent hydrocarbon group of L^{C} may be saturated or unsaturated and straight, branched, or cyclic. Specific examples thereof include groups obtained by further removing one or two hydrogen atoms from those exemplified above for the C₁-C₂₀ hydrocarbylene group.

In the formula (E1), Rf¹ and Rf² are each independently a hydrogen atom, a fluorine atom, or a trifluoromethyl group, and at least one of them is a fluorine atom or a trifluoromethyl group.

In the formula (E1), R³⁰¹ is a hydroxy group, a carboxy group, a C₁-C₆ saturated hydrocarbyl group, a C₁-C₆ saturated hydrocarbyloxy group, a C₂-C₆ saturated hydrocarbylcarbonyloxy group, a fluorine atom, a chlorine atom, a bromine atom, -N(R^{301A})(R^{301B}), -N(R^{301C})-C(=O)-R^{301D}, or -N(R^{301C})-C(=O)-O-R^{301D}. R^{301A} and R^{301B} are each independently a hydrogen atom or a C₁-C₆ saturated hydrocarbyl group. R^{301C} is a hydrogen atom or a C₁-C₆ saturated hydrocarbyl group. R^{301D} is a C₁-C₆ saturated hydrocarbyl group or a C₂-C₈ unsaturated aliphatic hydrocarbyl group.

The C₁-C₆ saturated hydrocarbyl group of R³⁰¹, R^{301A}, R^{301B} and R^{301C} may be straight, branched, or cyclic, and specific examples thereof include C₁-C₆ alkyl groups such as a methyl group, an ethyl group, a n-propyl group, an isopropyl group, a n-butyl group, an isobutyl group, a sec-butyl group, a tert-butyl group, a n-pentyl group, and a n-hexyl group; and C₃-C₆ cyclic saturated hydrocarbyl groups such as a cyclopropyl group, a cyclobutyl group, a cyclopentyl group, and a cyclohexyl group. Examples of the saturated hydrocarbyl moiety in the C₁-C₆ saturated hydrocarbyloxy group of R³⁰¹ are as exemplified above in the specific examples of the saturated hydrocarbyl group, and examples of the saturated hydrocarbyl moiety in the C₂-C₆ saturated hydrocarbylcarbonyloxy group of R³⁰¹ are as exemplified above for the C₁-C₆ saturated hydrocarbyl group, but of 1 to 5 carbon atoms.

The C₂-C₈ unsaturated aliphatic hydrocarbyl group of R^{301D} may be straight, branched, or cyclic, and specific examples thereof include C₂-C8 alkenyl groups such as a vinyl group, a propenyl group, a butenyl group, and a hexenyl group; C₂-C₈ alkynyl groups such as an ethynyl group, a propynyl group, and a butynyl group; and C₃-C₈ cyclic unsaturated aliphatic hydrocarbyl groups such as a cyclohexenyl group and a norbornenyl group.

In the formula (E1), R³⁰² is a C₁-C₂₀ saturated hydrocarbylene group or a C₆-C₂₀ arylene group, some or all hydrogen atoms in the saturated hydrocarbylene group may be substituted with a halogen atom other than a fluorine atom, and some or all hydrogen atoms in the arylene group may be substituted with a substituent selected from a C₁-C₂₀ saturated hydrocarbyl group, a C₁-C₂₀ saturated hydrocarbyloxy group, a C₆-C₂₀ aryl group, a halogen atom, and a hydroxy group.

The C₁-C₂₀ hydrocarbylene group of R³⁰² may be saturated or unsaturated and straight, branched, or cyclic. Specific examples thereof are as exemplified above for the C₁-C₂₀ hydrocarbylene group of L^{C}.

Specific examples of the C₆-C₂₀ arylene group of R³⁰² include a phenylene group, a naphthylene group, a phenanthrenediyl group, and an anthracenediyl group. The C₁-C₂₀ saturated hydrocarbyl group and the hydrocarbyl moiety in the C₁-C₂₀ hydrocarbyloxy group, which are substituents of the arylene group, may be straight, branched or cyclic, and specific examples thereof include C₁-C₂₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-octyl group, a n-nonyl group, a n-decyl group, an undecyl group, a dodecyl group, a tridecyl group, a tetradecyl group, a pentadecyl group, a heptadecyl group, an octadecyl group, a nonadecyl group, and an icosyl group; and C₃-C₂₀ cyclic saturated hydrocarbyl groups such as a cyclopropyl group, a cyclopentyl group, a cyclohexyl group, a cyclopropylmethyl group, a 4-methylcyclohexyl group, a cyclohexylmethyl group, a norbornyl group, and an adamantyl group. Specific examples of the C₆-C₁₄ arylene group which is a substituent of the arylene group include a phenylene group, a naphthylene group, a phenanthrenediyl group, and an anthracenediyl group.

As the anion having the formula (E1), an anion having the formula (E2) is preferred.

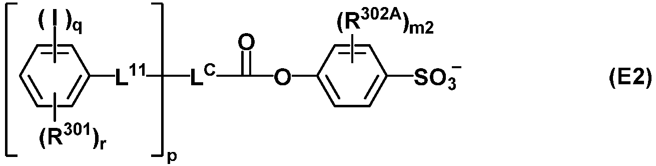

In the formula (E2), p, q, r, L¹¹, L^{C}, and R³⁰¹ are as defined above. m2 is 1, 2, 3, or 4. R^{302A} is a C₁-C₂₀ saturated hydrocarbyl group, a C₁-C₂₀ saturated hydrocarbyloxy group, a C₆-C₁₄ aryl group, a halogen atom, or a hydroxy group. When m2 is 2, 3, or 4, a plurality of R^{302A}'s may be identical or different.

Specific examples of the anion having the formula (E1) are shown below, but not limited thereto.

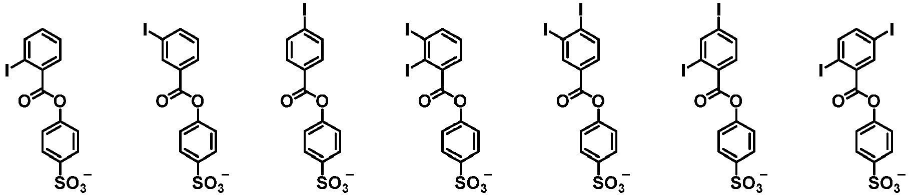

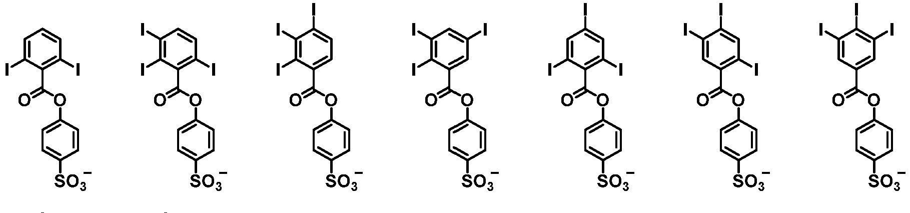

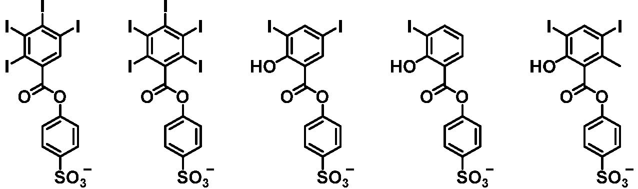

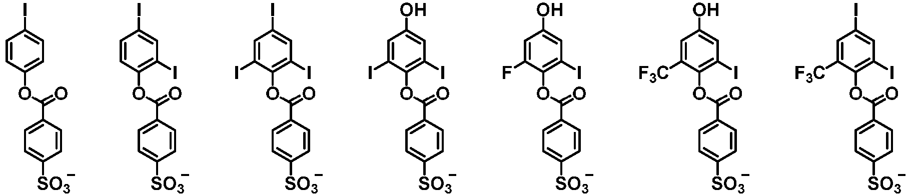

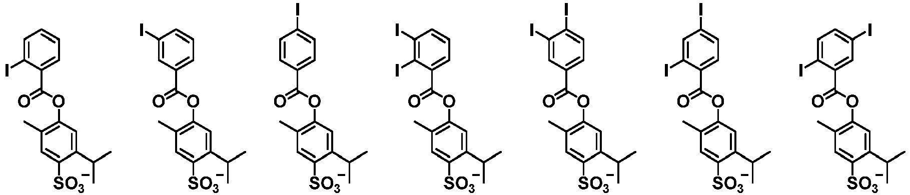

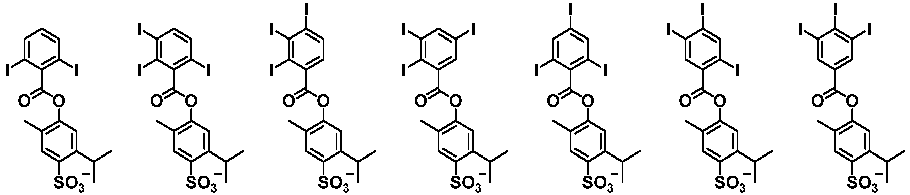

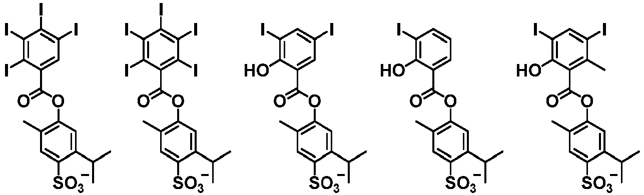

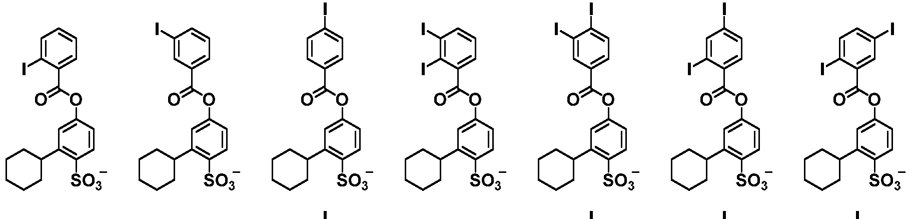

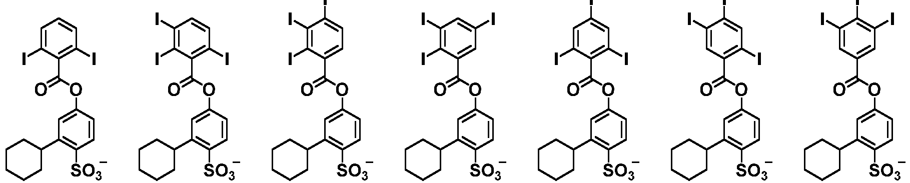

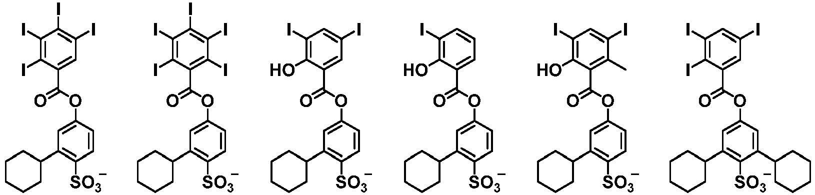

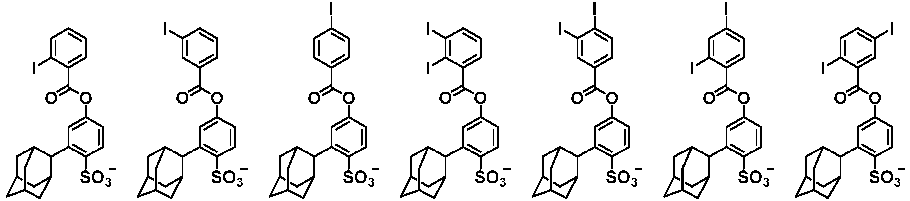

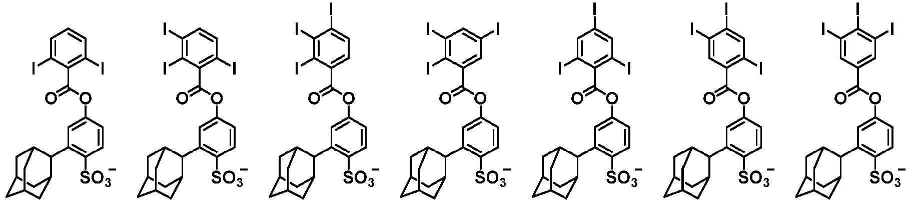

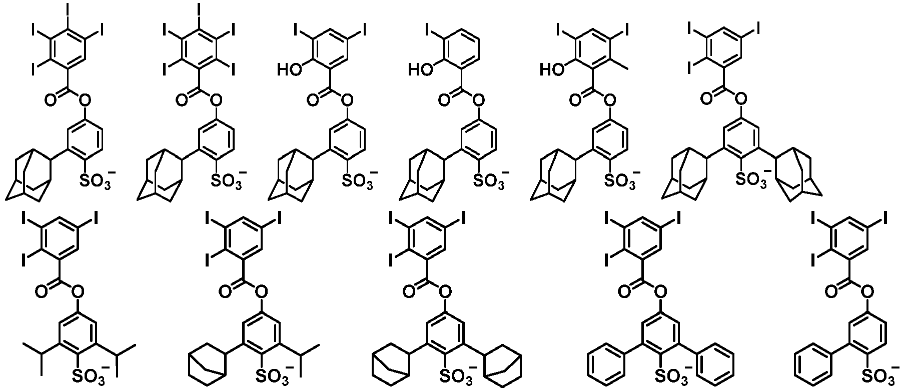

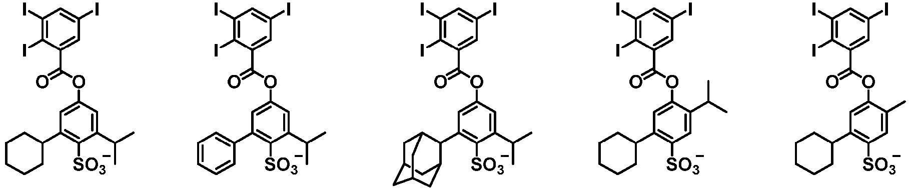

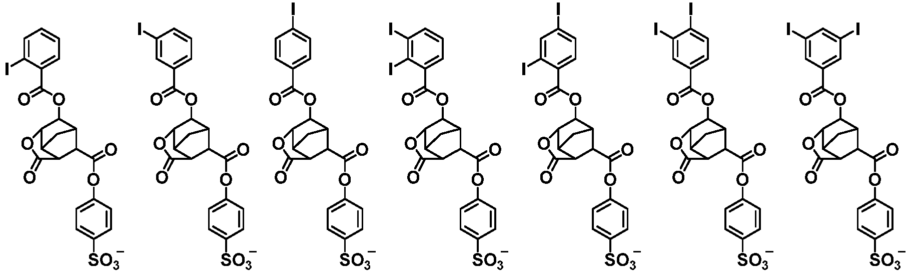

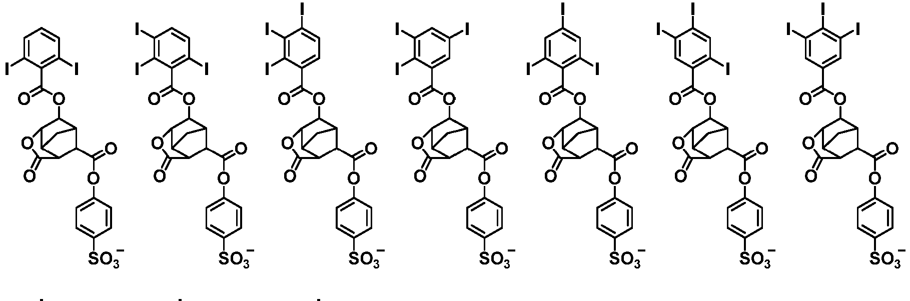

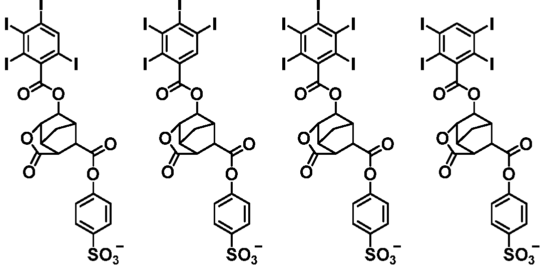

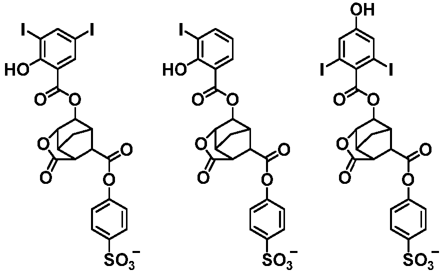

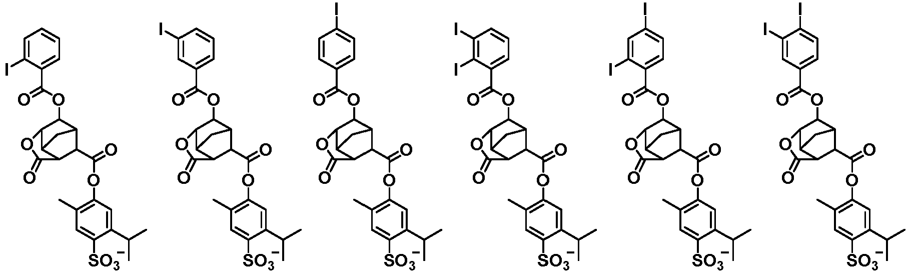

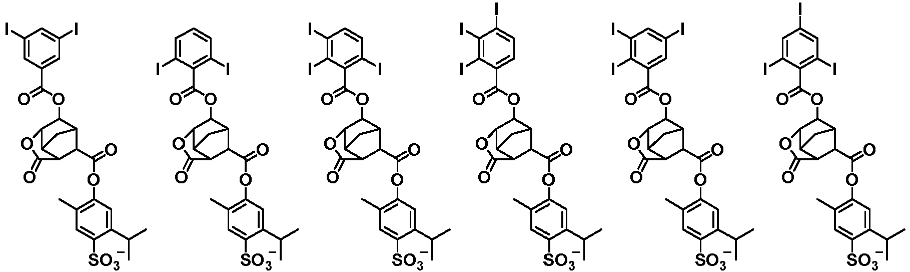

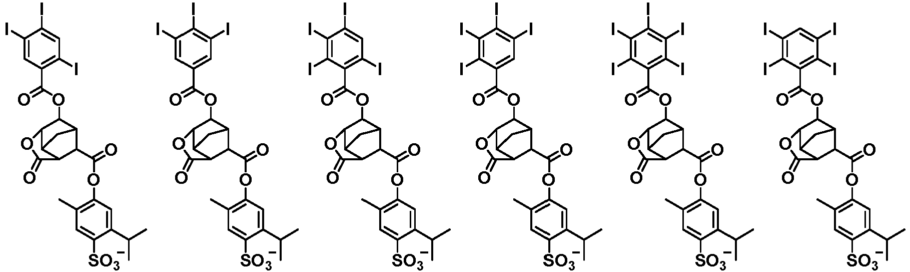

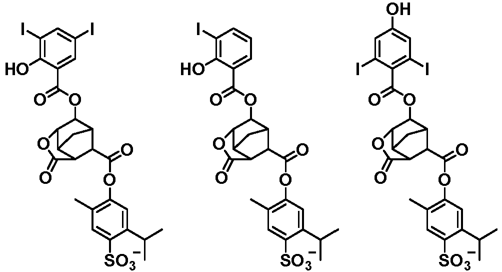

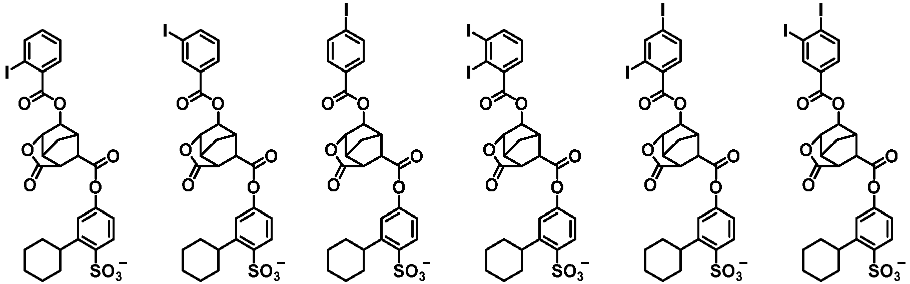

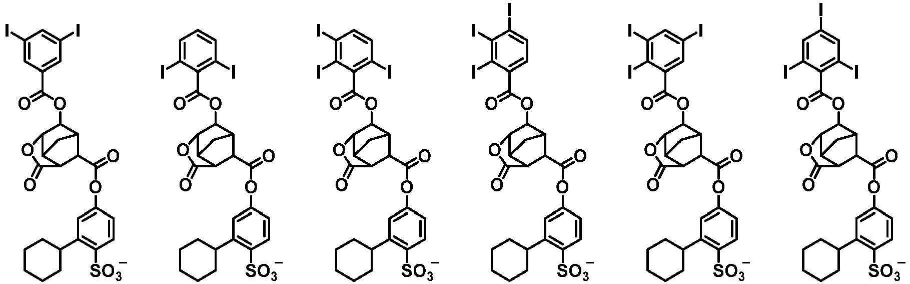

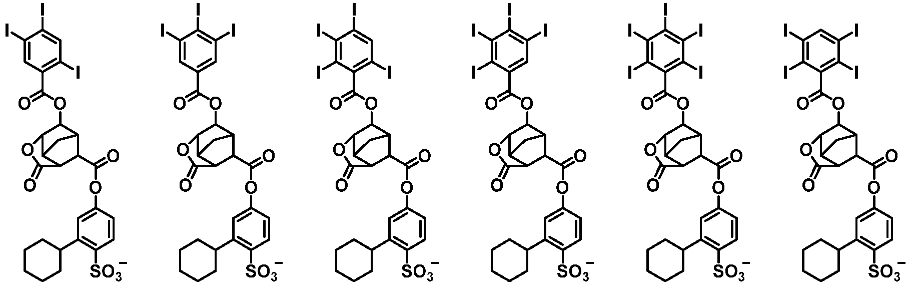

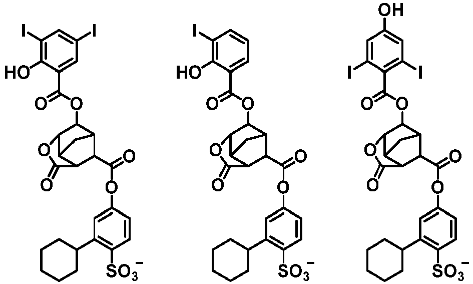

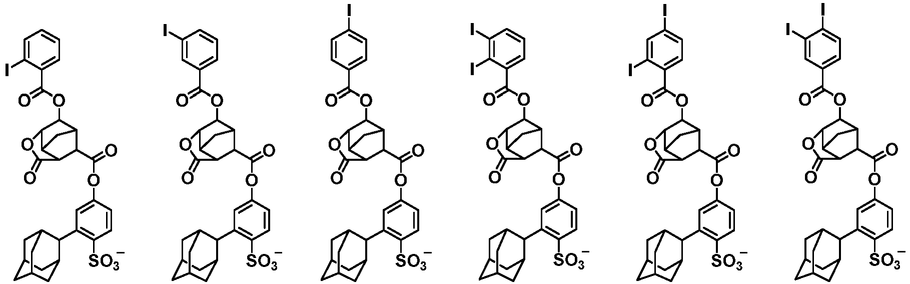

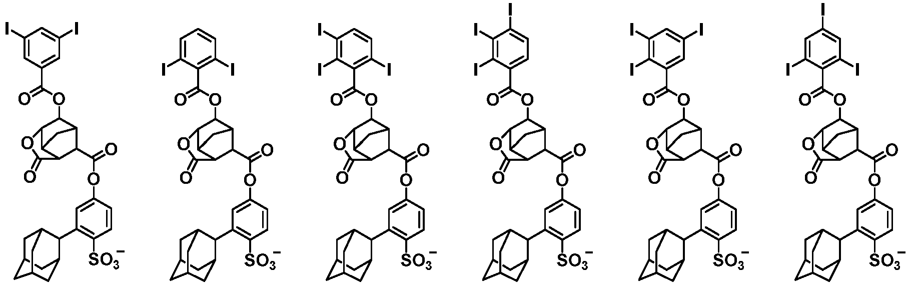

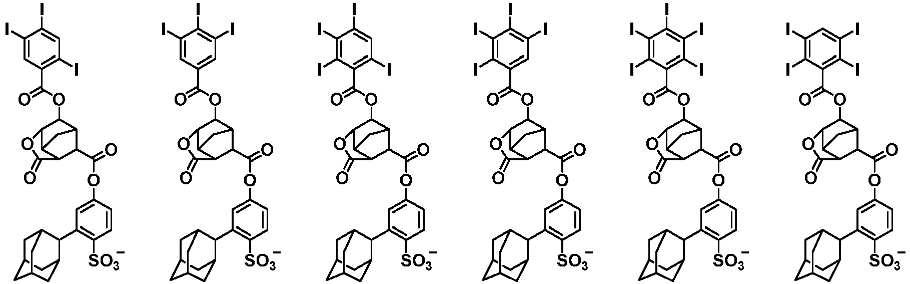

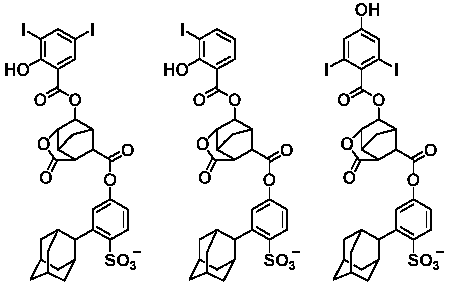

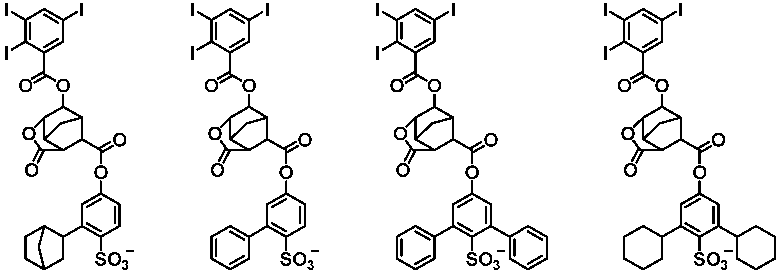

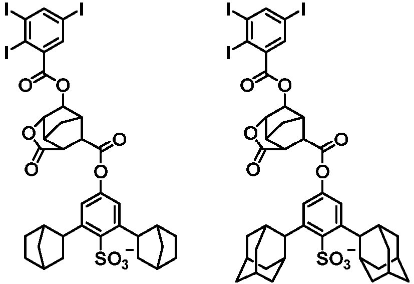

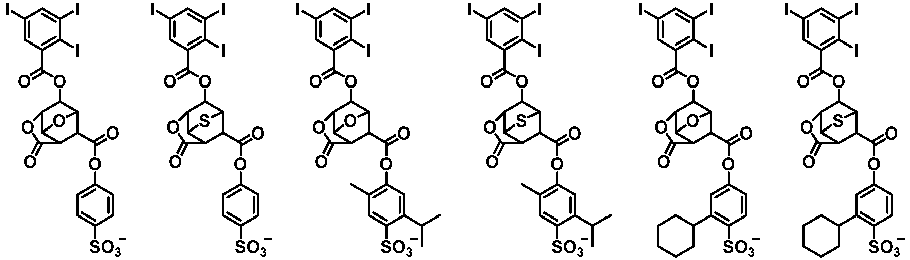

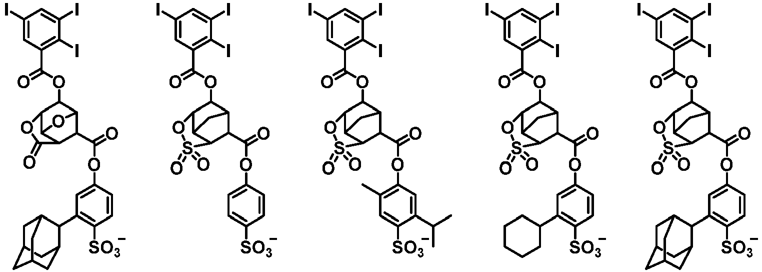

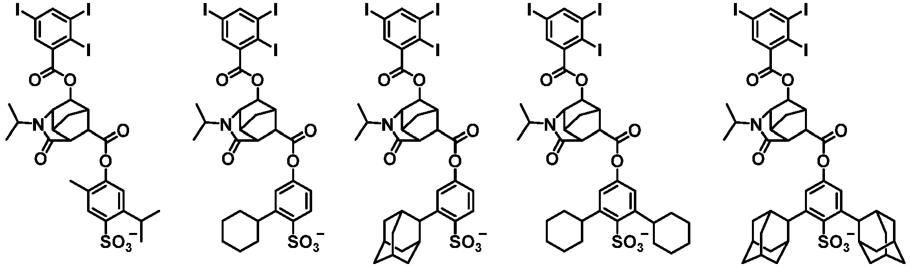

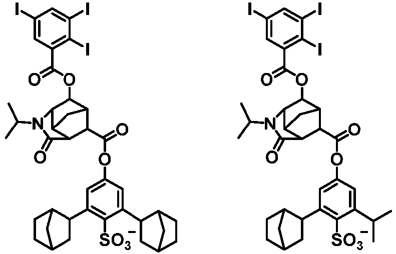

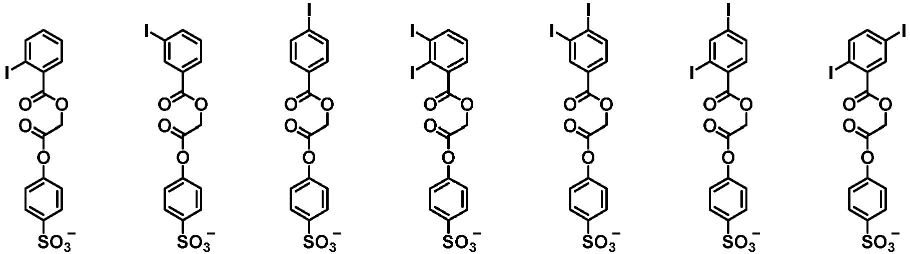

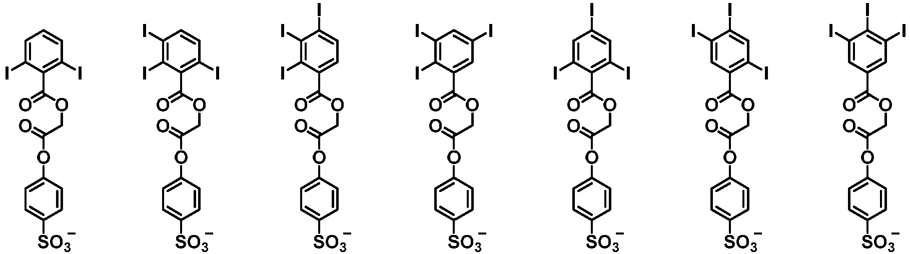

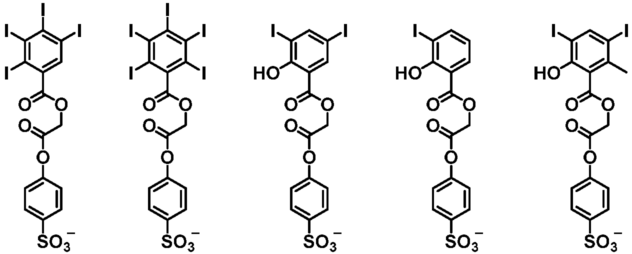

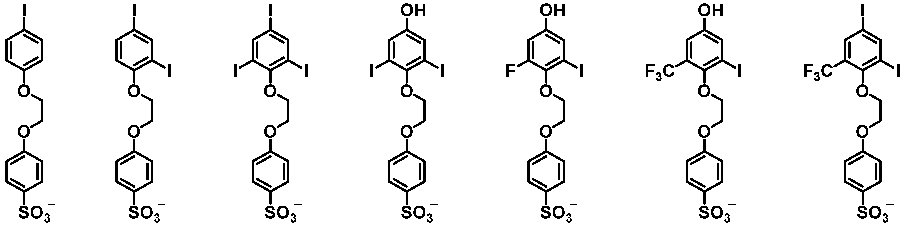

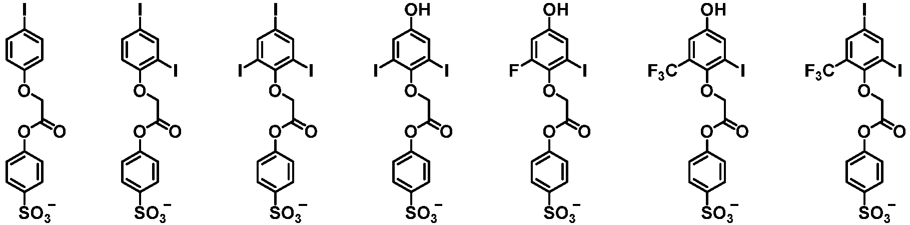

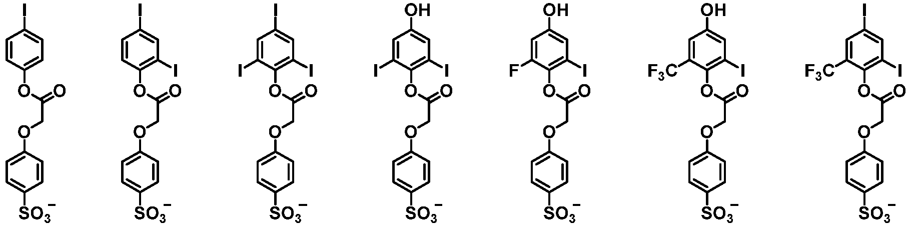

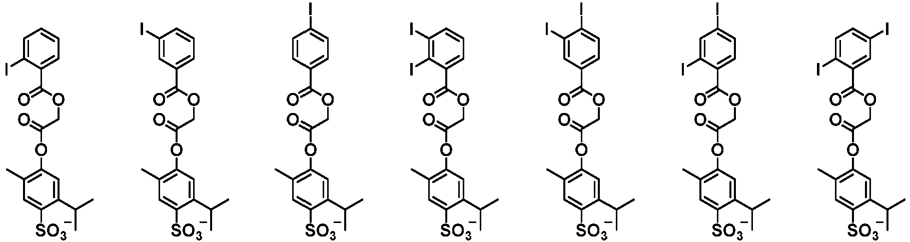

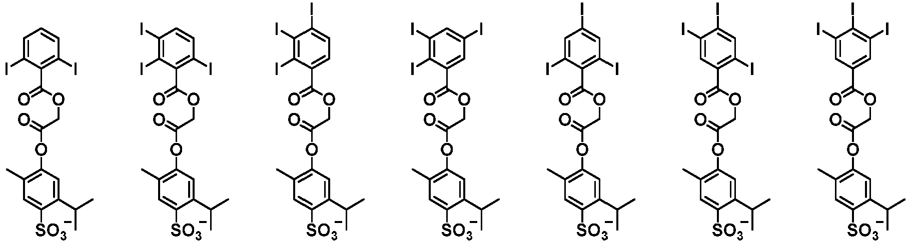

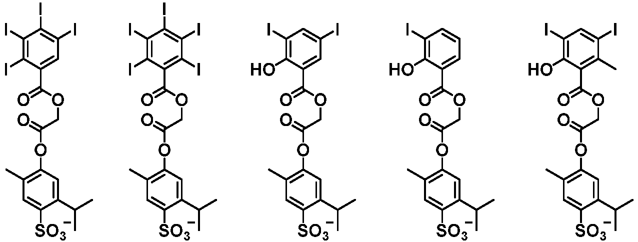

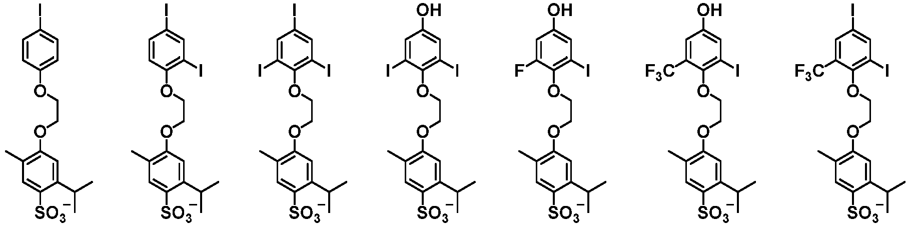

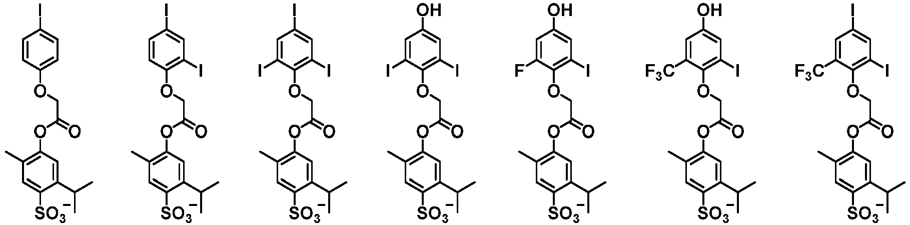

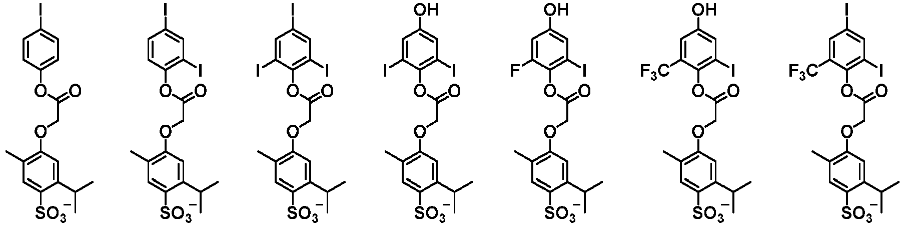

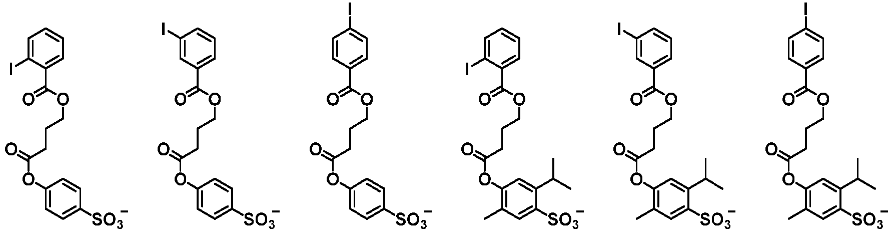

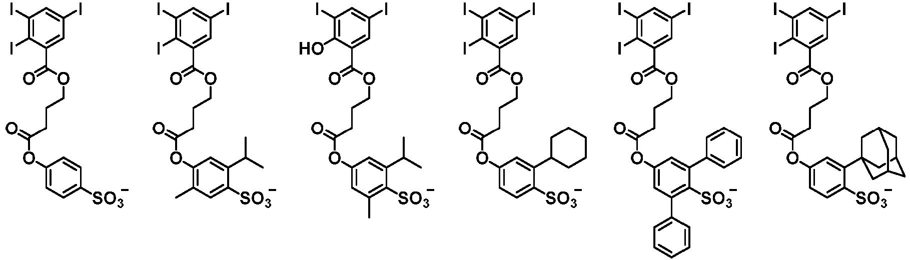

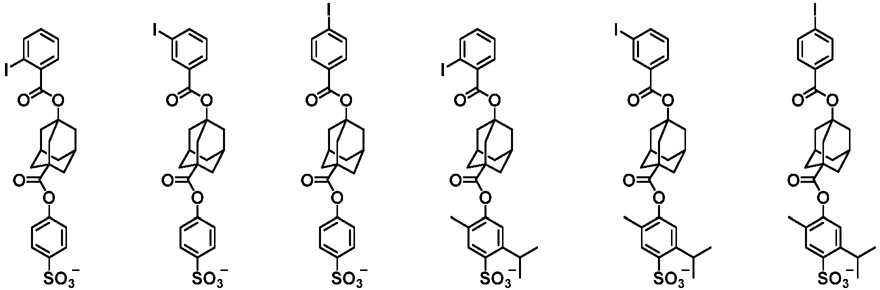

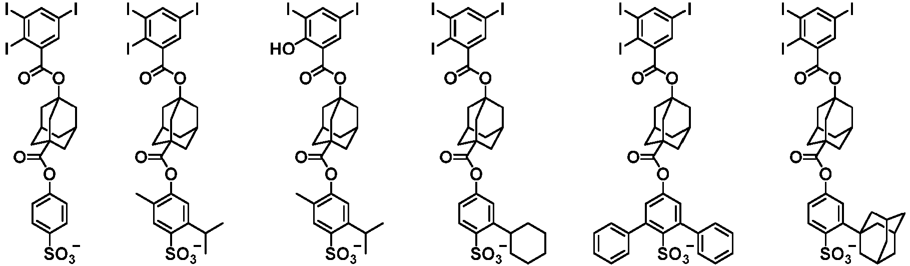

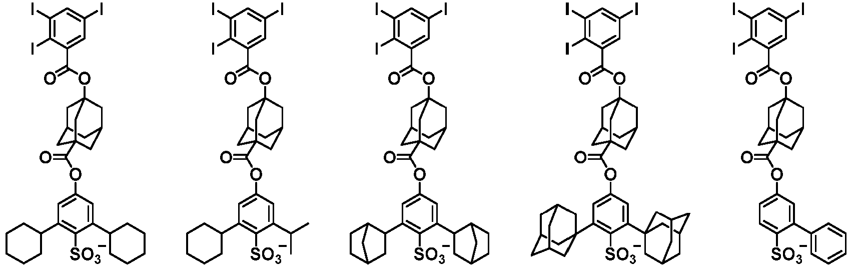

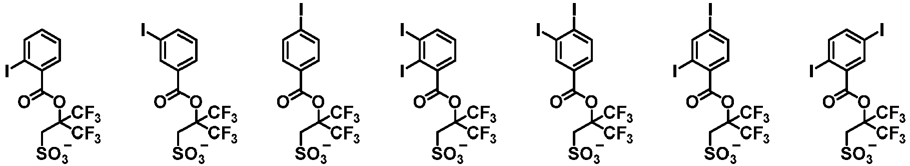

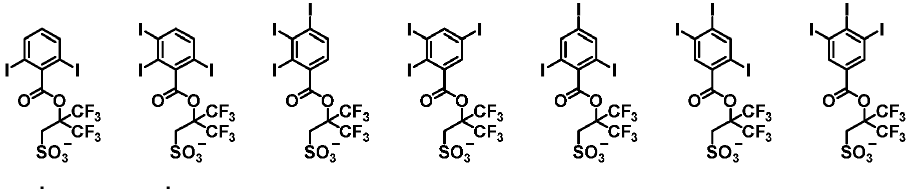

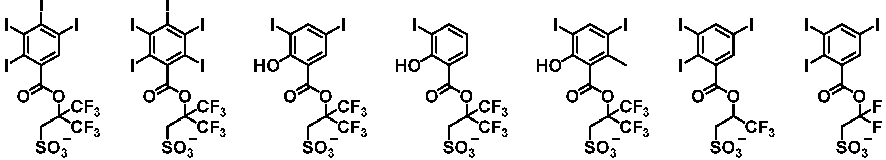

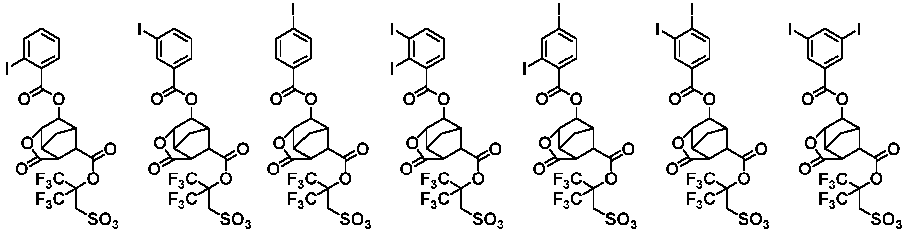

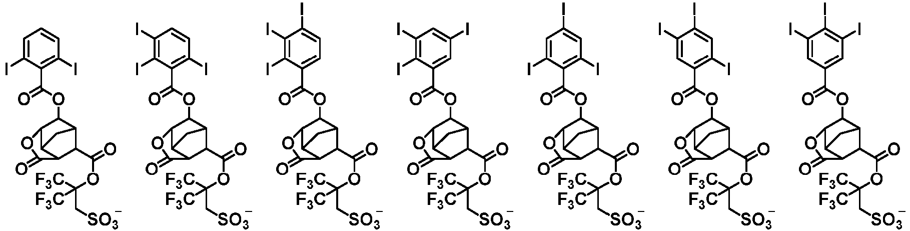

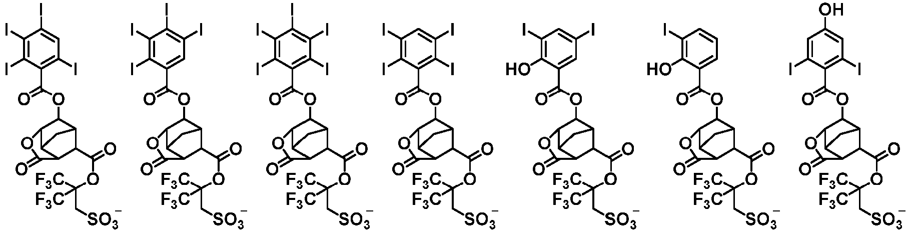

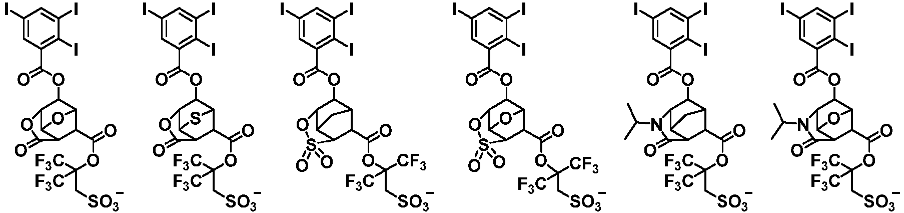

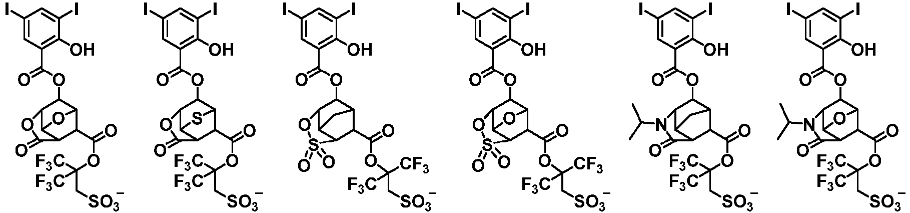

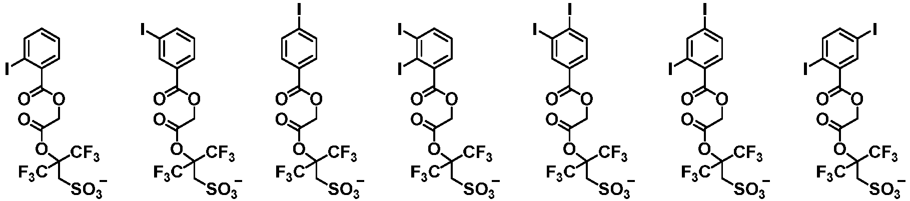

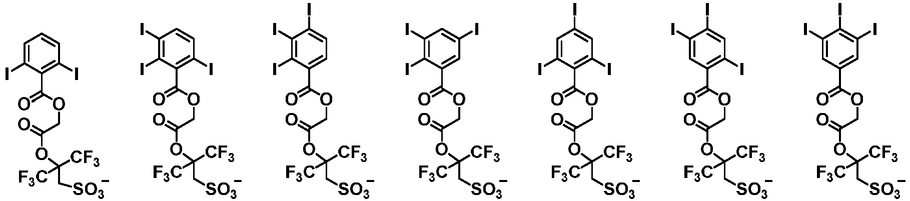

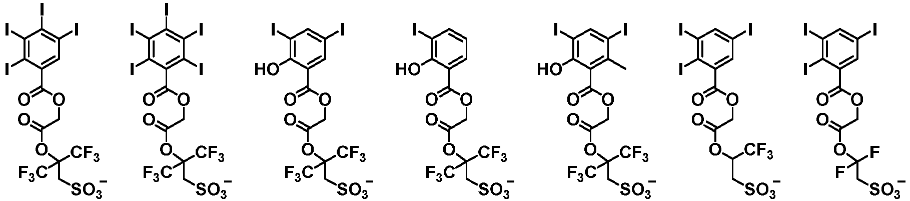

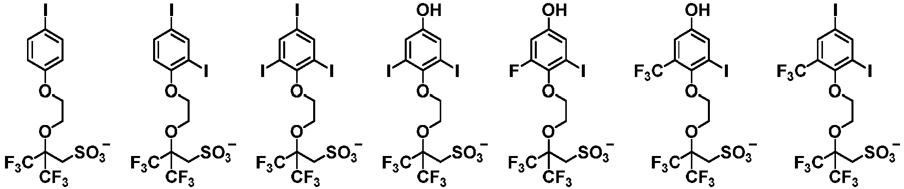

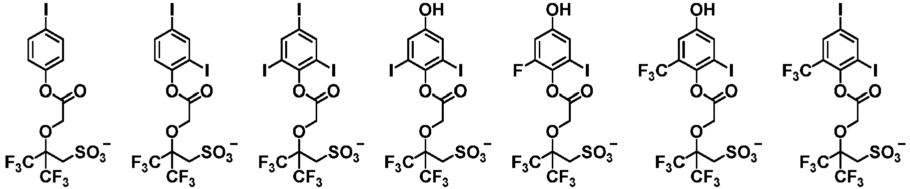

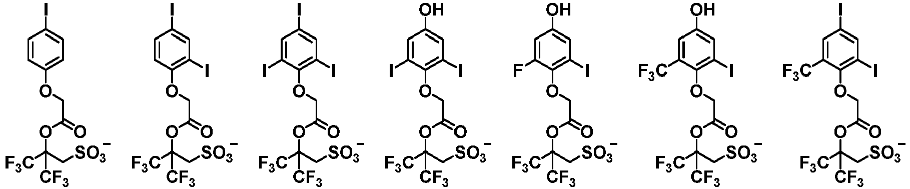

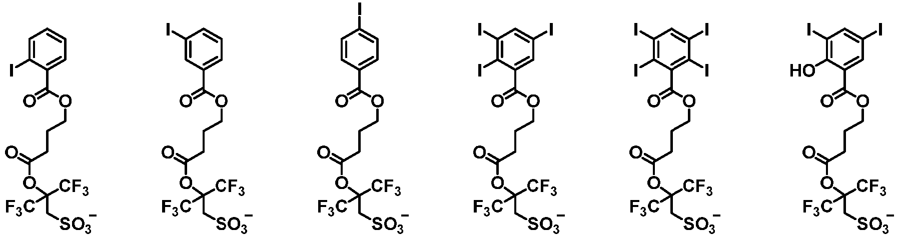

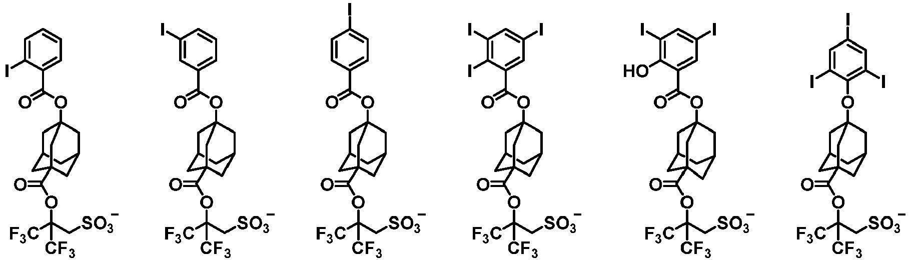

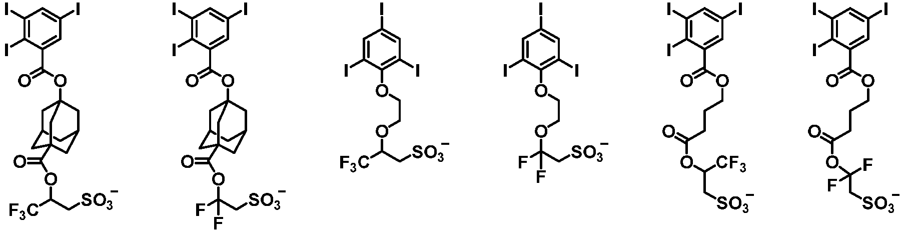

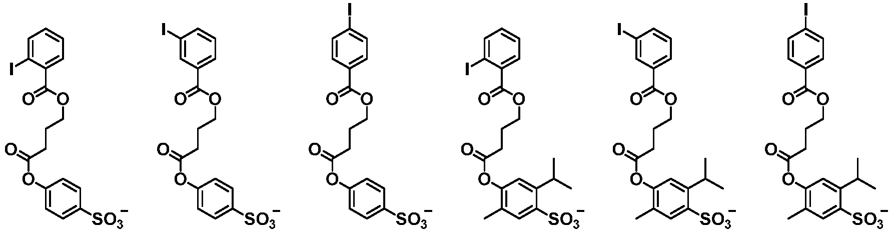

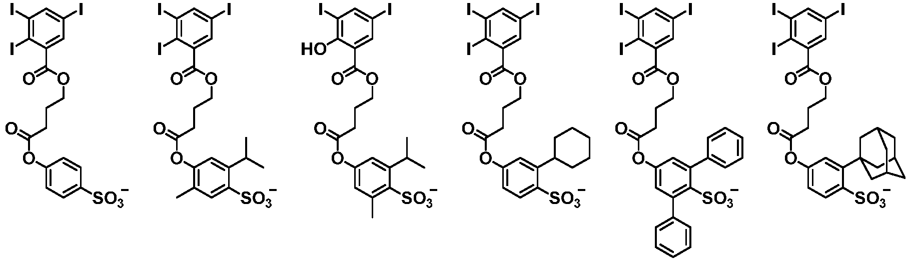

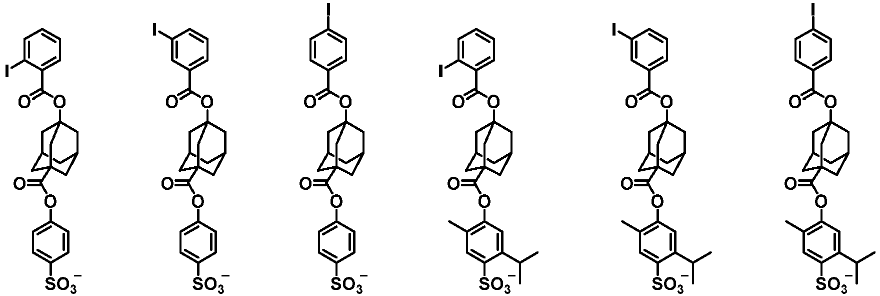

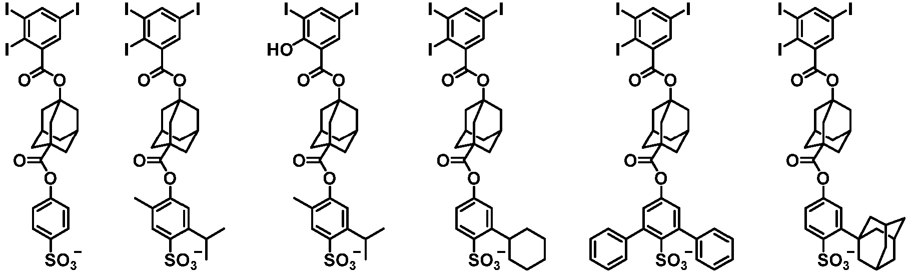

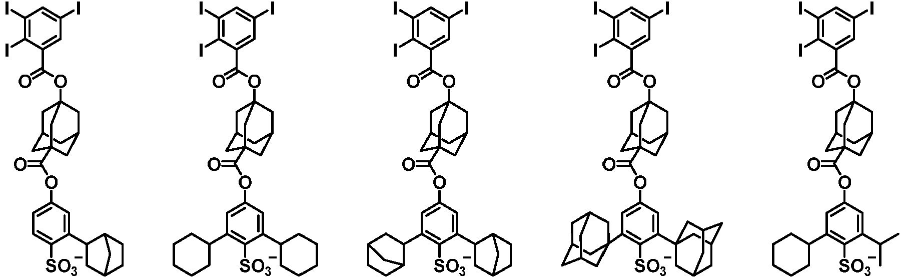

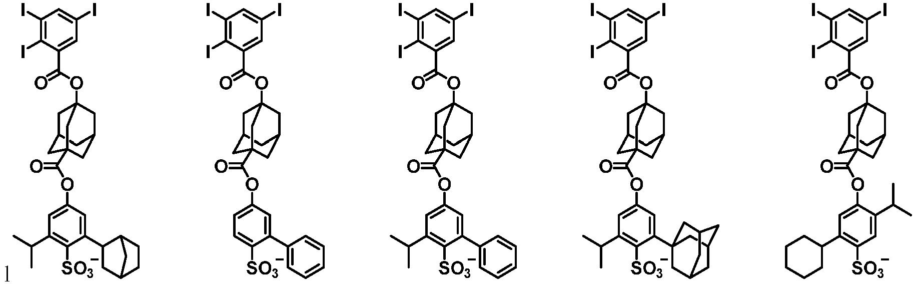

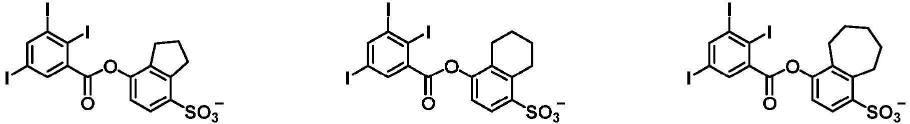

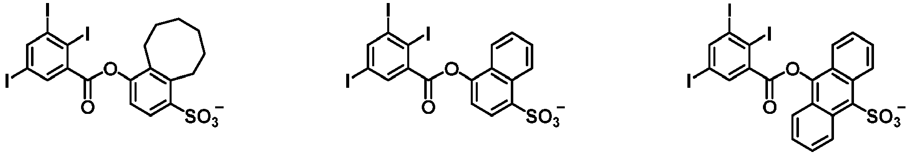

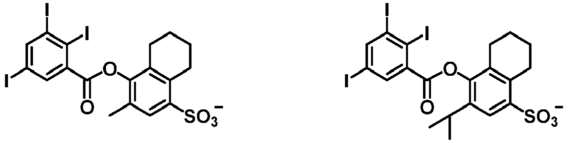

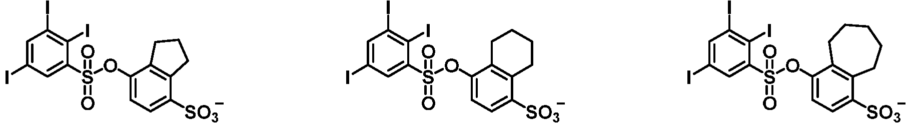

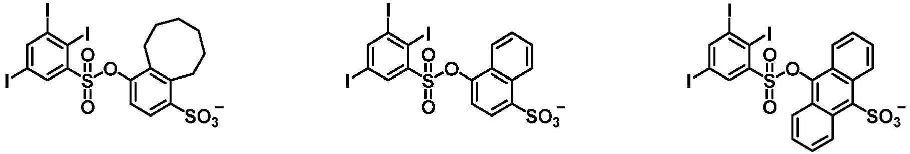

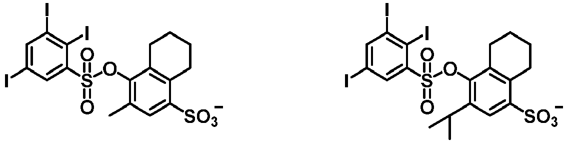

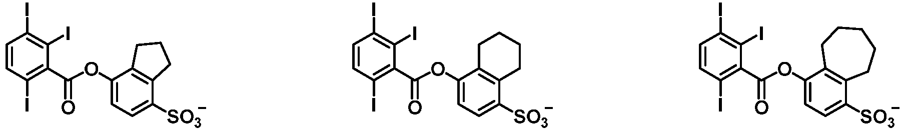

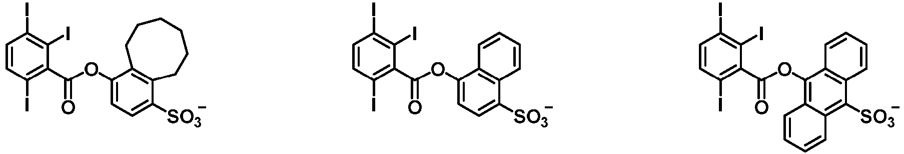

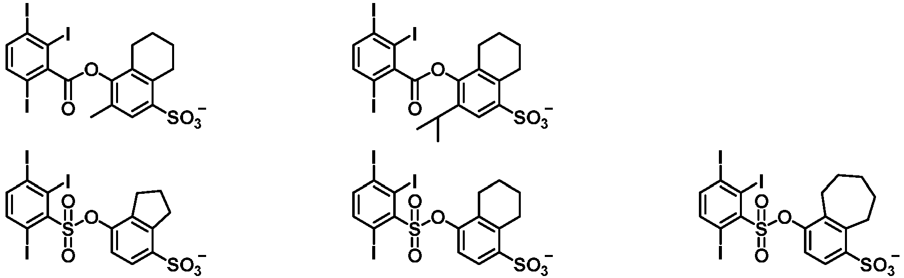

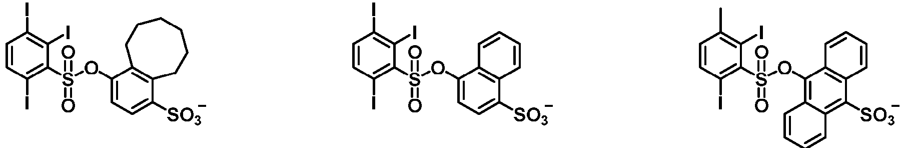

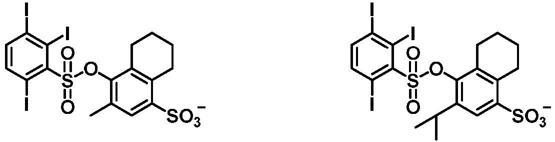

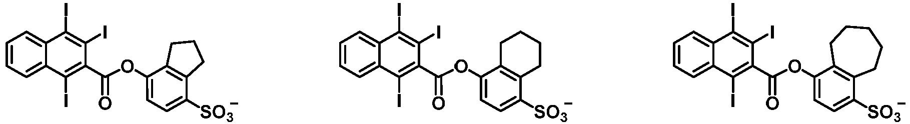

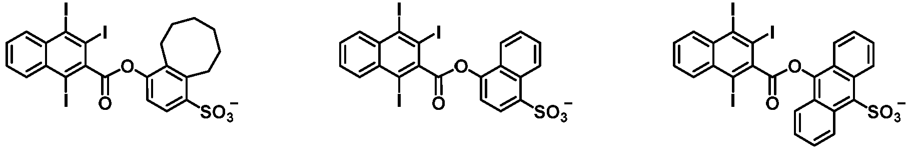

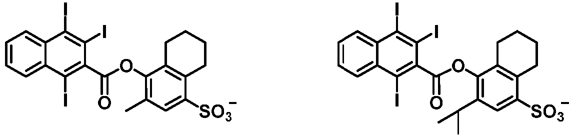

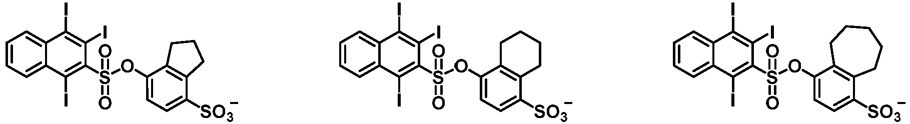

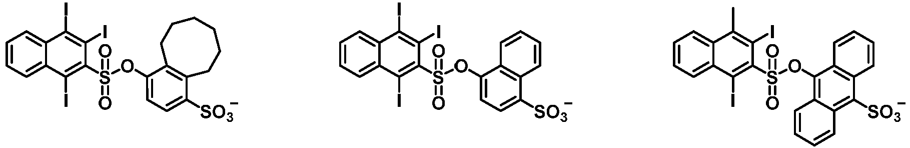

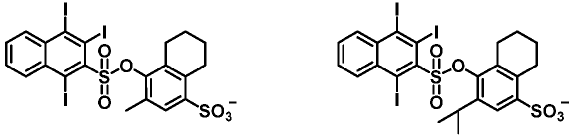

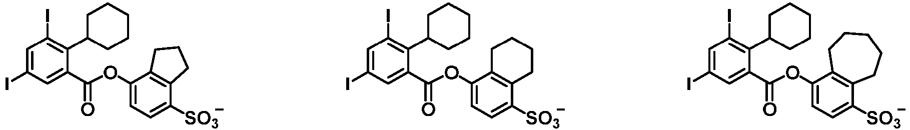

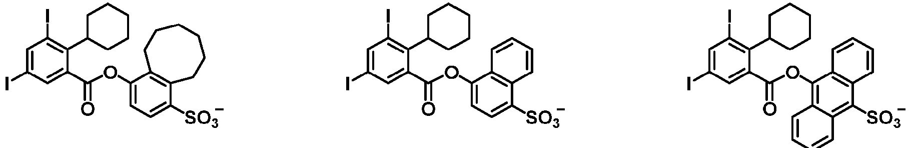

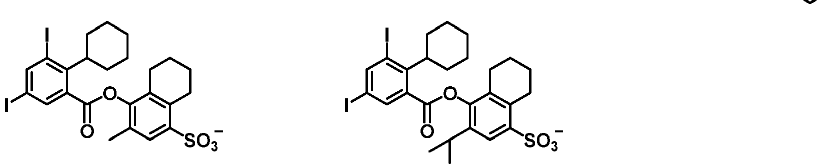

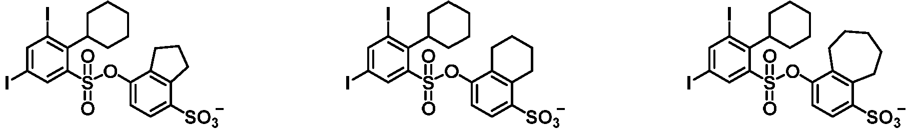

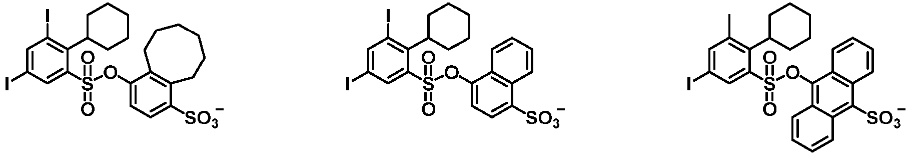

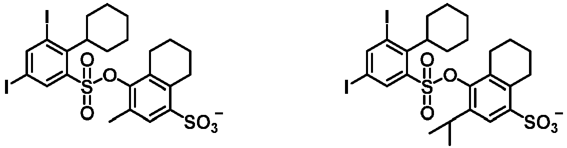

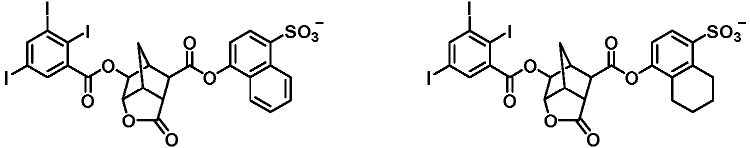

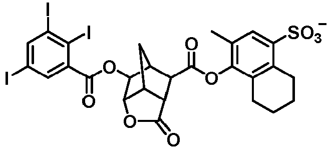

In the photoacid generator (E), a sulfonium cation or an iodonium cation is preferred as a cation that pairs with the anion described above. Specific examples of the sulfonium cation include those described in JP-A 2024-003744, paragraphs [0102] to [0125], those described in JP-A 2023-169812, paragraphs [0070] to [0085], and those having the formula (A2), but are not limited thereto. Specific examples of the iodonium cation include those described in JP-A 2024-000259, paragraph [0181], but are not limited thereto.

The acid generated by the photoacid generator preferably has a pKa of -2.0 or more, more preferably -1.0 or more. The upper limit of pKa is preferably 2.0. The pKa value is calculated using pKa DB in software ACD/Chemsketch ver: 9.04 manufactured by Advanced Chemistry Development, Inc.

When the chemically amplified positive resist composition of the invention contains the photoacid generator (E), the content thereof is preferably 1 to 10 parts by weight, and more preferably 1 to 5 parts by weight per 80 parts by weight of the base polymer. The incorporation of the photoacid generator (E) enables appropriate adjustment of the amount of an acid generated in the exposed portion and the degree of dissolution inhibition in the unexposed portion. As the photoacid generator (E), one type may be used alone or two or more types may be combined and used.

When the chemically amplified positive resist composition of the invention contains both the photoacid generator (E) and the quencher (B), the content ratio of the photoacid generator to the quencher (photoacid generator/quencher) is preferably less than 3, more preferably less than 2.5, and still more preferably less than 2 in terms of weight ratio. When the content ratio of the photoacid generator to the quencher contained in the chemically amplified positive resist composition is in the above range, acid diffusion can be sufficiently prevented, and excellent resolution and dimensional uniformity can be obtained.

### (F) Surfactant

The chemically amplified positive resist composition of the invention may contain a commonly used surfactant as a component (F) in order to improve the applicability to the substrate. Many surfactants are known as described in WO 2006/121096 A, JP-A 2008-102383 A, JP-A 2008-304590, JP-A 2004-115630, and JP-A 2005-8766, and selection can be made with reference to them.

When the chemically amplified positive resist composition of the invention contains the surfactant (F), the content thereof is preferably 2 parts by weight or less, and more preferably 1 part by weight or less, and the lower limit thereof is preferably 0.01 parts by weight or more per 80 parts by weight of the base polymer (A). As the surfactant (F), one type may be used alone or two or more types may be combined and used.

### Resist pattern forming process

A resist pattern forming process of the invention includes the steps of forming a resist film on a substrate using the chemically amplified positive resist composition described above, exposing the resist film to high-energy radiation, and developing the resist film exposed patternwise using an alkaline developer to obtain a resist pattern.

As the substrate, for example, a substrate for producing an integrated circuit (such as Si, SiO, SiO₂, SiN, SiON, TiN, WSi, BPSG, SOG, or an organic antireflective film) or a substrate for producing a mask circuit (such as Cr, CrO, CrON, MoSi₂, Si, SiO, or SiO₂) can be used. The resist film is formed by applying the chemically amplified positive resist composition onto the substrate by a method such as spin coating so as to have a film thickness of 0.03 to 2 µm, and prebaking the chemically amplified resist composition on a hotplate at preferably 60 to 150°C for 1 to 20 minutes, more preferably at 80 to 140°C for 1 to 10 minutes.

Subsequently, the resist film is exposed patternwise to high-energy radiation. Examples of the high-energy radiation include an ultraviolet ray, a far ultraviolet ray, excimer laser light (such as KrF and ArF), EB, EUV, an X-ray, a γ-ray, and synchrotron radiation.

When an ultraviolet ray, a far ultraviolet ray, excimer laser light, EUV, an X-ray, a γ-ray, or synchrotron radiation is used as the high-energy radiation, irradiation is performed using a mask for forming a desired pattern so that the exposure dose is preferably 1 to 300 mJ/cm² and more preferably 10 to 200 mJ/cm². When EB is used as the high-energy radiation, writing is directly performed so that the exposure dose is preferably 1 to 300 µC/cm² and more preferably 10 to 200 µC/cm². The chemically amplified positive resist composition of the invention is particularly useful in EUV or EB lithography.

In the exposure, in addition to a conventional exposure method, an immersion method in which a liquid is held between a mask and a resist film may be used. In this case, a protective film insoluble in water can also be used.

Post exposure baking (PEB) is then performed on a hot plate at preferably 60 to 150°C for 1 to 20 minutes, more preferably at 80 to 140°C for 1 to 10 minutes.

Thereafter, development is performed using a developer of an aqueous alkaline solution of, for example, tetramethylammonium hydroxide (TMAH) at preferably 0.1 to 5 wt%, more preferably 2 to 3 wt% for 0.1 to 3 minutes, preferably 0.5 to 2 minutes by a conventional method such as a dip method, a puddle method, or a spray method to form a desired pattern on the substrate.

The chemically amplified positive resist composition of the invention is useful particularly on use under the conditions that require high etching resistance, and a small change in pattern line width and a small LER even when the time from exposure to PEB is extended. In addition, the resist composition of the invention is particularly useful for application to a substrate having a material which is likely to cause pattern peeling or pattern collapse on the surface because good adhesion of a resist pattern is difficult to achieve. Examples of such a substrate include a substrate having a film formed by sputtering metallic chromium or a chromium compound containing one or more light elements selected from oxygen, nitrogen, and carbon. The chemically amplified positive resist composition of the invention is particularly useful for forming a pattern using a photomask blank as the substrate.

### EXAMPLES

Hereinafter, the invention is specifically described with showing Synthesis Examples, Examples, and Comparative Examples, but the invention is not limited to the following Examples. The copolymerization composition ratio is a molar ratio, and Mw is a measurement value by GPC in terms of polystyrene. The apparatus used is as follows.

| | |
|---|---|
| IR: | NICOLET 6700 manufactured by Thermo Fisher Scientific Inc. |
| ¹H-NMR: | ECA-500 manufactured by JEOL Ltd. |
| MALDI TOF-MS: | S3000 manufactured by JEOL Ltd. |

### [1] Synthesis of onium salt type monomer

### Synthesis Example 1-1

### Synthesis of onium salt type monomer A1-1

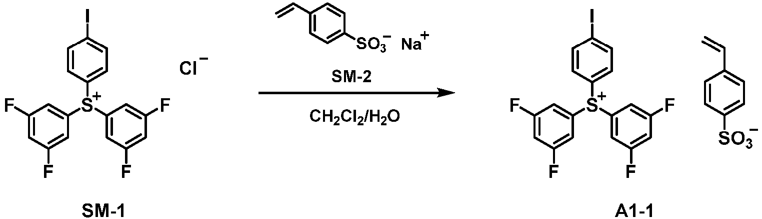

Under a nitrogen atmosphere, an aqueous solution of a raw material SM-1 (1046.2 g, corresponding to 47.1 g of pure content), a raw material SM-2 (21.6 g), and methylene chloride (300 g) were prepared and stirred at room temperature for 30 minutes. The organic layer was taken out, washed with water, and then concentrated under reduced pressure to obtain an onium salt type monomer A1-1 as oily matter (amount: 56.7 g, yield: 93%).

The IR spectrum data and results of TOF-MS of the onium salt type monomer A1-1 are shown below. The results of the nuclear magnetic resonance spectrum (¹H-NMR/DMSO-d₆) are shown in FIG. 1.
IR (D-ATR): v = 3436, 3060, 1706, 1599, 1560, 1495, 1443, 1387, 1294, 1200, 1134, 1123, 1055, 1033, 1009, 999, 912, 864, 844, 733, 719, 699, 675, 581, 555, 539, 508, 491 cm⁻¹.
MALDI TOF-MS:
   POSITIVE M⁺ 461 (corresponding to C₁₈H₁₀F₄IS⁺)
   NEGATIVE M⁻ 183 (corresponding to C₈H₇O₃S⁻)

### [2] Synthesis of polymer

### Synthesis Example 2-1

### Synthesis of polymer P-1

Under a nitrogen atmosphere, a flask was charged with a monomer A1-1 (19.2 g), a monomer A2-1 (50.1 g), a monomer A3-1-1 (30.7 g), V-601 (manufactured by FUJIFILM Wako Pure Chemical Corporation) (6.86 g), and MEK (139 g) to prepare a monomer-polymerization initiator solution. Another flask under a nitrogen atmosphere was charged with 46 g of MEK, heated to 80°C with stirring, and then the monomer-polymerization initiator solution was added dropwise thereto over 4 hours. After completion of the dropwise addition, stirring was continued for 2 hours while the temperature of the polymerization liquid was maintained at 80°C, and then the polymerization liquid was cooled to room temperature. The obtained polymerization liquid was added dropwise to 3,000 g of hexane with vigorous stirring, and the precipitated polymer was separated by filtration. The obtained polymer was washed twice with 600 g of hexane, and then vacuum dried at 50°C for 20 hours to obtain a polymer P-1 in a white powder form (amount: 97.1 g, yield: 97%). The polymer P-1 had a Mw of 9,700, and a Mw/Mn of 1.62. Mw is a measurement value by GPC in terms of polystyrene using DMF as a solvent.

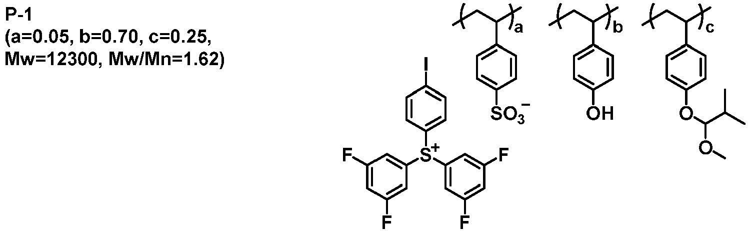

### Synthesis Examples 2-2 to 2-60, Comparative Synthesis Examples 1-1 to 1-38

### Synthesis of polymers P-2 to P-60 and comparative polymers CP-1 to CP-38

Polymers P-2 to P-60 shown in Tables 1 and 2 below and comparative polymers CP-1 to CP-38 shown in Table 3 below were synthesized in the same manner as in Synthesis Example 2-1 except that the type and blending ratio of each monomer were changed. In Tables 1 to 3 below, the incorporation ratio indicates a molar ratio.

**Table 1**

| Polymer | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | A1-1 | 5 | A2-1 | 70 | A3-1-1 | 25 | - | - | - | - | 12,300 | 1.62 |
| P-2 | A1-2 | 5 | A2-1 | 70 | A3-1-1 | 25 | - | - | - | - | 12,500 | 1.65 |
| P-3 | A1-3 | 5 | A2-1 | 70 | A3-1-1 | 25 | - | - | - | - | 12,200 | 1.64 |
| P-4 | A1-4 | 5 | A2-1 | 70 | A3-1-1 | 25 | - | - | - | - | 11,900 | 1.66 |
| P-5 | A1-5 | 5 | A2-1 | 70 | A3-1-1 | 25 | - | - | - | - | 12,400 | 1.64 |
| P-6 | A1-6 | 5 | A2-1 | 70 | A3-1-1 | 25 | - | - | - | - | 12,600 | 1.65 |
| P-7 | A1-1 | 5 | A2-1 | 65 | A3-1-1 | 20 | A4-1 | 10 | - | - | 11,800 | 1.62 |
| P-8 | A1-1 | 5 | A2-1 | 65 | A3-1-1 | 20 | A5-1 | 10 | - | - | 12,300 | 1.61 |
| P-9 | A1-1 | 5 | A2-1 | 65 | A3-1-1 | 20 | A6-1 | 10 | - | - | 11,900 | 1.67 |
| P-10 | A1-1 | 5 | A2-1 | 65 | A3-1-1 | 20 | A6-2 | 10 | - | - | 12,300 | 1.66 |
| P-11 | A1-1 | 10 | A2-1 | 56 | A3-1-1 | 21 | A4-1 | 13 | - | - | 12,200 | 1.65 |
| P-12 | A1-1 | 5 | A2-1 | 70 | A3-1-2 | 25 | - | - | - | - | 12,300 | 1.64 |
| P-13 | A1-1 | 5 | A2-1 | 70 | A3-1-3 | 25 | - | - | - | - | 11,900 | 1.66 |
| P-14 | A1-1 | 5 | A2-1 | 70 | A3-1-4 | 25 | - | - | - | - | 12,500 | 1.65 |
| P-15 | A1-1 | 5 | A2-1 | 70 | A3-1-5 | 25 | - | - | - | - | 12,200 | 1.63 |
| P-16 | A1-1 | 5 | A2-1 | 70 | A3-1-6 | 25 | - | - | - | - | 11,700 | 1.66 |
| P-17 | A1-1 | 5 | A2-1 | 70 | A3-1-7 | 25 | - | - | - | - | 11,900 | 1.65 |
| P-18 | A1-1 | 5 | A2-1 | 70 | A3-1-8 | 25 | - | - | - | - | 12,200 | 1.64 |
| P-19 | A1-1 | 5 | A2-1 | 70 | A3-1-9 | 25 | - | - | - | - | 12,100 | 1.65 |
| P-20 | A1-1 | 5 | A2-1 | 70 | A3-1-10 | 25 | - | - | - | - | 12,200 | 1.62 |
| P-21 | A1-1 | 5 | A2-1 | 70 | A3-1-11 | 25 | - | - | - | - | 12,300 | 1.62 |
| P-22 | A1-1 | 5 | A2-1 | 70 | A3-1-12 | 25 | - | - | - | - | 11,900 | 1.65 |
| P-23 | A1-1 | 5 | A2-1 | 70 | A3-1-13 | 25 | - | - | - | - | 12,200 | 1.62 |
| P-24 | A1-1 | 5 | A2-2 | 63 | A3-1-3 | 22 | A6-1 | 10 | - | - | 12,500 | 1.64 |
| P-25 | A1-2 | 5 | A2-2 | 63 | A3-1-3 | 22 | A6-1 | 10 | - | - | 12,300 | 1.62 |
| P-26 | A1-3 | 5 | A2-2 | 63 | A3-1-3 | 22 | A6-1 | 10 | - | - | 11,900 | 1.62 |
| P-27 | A1-4 | 5 | A2-2 | 63 | A3-1-3 | 22 | A6-1 | 10 | - | - | 12,500 | 1.62 |
| P-28 | A1-5 | 5 | A2-2 | 63 | A3-1-3 | 22 | A6-1 | 10 | - | - | 12,300 | 1.62 |
| P-29 | A1-6 | 5 | A2-2 | 63 | A3-1-3 | 22 | A6-1 | 10 | - | - | 12,300 | 1.62 |
| P-30 | A1-1 | 5 | A2-3 | 63 | A3-1-2 | 25 | A4-1 | 7 | - | - | 11,900 | 1.64 |

**Table 2**

| Polymer | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-31 | A1-2 | 5 | A2-3 | 63 | A3-1-5 | 25 | A4-1 | 7 | - | - | 12,300 | 1.66 |
| P-32 | A1-3 | 5 | A2-3 | 63 | A3-1-7 | 25 | A4-1 | 7 | - | - | 12,200 | 1.62 |
| P-33 | A1-4 | 5 | A2-3 | 63 | A3-1-8 | 25 | A4-1 | 7 | - | - | 12,500 | 1.62 |
| P-34 | A1-5 | 5 | A2-3 | 63 | A3-1-10 | 25 | A4-1 | 7 | - | - | 12,300 | 1.62 |
| P-35 | A1-6 | 5 | A2-3 | 63 | A3-1-13 | 25 | A4-1 | 7 | - | - | 12,500 | 1.64 |
| P-36 | A1-1 | 5 | A2-4 | 63 | A3-1-1 | 22 | A4-1 | 10 | - | - | 11,900 | 1.65 |
| P-37 | A1-1 | 6 | A2-1 | 70 | A3-1-8 | 12 | A3-2-1 | 12 | - | - | 12,500 | 1.62 |
| P-38 | A1-1 | 6 | A2-1 | 70 | A3-1-8 | 12 | A3-2-2 | 12 | - | - | 11,600 | 1.64 |
| P-39 | A1-1 | 6 | A2-1 | 70 | A3-1-8 | 12 | A3-2-3 | 12 | - | - | 12,200 | 1.62 |
| P-40 | A1-1 | 5 | A2-1 | 63 | A3-1-8 | 12 | A3-2-1 | 12 | A6-1 | 8 | 11,900 | 1.62 |
| P-41 | A1-1 | 6 | A2-1 | 70 | A3-1-10 | 12 | A3-2-1 | 12 | - | - | 12,300 | 1.65 |
| P-42 | A1-1 | 6 | A2-1 | 70 | A3-1-10 | 12 | A3-2-2 | 12 | - | - | 11,800 | 1.62 |
| P-43 | A1-1 | 6 | A2-1 | 70 | A3-1-10 | 12 | A3-2-3 | 12 | - | - | 12,100 | 1.66 |
| P-44 | A1-1 | 6 | A2-1 | 70 | A3-1-13 | 12 | A3-2-1 | 12 | - | - | 12,300 | 1.66 |
| P-45 | A1-1 | 6 | A2-1 | 70 | A3-1-13 | 12 | A3-2-2 | 12 | - | - | 11,900 | 1.62 |
| P-46 | A1-1 | 6 | A2-1 | 70 | A3-1-13 | 12 | A3-2-3 | 12 | - | - | 12,500 | 1.64 |
| P-47 | A1-1 | 6 | A2-1 | 70 | A3-2-1 | 24 | - | - | - | - | 12,200 | 1.62 |
| P-48 | A1-1 | 6 | A2-1 | 70 | A3-2-2 | 24 | - | - | - | - | 12,300 | 1.62 |
| P-49 | A1-1 | 6 | A2-1 | 70 | A3-2-3 | 24 | - | - | - | - | 11,900 | 1.66 |
| P-50 | A1-1 | 6 | A2-2 | 70 | A3-2-1 | 24 | - | - | - | - | 12,500 | 1.65 |
| P-51 | A1-1 | 6 | A2-2 | 70 | A3-2-2 | 24 | - | - | - | - | 12,300 | 1.62 |
| P-52 | A1-1 | 6 | A2-2 | 70 | A3-2-3 | 24 | - | - | - | - | 12,400 | 1.64 |
| P-53 | A1-1 | 5 | A2-1 | 63 | A3-2-1 | 22 | A4-1 | 10 | - | - | 12,300 | 1.66 |
| P-54 | A1-1 | 5 | A2-1 | 63 | A3-2-2 | 22 | A6-2 | 10 | - | - | 12,100 | 1.62 |
| P-55 | A1-2 | 6 | A2-1 | 70 | A3-1-9 | 24 | - | - | - | - | 12,300 | 1.62 |
| P-56 | A1-3 | 6 | A2-1 | 70 | A3-1-11 | 24 | - | - | - | - | 12,300 | 1.64 |
| P-57 | A1-4 | 6 | A2-1 | 70 | A3-1-12 | 24 | - | - | - | - | 12,500 | 1.62 |
| P-58 | A1-1 | 5 | A2-1 | 65 | A3-1-1 | 25 | A7-1 | 5 | - | - | 12,200 | 1.62 |
| P-59 | A1-1 | 5 | A2-1 | 65 | A3-1-1 | 25 | A8-1 | 5 | - | - | 12,500 | 1.65 |
| P-60 | A1-1 | 5 | A2-1 | 65 | A3-1-1 | 25 | A9-1 | 5 | - | - | 12,300 | 1.64 |

**Table 3**

| Polymer | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| CP-1 | CA1-1 | 5 | A2-1 | 70 | A3-1-1 | 25 | - | - | - | - | 12,200 | 1.62 |
| CP-2 | CA1-2 | 5 | A2-1 | 70 | A3-1-1 | 25 | - | - | - | - | 12,200 | 1.65 |
| CP-3 | CA1-3 | 5 | A2-1 | 70 | A3-1-1 | 25 | - | - | - | - | 12,300 | 1.62 |
| CP-4 | CA1-4 | 5 | A2-1 | 70 | A3-1-1 | 25 | - | - | - | - | 11,900 | 1.62 |
| CP-5 | CA1-1 | 5 | A2-1 | 65 | A3-1-1 | 20 | A4-1 | 10 | - | - | 12,400 | 1.62 |
| CP-6 | CA1-1 | 5 | A2-1 | 65 | A3-1-1 | 20 | A5-1 | 10 | - | - | 12,300 | 1.61 |
| CP-7 | CA1-1 | 5 | A2-1 | 65 | A3-1-1 | 20 | A6-1 | 10 | - | - | 11,800 | 1.67 |
| CP-8 | CA1-1 | 5 | A2-1 | 70 | A3-1-2 | 25 | - | - | - | - | 12,300 | 1.64 |
| CP-9 | CA1-2 | 5 | A2-1 | 70 | A3-1-3 | 25 | - | - | - | - | 12,400 | 1.66 |
| CP-10 | CA1-3 | 5 | A2-1 | 70 | A3-1-4 | 25 | - | - | - | - | 12,500 | 1.65 |
| CP-11 | CA1-4 | 5 | A2-1 | 70 | A3-1-8 | 25 | - | - | - | - | 11,900 | 1.64 |
| CP-12 | CA1-4 | 5 | A2-1 | 70 | A3-1-11 | 25 | - | - | - | - | 12,400 | 1.62 |
| CP-13 | CA1-4 | 5 | A2-1 | 70 | A3-1-13 | 25 | - | - | - | - | 12,200 | 1.62 |
| CP-14 | CA1-1 | 5 | A2-2 | 63 | A3-1-3 | 22 | A6-1 | 10 | - | - | 12,400 | 1.65 |
| CP-15 | CA1-2 | 5 | A2-2 | 63 | A3-1-3 | 22 | A6-1 | 10 | - | - | 12,300 | 1.62 |
| CP-16 | CA1-3 | 5 | A2-2 | 63 | A3-1-3 | 22 | A6-1 | 10 | - | - | 11,900 | 1.65 |
| CP-17 | CA1-4 | 5 | A2-2 | 63 | A3-1-3 | 22 | A6-1 | 10 | - | - | 11,800 | 1.62 |
| CP-18 | CA1-1 | 5 | A2-3 | 63 | A3-1-5 | 25 | A4-1 | 7 | - | - | 12,400 | 1.66 |
| CP-19 | CA1-4 | 5 | A2-3 | 63 | A3-1-8 | 25 | A4-1 | 7 | - | - | 12,200 | 1.62 |
| CP-20 | CA1-1 | 6 | A2-1 | 70 | A3-1-8 | 12 | A3-2-2 | 12 | - | - | 11,900 | 1.64 |
| CP-21 | CA1-2 | 6 | A2-1 | 70 | A3-1-8 | 12 | A3-2-3 | 12 | - | - | 12,200 | 1.65 |
| CP-22 | CA1-4 | 5 | A2-1 | 63 | A3-1-8 | 12 | A3-2-1 | 12 | A6-1 | 8 | 12,200 | 1.62 |
| CP-23 | CA1-1 | 6 | A2-1 | 70 | A3-1-13 | 12 | A3-2-1 | 12 | - | - | 11,900 | 1.66 |
| CP-24 | CA1-3 | 6 | A2-1 | 70 | A3-1-13 | 12 | A3-2-2 | 12 | - | - | 12,200 | 1.62 |
| CP-25 | CA1-4 | 6 | A2-1 | 70 | A3-1-13 | 12 | A3-2-3 | 12 | - | - | 12,400 | 1.64 |
| CP-26 | CA1-1 | 6 | A2-1 | 70 | A3-2-2 | 24 | - | - | - | - | 11,900 | 1.62 |
| CP-27 | CA1-2 | 6 | A2-1 | 70 | A3-2-3 | 24 | - | - | - | - | 12,400 | 1.65 |
| CP-28 | CA1-3 | 6 | A2-2 | 70 | A3-2-1 | 24 | - | - | - | - | 11,800 | 1.65 |
| CP-29 | CA1-4 | 6 | A2-2 | 70 | A3-2-2 | 24 | - | - | - | - | 12,200 | 1.62 |
| CP-30 | CA1-4 | 5 | A2-1 | 63 | A3-2-2 | 22 | A6-2 | 10 | - | - | 11,900 | 1.62 |
| CP-31 | CA1-1 | 6 | A2-1 | 70 | A3-1-9 | 24 | - | - | - | - | 12,500 | 1.62 |
| CP-32 | CA1-2 | 6 | A2-1 | 70 | A3-1-11 | 24 | - | - | - | - | 11,800 | 1.64 |
| CP-33 | CA1-4 | 6 | A2-1 | 70 | A3-1-12 | 24 | - | - | - | - | 12,400 | 1.62 |
| CP-34 | CA1-1 | 5 | A2-1 | 65 | A3-1-1 | 25 | A7-1 | 5 | - | - | 11,900 | 1.62 |
| CP-35 | CA1-3 | 5 | A2-1 | 65 | A3-1-1 | 25 | A8-1 | 5 | - | - | 12,200 | 1.65 |
| CP-36 | CA1-4 | 5 | A2-1 | 65 | A3-1-1 | 25 | A9-1 | 5 | - | - | 12,500 | 1.65 |
| CP-37 | CA1-2 | 12 | A2-2 | 56 | A3-1-9 | 22 | A4-1 | 10 | - | - | 11,800 | 1.64 |
| CP-38 | CA1-3 | 12 | A2-2 | 56 | A3-1-9 | 22 | A4-1 | 10 | - | - | 12,400 | 1.67 |

The monomers used in the synthesis of the polymers are as follows.

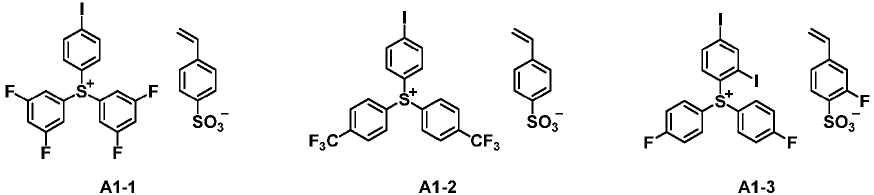

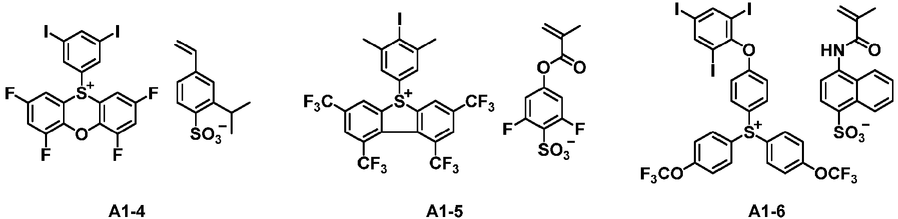

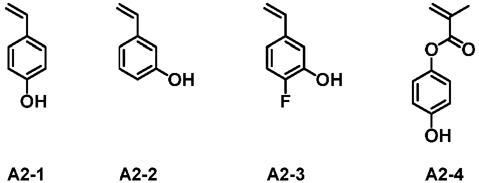

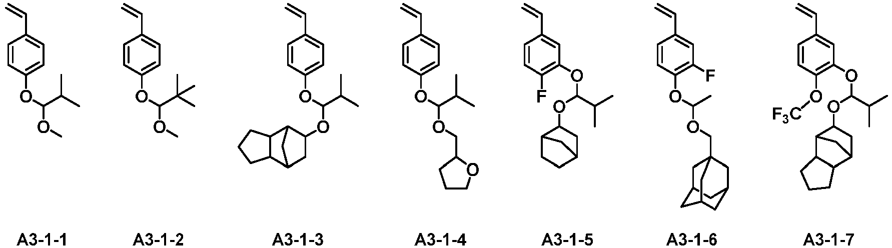

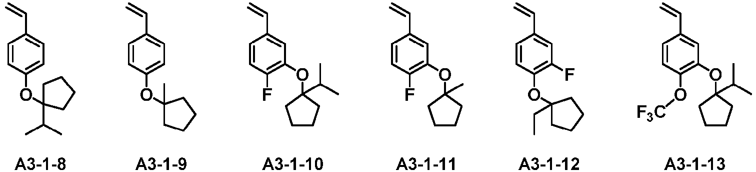

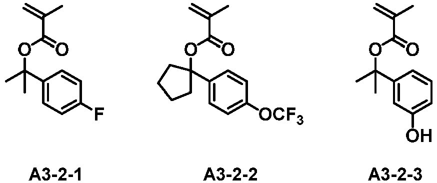

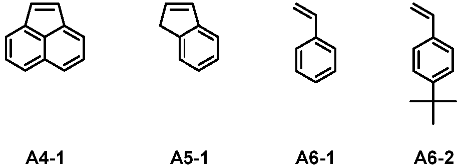

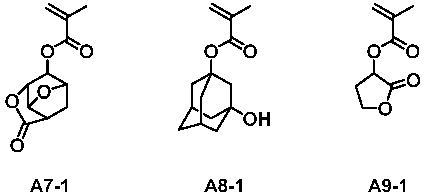

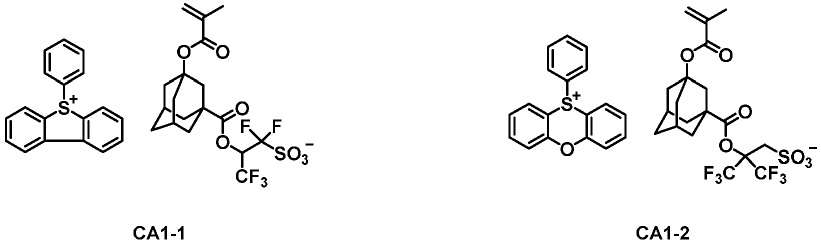

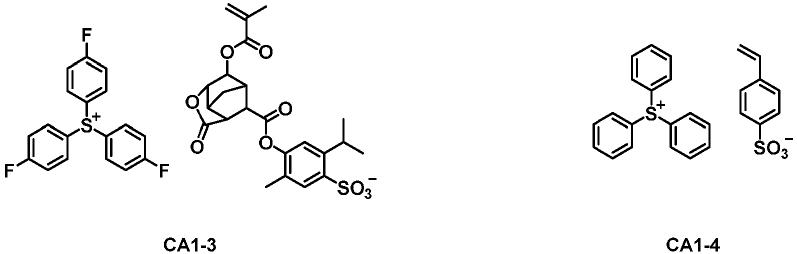

The dissolution rate of the polymer in an alkaline developer was obtained by applying a polymer solution (polymer concentration: 16.7 wt%, solvent: PGME) onto an 8-inch silicon wafer through spin coating, baking the solution at 100°C for 90 seconds to form a film having a film thickness of 1,000 nm, then performing development with a 2.38 wt% TMAH aqueous solution at 23°C for 100 seconds, and measuring the amount of film thickness loss, followed by calculation. As a result, the dissolution rate of the polymers P-1 to P-60 was 10 nm/min or less. The dissolution rate of the comparative polymers CP-1 to CP-38 was 10 nm/min or less.

### Synthesis Examples 3-1 to 3-16

### Synthesis of polymers AP-1 to AP-16

Polymers AP-1 to AP-16 shown below were synthesized in the same manner as in Synthesis Example 1-1 except that the raw material compounds to be used were changed.

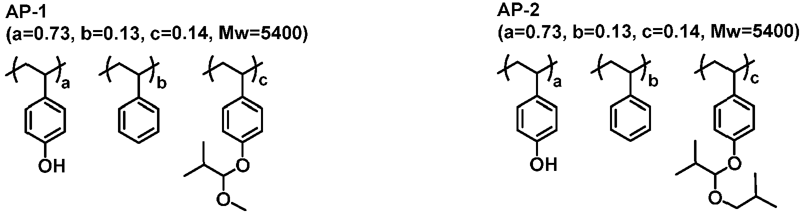

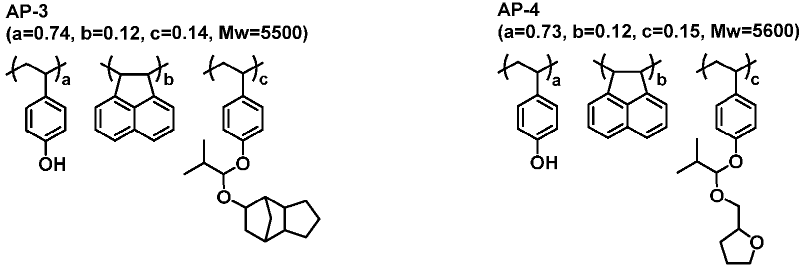

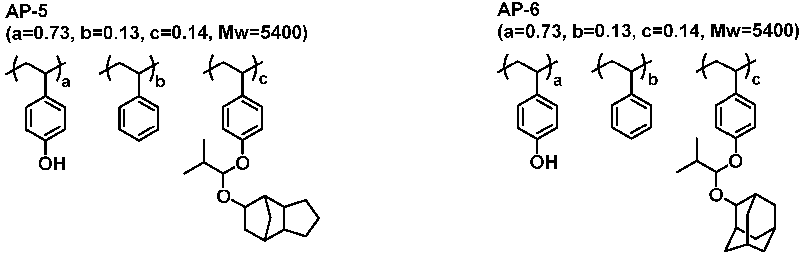

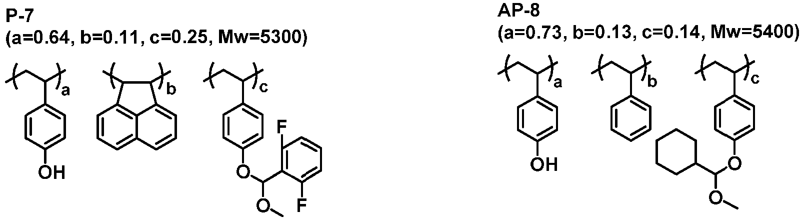

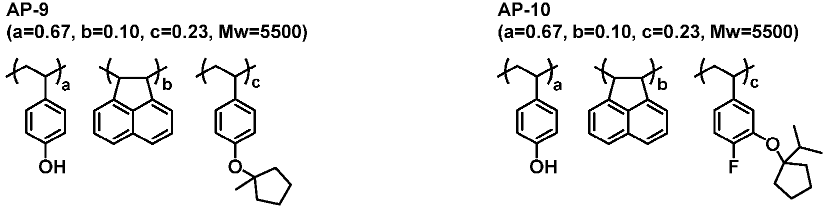

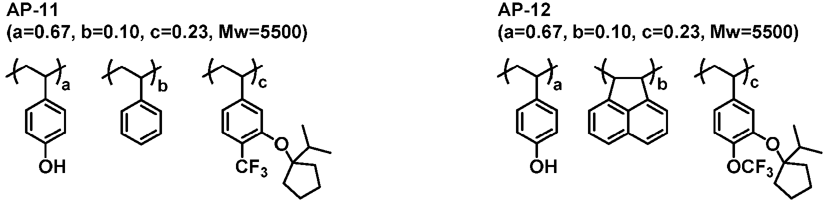

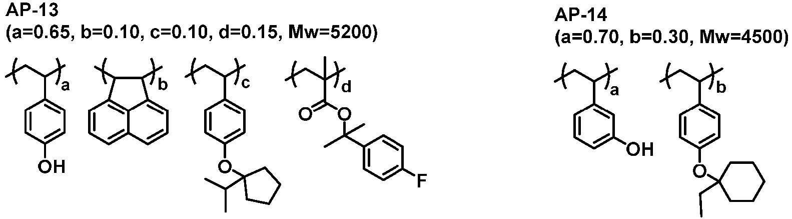

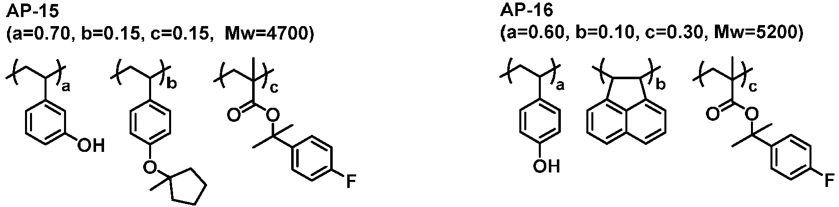

The dissolution rate of the polymers AP-1 to AP-16 was 10 nm/min or less.

### [3] Preparation of chemically amplified positive resist composition

### Examples 1-1 to 1-100, Comparative Examples 1-1 to 1-60

Each component was dissolved in an organic solvent according to the formulation shown in Tables 4 to 8 below, and the obtained solution was filtered through a nylon filter having a size of 5 nm and a UPE filter having a size of sub-1 nm to prepare a chemically amplified positive resist composition. The organic solvent is a mixed solvent of 920 parts by weight of PGMEA, 1,850 parts by weight of EL, or 1,850 parts by weight of diacetone alcohol and 1,850 parts by weight of PGME.

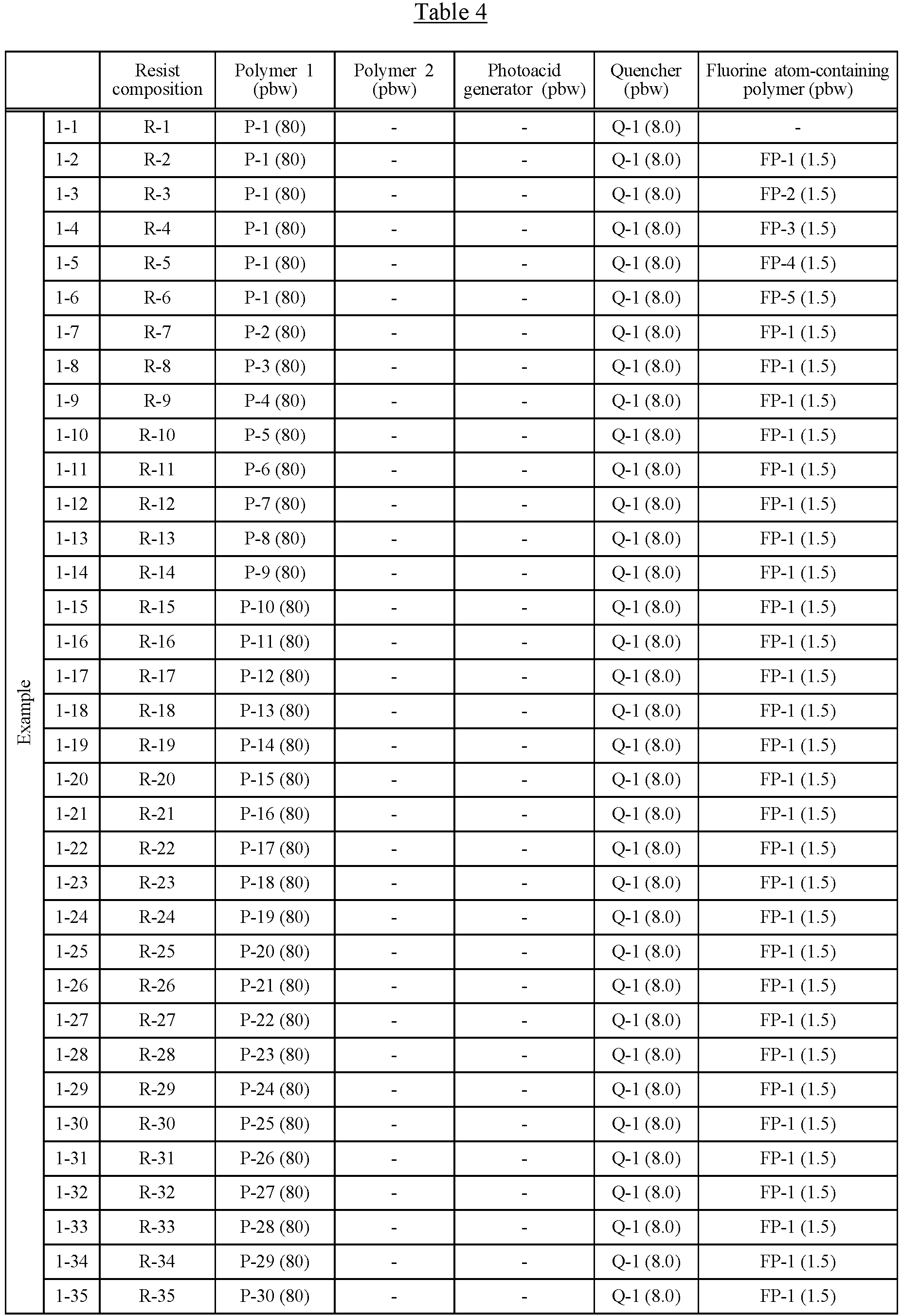

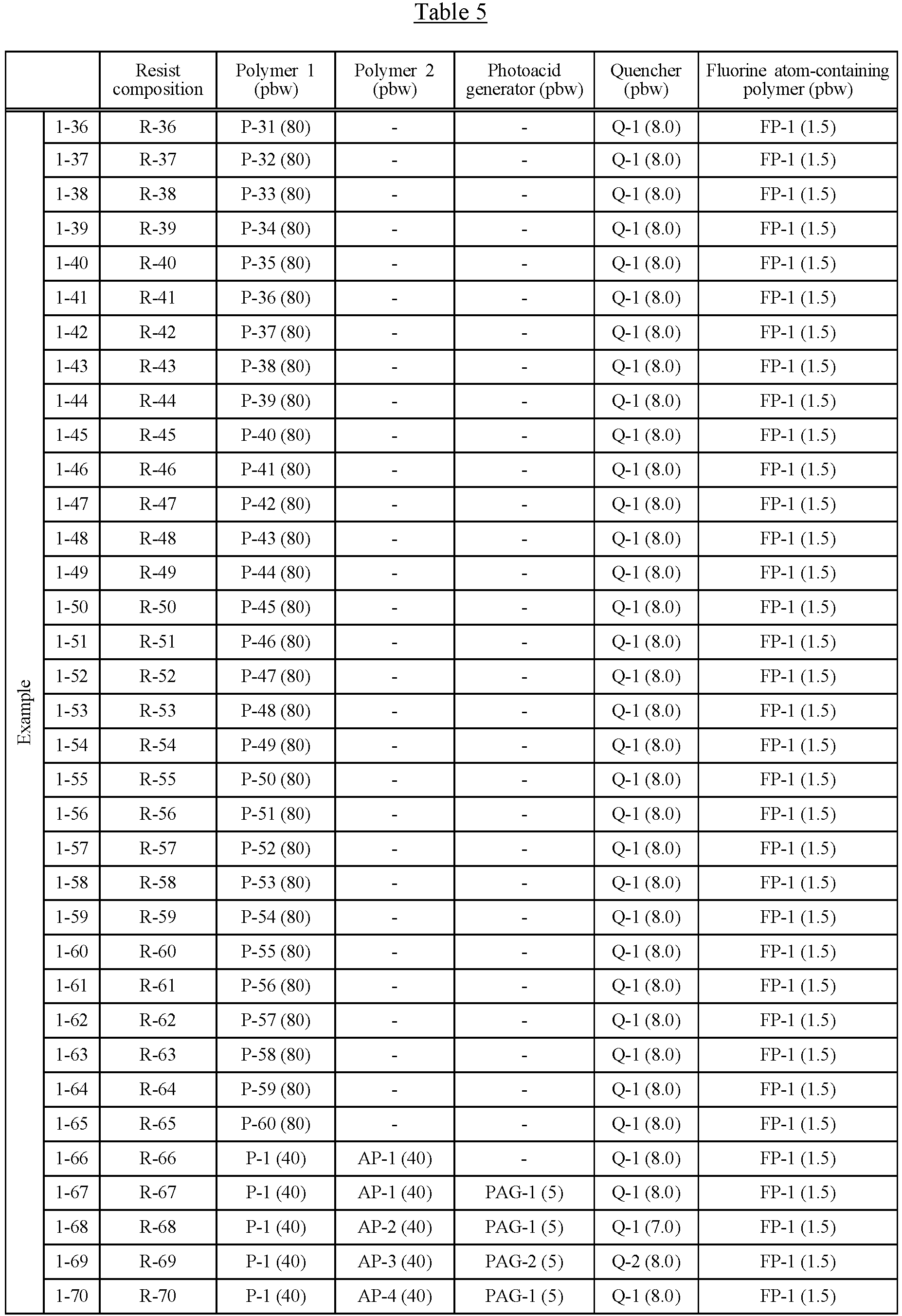

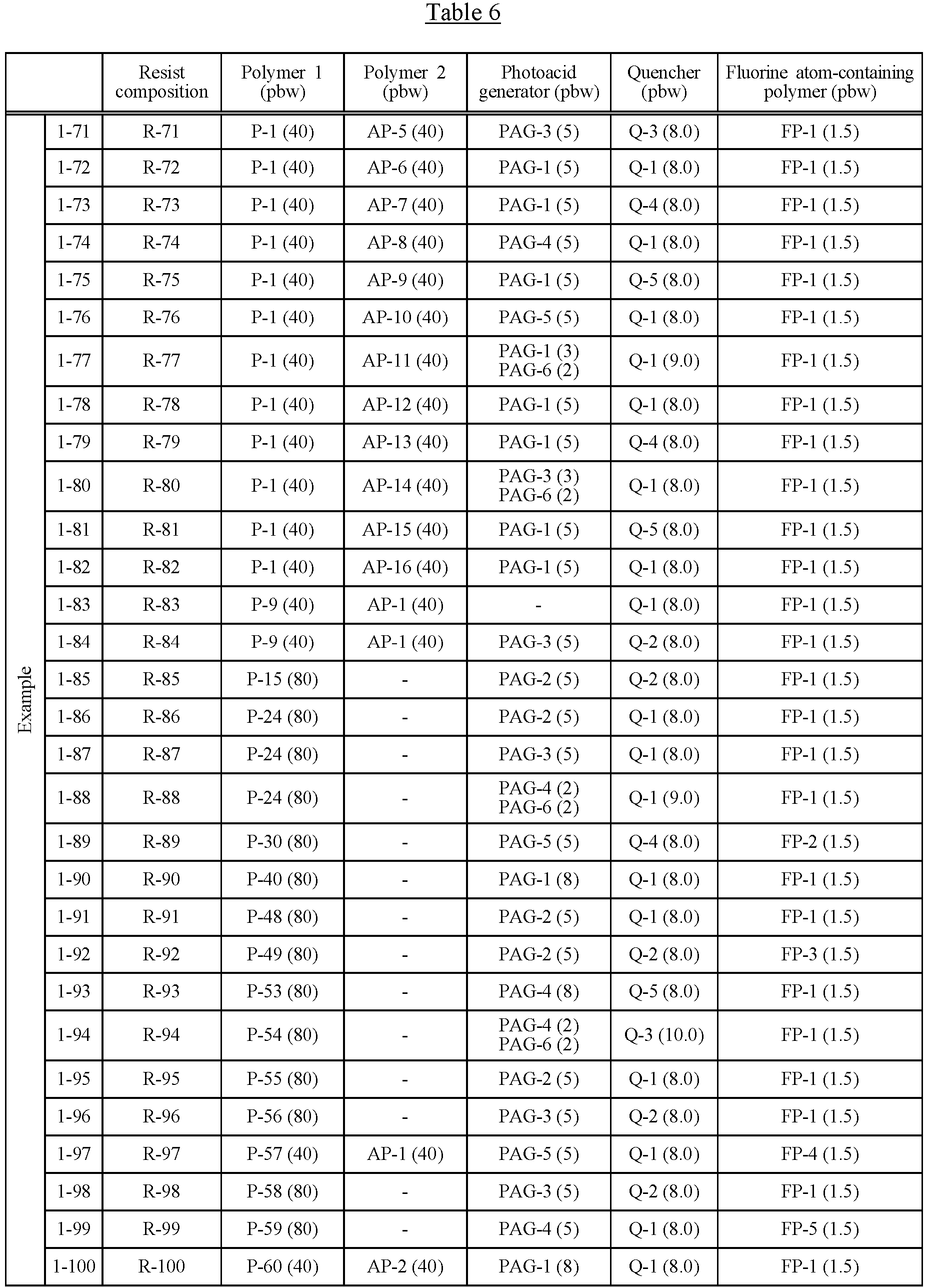

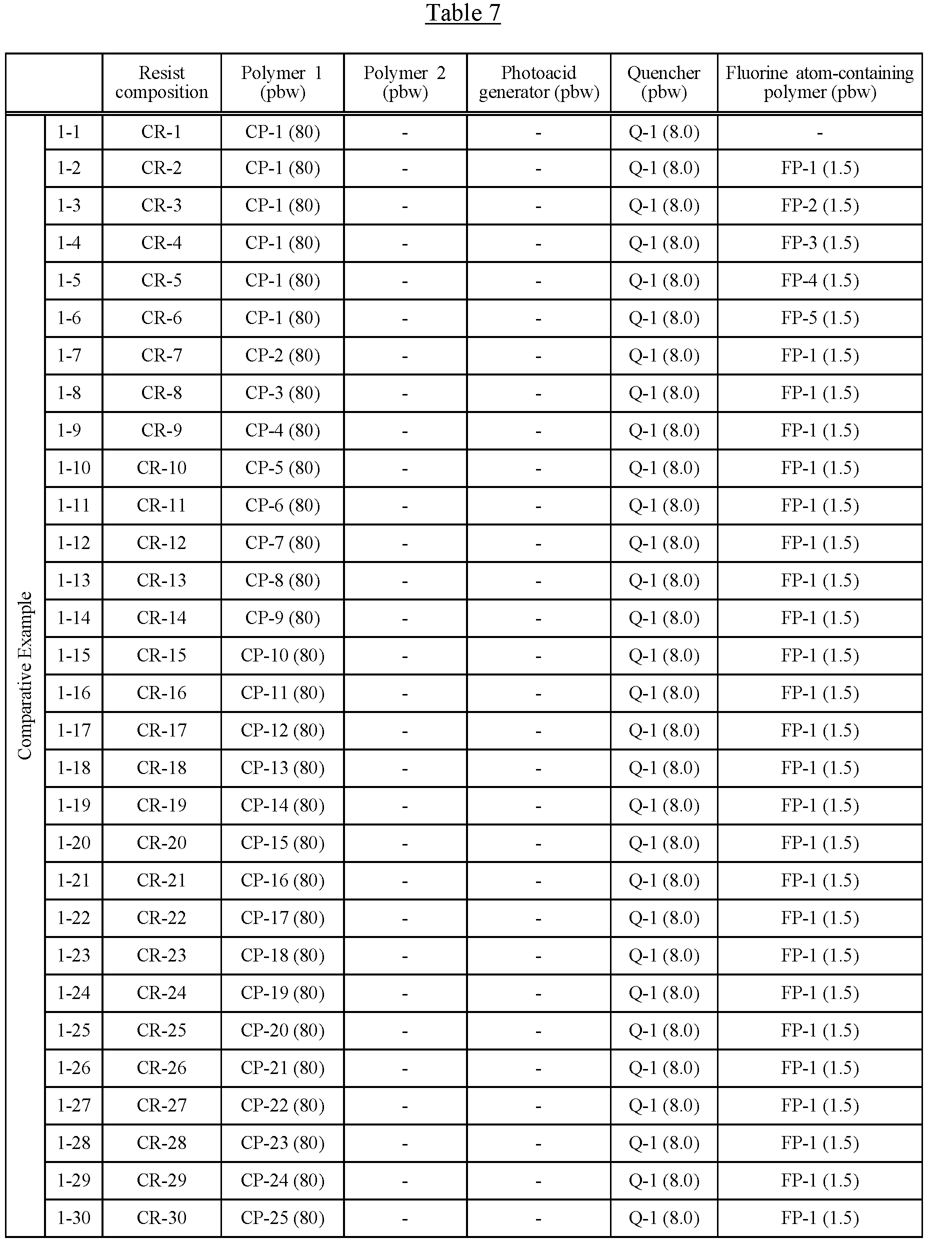

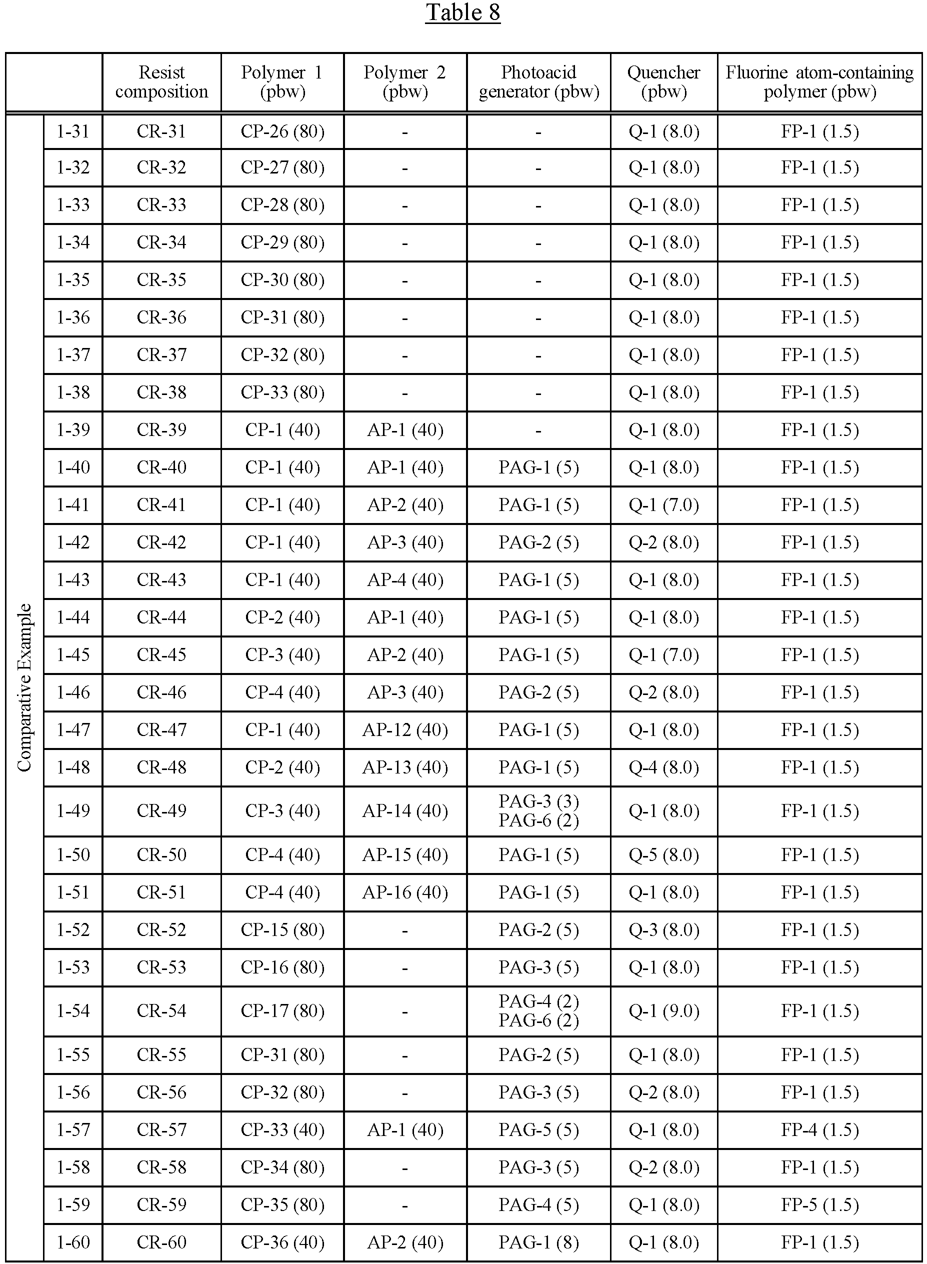

In Tables 4 to 8, the structures of the quenchers Q-1 to Q-5, the photoacid generators PAG-1 to PAG-6, and the polymers FP-1 to FP-5 are as follows.

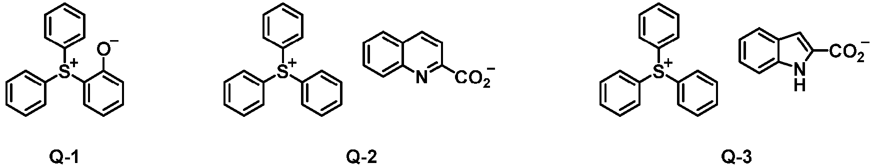

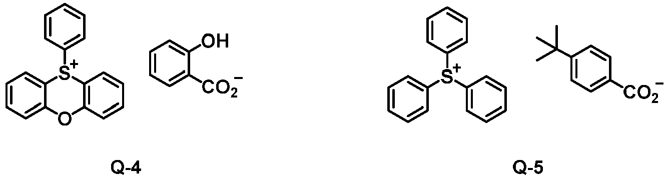

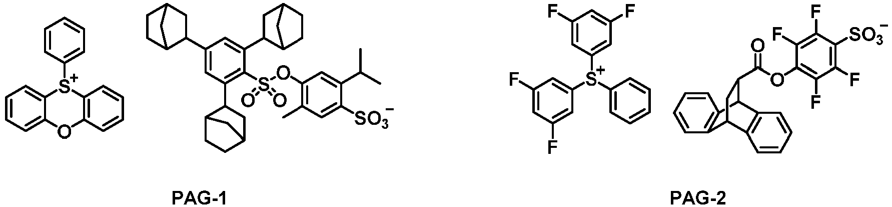

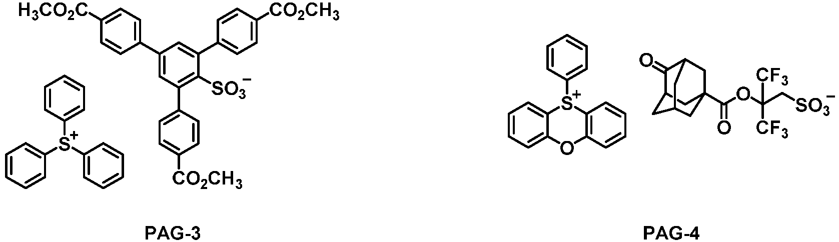

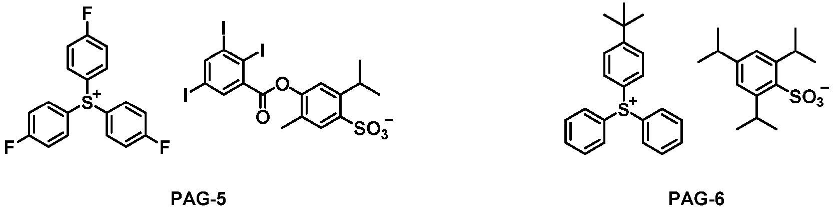

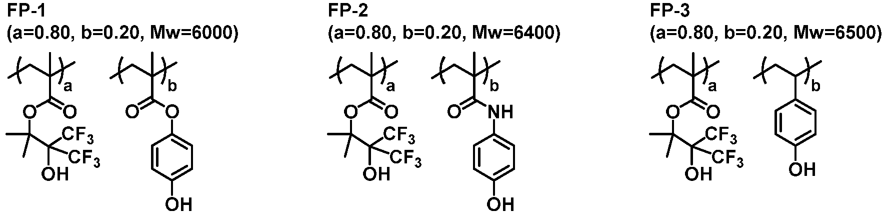

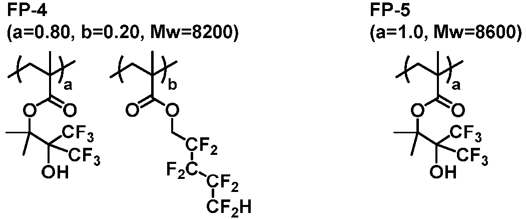

### [4] EB lithography test

### Examples 2-1 to 2-100 and Comparative Examples 2-1 to 2-60

Using ACT-M (manufactured by Tokyo Electron Ltd.), each of the chemically amplified positive resist compositions (R-1 to R-100, CR-1 to CR-60) was applied by spin coating onto a reflective mask blank for an EUV exposure mask having an outermost surface of 152 mm square formed of a chromium compound, and prebaked on a hot plate at 110°C for 600 seconds to prepare a resist film having a film thickness of 80 nm. The film thickness of the obtained resist film was measured using an optical measuring instrument NanoSpec (manufactured by Nanometrics Inc.). The measurement was performed at 81 points in the plane of the blank substrate excluding a peripheral band extending 10 mm inward from the blank periphery, and a film thickness average value and a film thickness range were calculated.

Subsequently, exposure was performed using an electron beam exposure apparatus (EBM-5000plus manufactured by NuFlare Technology Inc., accelerating voltage: 50 kV), PEB was performed at 110°C for 600 seconds, and development was performed with a 2.38 wt% TMAH aqueous solution to obtain a positive pattern.

The obtained resist pattern was evaluated as follows. The prepared patterned mask blank was observed with an aerial scanning electron microscope (SEM), an exposure dose which achieves 1:1 resolution of 200-nm 1:1 line-and-space (LS) was defined as the optimum exposure dose (µC/cm²), a minimum dimension at the exposure dose that achieves 1:1 resolution of 200-nm LS was defined as a resolution (limiting resolution), and LER of a 200-nm LS was measured with SEM. With respect to the limiting resolution of an isolated space (IS), a minimum dimension at the exposure dose that achieves 9:1 resolution of 200-nm 9:1 line-and-space (LS) was defined as limiting resolution. The pattern was visually observed to determine whether or not the profile was rectangular. The results are shown in Tables 9 to 13.

**Table 9**

| | | Resist composition | Optimum exposure dose (µC/cm²) | Limiting resolution LS (nm) | Limiting resolution IS (nm) | LER (nm) | Pattern profile |
|---|---|---|---|---|---|---|---|
| Example | 2-1 | R-1 | 200 | 32 | 18 | 3.3 | rectangular |
| | 2-2 | R-2 | 205 | 35 | 18 | 3.5 | rectangular |
| | 2-3 | R-3 | 200 | 35 | 18 | 3.3 | rectangular |
| | 2-4 | R-4 | 210 | 32 | 18 | 3.4 | rectangular |
| | 2-5 | R-5 | 200 | 32 | 18 | 3.6 | rectangular |
| | 2-6 | R-6 | 205 | 35 | 20 | 3.4 | rectangular |
| | 2-7 | R-7 | 210 | 35 | 18 | 3.3 | rectangular |
| | 2-8 | R-8 | 200 | 35 | 20 | 3.5 | rectangular |
| | 2-9 | R-9 | 205 | 32 | 18 | 3.5 | rectangular |
| | 2-10 | R-10 | 200 | 32 | 18 | 3.7 | rectangular |
| | 2-11 | R-11 | 210 | 35 | 18 | 3.4 | rectangular |
| | 2-12 | R-12 | 200 | 35 | 18 | 3.6 | rectangular |
| | 2-13 | R-13 | 205 | 32 | 20 | 3.6 | rectangular |
| | 2-14 | R-14 | 200 | 35 | 18 | 3.3 | rectangular |
| | 2-15 | R-15 | 210 | 35 | 18 | 3.6 | rectangular |
| | 2-16 | R-16 | 200 | 35 | 20 | 3.4 | rectangular |
| | 2-17 | R-17 | 205 | 32 | 18 | 3.4 | rectangular |
| | 2-18 | R-18 | 210 | 35 | 18 | 3.7 | rectangular |
| | 2-19 | R-19 | 200 | 35 | 18 | 3.6 | rectangular |
| | 2-20 | R-20 | 205 | 35 | 18 | 3.4 | rectangular |
| | 2-21 | R-21 | 200 | 35 | 20 | 3.6 | rectangular |
| | 2-22 | R-22 | 210 | 32 | 18 | 3.4 | rectangular |
| | 2-23 | R-23 | 205 | 35 | 18 | 3.6 | rectangular |
| | 2-24 | R-24 | 200 | 35 | 18 | 3.5 | rectangular |
| | 2-25 | R-25 | 210 | 35 | 18 | 3.4 | rectangular |
| | 2-26 | R-26 | 205 | 35 | 20 | 3.6 | rectangular |
| | 2-27 | R-27 | 200 | 32 | 18 | 3.4 | rectangular |
| | 2-28 | R-28 | 205 | 35 | 18 | 3.4 | rectangular |
| | 2-29 | R-29 | 210 | 35 | 18 | 3.4 | rectangular |
| | 2-30 | R-30 | 205 | 32 | 18 | 3.4 | rectangular |
| | 2-31 | R-31 | 200 | 35 | 20 | 3.4 | rectangular |
| | 2-32 | R-32 | 200 | 35 | 18 | 3.6 | rectangular |
| | 2-33 | R-33 | 205 | 35 | 18 | 3.5 | rectangular |
| | 2-34 | R-34 | 200 | 35 | 18 | 3.6 | rectangular |
| | 2-35 | R-35 | 210 | 35 | 20 | 3.4 | rectangular |

**Table 10**

| | | Resist composition | Optimum exposure dose (µC/cm²) | Limiting resolution LS (nm) | Limiting resolution IS (nm) | LER (nm) | Pattern profile |
|---|---|---|---|---|---|---|---|
| Example | 2-36 | R-36 | 200 | 35 | 18 | 3.6 | rectangular |
| | 2-37 | R-37 | 205 | 35 | 18 | 3.3 | rectangular |
| | 2-38 | R-38 | 210 | 32 | 18 | 3.4 | rectangular |
| | 2-39 | R-39 | 200 | 35 | 18 | 3.4 | rectangular |
| | 2-40 | R-40 | 205 | 32 | 18 | 3.4 | rectangular |
| | 2-41 | R-41 | 200 | 35 | 20 | 3.5 | rectangular |
| | 2-42 | R-42 | 210 | 35 | 18 | 3.4 | rectangular |
| | 2-43 | R-43 | 200 | 32 | 18 | 3.4 | rectangular |
| | 2-44 | R-44 | 205 | 35 | 18 | 3.6 | rectangular |
| | 2-45 | R-45 | 200 | 35 | 18 | 3.4 | rectangular |
| | 2-46 | R-46 | 210 | 35 | 18 | 3.6 | rectangular |
| | 2-47 | R-47 | 200 | 32 | 18 | 3.5 | rectangular |
| | 2-48 | R-48 | 205 | 35 | 18 | 3.6 | rectangular |
| | 2-49 | R-49 | 210 | 32 | 18 | 3.7 | rectangular |
| | 2-50 | R-50 | 200 | 35 | 18 | 3.6 | rectangular |
| | 2-51 | R-51 | 205 | 35 | 18 | 3.4 | rectangular |
| | 2-52 | R-52 | 200 | 35 | 20 | 3.6 | rectangular |
| | 2-53 | R-53 | 210 | 32 | 18 | 3.4 | rectangular |
| | 2-54 | R-54 | 205 | 35 | 18 | 3.6 | rectangular |
| | 2-55 | R-55 | 200 | 35 | 18 | 3.4 | rectangular |
| | 2-56 | R-56 | 210 | 35 | 20 | 3.5 | rectangular |
| | 2-57 | R-57 | 205 | 35 | 18 | 3.6 | rectangular |
| | 2-58 | R-58 | 200 | 32 | 18 | 3.4 | rectangular |
| | 2-59 | R-59 | 205 | 35 | 18 | 3.5 | rectangular |
| | 2-60 | R-60 | 210 | 35 | 18 | 3.6 | rectangular |
| | 2-61 | R-61 | 205 | 35 | 18 | 3.4 | rectangular |
| | 2-62 | R-62 | 200 | 32 | 20 | 3.4 | rectangular |
| | 2-63 | R-63 | 200 | 32 | 18 | 3.5 | rectangular |
| | 2-64 | R-64 | 200 | 35 | 18 | 3.6 | rectangular |
| | 2-65 | R-65 | 205 | 35 | 18 | 3.5 | rectangular |
| | 2-66 | R-66 | 200 | 35 | 20 | 3.4 | rectangular |
| | 2-67 | R-67 | 210 | 35 | 18 | 3.4 | rectangular |
| | 2-68 | R-68 | 200 | 32 | 18 | 3.6 | rectangular |
| | 2-69 | R-69 | 205 | 32 | 18 | 3.5 | rectangular |
| | 2-70 | R-70 | 210 | 35 | 18 | 3.3 | rectangular |

**Table 11**

| | | Resist composition | Optimum exposure dose (µC/cm²) | Limiting resolution LS (nm) | Limiting resolution IS (nm) | LER (nm) | Pattern profile |
|---|---|---|---|---|---|---|---|
| Example | 2-71 | R-71 | 200 | 35 | 18 | 3.4 | rectangular |
| | 2-72 | R-72 | 205 | 35 | 18 | 3.5 | rectangular |
| | 2-73 | R-73 | 200 | 32 | 18 | 3.7 | rectangular |
| | 2-74 | R-74 | 210 | 35 | 20 | 3.3 | rectangular |
| | 2-75 | R-75 | 200 | 35 | 18 | 3.4 | rectangular |
| | 2-76 | R-76 | 205 | 35 | 18 | 3.6 | rectangular |
| | 2-77 | R-77 | 200 | 32 | 18 | 3.7 | rectangular |
| | 2-78 | R-78 | 210 | 32 | 20 | 3.4 | rectangular |
| | 2-79 | R-79 | 200 | 35 | 18 | 3.5 | rectangular |
| | 2-80 | R-80 | 205 | 35 | 18 | 3.6 | rectangular |
| | 2-81 | R-81 | 210 | 35 | 20 | 3.3 | rectangular |
| | 2-82 | R-82 | 200 | 35 | 18 | 3.6 | rectangular |
| | 2-83 | R-83 | 205 | 35 | 18 | 3.3 | rectangular |
| | 2-84 | R-84 | 200 | 32 | 18 | 3.6 | rectangular |
| | 2-85 | R-85 | 210 | 32 | 20 | 3.7 | rectangular |
| | 2-86 | R-86 | 205 | 32 | 20 | 3.4 | rectangular |
| | 2-87 | R-87 | 200 | 35 | 18 | 3.5 | rectangular |
| | 2-88 | R-88 | 210 | 35 | 18 | 3.5 | rectangular |
| | 2-89 | R-89 | 205 | 35 | 18 | 3.6 | rectangular |
| | 2-90 | R-90 | 200 | 32 | 18 | 3.4 | rectangular |
| | 2-91 | R-91 | 205 | 35 | 18 | 3.5 | rectangular |
| | 2-92 | R-92 | 210 | 35 | 18 | 3.4 | rectangular |
| | 2-93 | R-93 | 205 | 32 | 20 | 3.7 | rectangular |
| | 2-94 | R-94 | 200 | 35 | 18 | 3.3 | rectangular |
| | 2-95 | R-95 | 205 | 35 | 18 | 3.6 | rectangular |
| | 2-96 | R-96 | 200 | 35 | 18 | 3.4 | rectangular |
| | 2-97 | R-97 | 205 | 32 | 20 | 3.5 | rectangular |
| | 2-98 | R-98 | 210 | 35 | 18 | 3.4 | rectangular |
| | 2-99 | R-99 | 205 | 35 | 20 | 3.3 | rectangular |
| | 2-100 | R-100 | 200 | 32 | 18 | 3.4 | rectangular |

**Table 12**

| | | Resist composition | Optimum exposure dose (µC/cm²) | Limiting resolution LS (nm) | Limiting resolution IS (nm) | LER (nm) | Pattern profile |
|---|---|---|---|---|---|---|---|
| Comparative Example | 2-1 | CR-1 | 200 | 40 | 30 | 4.6 | rectangular |
| | 2-2 | CR-2 | 210 | 45 | 28 | 4.4 | rectangular |
| | 2-3 | CR-3 | 200 | 45 | 28 | 4.3 | rectangular |
| | 2-4 | CR-4 | 205 | 40 | 30 | 4.2 | rectangular |
| | 2-5 | CR-5 | 200 | 45 | 28 | 4.3 | rectangular |
| | 2-6 | CR-6 | 210 | 45 | 28 | 4.5 | rectangular |
| | 2-7 | CR-7 | 205 | 40 | 30 | 4.3 | footing |
| | 2-8 | CR-8 | 200 | 45 | 28 | 4.3 | rectangular |
| | 2-9 | CR-9 | 210 | 40 | 28 | 4.1 | rectangular |
| | 2-10 | CR-10 | 205 | 45 | 30 | 4.3 | rectangular |
| | 2-11 | CR-11 | 200 | 40 | 28 | 4.2 | rectangular |
| | 2-12 | CR-12 | 205 | 45 | 28 | 4.3 | footing |
| | 2-13 | CR-13 | 210 | 45 | 30 | 4.1 | rectangular |
| | 2-14 | CR-14 | 200 | 40 | 28 | 4.1 | rectangular |
| | 2-15 | CR-15 | 210 | 45 | 30 | 4.6 | rectangular |
| | 2-16 | CR-16 | 200 | 45 | 28 | 4.3 | footing |
| | 2-17 | CR-17 | 205 | 45 | 28 | 4.3 | rectangular |
| | 2-18 | CR-18 | 200 | 40 | 28 | 4.1 | rectangular |
| | 2-19 | CR-19 | 210 | 45 | 30 | 4.2 | footing |
| | 2-20 | CR-20 | 205 | 40 | 28 | 4.3 | rectangular |
| | 2-21 | CR-21 | 200 | 45 | 35 | 4.1 | footing |
| | 2-22 | CR-22 | 210 | 45 | 28 | 4.2 | rectangular |
| | 2-23 | CR-23 | 200 | 45 | 28 | 4.2 | footing |
| | 2-24 | CR-24 | 200 | 40 | 28 | 4.3 | rectangular |
| | 2-25 | CR-25 | 210 | 45 | 30 | 4.1 | rectangular |
| | 2-26 | CR-26 | 210 | 45 | 28 | 4.6 | rectangular |
| | 2-27 | CR-27 | 200 | 45 | 28 | 4.4 | footing |
| | 2-28 | CR-28 | 205 | 45 | 28 | 4.3 | rectangular |
| | 2-29 | CR-29 | 200 | 40 | 35 | 4.2 | rectangular |
| | 2-30 | CR-30 | 210 | 45 | 30 | 4.3 | rectangular |

**Table 13**

| | | Resist composition | Optimum exposure dose (µC/cm²) | Limiting resolution LS (nm) | Limiting resolution IS (nm) | LER (nm) | Pattern profile |
|---|---|---|---|---|---|---|---|
| Comparative Example | 2-31 | CR-31 | 205 | 45 | 28 | 4.1 | rectangular |
| | 2-32 | CR-32 | 200 | 45 | 28 | 4.6 | footing |
| | 2-33 | CR-33 | 210 | 45 | 28 | 4.2 | footing |
| | 2-34 | CR-34 | 200 | 45 | 35 | 4.4 | rectangular |
| | 2-35 | CR-35 | 200 | 40 | 35 | 4.3 | rectangular |
| | 2-36 | CR-36 | 210 | 45 | 28 | 4.6 | rectangular |
| | 2-37 | CR-37 | 210 | 45 | 30 | 4.2 | footing |
| | 2-38 | CR-38 | 200 | 40 | 28 | 4.4 | rectangular |
| | 2-39 | CR-39 | 205 | 45 | 28 | 4.1 | rectangular |
| | 2-40 | CR-40 | 200 | 40 | 30 | 4.6 | rectangular |
| | 2-41 | CR-41 | 210 | 45 | 28 | 4.2 | footing |
| | 2-42 | CR-42 | 205 | 45 | 28 | 4.4 | rectangular |
| | 2-43 | CR-43 | 200 | 40 | 30 | 4.1 | rectangular |
| | 2-44 | CR-44 | 210 | 40 | 35 | 4.1 | footing |
| | 2-45 | CR-45 | 200 | 45 | 28 | 4.1 | rectangular |
| | 2-46 | CR-46 | 200 | 45 | 30 | 4.3 | footing |
| | 2-47 | CR-47 | 210 | 45 | 28 | 4.2 | rectangular |
| | 2-48 | CR-48 | 210 | 45 | 28 | 4.3 | footing |
| | 2-49 | CR-49 | 200 | 45 | 28 | 4.1 | rectangular |
| | 2-50 | CR-50 | 205 | 40 | 30 | 4.1 | footing |
| | 2-51 | CR-51 | 200 | 45 | 35 | 4.2 | rectangular |
| | 2-52 | CR-52 | 210 | 45 | 28 | 4.6 | footing |
| | 2-53 | CR-53 | 205 | 45 | 30 | 4.3 | rectangular |
| | 2-54 | CR-54 | 200 | 40 | 28 | 4.1 | footing |
| | 2-55 | CR-55 | 210 | 45 | 28 | 4.2 | rectangular |
| | 2-56 | CR-56 | 200 | 45 | 35 | 4.3 | rectangular |
| | 2-57 | CR-57 | 200 | 45 | 28 | 4.6 | rectangular |
| | 2-58 | CR-58 | 210 | 40 | 28 | 4.2 | footing |
| | 2-59 | CR-59 | 210 | 45 | 35 | 4.2 | rectangular |
| | 2-60 | CR-60 | 205 | 40 | 30 | 4.1 | footing |

### [5] Evaluation of etching resistance

### Examples 3-1 to 3-6 and Comparative Examples 3-1 to 3-4

Using ACT-M (manufactured by Tokyo Electron Ltd.), each of the chemically amplified positive resist compositions (R-2, R-7 to R-11, CR-2, CR-7 to CR-9) was applied by spin coating onto a reflective mask blank for an EUV exposure mask having an outermost surface of 152 mm square formed of a chromium compound, and prebaked on a hot plate at 110°C for 600 seconds to prepare a resist film having a film thickness of 120 nm. The film thickness of the obtained resist film was measured using an optical measuring instrument NanoSpec (manufactured by Nanometrics Inc.). The measurement was performed at 81 points in the plane of the blank substrate excluding a peripheral band extending 10 mm inward from the blank periphery, and a film thickness average value and a film thickness range were calculated. The obtained coated substrate was dry-etched by a dry etching apparatus (UNAXIS G4) under the following conditions, and the rate of film thickness loss (A/sec) derived from the residual film after etching was calculated. The results are shown in Table 14.

| | |
|---|---|
| RF1 (RIE): | pulse 700 V |
| RF2 (ICP): | CW 400 W |
| Pressure: | 6 mTorr |
| Cl₂: | 185 sccm |
| O₂: | 55 sccm |
| He: | 9.25 sccm |
| Etching time: | 75 sec |

**Table 14**

| | | Resist composition | Rate (A/sec) |
|---|---|---|---|
| Example | 3-1 | R-2 | 6.5 |
| | 3-2 | R-7 | 6.5 |
| | 3-3 | R-8 | 6.6 |
| | 3-4 | R-9 | 6.6 |
| | 3-5 | R-10 | 6.5 |
| | 3-6 | R-11 | 6.6 |
| Comparative Example | 3-1 | CR-2 | 8.9 |
| | 3-2 | CR-7 | 8.8 |
| | 3-3 | CR-8 | 7.9 |
| | 3-4 | CR-9 | 7.4 |

All of the chemically amplified positive resist compositions (R-1 to R-100) of the invention exhibited good resolution, LER, and pattern rectangularity. On the other hand, in the resist compositions (CR-1 to CR-60) of comparative examples, optimization of acid diffusion was insufficient, and deterioration was observed in resolution, LER, and pattern rectangularity. In addition, also in the dry etching evaluation using R-2 and R-7 to R-11, the etching resistance was good as compared with CR-2 and CR-7 to CR-9, and it was suggested that the incorporation of the skeleton of the formula (A1) of the invention in the polymer is effective in mask processing.

The resist pattern forming process using the chemically amplified positive resist composition of the invention is useful for photolithography in semiconductor element production, particularly in processing of transmissive and reflective photomask blanks.

## Claims

1. A chemically amplified positive resist composition comprising a base polymer (A) containing a polymer adapted to increase its solubility in an alkaline aqueous solution under the action of acid, the polymer comprising a repeat unit containing an aromatic sulfonate anion having the formula (A1-1) and a sulfonium cation having the formula (A1-2) and a repeat unit having the formula (A2), 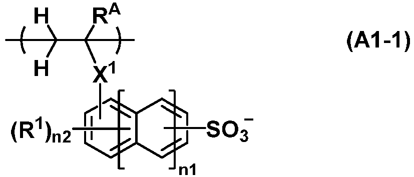 wherein n1 is 0 or 1, n2 is 0, 1, 2, 3, or 4 when n1 is 0, and is 0, 1, 2, 3, 4, 5, or 6 when n1 is 1,
R^{A} is a hydrogen atom, a fluorine atom, a methyl group, or a trifluoromethyl group,
R¹ is a halogen atom, a nitro group, a cyano group, a hydroxy group, a C₁-C₂₀ hydrocarbyl group which may contain a heteroatom, a C₁-C₂₀ hydrocarbyloxy group which may contain a heteroatom, or a C₁-C₂₀ hydrocarbylthio group which may contain a heteroatom, when n2 is 2 or more, a plurality of R¹'s may be identical or different, and a plurality of R¹'s may bond together to form a ring with the carbon atom to which they are attached, and
X¹ is a single bond, an ether bond, an ester bond, or an amide bond, 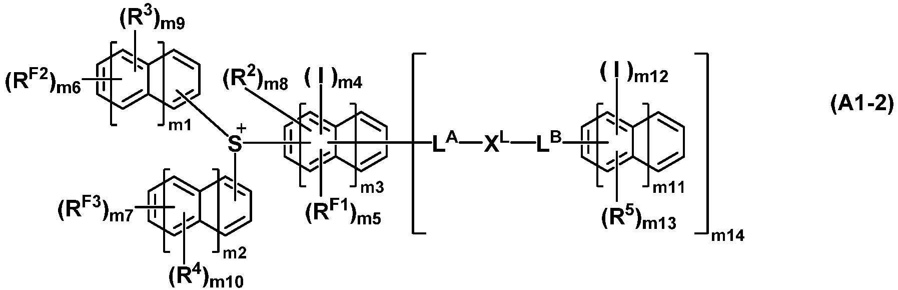 wherein m1 is 0 or 1, m2 is 0 or 1, m3 is 0 or 1, m4 is 0, 1, 2, 3, or 4, m5 is 0, 1, 2, 3, or 4, m6 is 0, 1, 2, 3, 4, 5, or 6, m7 is 0, 1, 2, 3, 4, 5, or 6, m8 is 0, 1, or 2, m9 is 0, 1, or 2, m10 is 0, 1, or 2, m11 is 0 or 1, m12 is 0, 1, 2, 3, or 4, m13 is 0, 1, or 2, m14 is 0, 1, or 2, meeting 0 ≤ m6+m9 ≤ 4 when m1 is 0, 0 ≤ m6+m9 ≤ 6 when m1 is 1, 0 ≤ m7+m10 ≤ 4 when m2 is 0, 0 ≤ m7+m10 ≤ 6 when m2 is 1, 1 ≤ m4+m5+m8+m14 ≤ 4 when m3 is 0, 1 ≤ m4+m5+m8+m14 ≤ 6 when m13 is 1, 0 ≤ m12+m13 ≤ 4 when m11 is 0, 0 ≤ m12+m13 ≤ 6 when m11 is 1, and m4+m12 ≥ 1,
R^{F1} to R^{F3} are each independently a fluorine atom, a C₁-C₆ fluorinated saturated hydrocarbyl group, a C₁-C₆ fluorinated saturated hydrocarbyloxy group, or a C₁-C₆ fluorinated saturated hydrocarbylthio group, when m5 is 2 or more, a plurality of R^{F1}'s may be identical or different, when m6 is 2 or more, a plurality of R^{F2}'s may be identical or different, when m7 is 2 or more, a plurality of R^{F3}'s may be identical or different,
R² to R⁵ are a halogen atom other than an iodine atom and a fluorine atom, a nitro group, a cyano group, a C₁-C₂₀ hydrocarbyl group which may contain a heteroatom, a C₁-C₂₀ hydrocarbyloxy group which may contain a heteroatom, or a C₁-C₂₀ hydrocarbylthio group which may contain a heteroatom, when m8 is 2, two R²'s may be identical or different, and two R²'s may bond together to form a ring with the carbon atom to which they are attached, when m9 is 2, two R³'s may be identical or different, and two R³'s may bond together to form a ring with the carbon atom to which they are attached, when m10 is 2, two R⁴'s may be identical or different, and two R⁴'s may bond together to form a ring with the carbon atom to which they are attached, when m13 is 2, two R⁵'s may be identical or different, and two R⁵'s may bond together to form a ring with the carbon atom to which they are attached,
aromatic rings that are directly bonded to S⁺ in the sulfonium cation may bond together to form a ring with S⁺,
L^{A} and L^{B} are each independently a single bond, an ether bond, an ester bond, an amide bond, a sulfonate ester bond, a sulfonamide bond, a carbonate bond, or a carbamate bond, and
X^{L} is a single bond or a C₁-C₄₀ hydrocarbylene group which may contain a heteroatom, 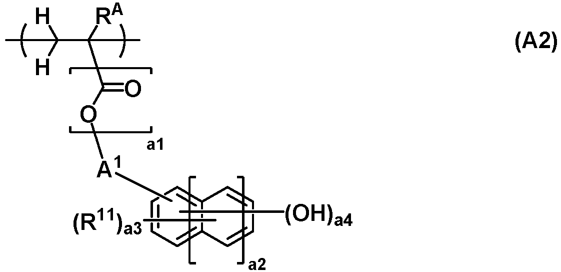
wherein a1 is 0 or 1, a2 is 0, 1, or 2, a3 is an integer meeting 0 ≤ a3 ≤ 5+2(a2)-a4, and a4 is 1, 2, or 3,
R^{A} is a hydrogen atom, a fluorine atom, a methyl group, or a trifluoromethyl group,
R¹¹ is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom, and
A¹ is a single bond or a C₁-C₁₀ saturated hydrocarbylene group, and -CH₂- in the saturated hydrocarbylene group may be substituted with -O-.

2. The chemically amplified positive resist composition of claim 1, wherein the sulfonium cation having the formula (A1-2) has the formula (A1-2-1): 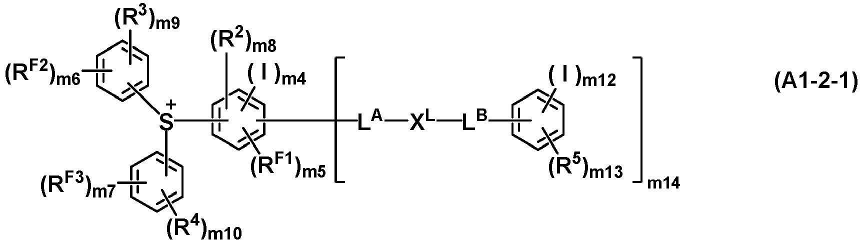 wherein m4 to m10, m12 to m14, R^{F1} to R^{F3}, R² to R⁵, L^{A}, L^{B}, and X^{L} are as defined above.

3. The chemically amplified positive resist composition of claim 2, wherein the sulfonium cation having the formula (A1-2-1) has the formula (A1-2-2): 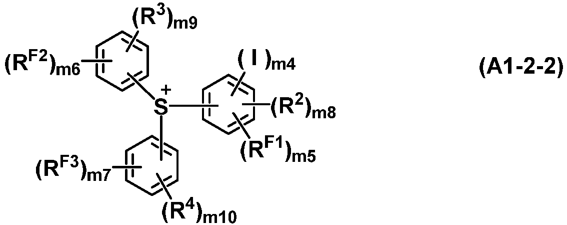 wherein m4 to m10, R^{F1} to R^{F3}, and R² to R⁵ are as defined above.

4. The chemically amplified positive resist composition of any one of claims 1 to 3, wherein the repeat unit having the formula (A2) has the formula (A2-1): 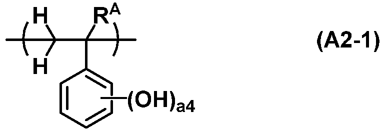 wherein R^{A} and a4 are as defined above.

5. The chemically amplified positive resist composition of any one of claims 1 to 4, wherein the polymer further contains at least one repeat unit selected from a repeat unit having the formula (A3-1) and a repeat unit having the formula (A3-2): 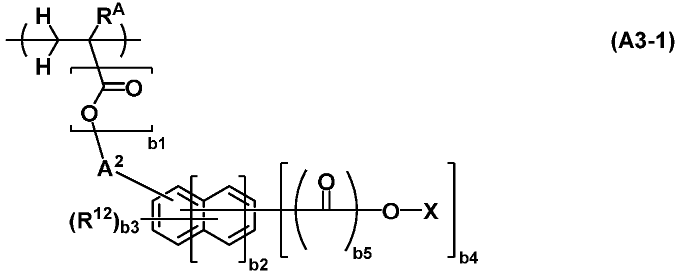 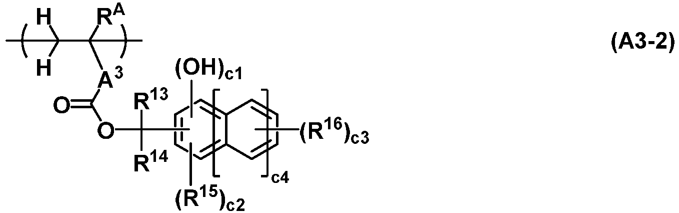 wherein b1 is 0 or 1, b2 is 0, 1, or 2, b3 is an integer meeting 0 ≤ b3 ≤ 5+2(b2)-b4, b4 is 1, 2, or 3, and b5 is 0 or 1,
R^{A} is a hydrogen atom, a fluorine atom, a methyl group, or a trifluoromethyl group,
R¹² is a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom,
A² is a single bond or a C₁-C₁₀ saturated hydrocarbylene group, and some -CH₂-in the saturated hydrocarbylene group may be substituted with -O-,
when b4 is 1, X is an acid labile group, when b4 is 2 or 3, X's are each independently a hydrogen atom or an acid labile group, but at least one X is an acid labile group,
c1 is 0, 1, or 2, c2 is 0, 1, or 2, c3 is 0, 1, 2, 3, 4, or 5, and c4 is 0, 1, or 2,
R¹³ and R¹⁴ are each independently a C₁-C₁₀ hydrocarbyl group which may contain a heteroatom, and R¹³ and R¹⁴ may bond together to form a ring with the carbon atom to which they are attached,
R¹⁵'s are each independently a fluorine atom, a C₁-C₅ fluorinated alkyl group, or a C₁-C₅ fluorinated alkoxy group,
R¹⁶'s are each independently a C₁-C₁₀ hydrocarbyl group which may contain a heteroatom,
A³ is a single bond, a phenylene group, a naphthylene group, or *-C(=O)-O-A³¹-, A³¹ is a C₁-C₂₀ aliphatic hydrocarbylene group, a phenylene group, or a naphthylene group, and the aliphatic hydrocarbylene group may contain at least one selected from a hydroxy group, an ether bond, an ester bond, and a lactone ring, and * designates a point of attachment to the carbon atom in the backbone.

6. The chemically amplified positive resist composition of any one of claims 1 to 5, wherein the polymer further contains at least one type selected from a repeat unit having the formula (B3), a repeat unit having the formula (B4), and a repeat unit having the formula (B5): 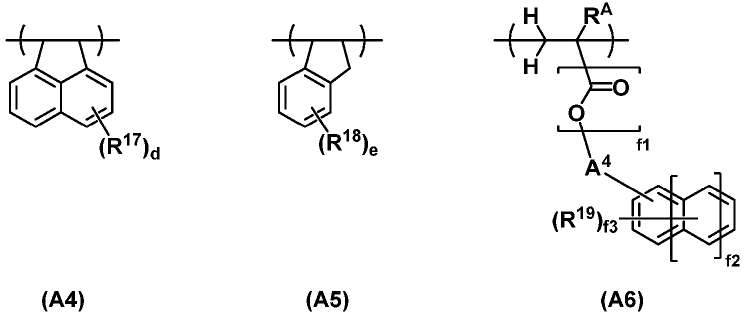 wherein d is 0, 1, 2, 3, 4, 5, or 6, e is 0, 1, 2, 3, or 4, f1 is 0 or 1, f2 is 0, 1, or 2, f3 is 0, 1, 2, 3, 4, or 5,
R^{A} is a hydrogen atom, a fluorine atom, a methyl group, or a trifluoromethyl group,
R¹⁷ and R¹⁸ are each independently a hydroxy group, a halogen atom, a C₁-C₆ saturated hydrocarbyl group which may be substituted with a halogen atom, a C₁-C₆ saturated hydrocarbyloxy group which may be substituted with a halogen atom, or a C₂-C₈ saturated hydrocarbylcarbonyloxy group which may be substituted with a halogen atom,
R¹⁹ is a halogen atom, a nitro group, a cyano group, a C₁-C₂₀ saturated hydrocarbyl group, a C₁-C₂₀ saturated hydrocarbyloxy group, a C₂-C₂₀ saturated hydrocarbylcarbonyloxy group, a C₂-C₂₀ saturated hydrocarbyloxyhydrocarbyl group, or a C₂-C₂₀ saturated hydrocarbylthiohydrocarbyl group, and may be a hydroxy group when f2 is 1 or 2, and
A⁴ is a single bond or a C₁-C₁₀ saturated hydrocarbylene group, and -CH₂- in the saturated hydrocarbylene group may be substituted with -O-.

7. The chemically amplified positive resist composition of any one of claims 1 to 6, wherein the content of a repeat unit having an aromatic ring skeleton is 60 mol% or more of the overall repeat units of the polymer contained in the base polymer (A).

8. The chemically amplified positive resist composition of any one of claims 1 to 7, further comprising a quencher (B).

9. The chemically amplified positive resist composition of any one of claims 1 to 8, further comprising an organic solvent (C).

10. The chemically amplified positive resist composition of any one of claims 1 to 9, further comprising a fluorine atom-containing polymer (D) containing at least one type selected from a repeat unit having the formula (D1), a repeat unit having the formula (D2), a repeat unit having the formula (D3), and a repeat unit having the formula (D4): 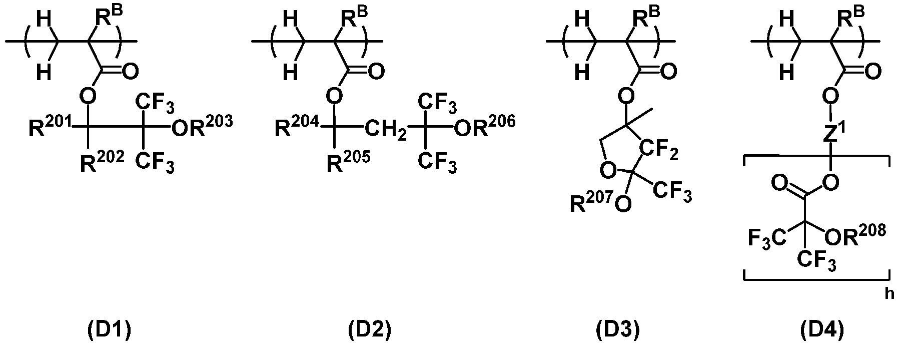 wherein h is 1, 2, or 3,
R^{B}'s are each independently a hydrogen atom, a fluorine atom, a methyl group, or a trifluoromethyl group,
R²⁰¹, R²⁰², R²⁰⁴, and R²⁰⁵ are each independently a hydrogen atom or a C₁-C₁₀ saturated hydrocarbyl group,
R²⁰³, R²⁰⁶, R²⁰⁷, and R²⁰⁸ are each independently a hydrogen atom, a C₁-C₁₅ hydrocarbyl group, a C₁-C₁₅ fluorinated hydrocarbyl group, or an acid labile group, and when R²⁰³, R²⁰⁶, R²⁰⁷, and R²⁰⁸ are a hydrocarbyl group or a fluorinated hydrocarbyl group, an ether bond or a carbonyl group may intervene in a carbon-carbon bond, and
Z¹ is a C₁-C₂₀ (h+1)-valent hydrocarbon group or a C₁-C₂₀ (h+1)-valent fluorinated hydrocarbon group.

11. The chemically amplified positive resist composition of claim 10, wherein the fluorine atom-containing polymer further contains at least one type selected from a repeat unit having the formula (D5) and a repeat unit having the formula (D6): 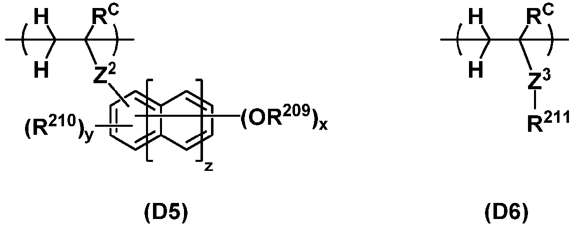 wherein x is 1, 2, or 3, y is an integer meeting 0 ≤ y ≤ 5+2z-x, and z is 0 or 1,
R^{C}'s are each independently a hydrogen atom or a methyl group,
R²⁰⁹ is a hydrogen atom or a C₁-C₅ straight or branched hydrocarbyl group in which a heteroatom-containing group may intervene in a carbon-carbon bond,
R²¹⁰ is a C₁-C₅ straight or branched hydrocarbyl group in which a heteroatom-containing group may intervene in a carbon-carbon bond,
R²¹¹ is a C₁-C₂₀ saturated hydrocarbyl group in which at least one hydrogen atom is substituted with a fluorine atom, and some -CH₂- in the saturated hydrocarbyl group may be substituted with an ester bond or an ether bond,
Z² is a single bond, *-C(=O)-O- or *-C(=O)-NH-,
Z³ is a single bond, -O-, *-C(=O)-O-Z³¹-Z³²-, or *-C(=O)-NH-Z³¹-Z³²-, Z³¹ is a single bond or a C₁-C₁₀ saturated hydrocarbylene group, and Z³² is a single bond, an ester bond, an ether bond, or a sulfonamide bond, and
* is a point of attachment to the carbon atom in the backbone.

12. The chemically amplified positive resist composition of any one of claims 1 to 11, further comprising an acid generator (E).

13. A resist pattern forming process comprising the steps of forming a resist film on a substrate using the chemically amplified positive resist composition of any one of claims 1 to 12, irradiating the resist film patternwise with high-energy radiation, and developing the resist film irradiated patternwise using an alkaline developer.

14. The resist pattern forming process of claim 13, wherein the substrate is a transmissive or reflective mask blank.

15. A transmissive or reflective mask blank, which is coated with the chemically amplified positive resist composition of any one of claims 1 to 12.
